(19) Europäisches Patentamt
European Patent Office
Office européen des brevets

(11) EP 3 637 489 A1

(12) **EUROPEAN PATENT APPLICATION**

(43) Date of publication:
**15.04.2020 Bulletin 2020/16**

(51) Int Cl.:
***H01L 51/54*** *(2006.01)*

(21) Application number: **19201655.8**

(22) Date of filing: **07.10.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **08.10.2018 KR 20180119964**
**04.10.2019 KR 20190122836**

(71) Applicant: **Samsung Electronics Co., Ltd.**
**Gyeonggi-do 16677 (KR)**

(72) Inventors:
- **CHOI, Hyeonho**
**16678 Gyeonggi-do (KR)**
- **KWAK, Seungyeon**
**16678 Gyeonggi-do (KR)**
- **KIM, Sangdong**
**16678 Gyeonggi-do (KR)**
- **ARATANI, Sukekazu**
**16678 Gyeonggi-do (KR)**
- **CHOI, Whail**
**16678 Gyeonggi-do (KR)**
- **KIM, Sunghan**
**16678 Gyeonggi-do (KR)**
- **CHOI, Byoungki**
**16678 Gyeonggi-do (KR)**
- **HWANG, Kyuyoung**
**16678 Gyeonggi-do (KR)**

(74) Representative: **Elkington and Fife LLP**
**Prospect House**
**8 Pembroke Road**
**Sevenoaks, Kent TN13 1XR (GB)**

# (54) ORGANOMETALLIC COMPOUND AND ORGANIC LIGHT-EMITTING DEVICE INCLUDING THE SAME

(57) An organometallic compound including a transition metal and at least one organic ligand, wherein the organometallic compound satisfies predetermined conditions described in the specification.

FIG. 1

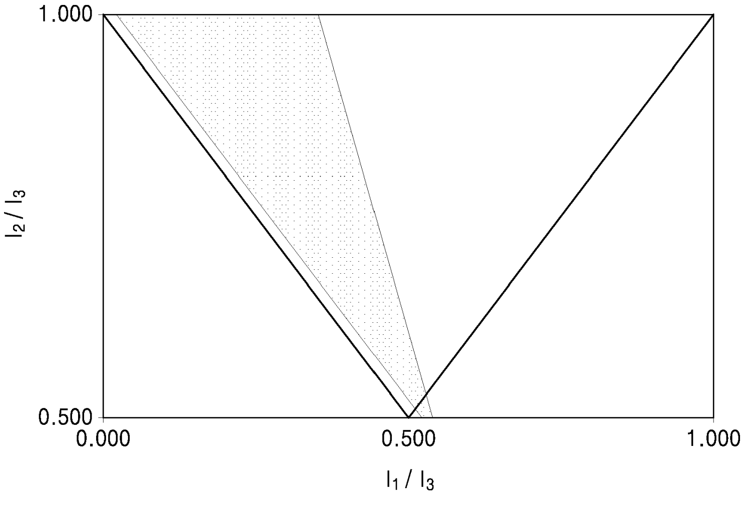


EP 3 637 489 A1

**Description**

FIELD OF THE INVENTION

One or more embodiments relate to an organometallic compound and an organic light-emitting device including the same.

BACKGROUND OF THE INVENTION

Organic light-emitting devices (OLEDs) are self-emission devices, which have superior characteristics in terms of a viewing angle, a response time, a brightness, a driving voltage, and a response speed, and which produce full-color images.

In an example, an organic light-emitting device includes an anode, a cathode, and an organic layer disposed between the anode and the cathode, wherein the organic layer includes an emission layer. A hole transport region may be disposed between the anode and the emission layer, and an electron transport region may be disposed between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state, thereby generating light.

Various types of organic light emitting devices are known. However, there still remains a need in OLEDs having low driving voltage, high efficiency, high brightness, and long lifespan.

SUMMARY OF THE INVENTION

Aspects of the present disclosure provide an organometallic compound, an organic light-emitting device including the organometallic compound.

Additional aspects will be set forth in part in the description which follows and, in part, will be apparent from the description, or may be learned by practice of the presented embodiments.

An aspect of the present disclosure provides an organometallic compound including a transition metal and at least one organic ligand,
wherein

the organometallic compound satisfies Condition 1, and
the organometallic compound has a radiative decay rate of $2.5 \times 10^5\ s^{-1}$ or more:

Condition 1

$$1.02 - x \leq y \leq 1.95 - 2.7x.$$

In Condition 1, x is an x coordinate value in principal moments of inertia diagram of the organometallic compound, wherein x is $I_1/I_3$ of the organometallic compound,

in Condition 1, y is a y coordinate value in the principal moments of inertia diagram of the organometallic compound, wherein y is $I_2/I_3$ of the organometallic compound,
$I_1$, $I_2$, and $I_3$ are three principal moments of inertia of the organometallic compound, which satisfy a relationship of $I_1 \leq I_2 \leq I_3$,
$I_1$, $I_2$, and $I_3$ are evaluated using a density functional theory method for the organometallic compound,
the radiative decay rate of the organometallic compound is a value calculated from a time-resolved photoluminescence spectrum with respect to film 1, and
the film 1 is a 40-nanometer-thick film obtained by vacuum-codepositing 1,3-bis(*N*-carbazolyl)benzene (mCP) and the organometallic compound on a quartz substrate at a weight ratio of 90 : 10 to 99 : 1.

Another aspect of the present disclosure provides an organic light-emitting device including:

a first electrode;
a second electrode; and
an organic layer disposed between the first electrode and the second electrode,

wherein the organic layer includes an emission layer, and wherein the organic layer includes at least one organometallic compound.

The organometallic compound in the emission layer of the organic layer may act as a dopant.

BRIEF DESCRIPTION OF THE DRAWINGS

These and/or other aspects will become apparent and more readily appreciated from the following description of the embodiments, taken in conjunction with the accompanying drawings in which:

FIG. 1 is a principal moments of inertia (PMI) diagram in which regions of an x coordinate value and a y coordinate value satisfying Condition 1 are indicated by a shaded triangle; and
FIG. 2 is a schematic view of an organic light-emitting device according to an embodiment.

DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly in contact with the other element or intervening elements may be present therebetween. In contrast, when an element is referred to as being "directly on" another element, there are no intervening elements present.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

The terminology used herein is for the purpose of describing particular embodiments only and is not intended to be limiting. As used herein, the singular forms "a," "an," and "the" are intended to include the plural forms as well, unless the context clearly indicates otherwise.

The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (*i.e.*, the limitations of the measurement system). For example, "about" can mean within one or more standard deviations, or within ± 30%, 20%, 10%, 5% of the stated value.

In an embodiment, an organometallic compound is provided. The organometallic compound according to an

embodiment may include a transition metal and at least one organic ligand.

For example, the transition metal may be a first-row transition metal, a second-row transition metal, or a third-row transition metal of the Periodic Table of Elements.

In an embodiment, the transition metal may be iridium (Ir), platinum (Pt), osmium (Os), titanium (Ti), zirconium (Zr), hafnium (Hf), europium (Eu), terbium (Tb), thulium (Tm), or rhodium (Rh).

In an embodiment, the transition metal may be platinum, palladium, gold, or iridium, but embodiments of the present disclosure are not limited thereto.

The organic ligand included in the organometallic compound may be the same as described below.

The organometallic compound may satisfy Condition 1:

Condition 1

$$1.02 - x \leq y \leq 1.95 - 2.7x.$$

In Condition 1, x is an x coordinate value in a principle of moments of inertia (PMI) diagram of the organometallic compound, which is $I_1/I_3$ of the organometallic compound and y is a y coordinate value in the PMI diagram of the organometallic compound, which is $I_2/I_3$ of the organometallic compound.

The $I_1$, $I_2$, and $I_3$ are three PMIs of the organometallic compound and may have a relationship of $I_1 \leq I_2 \leq I_3$. For example, the $I_1$, $I_2$, and $I_3$ of the organometallic compound may have a relationship of $I_1 \leq I_2 < I_3$, $I_1 < I_2 \leq I_3$, or $I_1 < I_2 < I_3$.

The $I_1$, $I_2$, and $I_3$ may be evaluated using a density functional theory (DFT) method. For example, the $I_1$, $I_2$, and $I_3$ may be evaluated using a density functional theory (DFT) method in which a B3LYP/LanL2DZ function is used for a transition metal included in the organometallic compound and a B3LYP/6-31 G(D,P) function is used for an organic ligand included in the organometallic compound in molecular structure optimization of the organometallic compound.

FIG. 1 is a PMI diagram in which regions of an x coordinate value and a y coordinate value satisfying Condition 1 are expressed by a shaded triangle.

In an embodiment, the organometallic compound may satisfy Condition 2:

Condition 2

$$1.06 - x \leq y \leq 1.95 - 2.7x.$$

In one or more embodiments, the organometallic compound may satisfy Condition 3:

Condition 3

$$1.06 - x \leq y \leq 4.70 - 10.0x.$$

In one or more embodiments, the transition metal included in the organometallic compound may be platinum, and the organometallic compound may satisfy Condition 4:

Condition 4

$$1.02 - x \leq y \leq 1.16 - x.$$

In one or more embodiments, the transition metal included in the organometallic compound may be iridium, and the organometallic compound may satisfy Condition 5:

Condition 5

$$1.00 - 0.5x \leq y \leq 1.95 - 2.7x.$$

The definitions of x and y in Conditions 1 to 5 may be the same as described herein. In one or more embodiments, the transition metal included in the organometallic compound may be platinum, and the organometallic compound may

satisfy at least one of Condition 1, Condition 2, Condition 3 and Condition 4.

In one or more embodiments, the transition metal included in the organometallic compound may be iridium, and the organometallic compound may satisfy at least one of Condition 1, Condition 2, Condition 3 and Condition 5.

In one or more embodiments, the transition metal included in the organometallic compound may be iridium, and the organometallic compound may satisfy at least one of Condition 1, Condition 2, and Condition 5.

In one or more embodiments, x in the PMI diagram of the organometallic compound may be in a range of 0.08 to 0.39 or 0.10 to 0.39, but embodiments of the present disclosure are not limited thereto.

In one or more embodiments, y in the PMI diagram of the organometallic compound may be in a range of 0.30 to 1.00 or 0.75 to 1.00, but embodiments of the present disclosure are not limited thereto.

The organometallic compound may have a radiative decay rate of $2.5 \times 10^5$ reverse seconds ($s^{-1}$) or more.

The radiative decay rate of the organometallic compound is a value calculated from a time-resolved photoluminescence (TRPL) spectrum with respect to film 1, and the film 1 is a 40-nanometer-thick (40-nm-thick) film obtained by vacuum-codepositing 1,3-bis(*N*-carbazolyl)benzene (mCP) and the organometallic compound on a quartz substrate at a weight ratio of 90 : 10 to 99 : 1 (for example, 96 : 4 or 98 : 2) (for example, at a vacuum degree of $10^{-7}$ torr).

In an embodiment, the organometallic compound may have a radiative decay rate of $2.5 \times 10^5$ $s^{-1}$ to $2.0 \times 10^6$ $s^{-1}$ or $4.0 \times 10^5$ $s^{-1}$ to $1.5 \times 10^6$ $s^{-1}$, but embodiments of the present disclosure are not limited thereto.

In another embodiment, the transition metal of the organometallic compound may be a platinum and the organometallic compound may have a radiative decay rate of $4.0 \times 10^5$ $s^{-1}$ to $2.0 \times 10^6$ $s^{-1}$.

In another embodiment, the transition metal of the organometallic compound may be an iridium and the organometallic compound may have a radiative decay rate of $6.70 \times 10^5$ $s^{-1}$ to $2.0 \times 10^6$ $s^{-1}$.

In another embodiment, the transition metal of the organometallic compound may be an iridium and the organometallic compound may have a radiative decay rate of $8.05 \times 10^5$ $s^{-1}$ to $2.0 \times 10^6$ $s^{-1}$.

In another embodiment, the transition metal of the organometallic compound may be an iridium and the organometallic compound may have a radiative decay rate of $1.20 \times 10^6$ $s^{-1}$ to $2.0 \times 10^6$ $s^{-1}$.

The organometallic compound may have a horizontal orientation ratio of a transition dipole moment in a range of 85 % to 100 %.

For example, the horizontal orientation ratio of the transition dipole moment of the organometallic compound may be in a range of, for example, 80 % to 100 %, 81 % to 100 %, 82 % to 100 %, 83 % to 100 %, 84 % to 100 %, 85 % to 100 %, 86 % to 100 %, 87 % to 100 %, 88 % to 100 %, 89 % to 100 %, 90 % to 100 %, 91 % to 100 %, 92 % to 100 %, 93 % to 100 %, 94 % to 100 %, 95 % to 100 %, 96 % to 100 %, 97 % to 100 %, 98 % to 100 %, 99 % to 100 %, or 100 %, but embodiments of the present disclosure are not limited thereto.

Since the organometallic compound has a high horizontal orientation ratio of a transition dipole moment, a large electric field traveling in a direction parallel to the plane of film including the organometallic compound (i.e., a horizontal direct) may be emitted and a loss of light due to a waveguide mode and/or a surface plasmon polariton mode may be reduced. Light emitted due to such a mechanism may have high external extraction efficiency (that is, efficiency of extraction of light emitted in the organometallic compound from a device (for example, an organic light-emitting device) including a film (for example, an emission layer described below) including the organometallic compound) to the outside). Thus, an electronic device, for example, an organic light-emitting device, which includes the organometallic compound, may have high luminescent efficiency.

The organic ligand included in the organometallic compound may include a tetradentate organic ligand, and the tetradentate organic ligand may include a $C_3$-$C_8$ nitrogen-containing condensed ring system in which a five membered ring and a six membered ring are condensed to each other. For example, the tetradentate organic ligand may include a benzimidazole ring system, a benzoxazole ring system, a benzothiazole ring system, or a benzotriazole ring system. In an embodiment, the tetradentate organic ligand may include a benzimidazole ring system. In this embodiment, the transition metal included in the organometallic compound may be platinum, palladium, or gold.

In an embodiment, the tetradentate organic ligand may include a benzimidazole ring system substituted with a substituted phenyl group and the substituted phenyl group is substituted with both at least one phenyl group and at least one tert-butyl group.

In an embodiment, the organic ligand comprises a bidentate organic ligand, and the bidentate organic ligand may comprise i) a $C_3$-$C_{15}$ nitrogen-containing condensed ring system in which at least two six membered rings are condensed to each other or ii) a $C_3$-$C_8$ condensed ring system in which a (e.g., one) five membered ring and a (e.g., one) six membered ring are condensed to each other. In this embodiment, the transition metal included in the organometallic compound may be iridium.

In an embodiment, the organic ligand may comprise 1) a bidentate organic ligand comprising a quinoline ring and a benzene ring, a bidentate organic ligand comprising an isoquinoline ring and a benzene ring, a bidentate organic ligand comprising an azabenzothiophene ring and a benzene ring, a bidentate organic ligand comprising an azabenzofuran ring and a benzene ring, a bidentate organic ligand comprising a benzoquinoline ring and a benzene ring, or a bidentate organic ligand comprising an benzoisoquinoline ring and a benzene ring; and 2) a bidentate organic ligand

linked to the transition metal via oxygen. In this embodiment, the transition metal included in the organometallic compound may be iridium.
In an embodiment,

a) the transition metal included in the organometallic compound may be iridium,
b) the organic ligand included in the organometallic compound may comprise i) a bidentate organic ligand comprising a quinoline ring and a benzene ring, or ii) a bidentate organic ligand comprising an isoquinoline ring and a benzene ring, and
c) the organometallic compound may have a radiative decay rate of 7.20 x $10^5$ $s^{-1}$ to 1.5 x $10^6$ $s^{-1}$ or 8.05 x $10^5$ $s^{-1}$ to 1.0 x $10^6$ $s^{-1}$.

In an embodiment,

a) the transition metal included in the organometallic compound may be iridium,
b) the organic ligand included in the organometallic compound may comprise i) a bidentate organic ligand comprising an azabenzothiophene ring and a benzene ring, or ii) a bidentate organic ligand comprising an azabenzofuran ring and a benzene ring, and
c) the organometallic compound may have a radiative decay rate of 2.00 x $10^5$ $s^{-1}$ to 2.0 x $10^6$ $s^{-1}$ or 3.00 x $10^5$ $s^{-1}$ to 1.5 x $10^6$ $s^{-1}$.

In an embodiment,

a) the transition metal included in the organometallic compound may be iridium,
b) the organic ligand included in the organometallic compound may comprise i) a bidentate organic ligand comprising a benzoquinoline ring and a benzene ring, or ii) a bidentate organic ligand comprising an benzoisoquinoline ring and a benzene ring, and
c) the organometallic compound may have a radiative decay rate of 1.20 x $10^6$ $s^{-1}$ to 2.0 x $10^6$ $s^{-1}$.

For example, the organometallic compound may be represented by one of Formulae 1A to 1K, but embodiments of the present disclosure are not limited thereto:

Description of Formula 1A

The organometallic compound may be represented by Formula 1A below:

Formula 1A

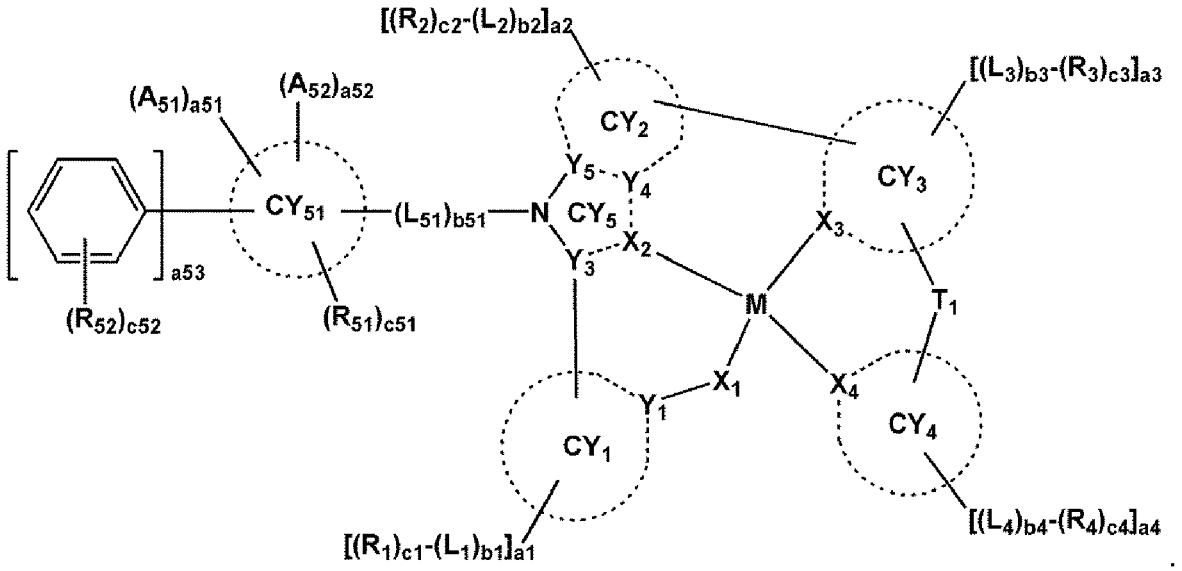

The organometallic compound represented by Formula 1A may include at least one selected from deuterium and a $C_1$-$C_{60}$ alkyl group substituted with at least one deuterium. The number of deuterium atoms in the organometallic

compound represented by Formula 1A may be from 1 to 20, for example, from 1 to 15, from 1 to 10, or from 1 to 5.

In Formula 1A, M may be a transition metal. For example, M may be Pt, Pd, or Au.

In Formula 1A, $X_1$ may be O or S, and a bond between $X_1$ and M may be a covalent bond. For example, $X_1$ may be O.

In Formula 1A, $X_2$ to $X_4$ may each independently be C or N. For example, $X_2$ and $X_3$ may each independently be C or N, and $X_4$ may be N.

In an embodiment, in Formula 1A, $X_2$ and $X_4$ may each independently be N, and $X_3$ may be C, but embodiments of the present disclosure are not limited thereto.

In Formula 1A, one bond selected from a bond between $X_2$ and M, a bond between $X_3$ and M, and a bond between $X_4$ and M may be a covalent bond, and the others thereof may be a coordinate bond. Therefore, the organometallic compound represented by Formula 1A may be electrically neutral.

In an embodiment, a bond between $X_2$ and M and a bond between $X_4$ and M may be a coordinate bond, and a bond between $X_3$ and M may be a covalent bond, but embodiments of the present disclosure are not limited thereto.

In Formula 1A, $Y_1$ and $Y_3$ to $Y_5$ may each independently be C or N. For example, $Y_1$ and $Y_3$ to $Y_5$ may be C.

In Formula 1A, a bond between $X_2$ and $Y_3$, a bond between $X_2$ and $Y_4$, and a bond between $Y_4$ and $Y_5$ may be a chemical bond (for example, a single bond, a double bond, or the like).

In Formula 1A, ring $CY_1$ to ring $CY_4$ and ring $CY_{51}$ may each independently be a $C_5$-$C_{30}$ carbocyclic group or a $C_1$-$C_{30}$ heterocyclic group. Each of the ring $CY_1$ to ring $CY_4$ and the ring $CY_{51}$ in Formula 1A may include at least one selected from deuterium a $C_1$-$C_{60}$ alkyl group substituted with at least one deuterium.

For example, ring $CY_1$ to ring $CY_4$ and ring $CY_{51}$ may each independently be i) a first ring, ii) a second ring, iii) a condensed ring in which at least two first rings are condensed, iv) a condensed ring in which at least two second rings are condensed, or v) a condensed ring in which at least one first ring and at least one second ring are condensed.

In an embodiment, the first ring may be a cyclopentane group, a cyclopentadiene group, a furan group, a thiophene group, a pyrrole group, a silole group, an indene group, a benzofuran group, a benzothiophene group, an indole group, a benzosilole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, or a triazasilole group, and

the second ring may be an adamantane group, a norbornene group, a bicyclo[1.1.1]pentane group, a bicyclo[2.1.1]hexane group, a bicyclo[2.2.1]heptane group, a bicyclo[2.2.2]octane group, a cyclohexane group, a cyclohexene group, a benzene group, a pyridine group, a pyrimidine group, a pyrazine group, a pyridazine group, or a triazine group.

In an embodiment, in Formula 1A, ring $CY_1$ to ring $CY_4$ and ring $CY_{51}$ may each independently be a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborrole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborrole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborrole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group.

In one or more embodiments, in Formula 1A, ring $CY_4$ may not be a benzimidazole group.

In Formula 1A, a cyclometalated ring formed by ring $CY_5$, ring $CY_2$, ring $CY_3$, and M may each independently be a 6-membered ring.

In Formula 1A, $T_1$ may be a single bond, a double bond, *-N($R_5$)-*', *-B($R_5$)-*', *-P($R_5$)-*', *-C($R_5$)($R_6$)-*', *-Si($R_5$)($R_6$)-*', *-Ge($R_5$)($R_6$)-*', *-S-*', *-Se-*', *-O-*, *-C(=O)-*', *-S(=O)-*', *-S(=O)$_2$-*', *-C($R_5$)=*', *=C($R_5$)-*', *-C($R_5$)=C($R_6$)-*', *-C(=S)-*', or *-C≡C-*', wherein * and *' each indicate a binding site to a neighboring atom. Here, $R_5$ and $R_6$ are the same as $R_1$ described in Formula 1A, and may optionally be linked to each other via a single bond, a double bond, *-N(R')-*', *-B(R')-*', *-P(R')-*', *-C(R')(R")-*', *-Si(R')(R")-*', *-Ge(R')(R")-*', *-S-*', *-Se-*', *-O-*', *-C(=O)-*', *-S(=O)-*', *-S(=O)$_2$-*', *-C(R')=*', *=C(R')-*', *-C(R')=C(R")-*', *-C(=S)-*', or *-C≡C-*' to form a $C_5$-$C_{30}$ carbocyclic

group that is unsubstituted or substituted with at least one $R_{10a}$ or a $C_1$-$C_{30}$ heterocyclic group that is unsubstituted or substituted with at least one $R_{10a}$. R', R", and $R_{10a}$ are each independently defined the same as $R_1$ in Formula 1A.

For example, in Formula 1A, $T_1$ may be a single bond, but embodiments of the present disclosure are not limited thereto.

In Formula 1A, $L_1$ to $L_4$ and $L_{51}$ may each independently be a single bond, a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$. Here, $R_{10a}$ is defined the same as $R_1$ in Formula 1A.

For example, in Formula 1A, $L_1$ to $L_4$ and $L_{51}$ may each independently be:

a single bond; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with at least one $R_{10a}$. Here, $R_{10a}$ is defined the same as $R_1$ in Formula 1A.

In an embodiment, in Formula 1A, $L_1$ to $L_4$ and $L_{51}$ may each independently be:

a single bond; or
a benzene group unsubstituted or substituted with at least one $R_{10a}$ group,
but embodiments of the present disclosure are not limited thereto.

In an embodiment, in Formula 1A,
$Y_1$ and $X_3$ may be C, and $X_2$ and $X_4$ may be N,
ring $CY_1$ to ring $CY_3$ and ring $CY_{51}$ may be a benzene group, and ring $CY_4$ may be a pyridine group, and
$L_4$ and $L_{51}$ may each independently be:

a single bond; or
a benzene group unsubstituted or substituted with at least one $R_{10a}$ group.

In Formula 1A, b1 to b4 and b51 each indicate the number of groups $L_1$ to $L_4$ and $L_{51}$, respectively, and may each independently be 1, 2, 3, 4 or 5. When b1 is two or more, two or more groups $L_1$ may be identical to or different from each other, when b2 is two or more, two or more groups $L_2$ may be identical to or different from each other, when b3 is two or more, two or more groups $L_3$ may be identical to or different from each other, when b4 is two or more, two or more groups $L_4$ may be identical to or different from each other, and when b51 is two or more, two or more groups $L_{51}$ may be identical to or different from each other.

For example, in Formula 1A, b1 to b4 and b51 may each independently be 1, 2 or 3, but embodiments of the present disclosure are not limited thereto.

In Formula 1A, $R_1$ to $R_6$, $R_{51}$, and $R_{52}$ may each independently be hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-Ge(Q_3)(Q_4)(Q_5)$,$-B(Q_6)(Q_7)$, $-P(=O)(Q_8)(Q_9)$, or $-P(Q_8)(Q_9)$, wherein $Q_1$ to $Q_9$ are each independently the same as described herein.

For example, $R_1$ to $R_6$, $R_{51}$, and $R_{52}$ may each independently be:

a hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, $C_1$-$C_{20}$ alkyl group, or a $C_1$-$C_{20}$ alkoxy group;

a $C_1$-$C_{20}$ alkyl group and a $C_1$-$C_{20}$ alkoxy group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a pyridinyl group, a pyrimidinyl group, or any combination thereof;

a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterium-containing $C_2$-$C_{20}$ alkyl group (for example, $*-C(CD_3)_3$), a $C_1$-$C_{20}$ alkoxy group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or any combination thereof; or

$-N(Q_1)(Q_2)$, $-Si(Q_3)(Q_4)(Q_5)$, $-Ge(Q_3)(Q_4)(Q_5)$, $-B(Q_6)(Q_7)$,$-P(=O)(Q_8)(Q_9)$, or $-P(Q_8)(Q_9)$.

In Formula 1A, c1 to c4, c51, and c52 each indicate the number of groups $R_1$ to $R_4$, $R_{51}$, and $R_{52}$, respectively, and may each independently be 1, 2, 3, 4 or 5. When c1 is two or more, two or more groups $R_1$ may be identical to or different from each other, when c2 is two or more, two or more groups $R_2$ may be identical to or different from each

other, when c3 is two or more, two or more groups $R_3$ may be identical to or different from each other, when c4 is two or more, two or more groups $R_4$ may be identical to or different from each other, when c51 is two or more, two or more groups $R_{51}$ may be identical to or different from each other, and when c52 is two or more, two or more groups $R_{52}$ may be identical to or different from each other. For example, c1 to c3, c51, and c52 may each independently be 1 or 2, but embodiments of the present disclosure are not limited thereto.

In Formula 1A, $A_{51}$ may be a $C_4$-$C_{60}$ alkyl group, and $A_{52}$ may be deuterium or a deuterium-containing $C_1$-$C_{60}$ alkyl group unsubstituted or substituted with at least one $C_3$-$C_{10}$ cycloalkyl group.

In an embodiment, in Formula 1A, $A_{51}$ may be a linear or branched $C_4$-$C_{10}$ alkyl group, and $A_{52}$ may be deuterium or a deuterium-containing linear or branched $C_1$-$C_{20}$ alkyl group unsubstituted or substituted with at least one $C_3$-$C_{10}$ cycloalkyl group.

In an embodiment, in Formula 1A, $A_{51}$ may be an n-butyl group, a sec-butyl group, an iso-butyl group, a tert-butyl group, an n-pentyl group, a tert-pentyl group, a neo-pentyl group, an iso-pentyl group, a sec-pentyl group, a 3-pentyl group, or a sec-iso-pentyl group, unsubstituted or substituted with a methyl group, an ethyl group, an n-propyl group, an iso-propyl group, an n-butyl group, a sec-butyl group, an iso-butyl group, a tert-butyl group, an n-pentyl group, a tert-pentyl group, a neo-pentyl group, an iso-pentyl group, a sec-pentyl group, a 3-pentyl group, a sec-iso-pentyl group, or any combination thereof.

In an embodiment, in Formula 1A, $A_{52}$ may be a deuterium-containing linear or branched $C_1$-$C_{20}$ alkyl group unsubstituted or substituted with at least one $C_3$-$C_{10}$ cycloalkyl group, in which the linear or branched $C_1$-$C_{20}$ alkyl group may be a methyl group, an ethyl group, an n-propyl group, an iso-propyl group, an n-butyl group, a sec-butyl group, an iso-butyl group, a tert-butyl group, an n-pentyl group, a tert-pentyl group, a neo-pentyl group, an iso-pentyl group, a sec-pentyl group, a 3-pentyl group, or a sec-iso-pentyl group, unsubstituted or substituted with a methyl group, an ethyl group, an n-propyl group, an iso-propyl group, an n-butyl group, a sec-butyl group, an iso-butyl group, a tert-butyl group, an n-pentyl group, a tert-pentyl group, a neo-pentyl group, an iso-pentyl group, a sec-pentyl group, a 3-pentyl group, a sec-iso-pentyl group, or any combination thereof.

The organometallic compound represented by Formula 1A may include a deuterium, a deuterium-containing $C_1$-$C_{60}$ alkyl group unsubstituted or substituted with at least one $C_3$-$C_{10}$ cycloalkyl group, or any combination thereof. The number of deuterium atoms in the organometallic compound represented by Formula 1A may be from 1 to 20, for example, from 1 to 15, from 1 to 10, or from 1 to 5.

In an embodiment, regarding Formula 1A,

$R_1$ to $R_6$, $R_{51}$, and $R_{52}$ may each independently be:

hydrogen, deuterium, -F, a cyano group, a nitro group, $-SF_5$, $-CH_3$,$-CD_3$, $-CD_2H$, $-CDH_2$, $-CF_3$, $-CF_2H$, $-CFH_2$, a group represented by one of Formulae 9-1 to 9-66, a group represented by one of Formulae 9-1 to 9-66 in which at least one hydrogen is substituted with deuterium, a group represented by one of Formulae 10-1 to 10-118, a group represented by one of Formulae 10-1 to 10-118 in which at least one hydrogen is substituted with deuterium, a group represented by one of Formulae 10-201 to 10-342, or a group represented by one of Formulae 10-201 to 10-342 in which at least one hydrogen is substituted with deuterium, and/or

$A_{51}$ may be a group represented by one of Formulae 9-4 to 9-36, and/or

$A_{52}$ may be a group represented by one of Formulae 9-1 to 9-63 in which at least one hydrogen is substituted with deuterium, and/or

a group represented by

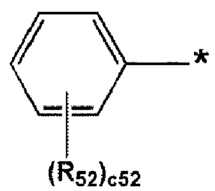

in Formula 1A may be a group represented by one of Formulae 10-10 to 10-118, or a group represented by one of Formulae 10-10 to 10-118 in which at least one hydrogen is substituted with deuterium:

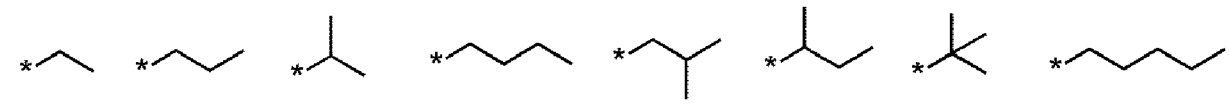

9-1 9-2 9-3 9-4 9-5 9-6 9-7 9-8

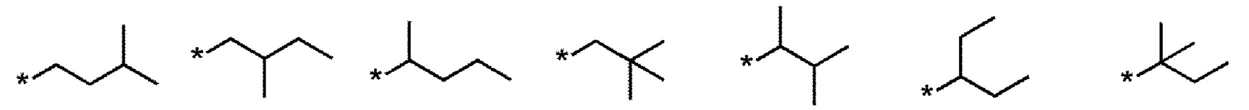

9-9 9-10 9-11 9-12 9-13 9-14 9-15

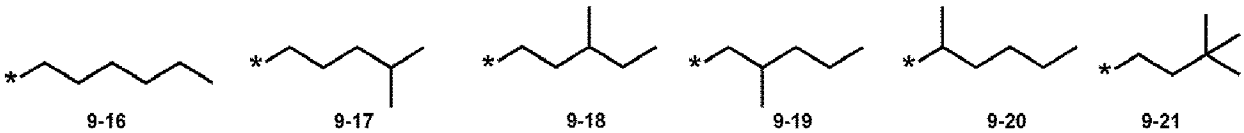

9-16 9-17 9-18 9-19 9-20 9-21

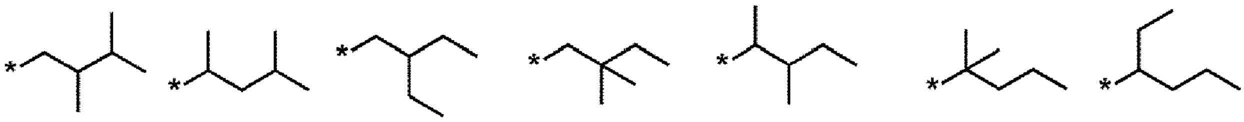

9-22 9-23 9-24 9-25 9-26 9-27 9-28

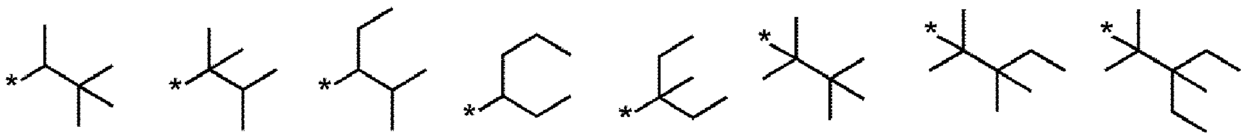

9-29 9-30 9-31 9-32 9-33 9-34 9-35 9-36

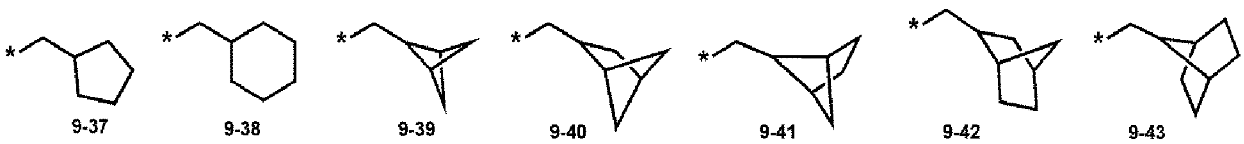

9-37 9-38 9-39 9-40 9-41 9-42 9-43

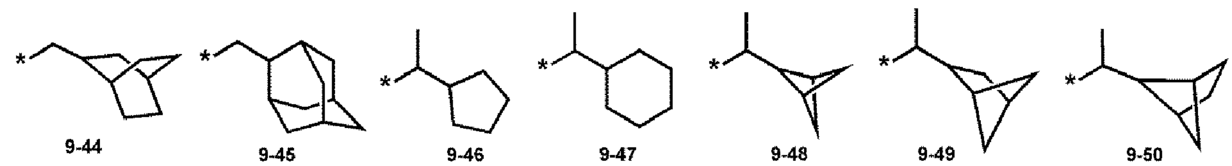

9-44 9-45 9-46 9-47 9-48 9-49 9-50

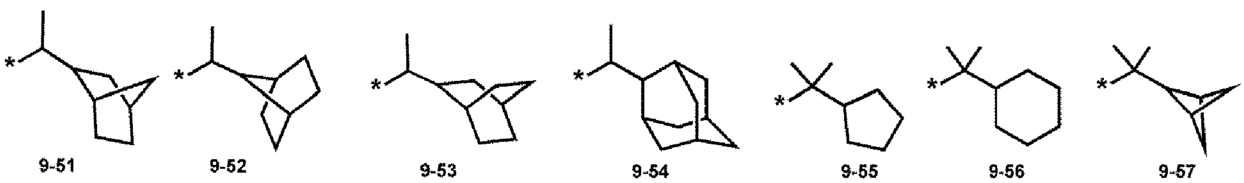

9-51 9-52 9-53 9-54 9-55 9-56 9-57

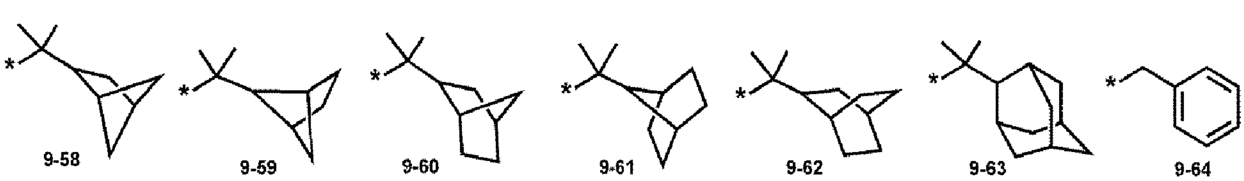

9-58 9-59 9-60 9-61 9-62 9-63 9-64

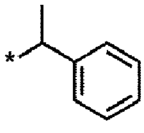
9-65

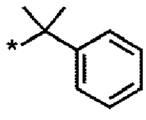
9-66

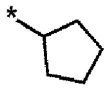
10-1

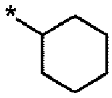
10-2

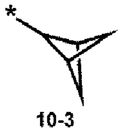
10-3

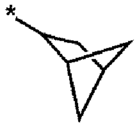
10-4

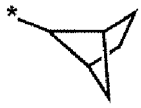
10-5

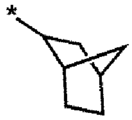
10-6

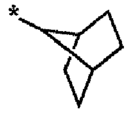
10-7

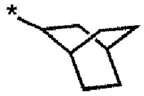
10-8

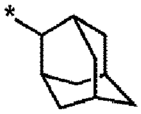
10-9

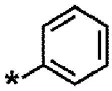
10-10

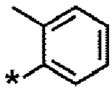
10-11

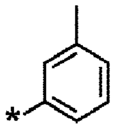
10-12

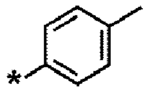
10-13

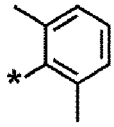
10-14

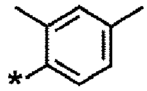
10-15

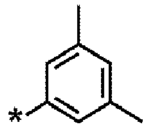
10-16

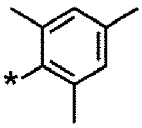
10-17

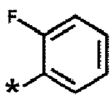
10-18

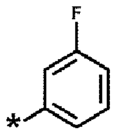
10-19

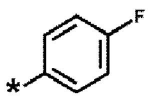
10-20

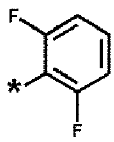
10-21

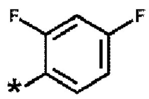
10-22

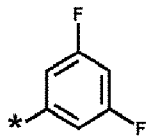
10-23

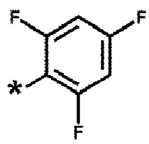
10-24

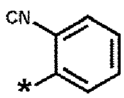
10-25

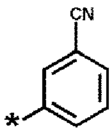
10-26

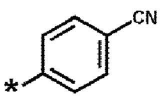
10-27

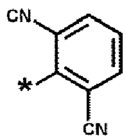
10-28

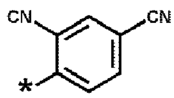
10-29

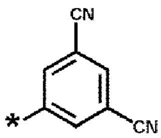
10-30

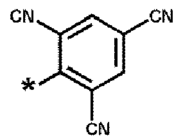
10-31

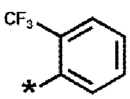
10-32

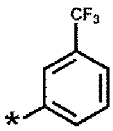
10-33

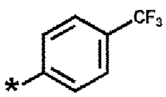
10-34

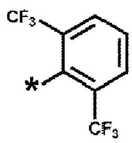
10-35

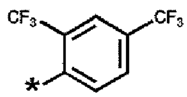
10-36

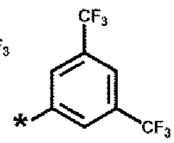
10-37

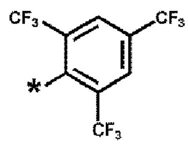
10-38

10-39

10-40

10-41

10-42

10-43

10-44

10-45

10-46

10-47

10-48

10-49

10-50

10-51

10-52

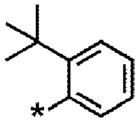 10-53
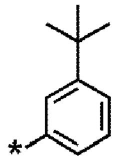 10-54
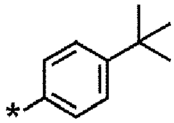 10-55
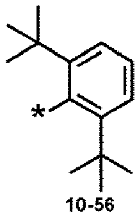 10-56
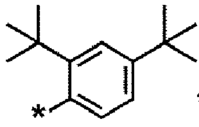 10-57
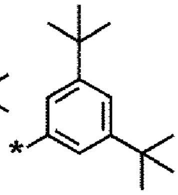 10-58
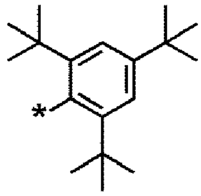 10-59

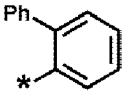 10-60
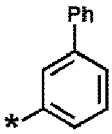 10-61
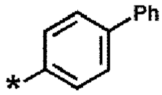 10-62
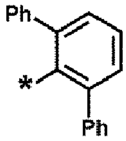 10-63
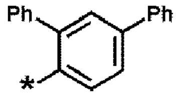 10-64
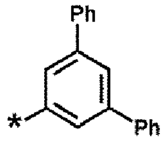 10-65
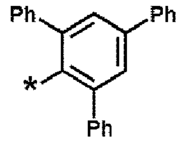 10-66

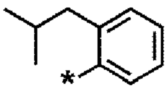 10-67
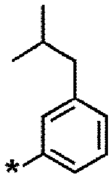 10-68
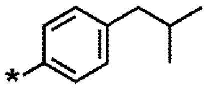 10-69
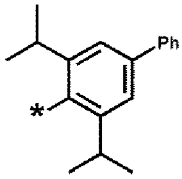 10-70
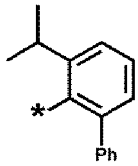 10-71
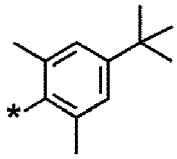 10-72

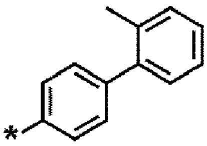 10-73
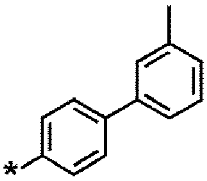 10-74
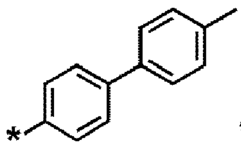 10-75
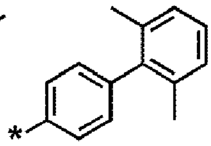 10-76
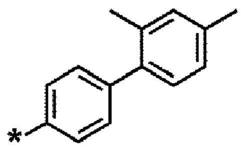 10-77

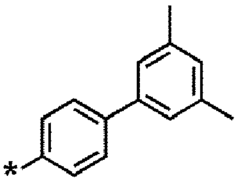 10-78
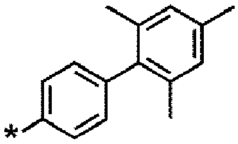 10-79
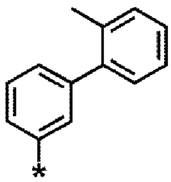 10-80
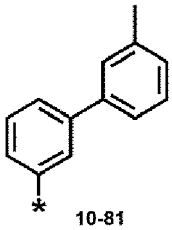 10-81
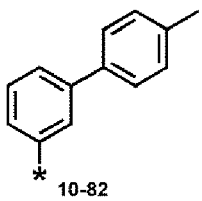 10-82

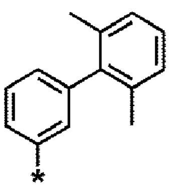 10-83
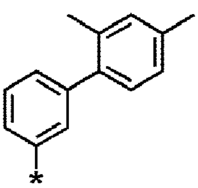 10-84
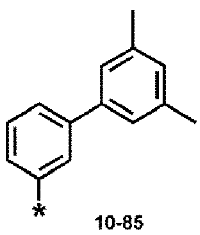 10-85
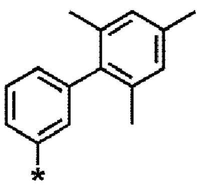 10-86
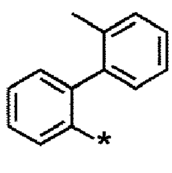 10-87
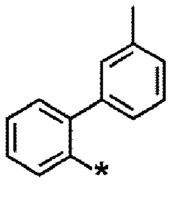 10-88

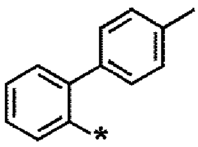
10-89

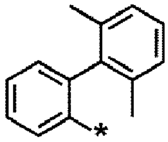
10-90

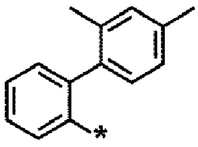
10-91

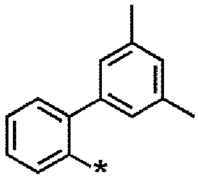
10-92

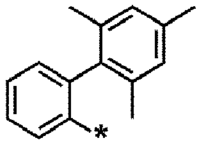
10-93

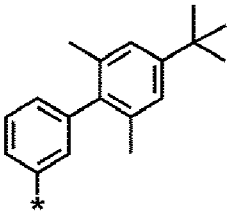
10-94

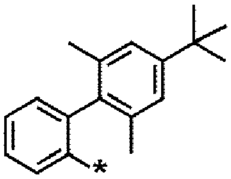
10-95

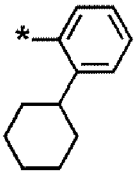
10-96

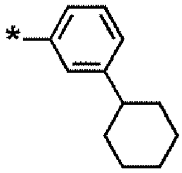
10-97

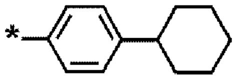
10-98

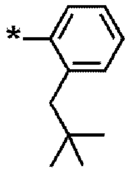
10-99

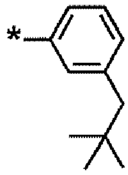
10-100

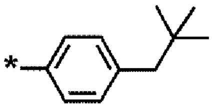
10-101

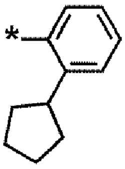
10-102

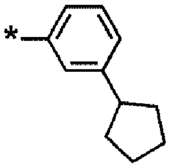
10-103

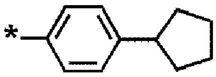
10-104

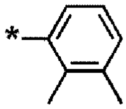
10-105

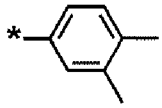
10-106

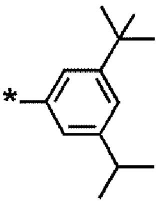
10-107

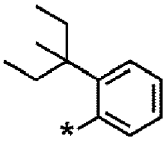
10-108

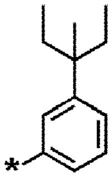
10-109

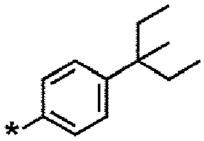
10-110

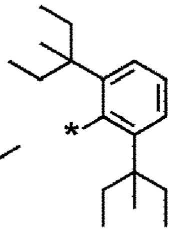
10-111

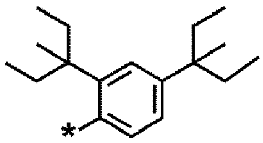
10-112

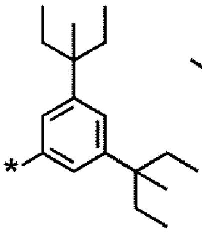
10-113

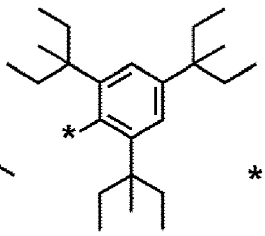
10-114

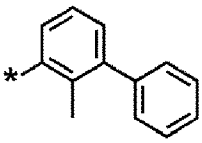
10-115

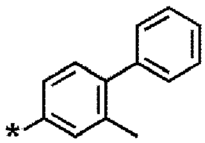
10-116

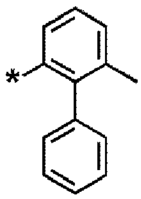
10-117

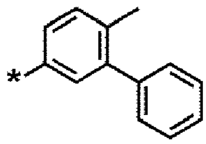
10-118

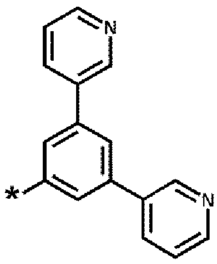
10-201

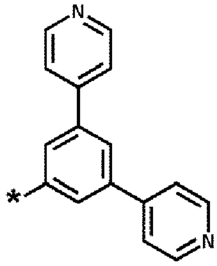
10-202

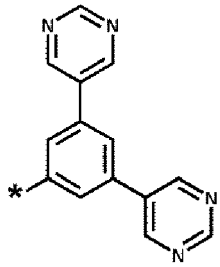
10-203

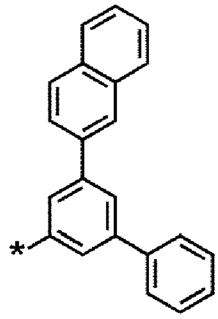
10-204

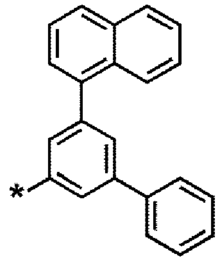
10-205

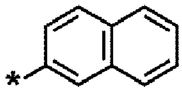
10-206

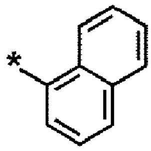
10-207

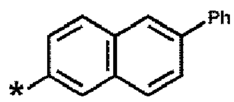
10-208

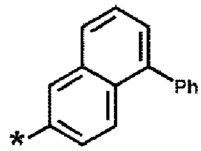
10-209

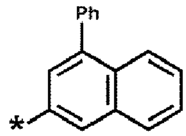
10-210

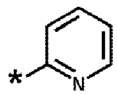
10-211

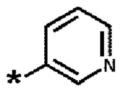
10-212

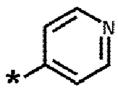
10-213

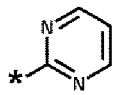
10-214

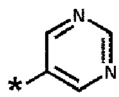
10-215

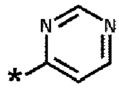
10-216

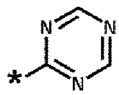
10-217

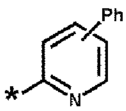
10-218

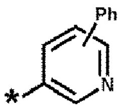
10-219

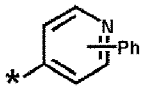
10-220

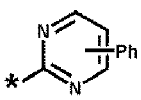
10-221

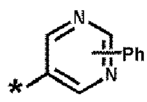
10-222

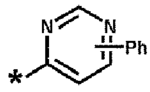
10-223

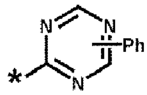
10-224

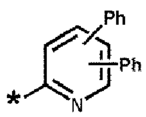
10-225

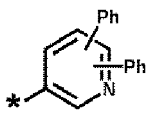
10-226

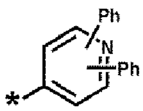
10-227

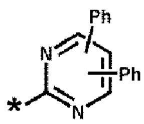
10-228

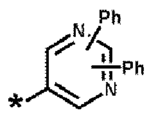
10-229

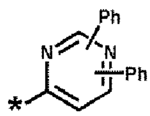
10-230

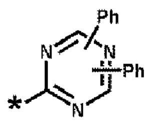
10-231

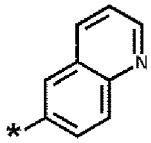
10-232

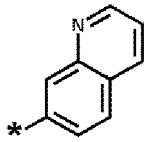
10-233

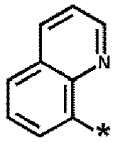
10-234

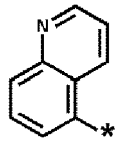
10-235

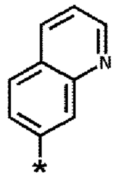
10-236

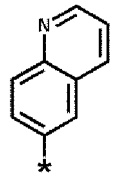
10-237

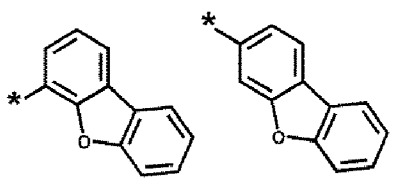
10-238 10-239

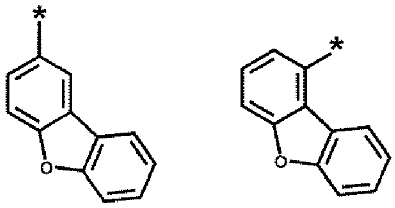
10-240 10-241

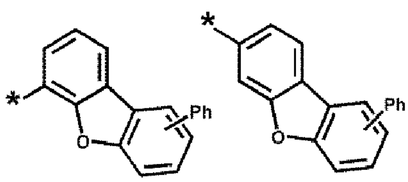
10-242 10-243

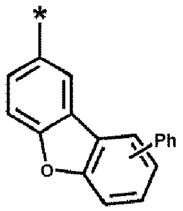
10-244
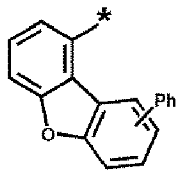
10-245
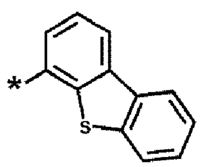
10-246
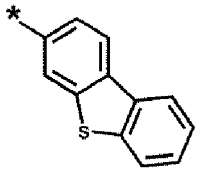
10-247
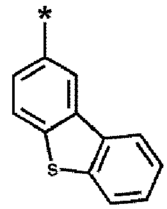
10-248
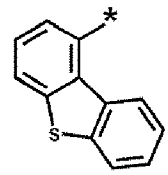
10-249

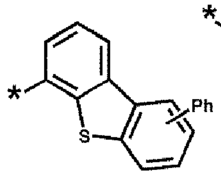
10-250
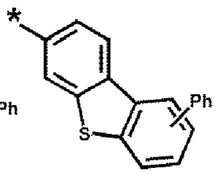
10-251
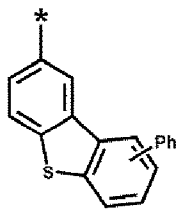
10-252
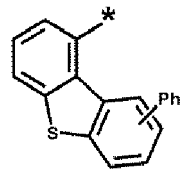
10-253
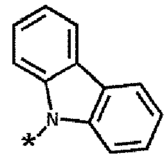
10-254
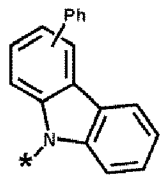
10-255

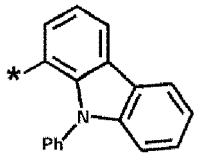
10-256
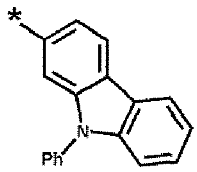
10-257
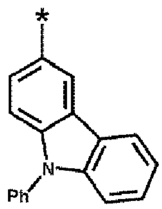
10-258
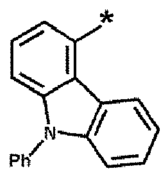
10-259
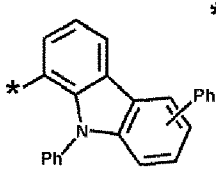
10-260
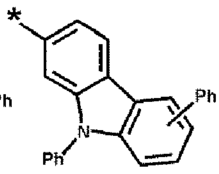
10-261

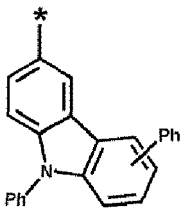
10-262
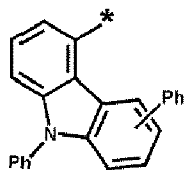
10-263
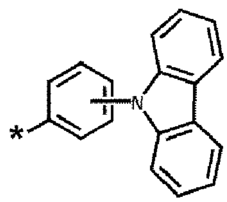
10-264
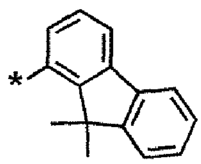
10-265
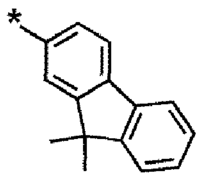
10-266
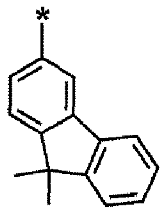
10-267

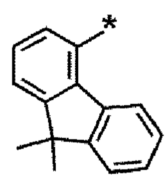
10-268
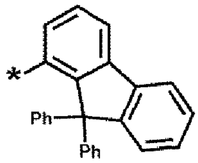
10-269
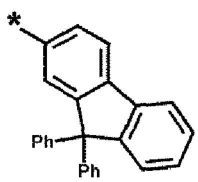
10-270
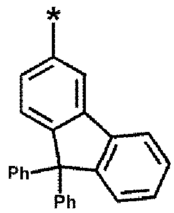
10-271
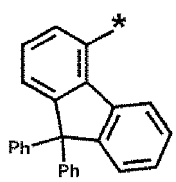
10-272

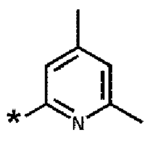
10-273
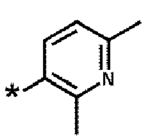
10-274
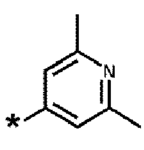
10-275
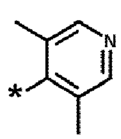
10-276
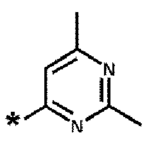
10-277
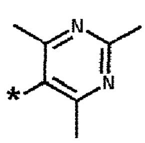
10-278
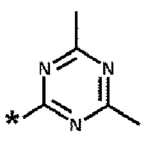
10-279

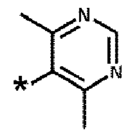
10-280

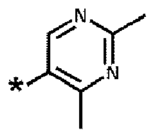
10-281

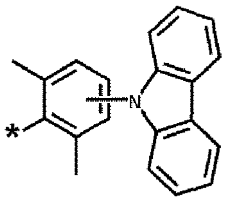
10-282

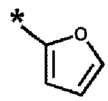
10-283

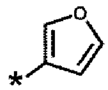
10-284

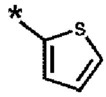
10-285

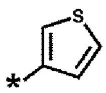
10-286

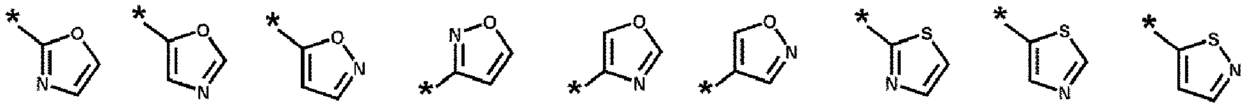
10-287 10-288 10-289 10-290 10-291 10-292 10-293 10-294 10-295

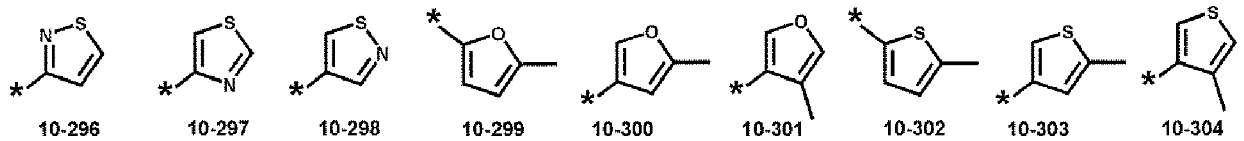
10-296 10-297 10-298 10-299 10-300 10-301 10-302 10-303 10-304

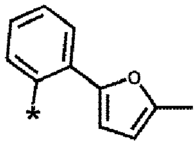
10-305

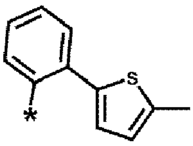
10-306

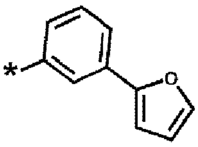
10-307

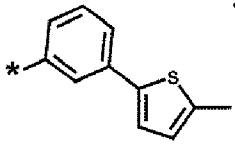
10-308

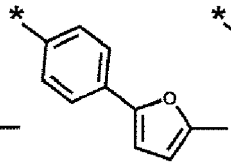
10-309

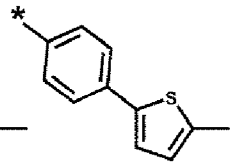
10-310

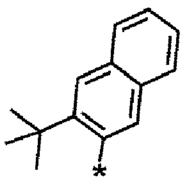
10-311

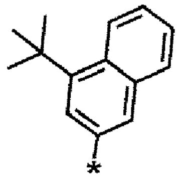
10-312

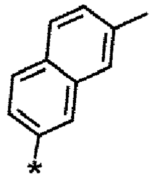
10-313

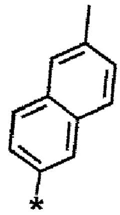
10-314

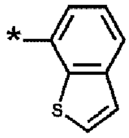
10-315

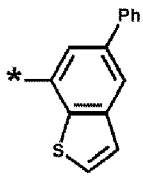
10-316

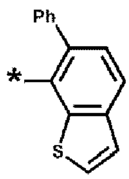
10-317

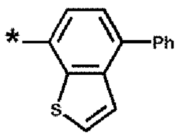
10-318

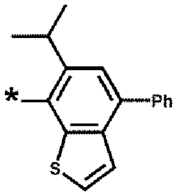
10-319

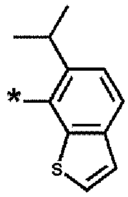
10-320

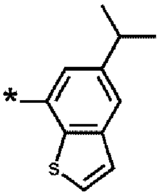
10-321

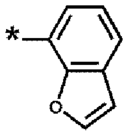
10-322

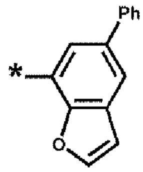
10-323

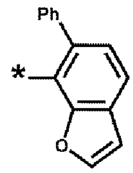
10-324

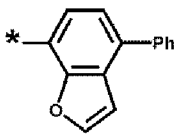
10-325

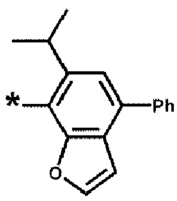
10-326

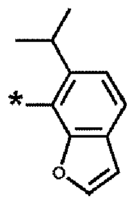
10-327

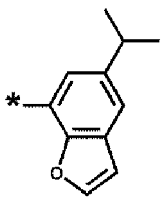
10-328

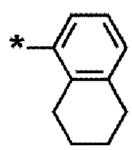
10-329

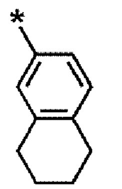
10-330

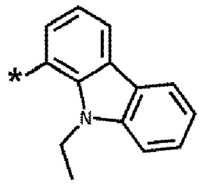
10-331

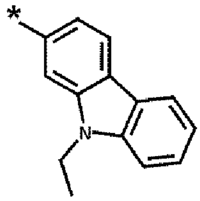 10-332
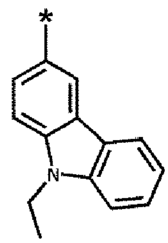 10-333
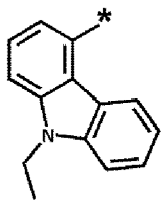 10-334
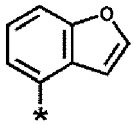 10-335
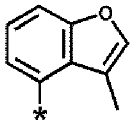 10-336
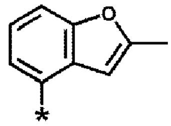 10-337

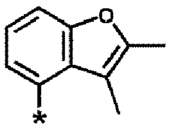 10-338
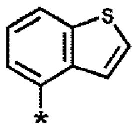 10-339
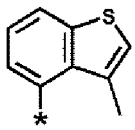 10-340
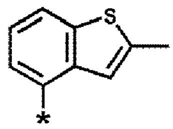 10-341
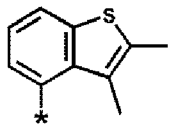 10-342

For example, Formula 9-33 may be a branched $C_6$ alkyl group (i.e., a tert-butyl group substituted with two methyl groups).

In Formulae 9-1 to 9-66, 10-1 to 10-118 and 10-201 to 10-342, * indicates a binding site to a neighboring atom, Ph indicates a phenyl group, and TMS indicates a trimethylsilyl group.

The "group represented by one of Formulae 9-1 to 9-66 in which at least one hydrogen is substituted with deuterium" may be, for example, a group represented by one of Formulae 9-501 to 9-514 or 9-601 to 9-638.

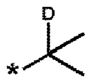 9-501
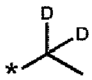 9-502
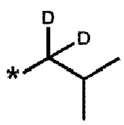 9-503
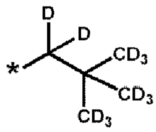 9-504
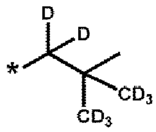 9-505
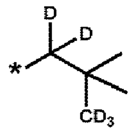 9-506
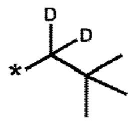 9-507

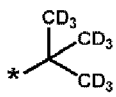 9-508
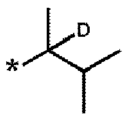 9-509
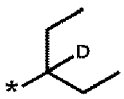 9-510
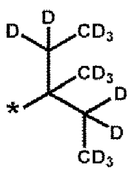 9-511
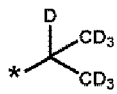 9-512
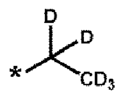 9-513
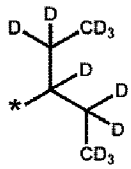 9-514

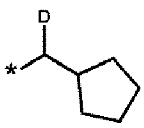 9-601
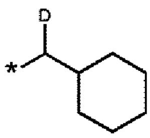 9-602
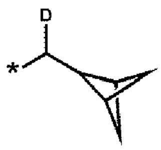 9-603
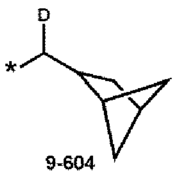 9-604
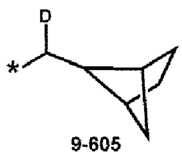 9-605
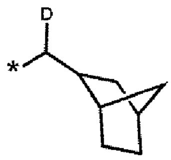 9-606
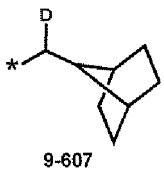 9-607

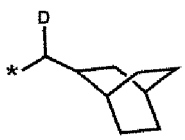 9-608
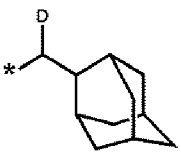 9-609
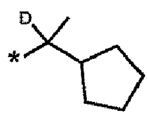 9-610
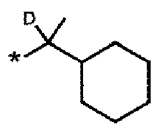 9-611
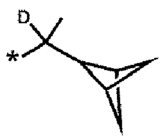 9-612
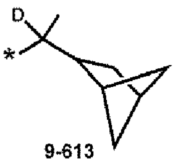 9-613

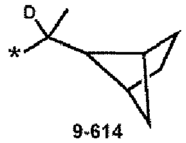 9-614
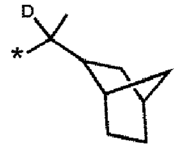 9-615
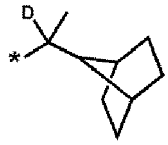 9-616
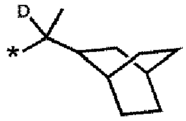 9-617
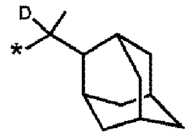 9-618
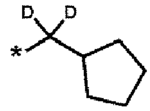 9-619

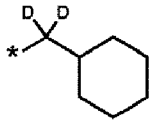 9-620
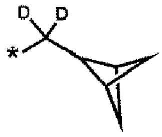 9-621
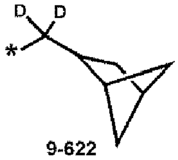 9-622
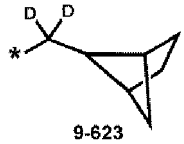 9-623
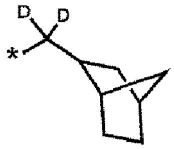 9-624
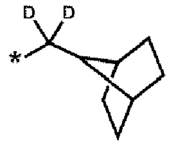 9-625

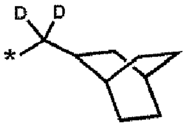 9-626
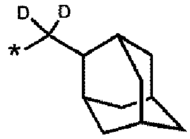 9-627
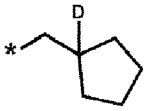 9-628
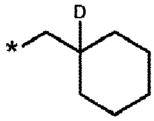 9-629
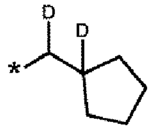 9-630
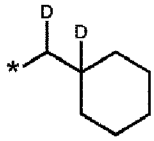 9-631

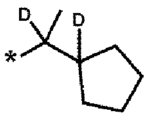 9-632
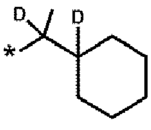 9-633
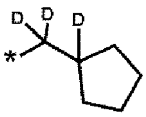 9-634
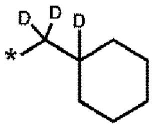 9-635
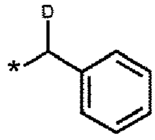 9-636
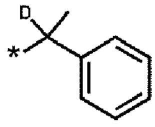 9-637
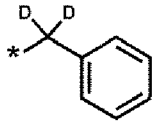 9-638

The "group represented by one of Formulae 10-1 to 10-118 in which at least one hydrogen is substituted with deuterium" may be, for example, a group represented by one of Formulae 10-501 to 10-552:

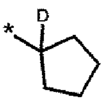 10-501
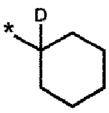 10-502
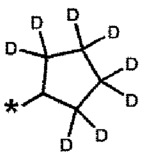 10-503
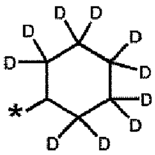 10-504
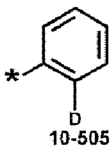 10-505
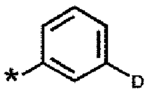 10-506
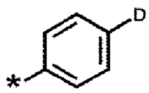 10-507
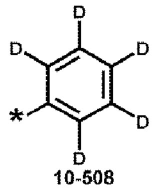 10-508

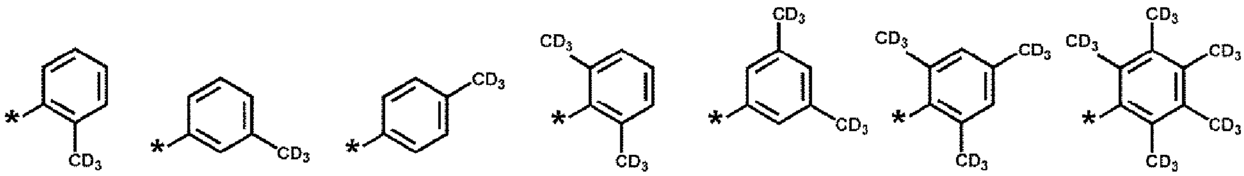

10-509 10-510 10-511 10-512 10-513 10-514 10-515

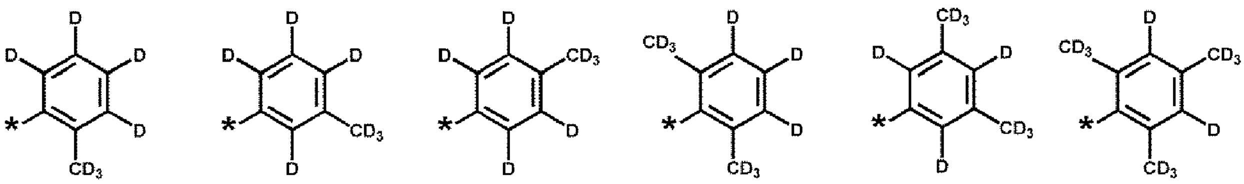

10-516 10-517 10-518 10-519 10-520 10-521

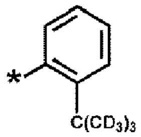
10-522
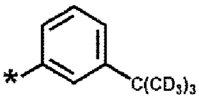
10-523
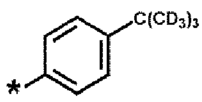
10-524
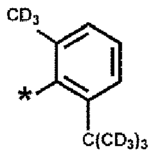
10-525
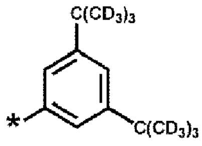
10-526
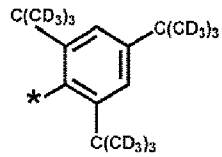
10-527

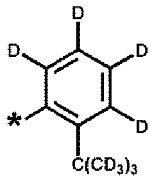
10-528
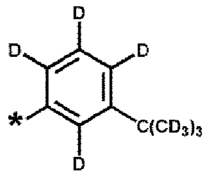
10-529
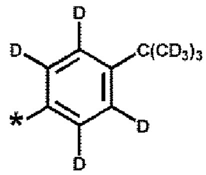
10-530
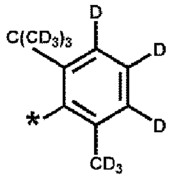
10-531
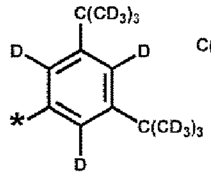
10-532
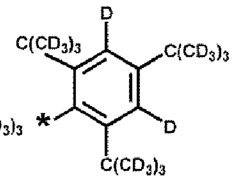
10-533

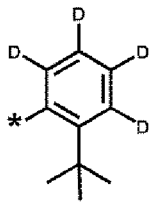
10-534
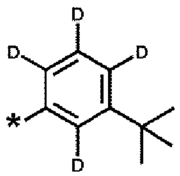
10-535
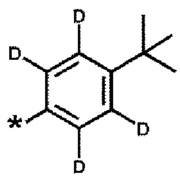
10-536
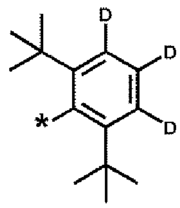
10-537
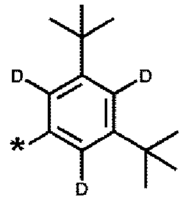
10-538
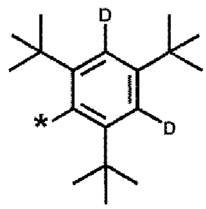
10-540

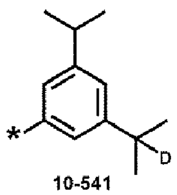
10-541
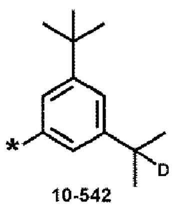
10-542
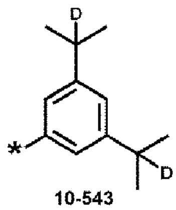
10-543
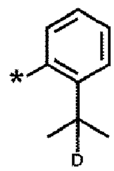
10-544
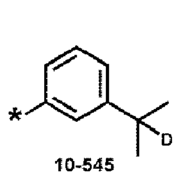
10-545
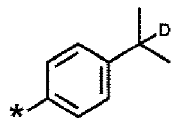
10-546

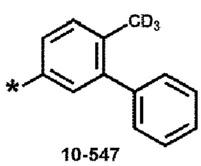
10-547
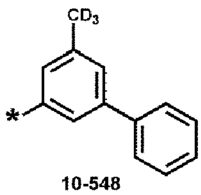
10-548
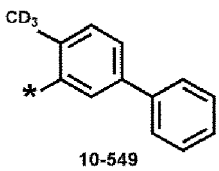
10-549
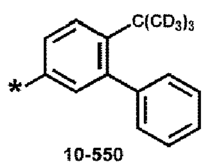
10-550
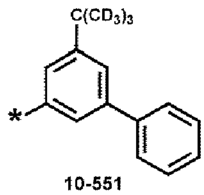
10-551

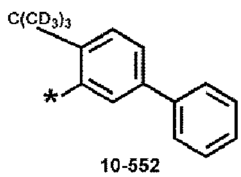
10-552

In an embodiment, in Formula 1A, $A_{52}$ may be a group represented by one of Formulae 9-1 to 9-36 in which all hydrogens are substituted with deuterium, but embodiments of the present disclosure are not limited thereto.

In Formula 1A, a1 to a4, a51, and a52 respectively indicate the number of groups $*\text{-}[(L_1)_{b1}\text{-}(R_1)_{c1}]$, $*\text{-}[(L_2)_{b2}\text{-}(R_2)_{c2}]$, $*\text{-}[(L_3)_{b3}\text{-}(R_3)_{c3}]$, $*\text{-}[(L_4)_{b4}\text{-}(R_4)_{c4}]$, $A_{51}$, and $A_{52}$, and may each independently be an integer from 0 to 10. When a1 is two or more, two or more groups $*\text{-}[(L_1)_{b1}\text{-}(R_1)c_1]$ may be identical to or different from each other, when a2 is two or more, two or more groups $*\text{-}[(L_2)_{b2}\text{-}(R_2)_{c2}]$ may be identical to or different from each other, when a3 is two or more, two or more groups $*\text{-}[(L_3)_{b3}\text{-}(R_3)_{c3}]$ may be identical to or different from each other, when a4 is two or more, two or more groups $*\text{-}[(L_4)_{b4}\text{-}(R_4)_{c4}]$ may be identical to or different from each other, when a51 is two or more, two or more groups $A_{51}$ may be identical to or different from each other, and when a52 is two or more, two or more groups $A_{52}$ may be identical to or different from each other, but embodiments of the present disclosure are not limited thereto.

For example, in Formula 1A, a1 to a4, a51, and a52 may each independently be 0, 1, 2, 3, 4, 5, or 6, but embodiments of the present disclosure are not limited thereto.

For example, in Formula 1A, a1 and a4 may each independently be 0, 1, 2, 3, or 4 and a2, a3, a51 and a52 may each independently be 0, 1, 2, or 3.

In Formula 1A, the sum of a51 and a52 may be 1 or more. That is, in Formula 1A, ring $CY_{51}$ is essentially substituted with at least one selected from a group represented by $A_{51}$ and a group represented by $A_{52}$.

For example, the sum of a51 and a52 may be 1, 2, or 3. In an embodiment, the sum of a51 and a52 may be 1 or 2.

In Formula 1A, a53 indicates the number of groups represented by

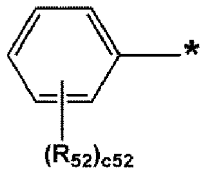

and may be an integer from 1 to 10. Since a53 in Formula 1A is not 0, ring $CY_{51}$ in Formula 1A is essentially substituted with a group represented by at least one

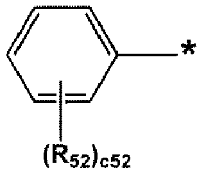

.

In an embodiment, in Formula 1A,

$L_1$ to $L_3$ may be a single bond, and
$R_1$ to $R_3$ may each independently be:

hydrogen, deuterium, -F, a cyano group, $C_1$-$C_{20}$ alkyl group, or a $C_1$-$C_{20}$ alkoxy group;
a $C_1$-$C_{20}$ alkyl group or a $C_1$-$C_{20}$ alkoxy group, each substituted with deuterium, -F, $-CD_3$, $-CD_2H$, $-CDH_2$, $-CF_3$, $-CF_2H$, $-CFH_2$, a cyano group, a $C_1$-$C_{10}$ alkyl group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, or any combination thereof; or
a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, or a terphenyl group, each unsubstituted or substituted with deuterium, -F, $-CD_3$, $-CD_2H$, $-CDH_2$, $-CF_3$, $-CF_2H$, $-CFH_2$, a cyano group, a $C_1$-$C_{20}$ alkyl group, a deuterium-containing $C_2$-$C_{20}$ alkyl group (for example, $*-C(CD_3)_3$), a $C_1$-$C_{20}$ alkoxy group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, or any combination thereof.

In an embodiment, in Formula 1A, a3, and a4 may not be 0, and a group represented by $*-(L_3)_{b3}-(R_3)_{c3}$, and

a group represented by *-$(L_4)_{b4}$-$(R_4)_{c4}$ may not be hydrogen.

In an embodiment, in Formula 1A, a1, a3, and a4 may not be 0, and a group represented by *-$(L_1)_{b1}$-$(R_1)_{c1}$, a group represented by *-$(L_3)_{b3}$-$(R_3)_{c3}$, and a group represented by *-$(L_4)_{b4}$-$(R_4)_{c4}$ may not be hydrogen.

In an embodiment, in Formula 1A, a1 may not be 0, a group represented by *-$(L_1)_{b1}$-$(R_1)_{c1}$ may not be hydrogen, and a group represented by *-$(L_1)_{b1}$-$(R_1)_{c1}$ in a number of a1 may include at least one deuterium.

In an embodiment, in Formula 1A, a1 may be 2, two groups represented by *-$(L_1)_{b1}$-$(R_1)_{c1}$ may not be hydrogen, and two groups represented by *-$(L_1)_{b1}$-$(R_1)_{c1}$ may be identical to each other.

In an embodiment, in Formula 1A, a1 may be 2, two groups represented by *-$(L_1)_{b1}$-$(R_1)_{c1}$ may not be hydrogen, and two groups represented by *-$(L_1)_{b1}$-$(R_1)_{c1}$ may be different from each other.

In an embodiment, in Formula 1A, a4 may not be 0, a group represented by *-$(L_4)_{b4}$-$(R_4)_{c4}$ may not be hydrogen, and a group represented by *-$(L_4)_{b4}$-$(R_4)_{c4}$ in a number of a4 may include at least one deuterium.

In an embodiment, in Formula 1A, a3 may not be 0, and at least one group represented by *-$(L_3)_{b3}$-$(R_3)_{c3}$ in a number of a3 may satisfy Condition A and Condition B:

Condition A
$L_3$ is a single bond.
Condition B
$R_3$ is

hydrogen, deuterium, -F, a cyano group, $C_1$-$C_{20}$ alkyl group, or a $C_1$-$C_{20}$ alkoxy group;
a $C_1$-$C_{20}$ alkyl group or a $C_1$-$C_{20}$ alkoxy group, each substituted with deuterium, -F, $-CD_3$, $-CD_2H$, $-CDH_2$, $-CF_3$, $-CF_2H$, $-CFH_2$, a cyano group, a $C_1$-$C_{10}$ alkyl group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, or any combination thereof; or
a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, or a terphenyl group, each unsubstituted or substituted with deuterium, -F, $-CD_3$, $-CD_2H$, $-CDH_2$, $-CF_3$, $-CF_2H$, $-CFH_2$, a cyano group, a $C_1$-$C_{20}$ alkyl group, a deuterium-containing $C_2$-$C_{20}$ alkyl group, a $C_1$-$C_{20}$ alkoxy group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, or any combination thereof.

In an embodiment, in Condition B, $R_3$ may not be hydrogen.

In an embodiment, in Formula 1A, a3 may not be 0, and at least one group represented by *-$(L_3)_{b3}$-$(R_3)_{c3}$ in a number of a3 may satisfy Condition A and Condition B(1):

Condition A
$L_3$ is a single bond.
Condition B(1)
$R_3$ is

a $C_4$-$C_{20}$ alkyl group unsubstituted or substituted with deuterium, -F,$-CD_3$, $-CD_2H$, $-CDH_2$, $-CF_3$, $-CF_2H$, $-CFH_2$, a cyano group, a $C_1$-$C_{10}$ alkyl group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl

group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, or any combination thereof; or

a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, or a terphenyl group, each unsubstituted or substituted with deuterium, -F, $-CD_3$, $-CD_2H$, $-CDH_2$, $-CF_3$, $-CF_2H$, $-CFH_2$, a cyano group, a $C_1$-$C_{20}$ alkyl group, a deuterium-containing $C_2$-$C_{20}$ alkyl group, a $C_1$-$C_{20}$ alkoxy group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, or any combination thereof.

In an embodiment, in Formula 1A, a4 may not be 0, and at least one group represented by $*-(L_4)_{b4}-(R_4)_{c4}$ in a number of a4 may satisfy Condition 1A, Condition 2A, or combination thereof:

Condition 1A

at least one $R_4$ in a number of c4 is a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group.

Condition 2A

$L_4$ is not a single bond.

In an embodiment, in Formula 1A, a4 may not be 0, and at least one group represented by $*-(L_4)_{b4}-(R_4)_{c4}$ in a number of a4 may satisfy Condition 1(1)A, Condition 2(1)A, or combination thereof:

Condition 1(1)A

at least one $R_4$ in a number of c4 is a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, or a terphenyl group, each unsubstituted or substituted with deuterium, -F, $-CD_3$, $-CD_2H$, $-CDH_2$,$-CF_3$, $-CF_2H$, $-CFH_2$, a cyano group, a $C_1$-$C_{20}$ alkyl group, a deuterium-containing $C_2$-$C_{20}$ alkyl group, a $C_1$-$C_{20}$ alkoxy group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, or any combination thereof.

Condition 2(1)A

$L_4$ is a benzene group unsubstituted or substituted with deuterium, -F, $-CD_3$, $-CD_2H$, $-CDH_2$, $-CF_3$, $-CF_2H$, $-CFH_2$, a cyano group, a $C_1$-$C_{20}$ alkyl group, a deuterium-containing $C_2$-$C_{20}$ alkyl group, a $C_1$-$C_{20}$ alkoxy group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl

group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, or any combination thereof.

In an embodiment, in Formula 1A, a4 may not be 0, and at least one group represented by *-$(L_4)_{b4}$-$(R_4)_{c4}$ in a number of a4 may satisfy Condition 3A, Condition 4A, Condition 5A, or combination thereof:

Condition 3A
at least one $R_4$ in a number of c4 is a substituted $C_6$-$C_{60}$ aryl group.
Condition 4A
$L_4$ is a $C_5$-$C_{30}$ carbocyclic group substituted with at least one $R_{10a}$ group,
Condition 5A
$L_4$ is a $C_5$-$C_{30}$ carbocyclic group that is unsubstituted or substituted with at least one $R_{10a}$ group and $R_4$ is not hydrogen.

In an embodiment, in Formula 1A, a4 may not be 0, and at least one group represented by *-$(L_4)_{b4}$-$(R_4)_{c4}$ in a number of a4 may satisfy Condition 3(1)A, Condition 4(1)A, Condition 5(1)A, or combination thereof:

Condition 3(1)A
at least one $R_4$ in a number of c4 is a phenyl group, a ($C_1$-$C_{20}$ alkyl)phenyl group, a biphenyl group, or a terphenyl group, each substituted with deuterium, -F, $-CD_3$, $-CD_2H$, $-CDH_2$, $-CF_3$, $-CF_2H$, $-CFH_2$, a cyano group, a $C_1$-$C_{20}$ alkyl group, a deuterium-containing $C_2$-$C_{20}$ alkyl group, a $C_1$-$C_{20}$ alkoxy group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, or any combination thereof.
Condition 4(1)A
$L_4$ is a benzene group substituted with deuterium, -F, $-CD_3$, $-CD_2H$,$-CDH_2$, $-CF_3$, $-CF_2H$, $-CFH_2$, a cyano group, a $C_1$-$C_{20}$ alkyl group, a deuterium-containing $C_2$-$C_{20}$ alkyl group, a $C_1$-$C_{20}$ alkoxy group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, or any combination thereof.
Condition 5(1)A

$L_4$ is a benzene group unsubstituted or substituted with deuterium, -F, $-CD_3$, $-CD_2H$, $-CDH_2$, $-CF_3$, $-CF_2H$, $-CFH_2$, a cyano group, a $C_1$-$C_{20}$ alkyl group, a deuterium-containing $C_2$-$C_{20}$ alkyl group, a $C_1$-$C_{20}$ alkoxy group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, or any combination thereof, and
$R_4$ is
deuterium, -F, a cyano group, $C_1$-$C_{20}$ alkyl group, or a $C_1$-$C_{20}$ alkoxy group;
a $C_1$-$C_{20}$ alkyl group or a $C_1$-$C_{20}$ alkoxy group, each substituted with deuterium, -F, $-CD_3$, $-CD_2H$, $-CDH_2$, $-CF_3$, $-CF_2H$, $-CFH_2$, a cyano group, a $C_1$-$C_{10}$ alkyl group, a cyclopentyl group, a cyclohexyl group, a cycloheptyl group, a cyclooctyl group, an adamantyl group, a norbornenyl group, a cyclopentenyl group, a cyclohexenyl

group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-C20 alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, or any combination thereof; or

a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, or a terphenyl group, each unsubstituted or substituted with deuterium, -F, $-CD_3$, $-CD_2H$, $-CDH_2$, $-CF_3$, $-CF_2H$, $-CFH_2$, a cyano group, a $C_1$-$C_{20}$ alkyl group, a deuterium-containing $C_2$-$C_{20}$ alkyl group, a $C_1$-$C_{20}$ alkoxy group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, or any combination thereof.

In an embodiment, in Formula 1A, a51 and a52 may each independently be 0, 1 or 2, the sum of a51 and a52 may be 1 or 2, and a53 may be 1 or 2.

* and *' each indicate a binding site to a neighboring atom.

For example, a group represented by

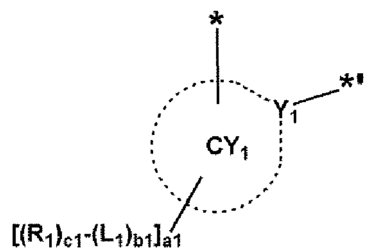

in Formula 1A may be a group represented by one of Formulae A1(1) to A1(30):

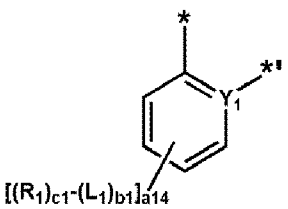
A1(1)

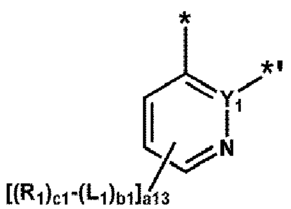
A1(2)

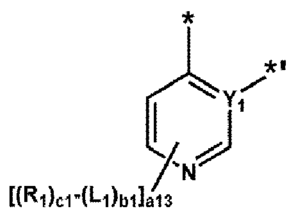
A1(3)

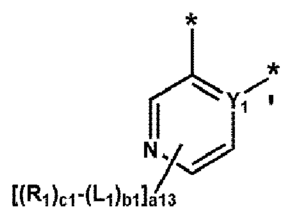
A1(4)

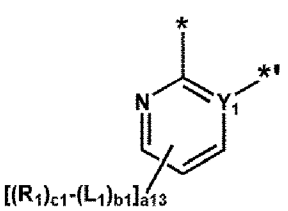
A1(5)

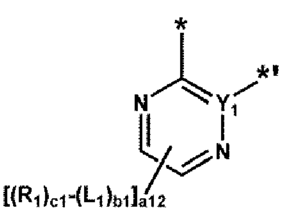
A1(6)

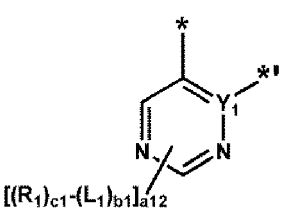
A1(7)

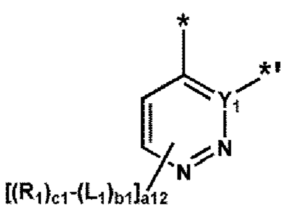
A1(8)

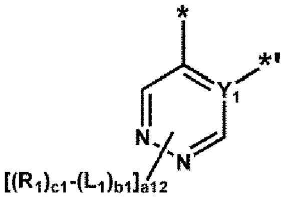
A1(9)

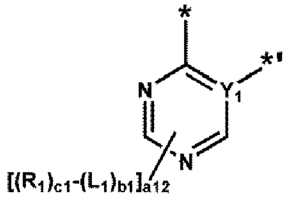
A1(10)

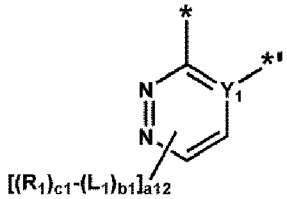
A1(11)

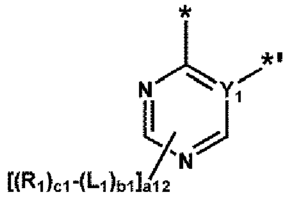
A1(12)

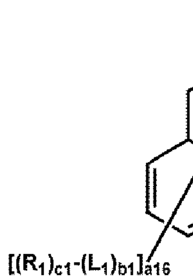
A1(13)

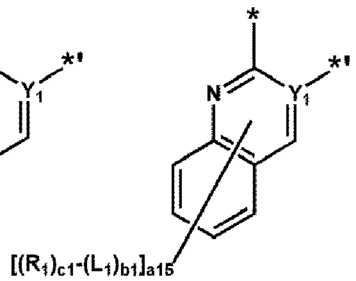
A1(14)

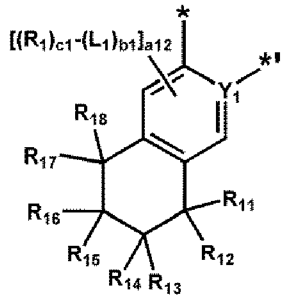
A1(15)

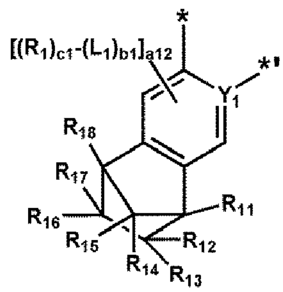
A1(16)

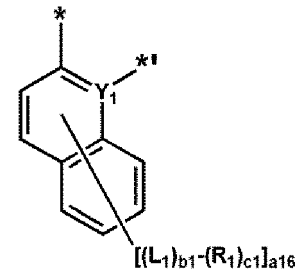
A1(17)

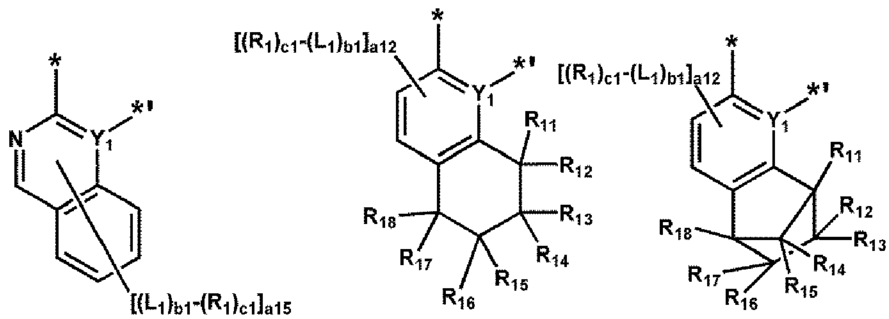
A1(18)

A1(19)

A1(20)

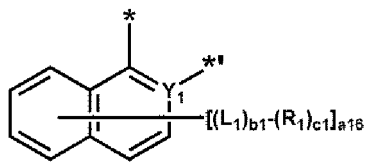
A1(21)

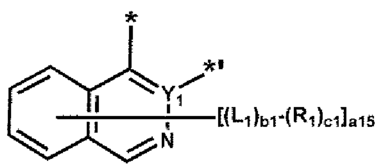
A1(22)

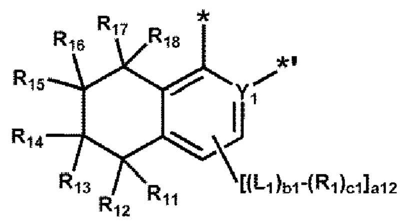
A1(23)

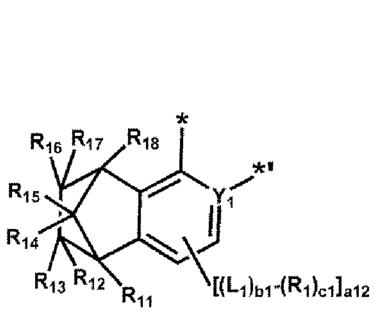
A1(24)

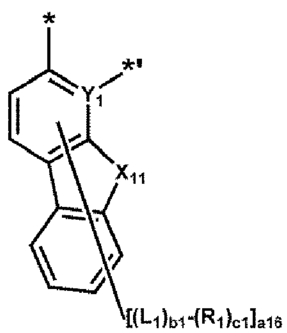
A1(25)

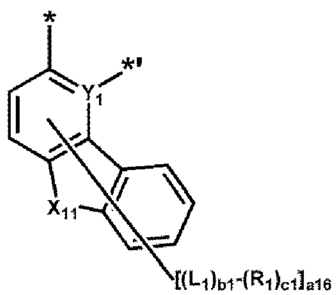
A1(26)

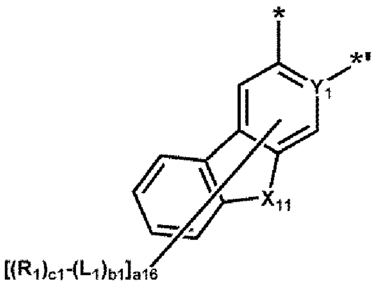

A1(27)

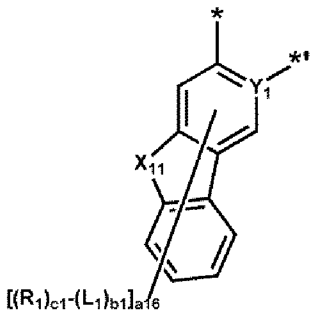

A1(28)

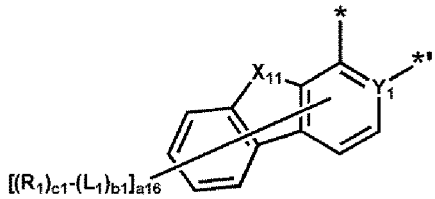

A1(29)

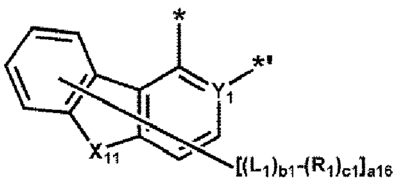

A1(30)

In Formulae A1(1) to A1(30),

$Y_1$, $L_1$, b1, $R_1$, and c1 may each independently be the same as described in Formula 1A,
$X_{11}$ may be O, S, $N(R_{11})$, $C(R_{11})(R_{12})$, or $Si(R_{11})(R_{12})$,
$R_{11}$ to $R_{18}$ may each independently be the same as described in connection with $R_1$ of Formula 1A
a12 may be an integer from 0 to 2,
a13 may be an integer from 0 to 3,
a14 may be an integer from 0 to 4,
a15 may be an integer from 0 to 5,
a16 may be an integer from 0 to 6,
*' indicates a binding site to $X_1$ in Formula 1A, and
* indicates a binding site to $Y_3$ in Formula 1A.

The group represented by

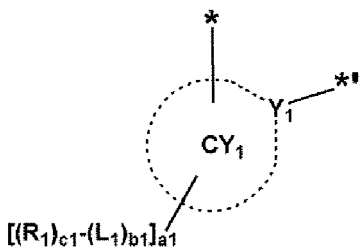

in Formula 1A may include deuterium, a deuterium-containing $C_1$-$C_{60}$ alkyl group unsubstituted or substituted with at least one $C_3$-$C_{10}$ cycloalkyl group, or any combination thereof. The number of deuterium atoms in the group represented by

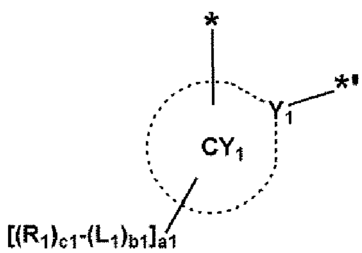

in Formula 1A may be from 1 to 20, for example, from 1 to 15, from 1 to 10, or from 1 to 5.

In an embodiment, a group represented by

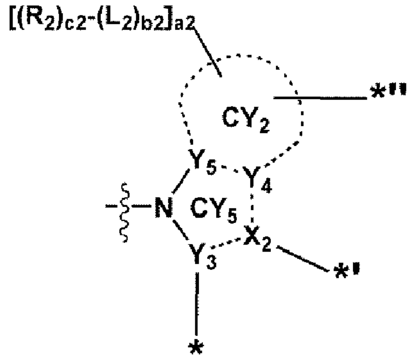

in Formula 1A may be a group represented by one of Formulae A2(1) to A2(4):

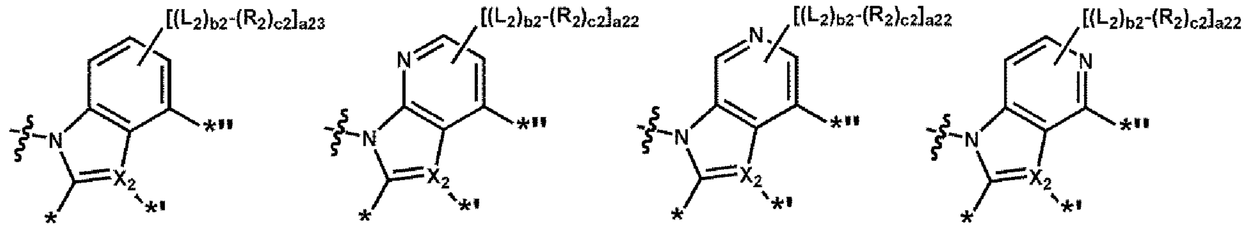

A2(1) A2(2) A2(3) A2(4)

.

In Formulae A2(1) to A2(4),

$X_2$, $L_2$, b2, $R_2$, and c2 may each independently be the same as described in Formula 1A,
a22 may be an integer from 0 to 2,
a23 may be an integer from 0 to 3,

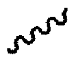 indicates a binding site to $L_{51}$ in Formula 1A,
*" indicates a binding site to ring $CY_3$ in Formula 1A,
*' indicates a binding site to M in Formula 1A, and
* indicates a binding site to ring $CY_1$ in Formula 1A.

The group represented by

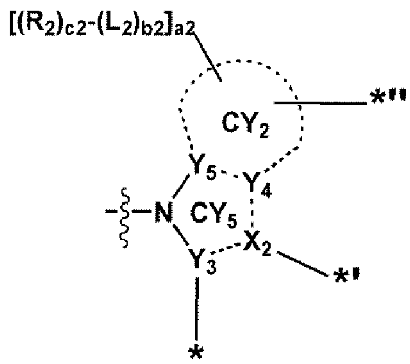

in Formula 1A may include deuterium, a deuterium-containing $C_1$-$C_{60}$ alkyl group unsubstituted or substituted with at least one $C_3$-$C_{10}$ cycloalkyl group, or any combination thereof. The number of deuterium atoms in the group represented by

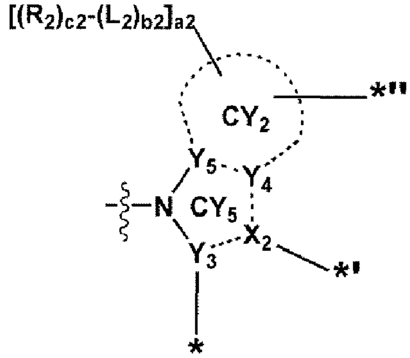

in Formula 1A may be from 1 to 20, for example, from 1 to 15, from 1 to 10, or from 1 to 5.

In an embodiment, a group represented by

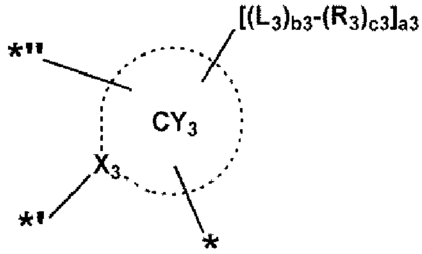

in Formula 1A may be a group represented by one of Formulae A3(1) to A3(17):

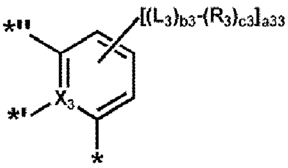

A3(1)

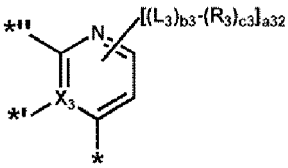

A3(2)

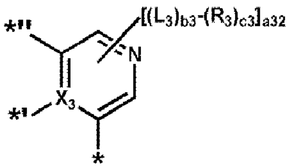

A3(3)

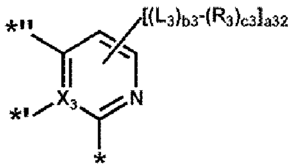

A3(4)

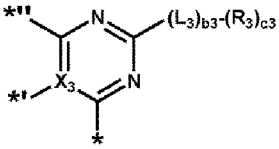

A3(5)

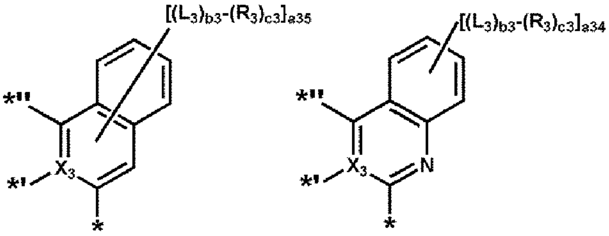

A3(6)

A3(7)

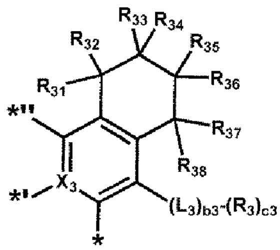

A3(8)

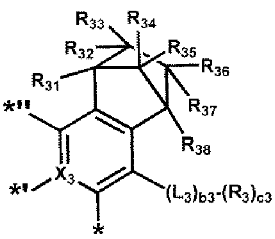

A3(9)

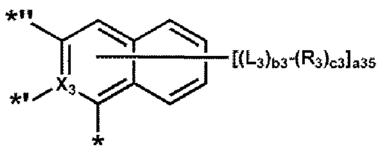

A3(10)

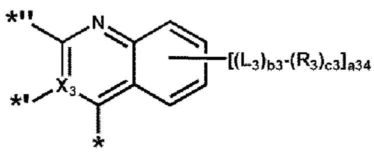

A3(11)

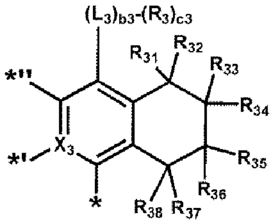
A3(12)

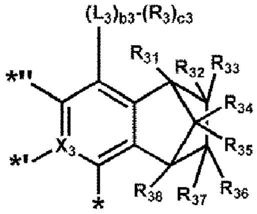
A3(13)

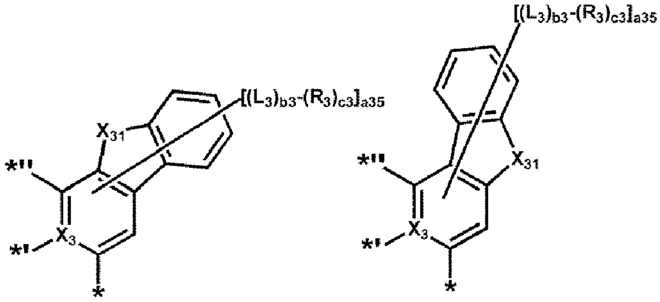
A3(14) A3(15)

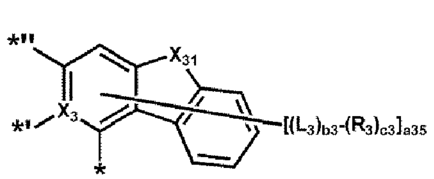
A3(16)

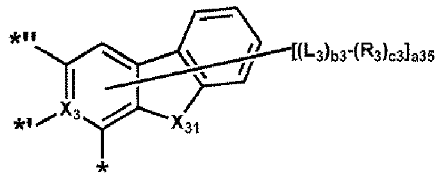
A3(17)

In Formulae A3(1) to A3(17),

$X_3$, $L_3$, b3, $R_3$, and c3 may each independently be the same as described in Formula 1A,
$X_{31}$ may be O, S, $N(R_{31})$, $C(R_{31})(R_{32})$, or $Si(R_{31})(R_{32})$,
$R_{31}$ to $R_{38}$ may each independently be the same as described in connection with $R_3$ of Formula 1A
a32 may be an integer from 0 to 2,
a33 may be an integer from 0 to 3,
a34 may be an integer from 0 to 4,
a35 may be an integer from 0 to 5,
*" indicates a binding site to ring $CY_2$ in Formula 1A,
*' indicates a binding site to M in Formula 1A, and
* indicates a binding site to $T_1$ in Formula 1A.

The group represented by

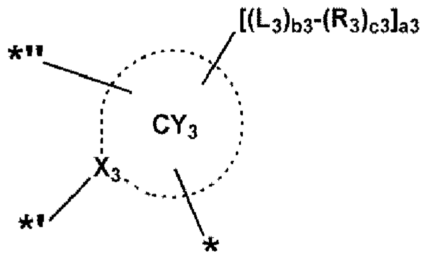

in Formula 1A may include deuterium, a deuterium-containing $C_1$-$C_{60}$ alkyl group unsubstituted or substituted with at least one $C_3$-$C_{10}$ cycloalkyl group, or any combination thereof. The number of deuterium atoms in the group represented by

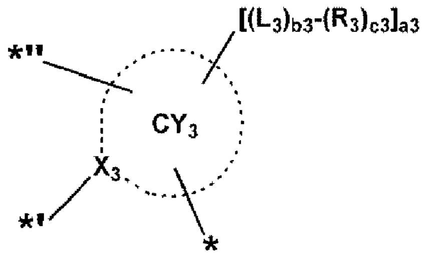

in Formula 1A may be from 1 to 20, for example, from 1 to 15, from 1 to 10, or from 1 to 5.

In an embodiment, a group represented by

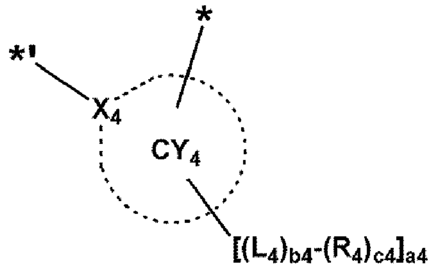

in Formula 1A may be a group represented by one of Formulae A4(1) to A4(45):

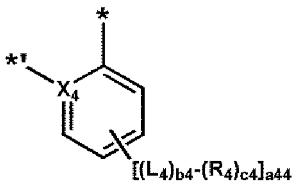

A4(1)

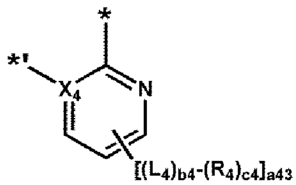

A4(2)

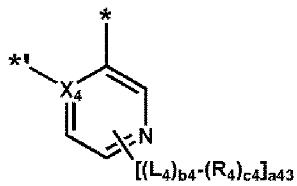

A4(3)

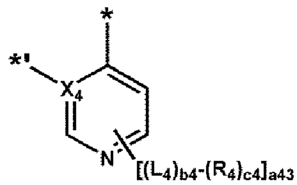

A4(4)

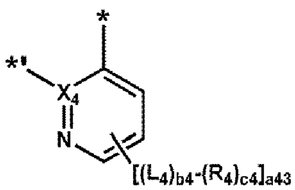

A4(5)

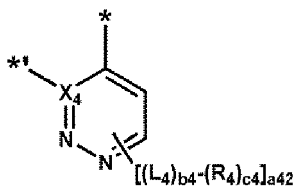

A4(6)

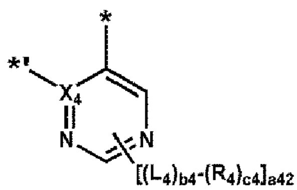

A4(7)

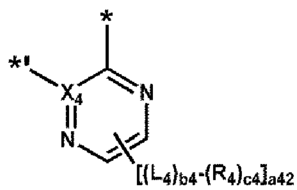

A4(8)

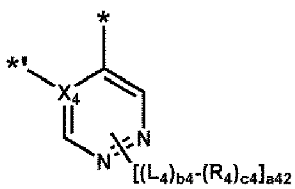

A4(9)

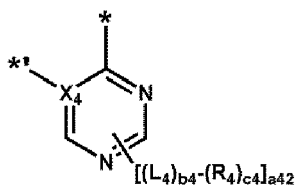

A4(10)

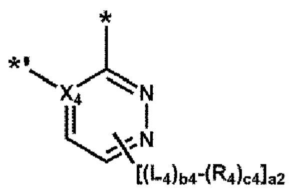

A4(11)

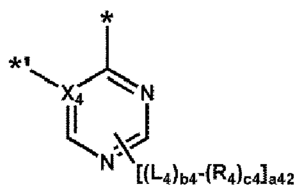

A4(12)

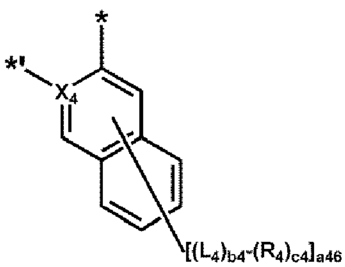

A4(13)

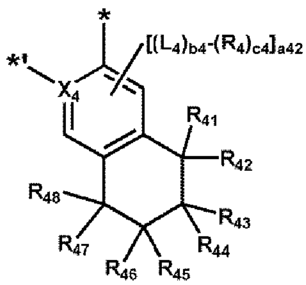

A4(14)

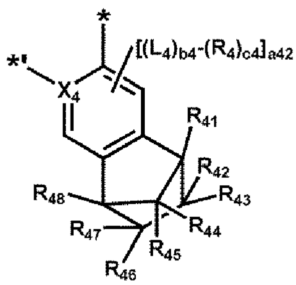

A4(15)

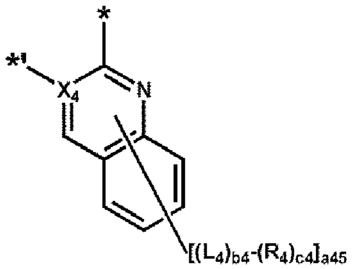

A4(16)

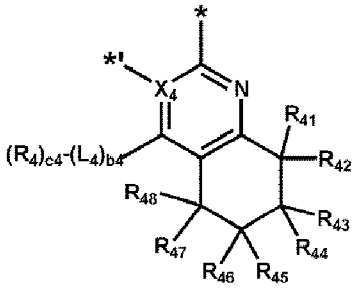

A4(17)

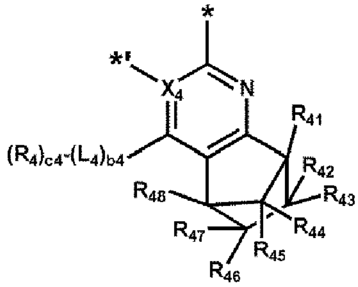

A4(18)

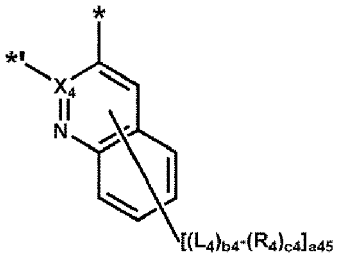

A4(19)

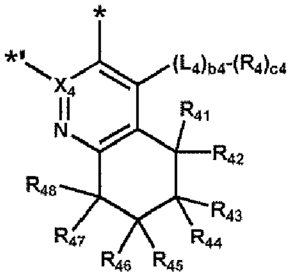

A4(20)

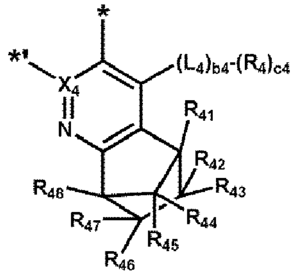

A4(21)

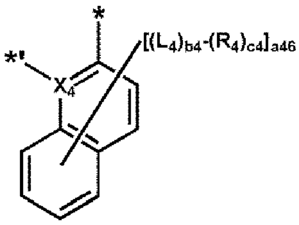

A4(22)

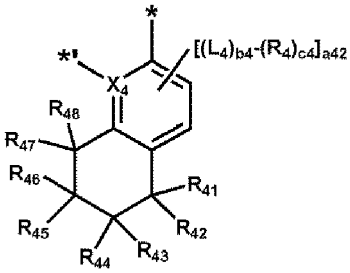

A4(23)

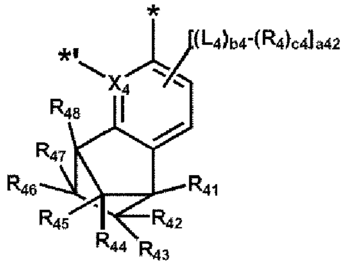

A4(24)

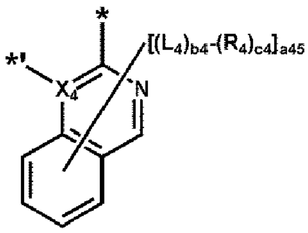

A4(25)

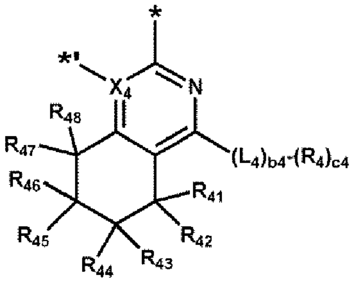

A4(26)

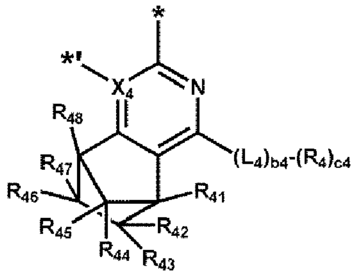

A4(27)

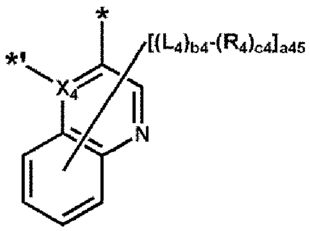

A4(28)

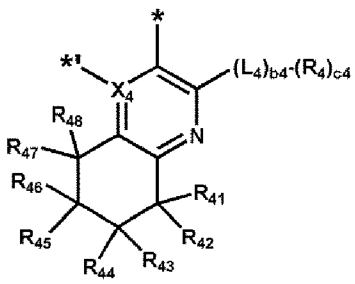

A4(29)

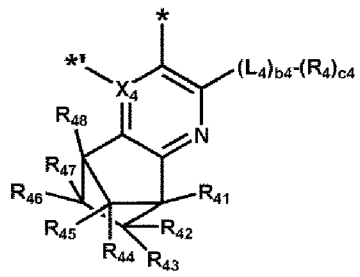

A4(30)

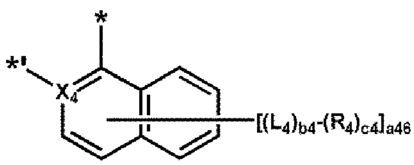

A4(31)

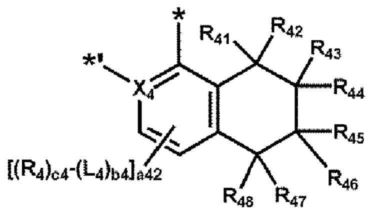

A4(32)

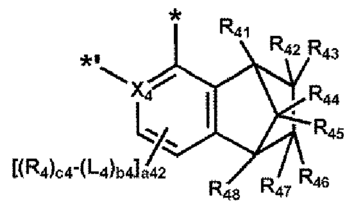

A4(33)

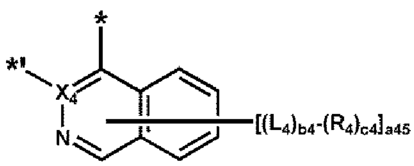

A4(34)

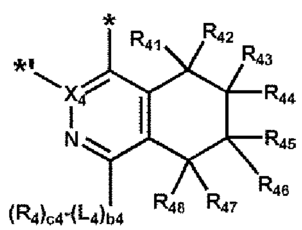

A4(35)

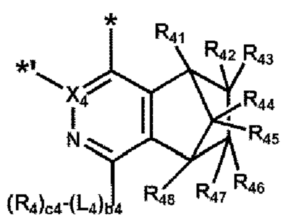

A4(36)

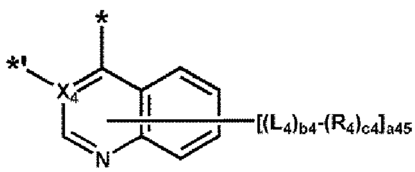

A4(37)

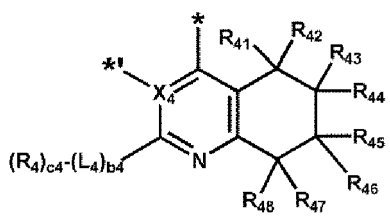

A4(38)

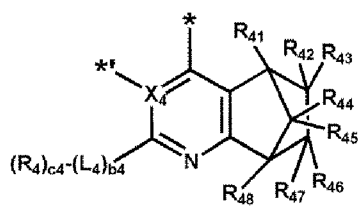

A4(39)

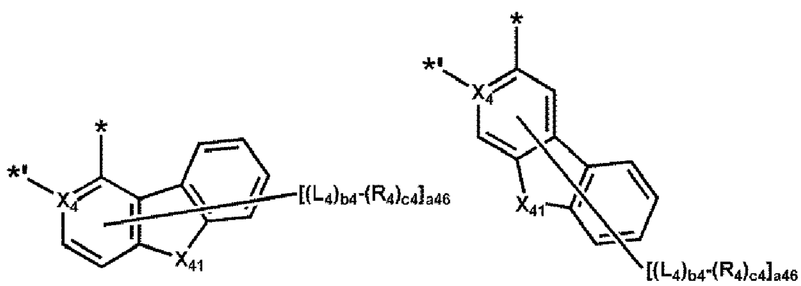

A4(40) A4(41)

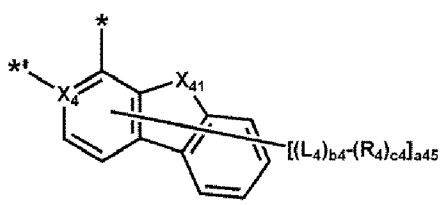

A4(42)

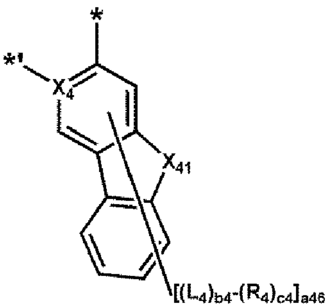

A4(43)

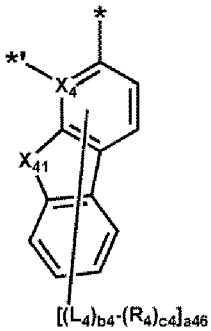

A4(44)

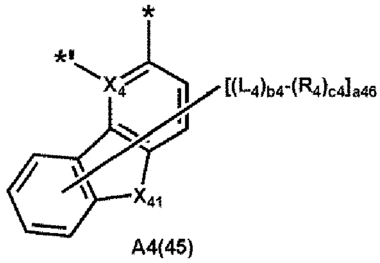

A4(45)

.

In Formulae A4(1) to A4(45),

$X_4$, $L_4$, b4, $R_4$, and c4 may each independently be the same as described in Formula 1A,
$X_{41}$ may be O, S, $N(R_{41})$, $C(R_{41})(R_{42})$, or $Si(R_{41})(R_{42})$,
$R_{41}$ to $R_{48}$ may each independently be the same as described in connection with $R_4$ of Formula 1A,
a42 may be an integer from 0 to 2,
a43 may be an integer from 0 to 3,
a44 may be an integer from 0 to 4,
a45 may be an integer from 0 to 5,
a46 may be an integer from 0 to 6,
*' indicates a binding site to M in Formula 1A, and
* indicates a binding site to $T_1$ in Formula 1A.

The group represented by

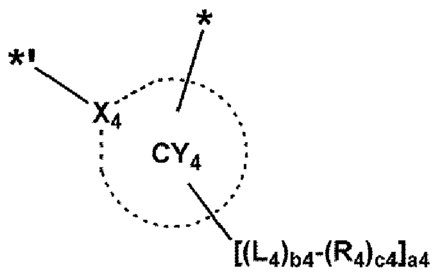

in Formula 1A may include deuterium, a deuterium-containing $C_1$-$C_{60}$ alkyl group unsubstituted or substituted with at least one $C_3$-$C_{10}$ cycloalkyl group, or any combination thereof. The number of deuterium atoms in the group represented by

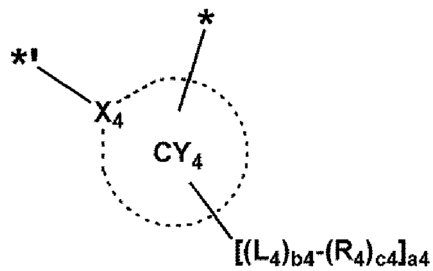

in Formula 1A may be from 1 to 20, for example, from 1 to 15, from 1 to 10, or from 1 to 5.

In an embodiment, in Formula 1A, a group represented by

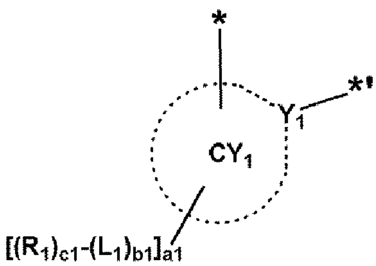

may be a group represented by one of Formulae CY1(1) to CY1(8), and/or

a group represented by

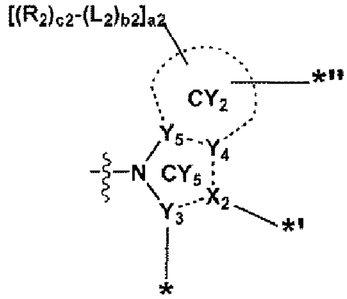

may be a group represented by one of Formulae CY2(1) to CY2(4), and/or

a group represented by

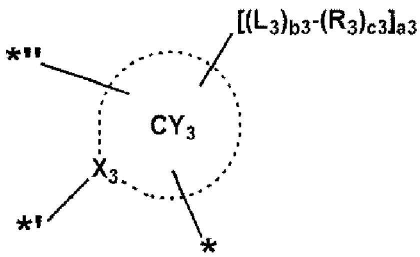

may be a group represented by one of Formulae CY3(1) to CY3(24), and/or

a group represented by

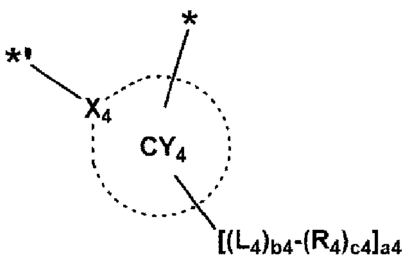

may be a group represented by one of Formulae CY4(1) to CY4(74), but embodiments of the present disclosure are not limited thereto:

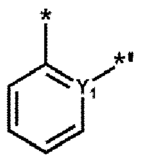
CY1(1)

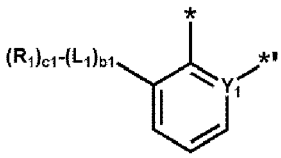
CY1(2)

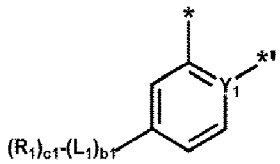
CY1(3)

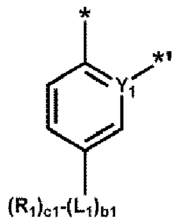
CY1(4)

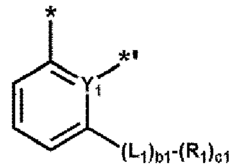
CY1(5)

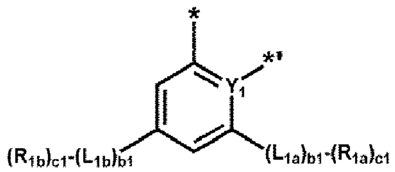
CY1(6)

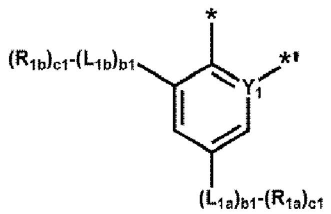
CY1(7)

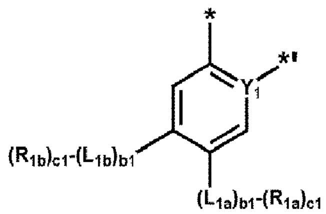
CY1(8)

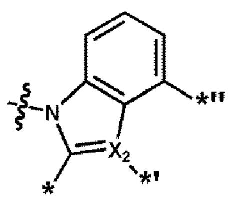
CY2(1)

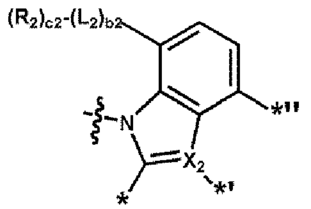
CY2(2)

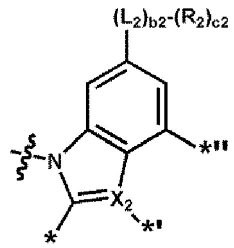
CY2(3)

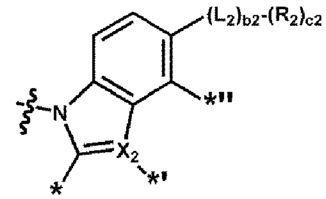
CY2(4)

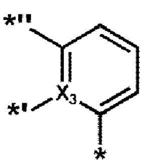
CY3(1)

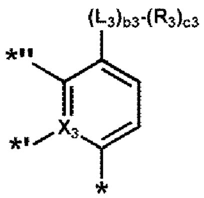
CY3(2)

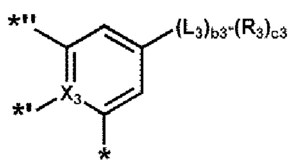
CY3(3)

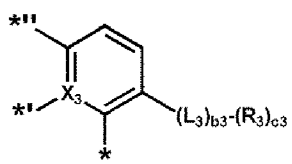
CY3(4)

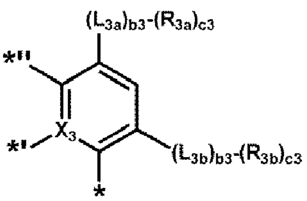
CY3(5)

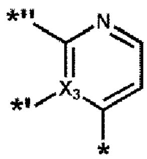
CY3(6)

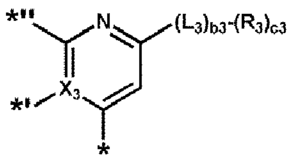
CY3(7)

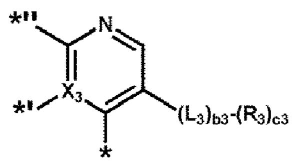
CY3(8)

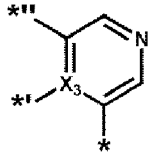
CY3(9)

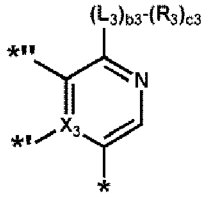
CY3(10)

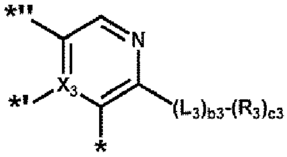
CY3(11)

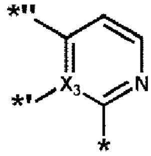
CY3(12)

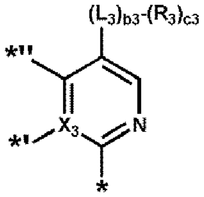
CY3(13)

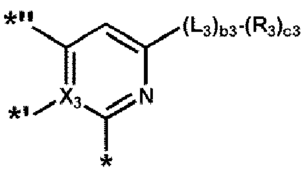

CY3(14)

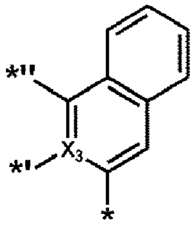

CY3(15)

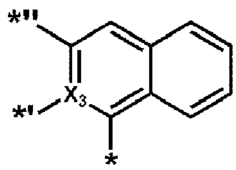

CY3(16)

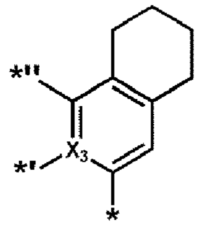

CY3(17)

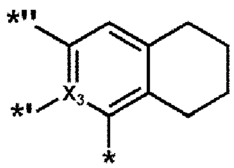

CY3(18)

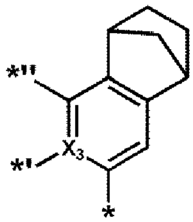

CY3(19)

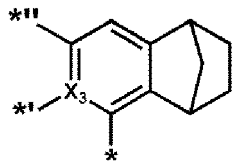

CY3(20)

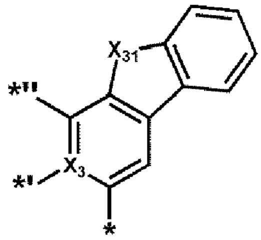

CY3(21)

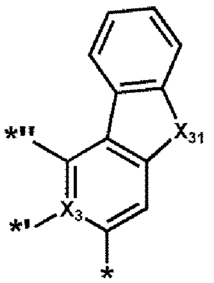

CY3(22)

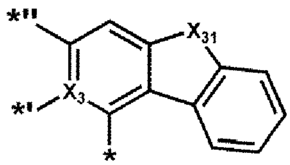

CY3(23)

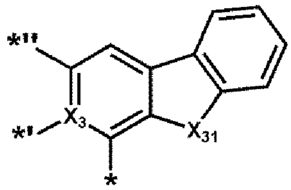

CY3(24)

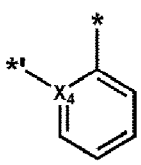

CY4(1)

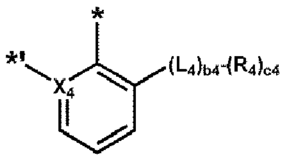

CY4(2)

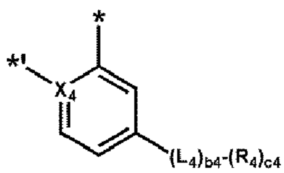

CY4(3)

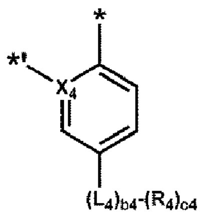

CY4(4)

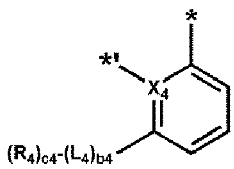

CY4(5)

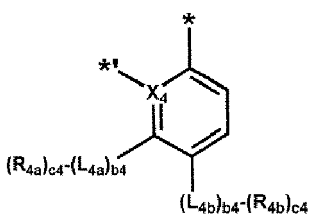

CY4(6)

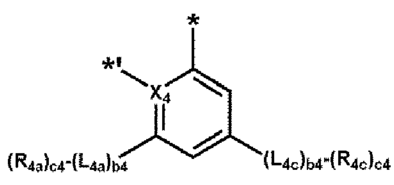

CY4(7)

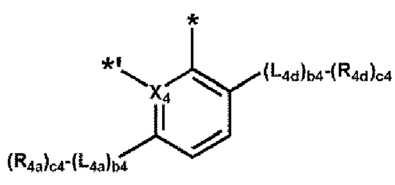

CY4(8)

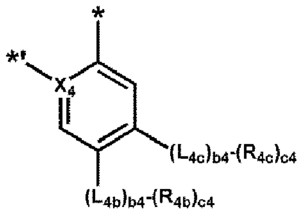
CY4(9)

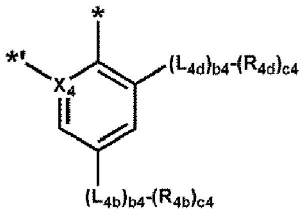
CY4(10)

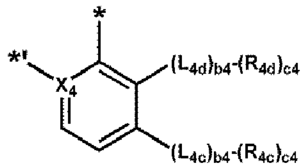
CY4(11)

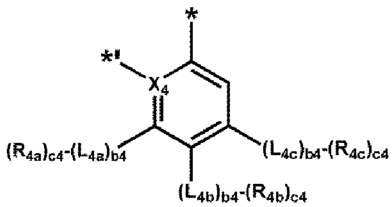
CY4(12)

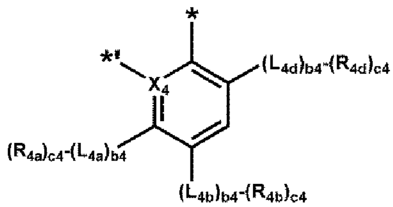
CY4(13)

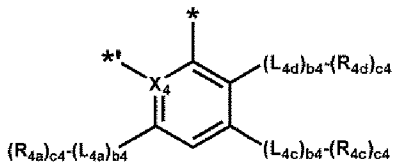
CY4(14)

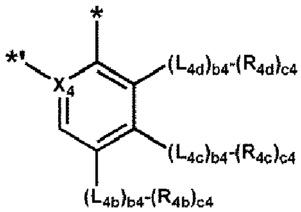
CY4(15)

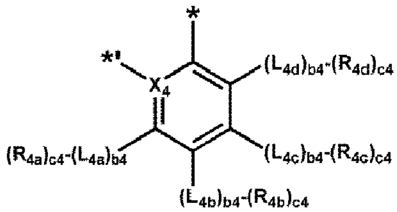
CY4(16)

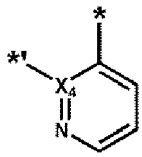
CY4(17)

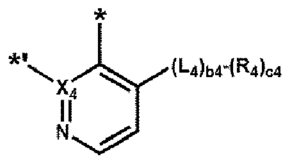
CY4(18)

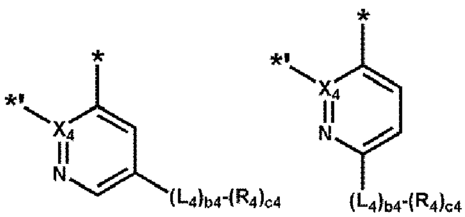
CY4(19)

CY4(20)

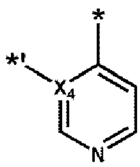
CY4(21)

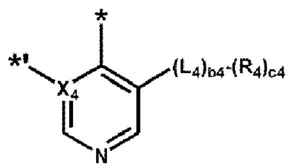
CY4(22)

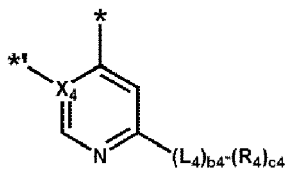
CY4(23)

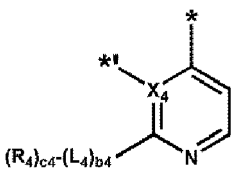
CY4(24)

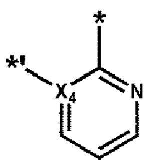
CY4(25)

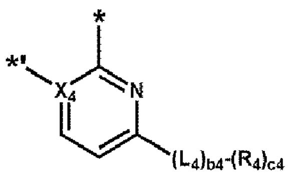
CY4(26)

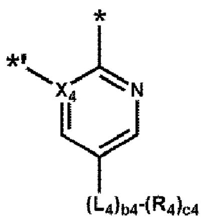
CY4(27)

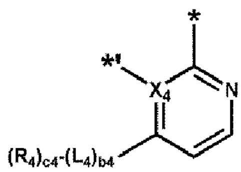
CY4(28)

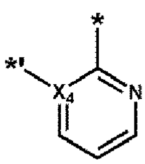
CY4(29)

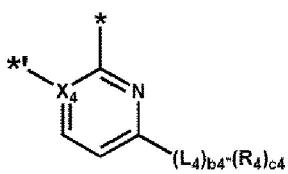
CY4(30)

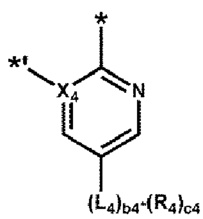
CY4(31)

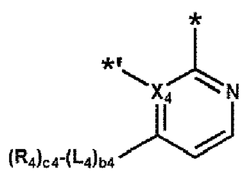
CY4(32)

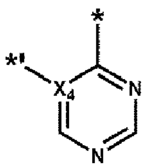
CY4(33)

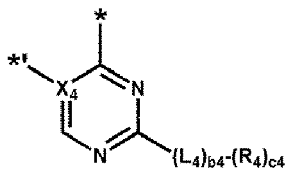
CY4(34)

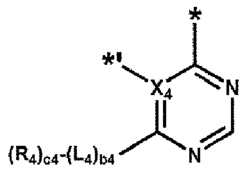
CY4(35)

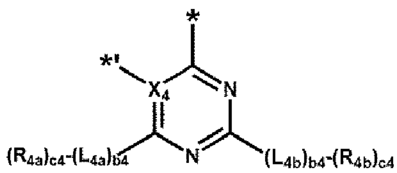
CY4(36)

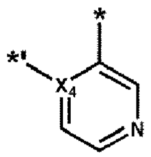
CY4(37)

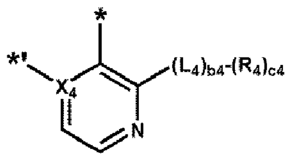
CY4(38)

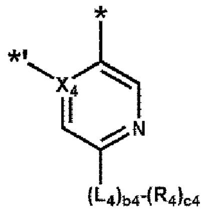
CY4(39)

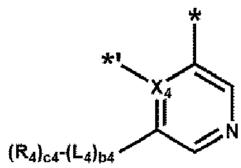
CY4(40)

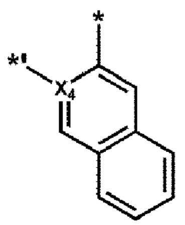
CY4(41)

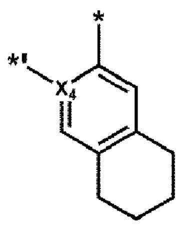
CY4(42)

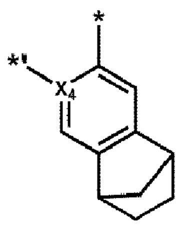
CY4(43)

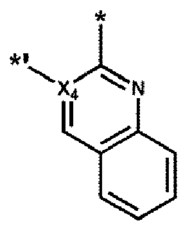
CY4(44)

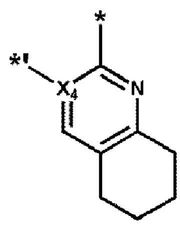
CY4(45)

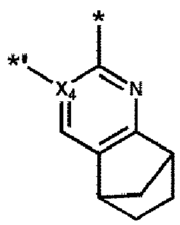
CY4(46)

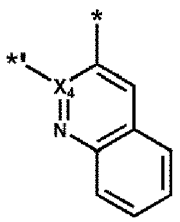
CY4(47)

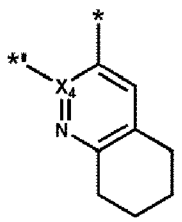
CY4(48)

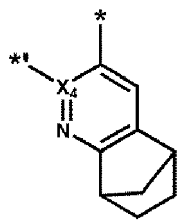
CY4(49)

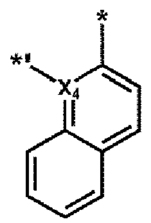
CY4(50)

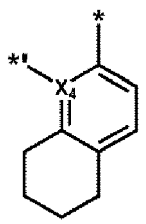
CY4(51)

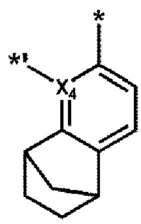
CY4(52)

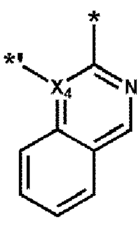
CY4(53)

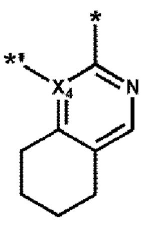
CY4(54)

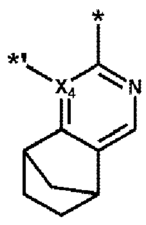
CY4(55)

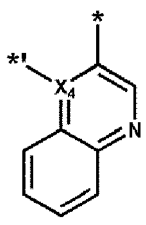
CY4(56)

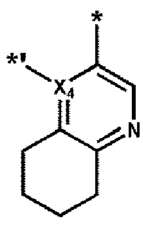
CY4(57)

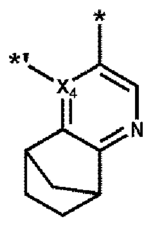
CY4(58)

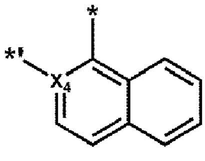
CY4(59)

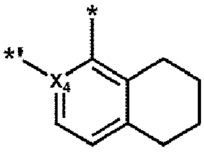
CY4(60)

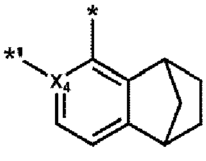
CY4(61)

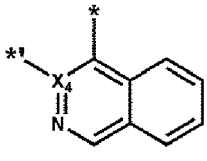
CY4(62)

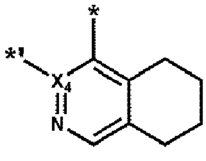
CY4(63)

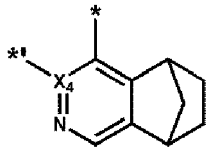
CY4(64)

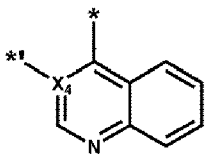 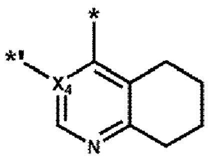 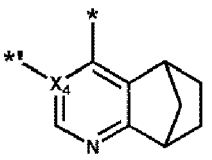 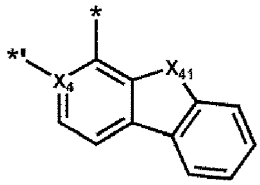 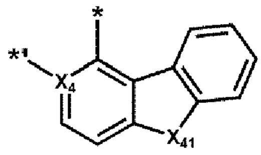

CY4(65) CY4(66) CY4(67) CY4(68) CY4(69)

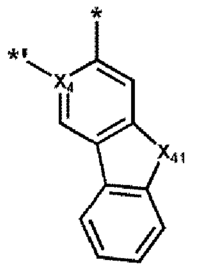 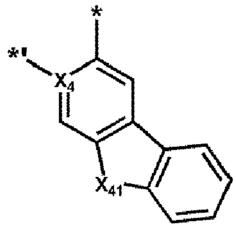 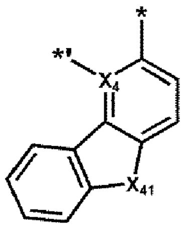 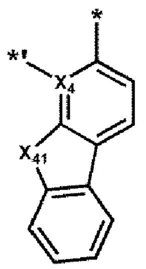 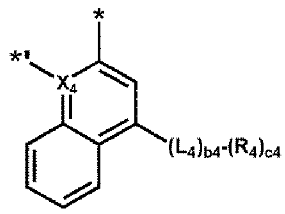

CY4(70) CY4(71) CY4(72) CY4(73) CY4(74)

In Formulae CY1(1) to CY1(8), CY2(1) to CY2(4), CY3(1) to CY3(24), and CY4(1) to CY4(74),

$X_2$ to $X_4$, $Y_1$, $L_1$ to $L_4$, b1 to b4, $R_1$ to $R_4$, and c1 to c4 may each independently be the same as described in Formula 1A,
$X_{31}$ may be O, S, $N(R_{31})$, $C(R_{31})(R_{32})$, or $Si(R_{31})(R_{32})$,
$X_{41}$ may be O, S, $N(R_{41})$, $C(R_{41})(R_{42})$, or $Si(R_{41})(R_{42})$,
$L_{1a}$ and $L_{1b}$ may each independently be the same as described in connection with $L_1$ of Formula 1A,
$R_{1a}$ and $R_{1b}$ may each independently be the same as described in connection with $R_1$ of Formula 1A,
$L_{3a}$ and $L_{3b}$ may each independently be the same as described in connection with $L_3$ of Formula 1A,
$R_{3a}$, $R_{3b}$, $R_{31}$, and $R_{32}$ may each independently be the same as described in connection with $R_3$ of Formula 1A,
$L_{4a}$ to $L_{4d}$ may each independently be the same as described in connection with $L_4$ of Formula 1A,
$R_{4a}$ to $R_{4d}$, $R_{41}$, and $R_{42}$ may each independently be the same as described in connection with $R_4$ of Formula 1A,
$*-(L_1)_{b1}-(R_1)_{c1}$, $*-(L_{1a})_{b1}-(R_{1a})_{c1}$, $*-(L_{1b})_{b1}-(R_{1b})_{c1}$, $*-(L_2)_{b2}-(R_2)_{c2}$, $*-(L_3)_{b3}-(R_3)_{c3}$, $*-(L_{3a})_{b3}-(R_{3a})_{c3}$, $*-(L_{3b})_{b3}-(R_{3b})_{c3}$, $*-(L_4)_{b4}-(R_4)_{c4}$, $*-(L_{4a})_{b4}-(R_{4a})_{c4}$, *-(L4b)b4-(R4b)c4, $*-(L_{4c})_{b4}-(R_{4c})_{c4}$, and $*-(L_{4d})_{b4}-(R_{4d})_{c4}$ may not be hydrogen, and * indicates a binding site to a neighboring atom,
in Formulae CY1(1) to CY1(8), *' indicates a binding site to $X_1$ in Formula 1A,
in Formulae CY2(1) to CY2(4), CY3(1) to CY3(24), and CY4(1) to CY4(74), *' indicates a binding site to M in Formula 1A,
in Formulae CY1(1) to CY1(8), * indicates a binding site to $Y_3$ in Formula 1A,
in Formulae CY2(1) to CY2(4), * indicates a binding site to ring $CY_1$ in Formula 1A, and *" indicates a binding site to ring $CY_3$ in Formula 1A,
in Formulae CY3(1) to CY3(24), *" indicates a binding site to ring $CY_2$ in Formula 1A, and * indicates a binding site to $T_1$ in Formula 1A, and
in Formulae CY4(1) to CY4(74), * indicates a binding site to $T_1$ in Formula 1A.

In an embodiment, a group represented by

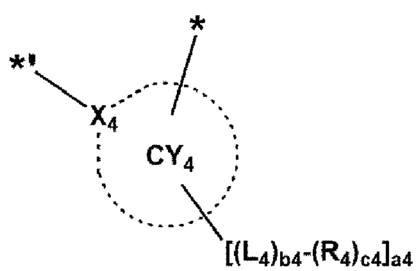

may be a group represented by Formula CY4-1 or CY4-2:

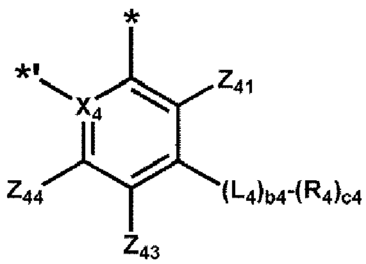

CY4-1

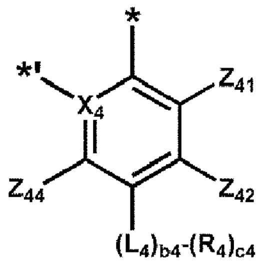

CY4-2 ,

in Formulae CY4-1 and CY4-2,

$X_4$, $L_4$, b4, $R_4$, and c4 may each independently be the same as described in Formula 1A,
$Z_{41}$ to $Z_{44}$ may each independently be the same as described in connection with $R_4$ of Formula 1A,
*' indicates a binding site to M in Formula 1A, and
* indicates a binding site to $T_1$ in Formula 1A.

For example, Formulae CY4-1 and CY4-2 may satisfy:

1) Condition 1A, Condition 2A, or any combination thereof (or, Condition 1(1)A, Condition 2(1)A, or any combination thereof), and/or
2) Condition 3A, Condition 4A, Condition 5A, or any combination thereof (or, Condition 3(1)A, Condition 4(1)A, Condition 5(1)A, or any combination thereof).

In an embodiment, in Formula 1A, a group represented by

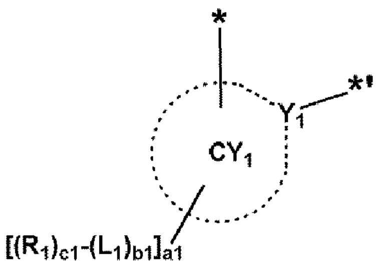

may be a group represented by Formula CY1(1) or CY1(6), and/or

a group represented by

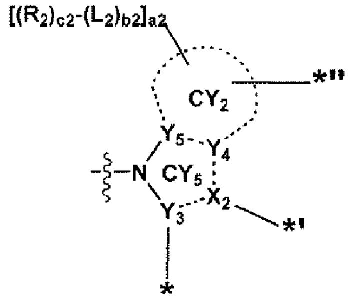

may be a group represented by Formula CY2(1), and/or

a group represented by

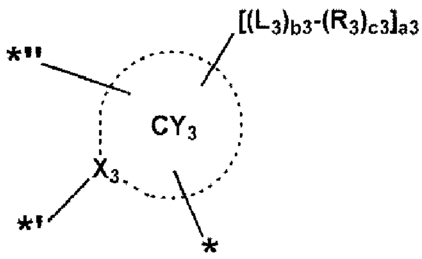

may be a group represented by Formula CY3(3), and/or

a group represented by

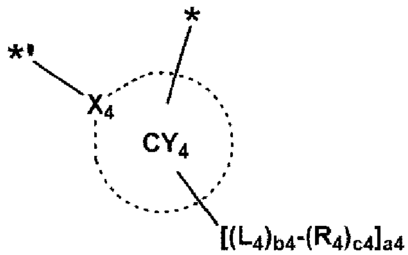

may be a group represented by Formula CY4(3), CY4(4) or CY4(16).

In an embodiment, a group represented by

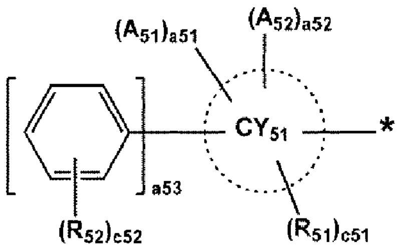

in Formula 1A may be a group represented by one of Formulae 51-1 to 51-32:

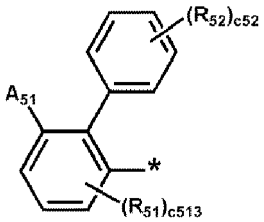

51-1

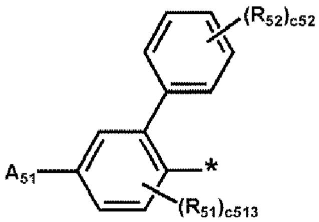

51-2

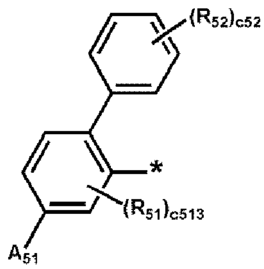

51-3

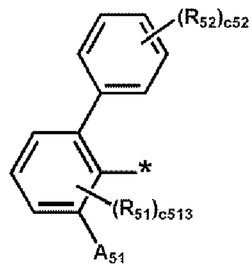

51-4

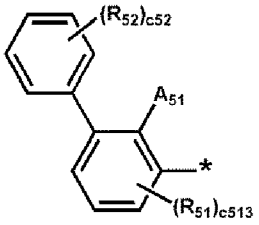
51-5

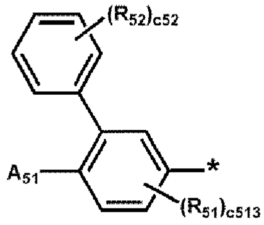
51-6

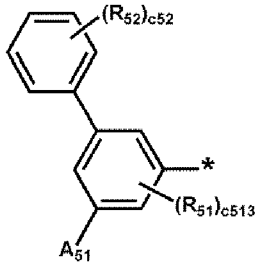
51-7

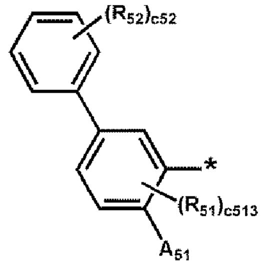
51-8

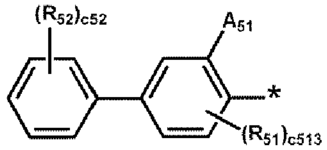
51-9

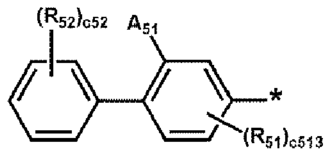
51-10

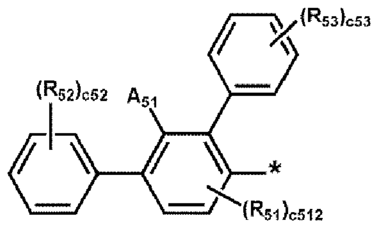
51-11

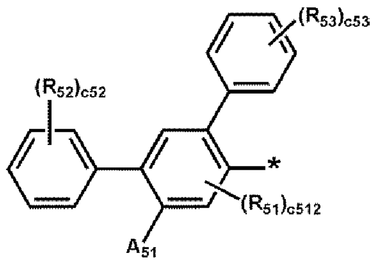
51-12

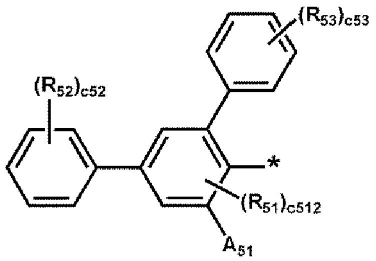
51-13

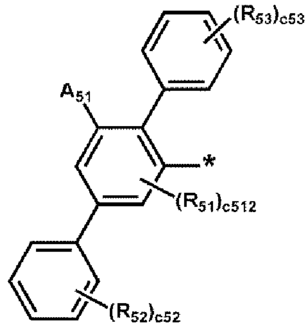
51-14

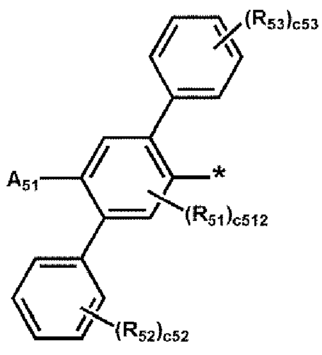
51-15

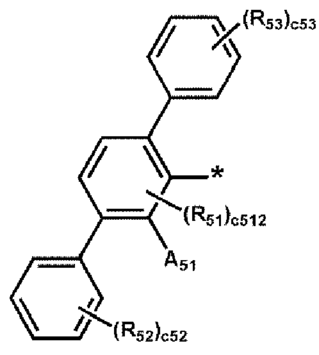
51-16

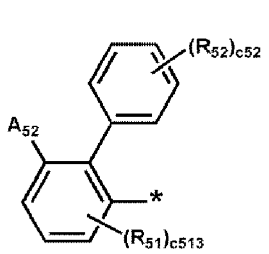
51-17

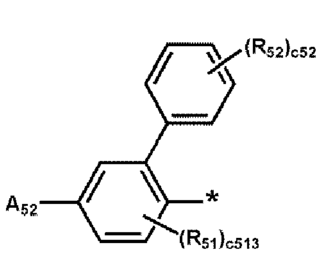
51-18

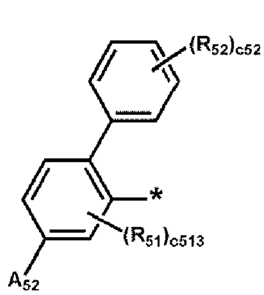
51-19

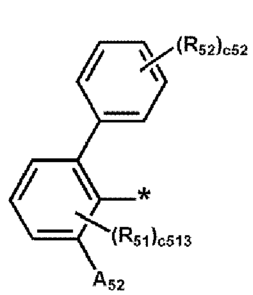
51-20

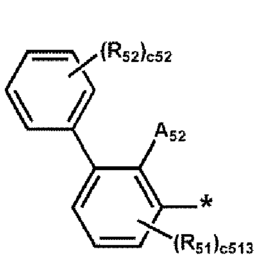
51-21

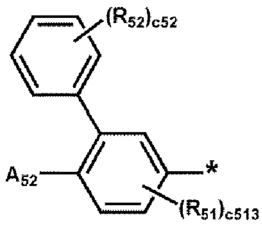
51-22

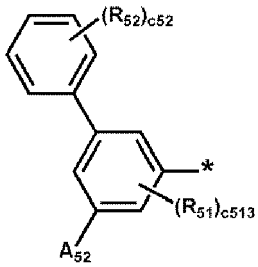
51-23

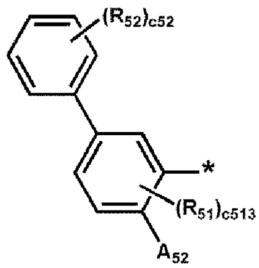
51-24

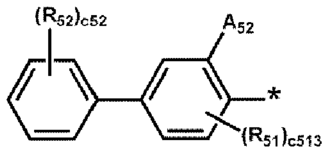
51-25

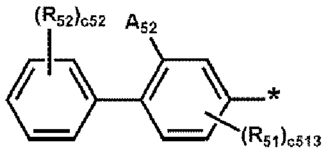
51-26

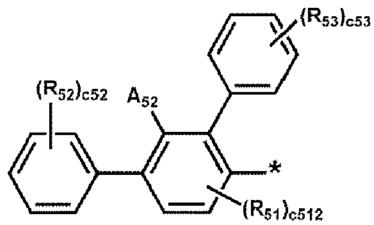
51-27

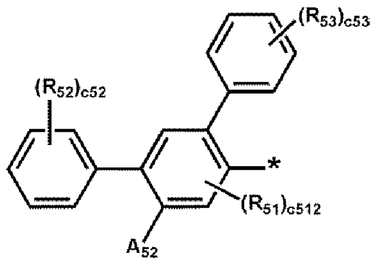
51-28

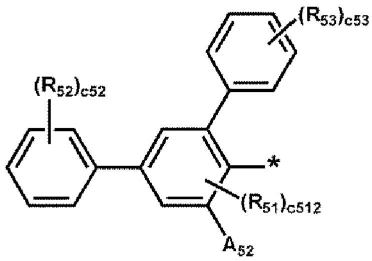
51-29

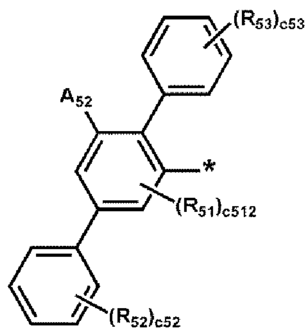
51-30

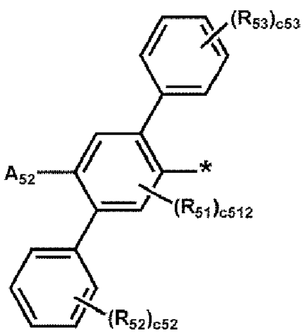
51-31

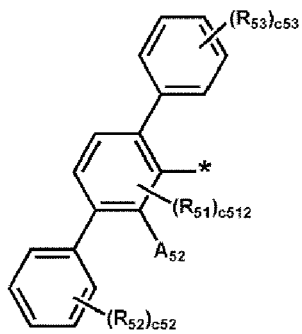
51-32

.

In Formulae 51-1 to 51-32, $R_{51}$, $R_{52}$, c52, $A_{51}$, and $A_{52}$ may each independently be the same as described in Formula 1A, $R_{53}$ and c53 may each independently be the same as described in connection with $R_{52}$ and c52 of Formula 1A, c512 is an integer of 0 to 2, c513 is an integer of 0 to 3, and * indicates a binding site to $L_{51}$.

In an embodiment, the organometallic compound may be represented by Formula 1-1A or 1-2A:

Formula 1-1A

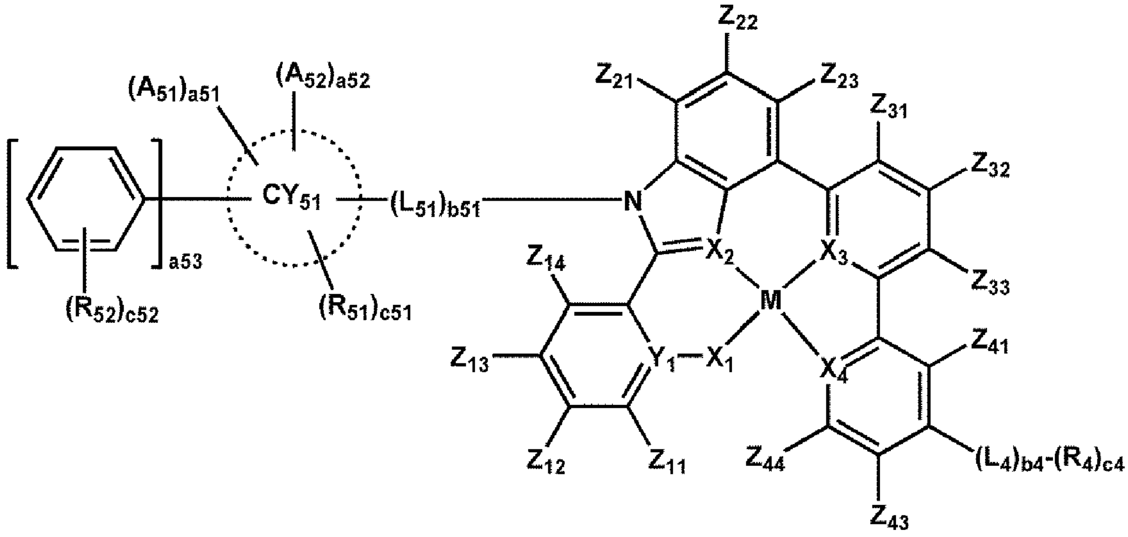

Formula 1-2A

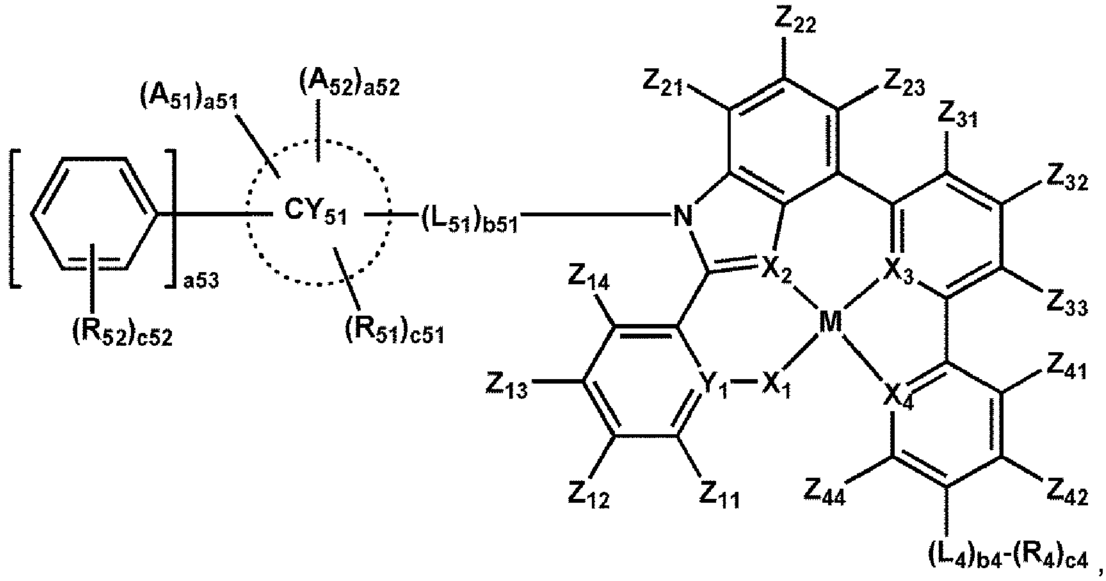

in Formulae 1-1A and 1-2A,

M, $X_1$ to $X_4$, $Y_1$, $Y_3$ to $Y_5$, $L_4$, $L_{51}$, b4, b51, $R_{51}$, $R_{52}$, c51, c52, $A_{51}$, $A_{52}$, a51, a52 and a53 may each independently be the same as described in Formula 1A,

$Z_{11}$ to $Z_{14}$ may each independently be the same as described in connection with $R_1$ of Formula 1A,

$Z_{21}$ to $Z_{23}$ may each independently be the same as described in connection with $R_2$ of Formula 1A,

$Z_{31}$ to $Z_{33}$ may each independently be the same as described in connection with $R_3$ of Formula 1A,

$Z_{41}$ to $Z_{44}$ may each independently be the same as described in connection with $R_4$ of Formula 1A,

two or more groups of $Z_{11}$ to $Z_{14}$ may be optionally linked to form a $C_5$-$C_{30}$ carbocyclic group that is unsubstituted or substituted with at least one $R_{10a}$ group or a $C_2$-$C_{30}$ heterocyclic group that is unsubstituted or substituted with at least one $R_{10a}$ group,

two or more groups of $Z_{21}$ to $Z_{23}$ may be optionally linked to form a $C_5$-$C_{30}$ carbocyclic group that is unsubstituted or substituted with at least one $R_{10a}$ group or a $C_2$-$C_{30}$ heterocyclic group that is unsubstituted or substituted with at least one $R_{10a}$ group,

two or more groups of $Z_{31}$ to $Z_{33}$ may be optionally linked to form a $C_5$-$C_{30}$ carbocyclic group that is unsubstituted

or substituted with at least one $R_{10a}$ group or a $C_2$-$C_{30}$ heterocyclic group that is unsubstituted or substituted with at least one $R_{10a}$ group,

two or more groups of $Z_{41}$ to $Z_{44}$ may be optionally linked to form a $C_5$-$C_{30}$ carbocyclic group that is unsubstituted or substituted with at least one $R_{10a}$ group or a $C_2$-$C_{30}$ heterocyclic group that is unsubstituted or substituted with at least one $R_{10a}$ group, and

$R_{10a}$ is the same as described in connection with $R_1$ of Formula 1A.

Descriptions for Formula 1A described herein can be applied for Formulae 1-1A and 1-2A.

For example,

1) Formulae 1-1A and 1-2A may satisfy Condition A, Condition B, or any combination thereof (or, Condition A, Condition B(1), or any combination thereof), and/or

2) Formulae 1-1A and 1-2A may satisfy Condition 1A, Condition 2A, or any combination thereof (or, Condition 1(1)A, Condition 2(1)A, or any combination thereof), and/or

3) Formulae 1-1A and 1-2A may satisfy Condition 3A, Condition 4A, Condition 5A, or any combination thereof (or, Condition 3(1)A, Condition 4(1)A, Condition 5(1)A, or any combination thereof), and/or

4) a group represented by

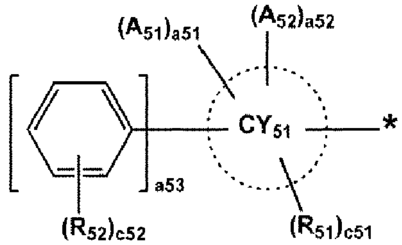

in Formulae 1-1A and 1-2A may be a group represented by one of Formulae 51-1 to 51-32.

In an embodiment, $Z_{12}$, $Z_{14}$, $Z_{21}$ to $Z_{23}$, $Z_{31}$, $Z_{33}$ and $Z_{41}$ to $Z_{44}$ in Formulae 1-1A and 1-2A may each independently be hydrogen, deuterium, $-CH_3$, or $-CD_3$.

In an embodiment, $Z_{12}$, $Z_{14}$, $Z_{21}$ to $Z_{23}$, $Z_{31}$, $Z_{33}$ and $Z_{41}$ to $Z_{44}$ in Formulae 1-1A and 1-2A may each independently be hydrogen, or deuterium.

In an embodiment, $Z_{11}$ and $Z_{13}$ in Formulae 1-1A and 1-2A may not be hydrogen and $Z_{11}$ and $Z_{13}$ may include a deuterium.

In an embodiment, $Z_{11}$ and $Z_{13}$ in Formulae 1-1A and 1-2A may not be hydrogen and $Z_{11}$ and $Z_{13}$ may be identical to each other.

In an embodiment, $Z_{11}$ and $Z_{13}$ in Formulae 1-1A and 1-2A may not be hydrogen and $Z_{11}$ and $Z_{13}$ may be different from each other.

In Formula 1A, i) two or more groups of a plurality of $R_1$ groups may optionally be linked to form a $C_5$-$C_{30}$ carbocyclic group that is unsubstituted or substituted with at least one $R_{10a}$ group or a $C_2$-$C_{30}$ heterocyclic group that is unsubstituted or substituted with at least one $R_{10a}$ group, ii) two or more groups of a plurality of $R_2$ groups may optionally be linked to form a $C_5$-$C_{30}$ carbocyclic group that is unsubstituted or substituted with at least one $R_{10a}$ group or a $C_2$-$C_{30}$ heterocyclic group that is unsubstituted or substituted with at least one $R_{10a}$ group, iii) two or more groups of a plurality of $R_3$ groups may optionally be linked to form a $C_5$-$C_{30}$ carbocyclic group that is unsubstituted or substituted with at least one $R_{10a}$ group or a $C_2$-$C_{30}$ heterocyclic group that is unsubstituted or substituted with at least one $R_{10a}$ group, iv) two or more groups of a plurality of $R_4$ groups may optionally be linked to form a $C_5$-$C_{30}$ carbocyclic group that is unsubstituted or substituted with at least one $R_{10a}$ group or a $C_2$-$C_{30}$ heterocyclic group that is unsubstituted or substituted with at least one $R_{10a}$ group, and v) two or more groups of $R_1$ to $R_6$ may optionally be linked to form a $C_5$-$C_{30}$ carbocyclic group that is unsubstituted or substituted with at least one $R_{10a}$ group or a $C_2$-$C_{30}$ heterocyclic group that is unsubstituted or substituted with at least one $R_{10a}$ group. An $R_{10a}$ group may be the same as described in connection with $R_1$.

**[0139]** * and *' are each independently a binding site with a neighboring atom.

Description of Formula 1B

The organometallic compound may be represented by Formula 1B:

Formula 1B

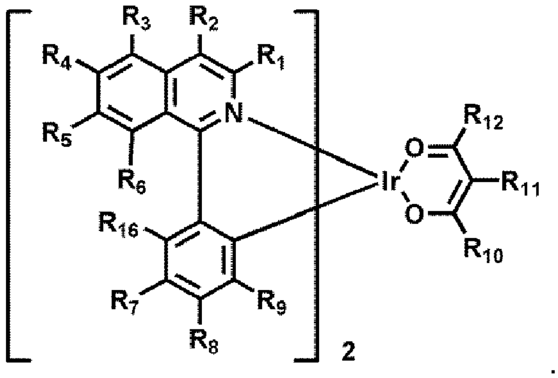

In Formula 1B, $R_1$ to $R_{12}$ and $R_{16}$ may each independently be hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-Ge(Q_3)(Q_4)(Q_5)$, - $B(Q_6)(Q_7)$, $-P(=O)(Q_8)(Q_9)$, or $-P(Q_8)(Q_9)$, wherein $Q_1$ to $Q_9$ are each independently the same as described herein.

For example, $R_1$ to $R_{12}$ and $R_{16}$ may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, $C_1$-$C_{20}$ alkyl group, or a $C_1$-$C_{20}$ alkoxy group;

a $C_1$-$C_{20}$ alkyl group or a $C_1$-$C_{20}$ alkoxy group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantyladamantyl group, a norbornyl group, a norbornenyl group, a cyclopentenyl group, a cyclohexenyl group, a cycloheptenyl group, bicyclo[1.1.1]pentyl, bicyclo[2.1.1]hexyl, bicyclo[2.2.1]heptyl, a bicyclo[2.2.2]octyl group, a phenyl group, a biphenyl group, a terphenyl group, a naphthyl group, a pyridinyl group, a pyrimidinyl group, or any combination thereof;

a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, bicyclo[1.1.1]pentyl, bicyclo[2.1.1]hexyl, bicyclo[2.2.1]heptyl, a bicyclo[2.2.2]octyl group, a phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group,

a cycloheptyl group, a cyclooctyl group, an adamantyl group, a norbornyl group, a norbornenyl group, a cyclopentenyl group, a cyclohexenyl group, a cycloheptenyl group, bicyclo[1.1.1]pentyl, bicyclo[2.1.1]hexyl, bicyclo[2.2.1]heptyl, a bicyclo[2.2.2]octyl group, a phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, $-Si(Q_{33})(Q_{34})(Q_{35})$, or any combination thereof; or

$-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, and $-P(Q_8)(Q_9)$.

In an embodiment, $R_1$ to $R_9$ and $R_{16}$ may each independently be hydrogen, deuterium, a substituted or unsubstituted $C_1$-$C_{60}$ alkyl group, a substituted or unsubstituted $C_3$-$C_{10}$ cycloalkyl group, or $-Si(Q_3)(Q_4)(Q_5)$. $Q_3$ to $Q_5$ are the same as described in this disclosure.

In one or more embodiments, $R_1$ to $R_{12}$ and $R_{16}$ may each independently be:

hydrogen, deuterium, a methyl group, an ethyl group, an n-propyl group, an iso-propyl group, an n-butyl group, a sec-butyl group, an iso-butyl group, a tert-butyl group, an n-pentyl group, a tert-pentyl group, a neopentyl, an iso-pentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, bicyclo[1.1.1]pentyl, bicyclo[2.1.1]hexyl, bicyclo[2.2.1]heptyl, a bicyclo[2.2.2]octyl group, a phenyl group, a biphenyl group, a terphenyl group, a naphthyl group, a pyridinyl group, a pyrimidinyl group, a carbazolyl group, a fluorenyl group, a dibenzosilolyl group, a dibenzofuranyl group, a dibenzothiophenyl group, or $-Si(Q_3)(Q_4)(Q_5)$;

a methyl group, an ethyl group, an n-propyl group, an iso-propyl group, an n-butyl group, a sec-butyl group, an iso-butyl group, a tert-butyl group, an n-pentyl group, a tert-pentyl group, a neopentyl group, an iso-pentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, or a tert-decyl group, each substituted with at least one deuterium; or

a methoxy group, an ethoxy group, a propoxy group, a butoxy group, a pentoxy group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, bicyclo[1.1.1]pentyl, bicyclo[2.1.1]hexyl, bicyclo[2.2.1]heptyl, a bicyclo[2.2.2]octyl group, a phenyl group, a biphenyl group, a terphenyl group, a naphthyl group, a pyridinyl group, a pyrimidinyl group, a carbazolyl group, a fluorenyl group, a dibenzosilolyl group, a dibenzofuranyl group, or a dibenzothiophenyl group, each substituted with deuterium, a $C_1$-$C_{10}$ alkyl group or any combination thereof, and

$Q_3$ to $Q_5$ are the same as described herein.

In one or more embodiments, $R_1$ to $R_{12}$ and $R_{16}$ may each independently be hydrogen, deuterium, -F, a cyano group, a nitro group, $-SF_5$, $-CH_3$, $-CD_3$, $-CD_2H$, $-CDH_2$, $-CF_3$, $-CF_2H$, $-CFH_2$, a group represented by any one of Formulae 9-1 to 9-66, a group represented by any one of Formulae 9-1 to 9-66 in which at least one hydrogen is substituted with deuterium, a group represented by any one of Formulae 10-1 to 10-118, a group represented by any one of Formulae 10-1 to 10-118 in which at least one hydrogen is substituted with deuterium, a group represented by any one of Formulae 10-201 to 10-342, a group represented by any one of Formulae 10-201 to 10-342 in which at least one hydrogen is substituted with deuterium, or $-Si(Q_3)(Q_4)(Q_5)$ (wherein $Q_3$ to $Q_5$ are the same as described herein). Above Formulae 9-1 to 9-66, 10-1 to 10-118 and 10-201 to 10-342 are the same as described in conenection with Formula 1A.

At least one of $R_1$ to $R_6$ in Formula 1B may each independently be a group represented by Formula 2B:

Formula 2B

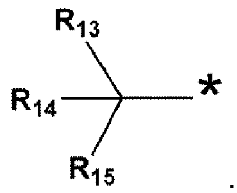

The number of carbon atoms included in Formula 2B may be 4 or more (for example, 4 to 20, 4 to 15 or 4 to 10), $R_{13}$ in Formula 2B may be hydrogen, deuterium, a $C_1$-$C_{20}$ alkyl group, deuterium-containing $C_1$-$C_{20}$ alkyl group, a $C_3$-$C_{10}$ cycloalkyl group, or a deuterium-containing $C_3$-$C_{10}$ cycloalkyl group,

$R_{14}$ and $R_{15}$ in Formula 2B may each independently be a $C_1$-$C_{20}$ alkyl group, deuterium-containing $C_1$-$C_{20}$ alkyl group, a $C_3$-$C_{10}$ cycloalkyl group, or a deuterium-containing $C_3$-$C_{10}$ cycloalkyl group, and

* indicates a binding site to a neighboring atom.

In an embodiment, at least one of $R_2$ to $R_5$ in Formula 1B may be a group represented by Formula 2B.

In one or more embodiments, one of $R_2$ to $R_5$ in Formula 1B may be a group represented by Formula 2B, and $R_1$ to $R_6$ other than the group represented by Formula 2B may be hydrogen.

In one or more embodiments, in Formula 1B,

1) $R_2$ may be a group represented by Formula 2B and $R_1$ and $R_3$ to $R_6$ may be hydrogen,
2) $R_3$ may be a group represented by Formula 2B and $R_1$, $R_2$ and $R_4$ to $R_6$ may be hydrogen,
3) $R_4$ may be a group represented by Formula 2B and $R_1$ to $R_3$, $R_5$ and $R_6$ may be hydrogen,
4) $R_5$ may be a group represented by Formula 2B and $R_1$ to $R_4$ and $R_6$ may be hydrogen,
5) $R_5$ may be a group represented by Formula 2B, $R_3$ may be a substituted or unsubstituted $C_1$-$C_{60}$ alkyl group, or a substituted or unsubstituted $C_3$-$C_{10}$ cycloalkyl group, and $R_1$, $R_2$, $R_4$ and $R_6$ may be hydrogen,
6) $R_4$ may be a group represented by Formula 2B, $R_2$ may be a substituted or unsubstituted $C_1$-$C_{60}$ alkyl group, or a substituted or unsubstituted $C_3$-$C_{10}$ cycloalkyl group, and $R_1$, $R_3$, $R_5$ and $R_6$ may be hydrogen,
7) $R_2$ may be a group represented by Formula 2B, $R_5$ may be a substituted or unsubstituted $C_1$-$C_{60}$ alkyl group, or a substituted or unsubstituted $C_3$-$C_{10}$ cycloalkyl group, and $R_1$, $R_3$, $R_4$ and $R_6$ may be hydrogen,
8) $R_4$ may be a group represented by Formula 2B, $R_5$ may be a substituted or unsubstituted $C_1$-$C_{60}$ alkyl group, or a substituted or unsubstituted $C_3$-$C_{10}$ cycloalkyl group, and $R_1$, $R_2$, $R_3$ and $R_6$ may be hydrogen, or
9) $R_4$ may be a group represented by Formula 2B, $R_3$ may be a substituted or unsubstituted $C_1$-$C_{60}$ alkyl group, or a substituted or unsubstituted $C_3$-$C_{10}$ cycloalkyl group, and $R_1$, $R_2$, $R_5$ and $R_6$ may be hydrogen,

In one or more embodiments, $R_7$ and $R_9$ in Formula 1B may not be hydrogen.

In one or more embodiments, $R_7$ and $R_9$ in Formula 1B may not be hydrogen, and $R_8$ and $R_{16}$ may be hydrogen.

In one or more embodiments, $R_{16}$ in Formula 1B may be hydrogen.

In one or more embodiments, $R_7$ and $R_9$ in Formula 1B may not be hydrogen, and $R_7$ and $R_9$ may be identical to each other.

In one or more embodiments, $R_7$ and $R_9$ in Formula 1B may not be hydrogen, and $R_7$ and $R_9$ may be different from each other.

In one or more embodiments, $R_7$ and $R_9$ in Formula 1B may not be hydrogen, $R_7$ and $R_9$ may be different from each other, and the number of carbon atoms included in $R_7$ may be greater than that of carbon atoms included in Rg.

In one or more embodiments, $R_7$ and $R_9$ in Formula 1B may each independently be a substituted or unsubstituted $C_1$-$C_{60}$ alkyl group, a substituted or unsubstituted $C_3$-$C_{10}$ cycloalkyl group, or a substituted or unsubstituted $C_6$-$C_{60}$ aryl group.

In one or more embodiments, at least one of $R_7$ and $R_9$ in Formula 1B may each independently be a substituted or unsubstituted $C_2$-$C_{60}$ alkyl group, a substituted or unsubstituted $C_3$-$C_{10}$ cycloalkyl group, or a substituted or unsubstituted $C_6$-$C_{60}$ aryl group.

In one or more embodiments, $R_{13}$ in Formula 2B may be hydrogen or deuterium.

In one or more embodiments, $R_{13}$ in Formula 2B may be a $C_1$-$C_{20}$ alkyl group, a deuterium-containing $C_1$-$C_{20}$ alkyl group, a $C_3$-$C_{10}$ cycloalkyl group, or a deuterium-containing $C_3$-$C_{10}$ cycloalkyl group.

In one or more embodiments, $R_{14}$ and $R_{15}$ in Formula 2B may be different from each other.

In one or more embodiments, in Formula 2B,

$R_{13}$ may be hydrogen, deuterium, $-CH_3$, $-CDH_2$, $-CD_2H$, or $-CD_3$,

$R_{14}$ and $R_{15}$ may each independently be :

a methyl group, an ethyl group, an n-propyl group, an iso-propyl group, an n-butyl group, a sec-butyl group, an iso-butyl group, a tert-butyl group, an n-pentyl group, a tert-pentyl group, a neopentyl, an iso-pentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, bicyclo[1.1.1]pentyl, bicyclo[2.1.1]hexyl, bicyclo[2.2.1]heptyl, or a bicyclo[2.2.2]octyl group; or

a methyl group, an ethyl group, an n-propyl group, an iso-propyl group, an n-butyl group, a sec-butyl group, an iso-butyl group, a tert-butyl group, an n-pentyl group, a tert-pentyl group, a neopentyl, an iso-pentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, bicyclo[1.1.1]pentyl, bicyclo[2.1.1]hexyl, bicyclo[2.2.1]heptyl, or a bicyclo[2.2.2]octyl group, each substituted with at least one deuterium.

In one or more embodiments, in Formula 2B, $R_{14}$ and $R_{15}$ may each independently be $-CH_3$, $-CD_3$, $-CD_2H$, $-CDH_2$, a group represented by any one of Formulae 9-1 to 9-36, a group represented by any one of Formulae 9-1 to 9-36 in which at least one hydrogen is substituted with deuterium, a group represented by any one of Formulae 10-1 to 10-9, or a group represented by any one of Formulae 10-1 to 10-9 in which at least one hydrogen is substituted with deuterium. Above Formulae 9-1 to 9-36 and 10-1 to 10-9 are the same as described in connection with Formula 1A.

In one or more embodiments, a case where all of $R_{13}$ to $R_{15}$ in Formula 2B are the same may be excluded.

In one or more embodiments, a case where all of $R_{13}$ to $R_{15}$ in Formula 2B are each independently a methyl group may be excluded.

At least one of $R_{10}$ and $R_{12}$ in Formula 1B may each independently be a group represented by Formula 3B:

Formula 3B

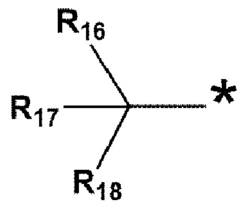

.

In Formula 3B, $R_{16}$ to $R_{18}$ may each independently be:

hydrogen, deuterium, a $C_1$-$C_{20}$ alkyl group, a $C_3$-$C_{10}$ cycloalkyl group, a $C_6$-$C_{60}$ aryl group, or a $C_1$-$C_{60}$ heteroaryl group; or

a $C_1$-$C_{20}$ alkyl group, a $C_3$-$C_{10}$ cycloalkyl group, a $C_6$-$C_{60}$ aryl group, or a $C_1$-$C_{60}$ heteroaryl group, each substituted with deuterium, a $C_1$-$C_{20}$ alkyl group, any combination thereof; and

* indicates a binding site to a neighboring atom.

For example, $R_{16}$ to $R_{18}$ in Formula 3B may each independently be hydrogen or deuterium.

In an embodiment, one or more selected from $R_{16}$ to $R_{18}$ in Formula 3B may be neither hydrogen nor deuterium. That is, Formula 3B may have two or less benzylic protons.

In one or more embodiments, two or more selected from $R_{16}$ to $R_{18}$ in Formula 3B may each independently be neither hydrogen nor deuterium. That is, Formula 3B may have one or no benzylic proton.

In an embodiment, in Formula 3B,

$R_{16}$ to $R_{18}$ may each independently be hydrogen or deuterium;

$R_{16}$ to $R_{18}$ may each independently be a methyl group or a deuterium-containing methyl group;

$R_{16}$ and $R_{17}$ may each independently be hydrogen or deuterium, and $R_{18}$ may be a methyl group or a deuterium-containing methyl group;

$R_{16}$ may be a methyl group or deuterium-containing methyl group, and $R_{17}$ and $R_{18}$ may each independently be a $C_2$-$C_{20}$

alkyl group or a deuterium-containing $C_2$-$C_{20}$ alkyl group;

$R_{16}$ and $R_{17}$ may each independently be hydrogen or deuterium, and $R_{18}$ may be a $C_2$-$C_{20}$ alkyl group or a deuterium-containing $C_2$-$C_{20}$ alkyl group; or

$R_{16}$ and $R_{17}$ may each independently be a methyl group or a deuterium-containing methyl group, and $R_{18}$ may be a $C_2$-$C_{20}$ alkyl group or a deuterium-containing $C_2$-$C_{20}$ alkyl group.

"The $C_2$-$C_{20}$ alkyl group or the deuterium-containing $C_2$-$C_{20}$ alkyl group" may be an ethyl group, an n-propyl group, an iso-propyl group, an n-butyl group, a sec-butyl group, an iso-butyl group, a tert-butyl group, an n-pentyl group, a tert-pentyl group, a neopentyl, an iso-pentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, or a tert-decyl group, each unsubstituted or substituted with at least one deuterium.

In one or more embodiments, $R_{10}$ and $R_{12}$ in Formula 1B may be identical to each other.

In one or more embodiments, $R_{10}$ and $R_{12}$ in Formula 1B may be different from each other.

For example, in Formula 1B, $R_{10}$ may be an ethyl group, and $R_{12}$ may be a methyl group, an n-propyl group, or an iso-propyl group, but embodiments of the present disclosure are not limited thereto.

In one or more embodiments, at least one of $R_{10}$, $R_{12}$ and $R_{14}$ in Formulae 1B and 2B may each independently be a $C_3$-$C_{10}$ cycloalkyl group, or a deuterium-containing $C_3$-$C_{10}$ cycloalkyl group.

$R_{1a}$ may be the same as defined in connection with $R_7$ of Formula 1B.

In one or more embodiments, the organometallic compound represented by Formula 1B may satisfy at least one of <Condition 1B> to <Condition 6B>:

<Condition 1B> At least one of $R_1$ to $R_3$, $R_5$ and $R_6$ in Formula 1B may not be hydrogen.

<Condition 2B> At least one of $R_7$ and $R_9$ in Formula 1B may each independently be a group having two more more cabons.

<Condition 3B> At least one of $R_7$ and $R_9$ in Formula 1B may each independently be a substituted or unsubstituted $C_2$-$C_{60}$ alkyl group, a substituted or unsubstituted $C_3$-$C_{10}$ cycloalkyl group, or a substituted or unsubstituted $C_6$-$C_{60}$ aryl group.

<Condition 4B> At least one of $R_{10}$ and $R_{12}$ in Formula 1B may each independently be a group represented by Formula 3B and $R_{16}$ and $R_{18}$ in Formula 3B may not be hydrogen.

<Condition 5B> At least one of $R_{10}$ and $R_{12}$ in Formula 1B may each independently be a group represented by Formula 3B and at least one of $R_{16}$ and $R_{18}$ in Formula 3B may each independently be a $C_2$-$C_{20}$ alkyl group, a $C_3$-$C_{10}$ cycloalkyl group or a $C_6$-$C_{60}$ aryl group; or a $C_2$-$C_{20}$ alkyl group, a $C_3$-$C_{10}$ cycloalkyl group or a $C_6$-$C_{60}$ aryl group, each substituted with deuterium, a $C_1$-$C_{20}$ alkyl group, or any combination thereof.

<Condition 6B> At least one of $R_{10}$ and $R_{12}$ in Formula 1B may each independently be a substituted or unsubstituted $C_3$-$C_{10}$ cycloalkyl group.

In one or more embodiments, when $R_4$ in Formula 1B is a group represented by Formula 2B, $R_{13}$ in Formula 2B is hydrogen, $R_{14}$ in Formula 2B is a methyl group and $R_{15}$ in Formula 2 is a ethyl group, the organometallic compound represented by Formula 1B may satisfy at least one of <Codition 1B> to <Condition 6B>.

For example, in Formula 1B, at least two selected from $R_1$ to $R_6$ may optionally be linked to form a $C_5$-$C_{30}$ carbocyclic group unsubstituted or substituted with at least one $R_{10a}$ or a $C_2$-$C_{30}$ heterocyclic group unsubstituted or substituted with at least one $R_{10a}$ and at least two selected from $R_7$ to $R_9$ and $R_{16}$ may optionally be linked to form a $C_5$-$C_{30}$ carbocyclic group unsubstituted or substituted with at least one $R_{10a}$ or a $C_2$-$C_{30}$ heterocyclic group unsubstituted or substituted with at least one $R_{10a}$. An $R_{10a}$ group may be the same as described in connection with $R_1$ in Formula 1A.

Description of Formula 1C

The organometallic compound may be represented by Formula 1C:

Formula 1C

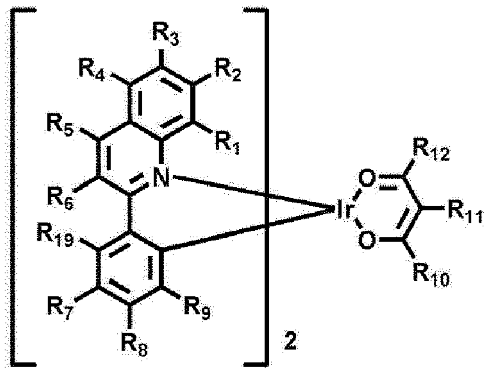

.

Descriptions for $R_1$ to $R_{12}$ and $R_{19}$ in Formula 1C are each independently the same as descriptions for $R_1$ to $R_{12}$ and $R_{16}$ of Formula 1B.

In an embodiment, at least one selected from $R_1$ to $R_6$ in Formula 1C may each independently be a group represented by Formula 2C:

Formula 2C

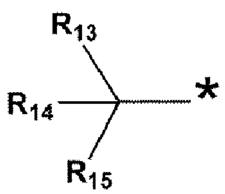

.

Descriptions for Formula 2C are the same as descriptions for Formula 2B.

In one or more embodiments, in Formula 1C,

1) $R_2$ may be a group represented by Formula 2C and $R_1$ and $R_3$ to $R_6$ may be hydrogen,
2) $R_3$ may be a group represented by Formula 2C and $R_1$, $R_2$ and $R_4$ to $R_6$ may be hydrogen,
3) $R_4$ may be a group represented by Formula 2C and $R_1$ to $R_3$, $R_5$ and $R_6$ may be hydrogen,
4) $R_5$ may be a group represented by Formula 2C and $R_1$ to $R_4$ and $R_6$ may be hydrogen,
5) $R_4$ may be a group represented by Formula 2C, $R_5$ may be a substituted or unsubstituted $C_1$-$C_{60}$ alkyl group, a substituted or unsubstituted $C_3$-$C_{10}$ cycloalkyl group, a phenyl group, a biphenyl group, or -Si($Q_3$)($Q_4$)($Q_5$) and $R_1$, $R_2$, $R_3$ and $R_6$ may be hydrogen,
6) $R_5$ may be a group represented by Formula 2C, $R_3$ may be a substituted or unsubstituted $C_1$-$C_{60}$ alkyl group, a substituted or unsubstituted $C_3$-$C_{10}$ cycloalkyl group, a phenyl group, a biphenyl group, or -Si($Q_3$)($Q_4$)($Q_5$) and $R_1$, $R_2$, $R_4$ and $R_6$ may be hydrogen,
7) $R_2$ may be a group represented by Formula 2C, $R_5$ may be a substituted or unsubstituted $C_1$-$C_{60}$ alkyl group, a substituted or unsubstituted $C_3$-$C_{10}$ cycloalkyl group, a phenyl group, a biphenyl group, or -Si($Q_3$)($Q_4$)($Q_5$) and $R_1$, $R_3$, $R_4$ and $R_6$ may be hydrogen,
8) $R_4$ may be a group represented by Formula 2C, $R_6$ may be a substituted or unsubstituted $C_1$-$C_{60}$ alkyl group, a substituted or unsubstituted $C_3$-$C_{10}$ cycloalkyl group, a phenyl group, a biphenyl group, or -Si($Q_3$)($Q_4$)($Q_5$) and $R_1$, $R_2$, $R_3$ and $R_5$ may be hydrogen,
9) $R_3$ may be a group represented by Formula 2C, $R_5$ may be a substituted or unsubstituted $C_1$-$C_{60}$ alkyl group, a substituted or unsubstituted $C_3$-$C_{10}$ cycloalkyl group, a phenyl group, a biphenyl group, or -Si($Q_3$)($Q_4$)($Q_5$) and $R_1$, $R_2$, $R_4$ and $R_6$ may be hydrogen, or
10) $R_2$ may be a group represented by Formula 2C, $R_4$ and $R_5$ may each independently be a substituted or unsubstituted $C_1$-$C_{60}$ alkyl group, a substituted or unsubstituted $C_3$-$C_{10}$ cycloalkyl group, a phenyl group, a biphenyl group, or -Si($Q_3$)($Q_4$)($Q_5$) and $R_1$, $R_3$ and $R_6$ may be hydrogen. In one or more embodiments, in Formula 1C,

1) $R_7$ and $R_9$ may not be hydrogen and $R_8$ and $R_{19}$ may be hydrogen,
2) $R_7$ and $R_8$ may not be hydrogen and $R_9$ and $R_{19}$ may be hydrogen,

3) $R_7$ to $R_9$ may not be hydrogen and $R_{19}$ may be hydrogen, or

4) $R_7$ may not be hydrogen and $R_8$, $R_9$ and $R_{19}$ may be hydrogen.

In one or more embodiments, in Formula 1C, at least one selected from $R_{10}$ and $R_{12}$ may each independently be a group represented by Formula 3C:

Formula 3C

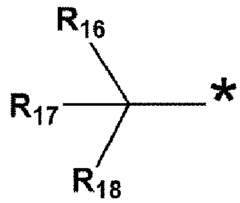

.

Descriptions for Formula 3C are the same as descriptions for Formula 3B.

In one or more embodiments, the organometallic compound represented by Formula 1C may satisfy at least one of <Codition 1B> to <Condition 6B> described in connection with Formula 1B.

Description of Formula 1D

The organometallic compound may be represented by Formula 1D:

Formula 1D

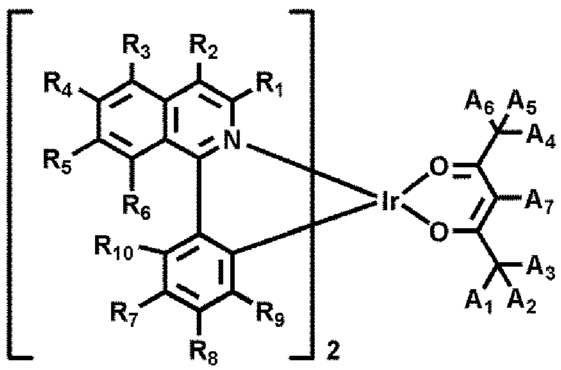

.

Descriptions for $R_1$ to $R_{10}$ and $A_7$ in Formula 1D are each independently the same as descriptions for $R_1$ to $R_9$, $R_{16}$ and $R_{11}$ of Formula 1B, provided that, at least one of $R_1$ to $R_{10}$ may each independently be a substituted or unsubstituted $C_2$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, or $-P(Q_8)(Q_9)$.

$A_1$ to $A_6$ in Formula 1D may each independently be a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a

substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, or a substituted or unsubstituted monovalent non-aromatic condensed heteropolycyclic group.

$Q_1$ to $Q_9$ are the same as described herein.

In an embodiment, in Formula 1D,

$R_1$ to $R_{10}$ and $A_7$ may each independently be hydrogen, deuterium, a cyano group, a substituted or unsubstituted $C_1$-$C_{60}$ alkyl group, or a substituted or unsubstituted $C_3$-$C_{10}$ cycloalkyl group and/or

at least one of $R_1$ to $R_{10}$ (for example, at least one of $R_1$ to $R_6$) may each independently be a substituted or unsubstituted $C_2$-$C_{60}$ alkyl group, or a substituted or unsubstituted $C_3$-$C_{10}$ cycloalkyl group, and/or

$A_1$ to $A_6$ may each independently be a substituted or unsubstituted $C_1$-$C_{60}$ alkyl group or a substituted or unsubstituted $C_3$-$C_{10}$ cycloalkyl group.

In one or more embodiments, at least one of $R_1$ to $R_{10}$ (for example, at least one of $R_1$ to $R_6$ / in an embodiment, $R_4$) in Formula 1D may each independently be:

an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1,1]hexyl group, a bicyclo[2.2.1]heptyl group, a bicyclo[2.2.2]octyl group, a phenyl group, a biphenyl group, a terphenyl group, a naphthyl group, a pyridinyl group, a pyrimidinyl group, a carbazolyl group, a fluorenyl group, a dibenzosilolyl group, a dibenzofuranyl group, a dibenzothiophenyl group, or -Si($Q_3$)($Q_4$)($Q_5$);

an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each substituted with deuterium, -F, a cyano group, or any combination thereof; or

a methoxy group, an ethoxy group, a propoxy group, a butoxy group, a pentoxy group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1,1]hexyl group, a bicyclo[2.2.1]heptyl group, a bicyclo[2.2.2]octyl group, a phenyl group, a biphenyl group, a terphenyl group, a naphthyl group, a pyridinyl group, a pyrimidinyl group, a carbazolyl group, a fluorenyl group, a dibenzosilolyl group, a dibenzofuranyl group, or a dibenzothiophenyl group, each substituted with deuterium, -F, a cyano group, a $C_1$-$C_{10}$ alkyl group, or any combination thereof.

$Q_3$ to $Q_5$ are the same as described herein.

In one or more embodiments, $A_1$ to $A_6$ in Formula 1D may each independently be:

a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1,1]hexyl group, a bicyclo[2.2.1]heptyl group, a bicyclo[2.2.2]octyl group, a phenyl group, a biphenyl group, a terphenyl group, a naphthyl group, a pyridinyl group, a pyrimidinyl group, a carbazolyl group, a fluorenyl group, a dibenzosilolyl group, a dibenzofuranyl group or a dibenzothiophenyl group;

a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each substituted with deuterium, -F, a cyano group, or any combination thereof; or

a methoxy group, an ethoxy group, a propoxy group, a butoxy group, a pentoxy group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1,1]hexyl group, a bicyclo[2.2.1]heptyl group, a bicyclo[2.2.2]octyl group, a phenyl group, a biphenyl group, a terphenyl group, a naphthyl group, a pyridinyl group, a pyrimidinyl group, a carbazolyl group, a fluorenyl group, a dibenzosilolyl group, a dibenzofuranyl group, or a dibenzothiophenyl group, each substituted with deuterium, -F, a cyano group, a $C_1$-$C_{10}$ alkyl group, or any combination thereof.

$Q_3$ to $Q_5$ are the same as described herein.

In one or more embodiments, in Formula 1D,

$R_1$ to $R_{10}$ and $A_7$ may each independently be hydrogen, deuterium, -F, a cyano group, a nitro group, $-SF_5$, $-CH_3$, $-CD_3$, $-CD_2H$, $-CDH_2$, $-CF_3$, $-CF_2H$, - $CFH_2$, a group represented by any one of Formulae 9-1 to 9-66, a group represented by any one of Formulae 9-1 to 9-66 in which at least one hydrogen is substituted with deuterium, a group represented by any one of Formulae 10-1 to 10-118, a group represented by any one of Formulae 10-1 to 10-118 in which at least one hydrogen is substituted with deuterium, a group represented by any one of Formulae 10-201 to 10-342, a group represented by any one of Formulae 10-201 to 10-342 in which at least one hydrogen is substituted with deuterium, $-Si(Q_3)(Q_4)(Q_5)$, or $-Ge(Q_3)(Q_4)(Q_5)$ (wherein $Q_3$ to $Q_5$ are the same as described herein), and/or

at least one of $R_1$ to $R_{10}$ (for example, at least one of $R_1$ to $R_6$) may each independently be a group represented by any one of Formulae 9-1 to 9-66, a group represented by any one of Formulae 9-1 to 9-66 in which at least one hydrogen is substituted with deuterium, a group represented by any one of Formulae 10-1 to 10-118, a group represented by any one of Formulae 10-1 to 10-118 in which at least one hydrogen is substituted with deuterium, a group represented by any one of Formulae 10-201 to 10-342, a group represented by any one of Formulae 10-201 to 10-342 in which at least one hydrogen is substituted with deuterium, $-Si(Q_3)(Q_4)(Q_5)$, or $-Ge(Q_3)(Q_4)(Q_5)$ (wherein $Q_3$ to $Q_5$ are the same as described herein), and/or

$A_1$ to $A_6$ may each independently be $-CH_3$, $-CD_3$, $-CD_2H$, $-CDH_2$, $-CF_3$, $-CF_2H$, $-CFH_2$, a group represented by any one of Formulae 9-1 to 9-66, a group represented by any one of Formulae 9-1 to 9-66 in which at least one hydrogen is substituted with deuterium, a group represented by any one of Formulae 10-1 to 10-118, a group represented by any one of Formulae 10-1 to 10-118 in which at least one hydrogen is substituted with deuterium, a group represented by any one of Formulae 10-201 to 10-342, or a group represented by any one of Formulae 10-201 to 10-342 in which at least one hydrogen is substituted with deuterium. Above Formulae 9-1 to 9-66, 10-1 to 10-118 and 10-201 to 10-342 are the same as described in connection with Formula 1A.

In one or more embodiments, in Formula 1D, at least one selected from $R_1$ to $R_{10}$ may be a group represented by Formula 2D:

Formula 2D

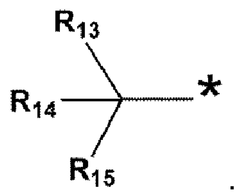

Descriptions for Formula 2D are the same as descriptions for Formula 2B.

In one or more embodiments, in Formula 2D,

$R_{13}$ may be hydrogen, deuterium, $-CH_3$, $-CDH_2$, $-CD_2H$, or $-CD_3$, and

$R_{14}$ and $R_{15}$ may each independently be a methyl group, an ethyl group, an n-propyl group, an isopropyl group, an n-butyl group, a sec-butyl group, an isobutyl group, a tert-butyl group, an n-pentyl group, a tert-pentyl group, a neopentyl

group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a cyclopentyl group, a cyclohexyl group, a cycloheptyl group, a cyclooctyl group, a bicyclo[1.1.1]pentyl group, a bicyclo[2.1.1]hexyl group, a bicyclo[2.2.1]heptyl group, or a bicyclo[2.2.2]octyl group, each unsubstituted or substituted with at least one deuterium.

In one or more embodiments, in Formula 2D,

$R_{13}$ may be hydrogen, deuterium, $-CH_3$, $-CDH_2$, $-CD_2H$, or $-CD_3$,

$R_{14}$ may be $-CH_3$, $-CDH_2$, $-CD_2H$, or $-CD_3$, and

$R_{15}$ may be an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a cyclopentyl group, a cyclohexyl group, a cycloheptyl group, a cyclooctyl group, a bicyclo[1.1.1]pentyl group, a bicyclo[2.1,1]hexyl group, a bicyclo[2.2.1]heptyl group, or a bicyclo[2.2.2]octyl group, each unsubstituted or substituted with at least one deuterium.

In an embodiment, at least one of $R_1$ to $R_6$ in Formula 1D may each independently be a group represented by Formula 2D.

For example, $R_4$ in Formula 1D may be a group represented by Formula 2D.

In an embodiment, $R_1$ to $R_3$, $R_5$, and $R_6$ in Formula 1D may each be hydrogen, and $R_4$ may be a group represented by Formula 2D.

In an embodiment, at least one of $R_4$, $R_7$, and $R_9$ in Formula 1D may not be each hydrogen.

In one or more embodiments, each of $R_7$ and $R_9$ in Formula 1D may not be hydrogen.

In one or more embodiments, in Formula 1D, each of $R_7$ and $R_9$ may not be hydrogen, and each of $R_8$ and $R_{10}$ may not be hydrogen.

In one or more embodiments, none of $R_4$, $R_7$, and $R_9$ in Formula 1D may be hydrogen.

In one or more embodiments, each of $R_7$ and $R_9$ in Formula 1D may not be hydrogen, and $R_7$ and $R_9$ may be identical to each other.

In one or more embodiments, each of $R_7$ and $R_9$ in Formula 1D may not be hydrogen, and $R_7$ and $R_9$ may be different from each other.

In one or more embodiments, in Formula 1D, each of $R_7$ and $R_9$ may not be hydrogen, $R_7$ and $R_9$ may be different from each other, and the number of carbon atoms included in $R_7$ may be greater than that of carbon atoms included in $R_9$.

In one or more embodiments, $R_7$ and $R_9$ in Formula 1D may each independently be a substituted or unsubstituted $C_1$-$C_{60}$ alkyl group, a substituted or unsubstituted $C_3$-$C_{10}$ cycloalkyl group, or a substituted or unsubstituted $C_6$-$C_{60}$ aryl group.

In one or more embodiments, at least one of $R_7$ and $R_9$ in Formula 1D may each independently be a substituted or unsubstituted $C_2$-$C_{60}$ alkyl group, a substituted or unsubstituted $C_3$-$C_{10}$ cycloalkyl group, or a substituted or unsubstituted $C_6$-$C_{60}$ aryl group.

In one or more embodiments, at least one of $A_1$ to $A_6$ in Formula 1D may each independently be a substituted or unsubstituted $C_2$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, or a substituted or unsubstituted monovalent non-aromatic condensed heteropolycyclic group.

For example, at least one of $A_1$ to $A_6$ in Formula 1D may each independently be:

an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an

n-decyl group, an isodecyl group, a sec-decyl group, or a tert-decyl group, each unsubstituted or substituted with deuterium, -F, a cyano group, any combination thereof; or

a methoxy group, an ethoxy group, a propoxy group, a butoxy group, a pentoxy group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1,1]hexyl group, a bicyclo[2.2.1]heptyl group, a bicyclo[2.2.2]octyl group, a phenyl group, a biphenyl group, a terphenyl group, a naphthyl group, a pyridinyl group, a pyrimidinyl group, a carbazolyl group, a fluorenyl group, a dibenzosilolyl group, a dibenzofuranyl group, or a dibenzothiophenyl group, each unsubstituted or substituted with deuterium, -F, a cyano group, a $C_1$-$C_{10}$ alkyl group, any combination thereof.

$Q_3$ to $Q_5$ are the same as described herein.

In an embodiment, at least one of $A_1$ to $A_6$ in Formula 1D may each independently be a group represented by any one of Formulae 9-1 to 9-66, a group represented by any one of Formulae 9-1 to 9-66 in which at least one hydrogen is substituted with deuterium, a group represented by any one of Formulae 10-1 to 10-118, a group represented by any one of Formulae 10-1 to 10-118 in which at least one hydrogen is substituted with deuterium, a group represented by any one of Formulae 10-201 to 10-342, or a group represented by any one of Formulae 10-201 to 10-342 in which at least one hydrogen is substituted with deuterium. Above Formulae 9-1 to 9-66, 10-1 to 10-118 and 10-201 to 10-342 are the same as described in connection with Formula 1A.

In one or more embodiments, $A_7$ may not be hydrogen.

In one or more embodiments, in Formula 1D, a group represented by *-C($A_1$)($A_2$)($A_3$) and a group represented by *-C($A_4$)($A_5$)($A_6$) may be identical to each other, and * indicates a binding site to a neighboring atom.

In one or more embodiments, in Formula 1D a group represented by *-C($A_1$)($A_2$)($A_3$) and a group represented by *-C($A_4$)($A_5$)($A_6$) may be different from each other, and * indicates a binding site to a neighboring atom.

In one or more embodiments, in Formula 1D,

$A_1$ an $A_2$ may be identical to each other, and $A_1$ and $A_3$ may be different from each other; and/or

$A_4$ and $A_5$ may be identical to each other, and $A_4$ and $A_6$ may be different from each other.

In Formula 1D, two or more of $R_1$ to $R_{10}$ may optionally be linked to form a $C_5$-$C_{60}$ carbocyclic group unsubstituted or substituted with at least one $R_{1a}$ or a $C_1$-$C_{60}$ heterocyclic group unsubstituted or substituted with at least one $R_{1a}$, and two or more of $A_1$ to $A_6$ may optionally be linked to form a $C_5$-$C_{60}$ carbocyclic group unsubstituted or substituted with at least one $R_{1a}$ or a $C_1$-$C_{60}$ heterocyclic group unsubstituted or substituted with at least one $R_{1a}$. Here, $R_{1a}$ is the same as defined in connection with $R_7$ of Formula 1D.

In an embodiment, two or more of $A_1$ to $A_3$ (for example, all of $A_1$ to $A_3$) in Formula 1D may be linked to form a $C_5$-$C_{60}$ carbocyclic group unsubstituted or substituted with at least one $R_{1a}$ or a $C_1$-$C_{60}$ heterocyclic group unsubstituted or substituted with at least one $R_{1a}$, and/or two or more of $A_4$ to $A_6$ (for example, all of $A_4$ to $A_6$) in Formula 1D may be linked to form a $C_5$-$C_{60}$ carbocyclic group unsubstituted or substituted with at least one $R_{1a}$ or a $C_1$-$C_{60}$ heterocyclic group unsubstituted or substituted with at least one $R_{1a}$.

In one or more embodiments, in Formula 1D, at least one of a group represented by *-C($A_1$)($A_2$)($A_3$) and a group represented by *-($A_4$)($A_5$)($A_6$) may each independently be a cyclopentane group, a cyclohexane group, a cycloheptane group, a cyclooctane group, an adamantane group, a norbornane group, a norbornene group, a cyclopentene group, a cyclohexene group, a cycloheptene group, a bicyclo[1.1.1]pentane group, a bicyclo[2.1.1]hexane group, a bicyclo[2.2.1]heptane group, a bicyclo[2.2.2]octane group, a benzene group, a naphthalene group, a fluorene group, a phenanthrene group, an anthracene group, a fluoranthene group, a triphenylene group, a pyrene group, a chrysene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, an isoindole group, an indole group, an indazole group, a purine group, a quinoline group, an isoquinoline group, a benzoquinoline group, a quinoxaline group, a quinazoline group, a cinnoline group, a carbazole group, a phenanthroline group, a benzimidazole group, a benzofuran group, a benzothiophene group, an isobenzothiophene group, a benzoxazole group, an isobenzoxazole group, a triazole group, a tetrazole group, an oxadiazole group, a triazine group, a tetrazine group, a dibenzofuran group, a dibenzothiophene group, a benzocarbazole group, a dibenzocarbazole group, an imidazopyridine group, or an imidazopyrimidine group, each unsubstituted or substituted with at least one $R_{1a}$.

Description of Formula 1E

The organometallic compound may be represented by Formula 1E:

Formula 1E

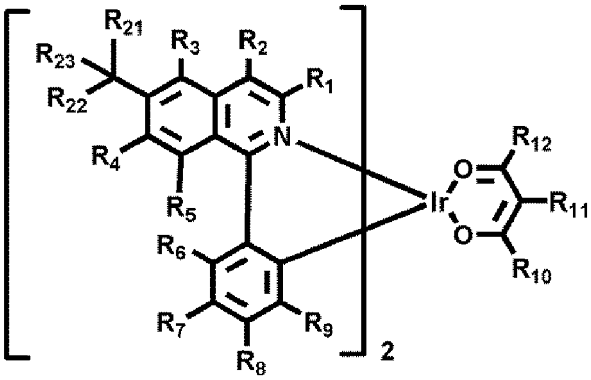

.

Descriptions for $R_1$ to $R_{12}$ and $R_{23}$ in Formula 1E are each independently the same as descriptions for $R_1$, $R_2$, $R_3$, $R_5$, $R_6$, $R_{16}$, $R_7$, $R_8$, $R_9$, $R_{10}$, $R_{11}$ and $R_{12}$ of Formula 1B.

In Formula 1E, at least one of $R_1$ to $R_5$ (for example, one, two, three, four, or five of $R_1$ to $R_5$) may not be hydrogen. For example, at least one of $R_1$ to $R_5$ in Formula 1E (for example, one, two, three, four, or five of $R_1$ to $R_5$) may each independently be deuterium, -F, -Cl, -Br, -I, -$SF_5$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_2$-$C_{10}$ heterocycloalkyl group, a substituted or unsubstituted $C_3$-$C_{10}$ cycloalkenyl group, a substituted or unsubstituted $C_2$-$C_{10}$ heterocycloalkenyl group, a substituted or unsubstituted $C_6$-$C_{60}$ aryl group, a a substituted or unsubstituted $C_7$-$C_{60}$ arylalkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, -$N(Q_1)(Q_2)$, -$Si(Q_3)(Q_4)(Q_5)$, -$Ge(Q_3)(Q_4)(Q_5)$, -$B(Q_6)(Q_7)$, -$P(=O)(Q_8)(Q_9)$, or - $P(Q_8)(Q_9)$.

In an embodiment, in Formula 1E,

$R_1$ may not be hydrogen and $R_2$, $R_3$, $R_4$ and $R_5$ may each be independently be hydrogen or deuterium;
$R_2$ may not be hydrogen and $R_1$, $R_3$, $R_4$ and $R_5$ may each be independently hydrogen or deuterium;
$R_3$ may not be hydrogen and $R_1$, $R_2$, $R_4$ and $R_5$ may each be independently hydrogen or deuterium;
$R_4$ may not be hydrogen and $R_1$, $R_2$, $R_3$ and $R_5$ may each independently be hydrogen or deuterium; or
$R_5$ may not be hydrogen and $R_1$, $R_2$, $R_3$ and $R_4$ may each independently be hydrogen or deuterium.

In an embodiment, in Formula 1E, $R_1$ to $R_{12}$ and $R_{23}$ may each independently be:

hydrogen, deuterium, -F, a cyano group, or a $C_1$-$C_{20}$ alkyl group;

a $C_1$-$C_{20}$ alkyl group substituted with deuterium, -F, -$CD_3$, -$CD_2H$, -$CDH_2$, - $CF_3$, -$CF_2H$, -$CFH_2$, a cyano group, a $C_1$-$C_{10}$ alkyl group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1,1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, or any combination thereof;

a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, or a terphenyl group, each unsubstituted or substituted with deuterium, -F, -$CD_3$, -$CD_2H$, -$CDH_2$, -$CF_3$, - $CF_2H$, -$CFH_2$, a cyano group, a $C_1$-$C_{10}$ alkyl group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1,1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, or any combination thereof; or

-$Si(Q_3)(Q_4)(Q_5)$, or -$Ge(Q_3)(Q_4)(Q_5)$; and/or

at least one of $R_1$ to $R_5$ may each independently be:

deuterium, -F, a cyano group, or a $C_1$-$C_{20}$ alkyl group;
a $C_1$-$C_{20}$ alkyl group substituted with deuterium, -F, $-CD_3$, $-CD_2H$, $-CDH_2$, - $CF_3$, $-CF_2H$, $-CFH_2$, a cyano group, a $C_1$-$C_{10}$ alkyl group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1,1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, or any combination thereof;
a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1,1]hexyl group, a bicyclo[2.2.1]heptyl group, a bicyclo[2.2.2]octyl group, a phenyl group, a ($C_1$-$C_{20}$ alkyl)phenyl group, a biphenyl group, or a terphenyl group, each unsubstituted or substituted with deuterium, -F, $-CD_3$, $-CD_2H$, $-CDH_2$, $-CF_3$, - $CF_2H$, $-CFH_2$, a cyano group, a $C_1$-$C_{10}$ alkyl group, a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1,1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, or any combination thereof; or
-Si($Q_3$)($Q_4$)($Q_5$), or -Ge($Q_3$)($Q_4$)($Q_5$), wherein $Q_3$ to $Q_5$ may be each understood by referring to the detailed herein.

In Formula 1E, $R_{21}$ may be a $C_2$-$C_{20}$ alkyl group, a deuterium-containing C2-$C_{20}$ alkyl group, a $C_3$-$C_{10}$ cycloalkyl group, or a deuterium-containing $C_3$-$C_{10}$ cycloalkyl group, and $R_{22}$ may be a $C_1$-$C_{20}$ alkyl group, a deuterium-containing $C_1$-$C_{20}$ alkyl group, a $C_3$-$C_{10}$ cycloalkyl group, or a deuterium-containing $C_3$-$C_{10}$ cycloalkyl group.

In an exemplary embodiment, $R_{21}$ in Formula 1E may be an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a cyclopentyl group, a cyclohexyl group, a cycloheptyl group, a cyclooctyl group, a bicyclo[1.1.1]pentyl group, a bicyclo[2.1.1]hexyl group, a bicyclo[2.2.1]heptyl group, or a bicyclo[2.2.2]octyl group, each unsubstituted or substituted with at least one deuterium.

In an exemplary embodiment, $R_{22}$ in Formula 1E may be a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a cyclopentyl group, a cyclohexyl group, a cycloheptyl group, a cyclooctyl group, a bicyclo[1.1.1]pentyl group, a bicyclo[2.1.1]hexyl group, a bicyclo[2.2.1]heptyl group, or a bicyclo[2.2.2]octyl group, each unsubstituted or substituted with at least one deuterium.

In an embodiment, one of $R_1$ to $R_5$ in Formula 1E may be a substituted or unsubstituted $C_1$-$C_{60}$ alkyl group, a substituted or unsubstituted $C_3$-$C_{10}$ cycloalkyl group, -Si($Q_3$)($Q_4$)($Q_5$), or -Ge($Q_3$)($Q_4$)($Q_5$).

In an embodiment, in Formula 1E, $R_6$ and $R_8$ may each independently be hydrogen or deuterium, and $R_7$ and Rg may each independently be a substituted or unsubstituted $C_1$-$C_{60}$ alkyl group, a substituted or unsubstituted $C_3$-$C_{10}$ cycloalkyl group, -Si($Q_3$)($Q_4$)($Q_5$), or -Ge($Q_3$)($Q_4$)($Q_5$).

In an embodiment, in Formula 1E, $R_{21}$ may be a $C_3$-$C_{10}$ cycloalkyl group or a deuterium-containing $C_3$-$C_{10}$ cycloalkyl group.

In an embodiment, in Formula 1E, $R_{21}$ may be a $C_3$-$C_{20}$ alkyl group, a deuterium-containing $C_3$-$C_{20}$ alkyl group, a $C_3$-$C_{10}$ cycloalkyl group, or a deuterium-containing $C_3$-$C_{10}$ cycloalkyl group.

In an embodiment, in Formula 1E, $R_{21}$ may be a branched $C_3$-$C_{20}$ alkyl group, a deuterium-containing branched $C_3$-$C_{20}$ alkyl group, a $C_3$-$C_{10}$ cycloalkyl group, or a deuterium-containing $C_3$-$C_{10}$ cycloalkyl group.

In an embodiment, in Formula 1E, $R_{22}$ may be a methyl group.

In an embodiment, in Formula 1E, $R_{22}$ may be a $C_2$-$C_{20}$ alkyl group, a deuterium-containing $C_2$-$C_{20}$ alkyl group, a $C_3$-$C_{10}$ cycloalkyl group, or a deuterium-containing $C_3$-$C_{10}$ cycloalkyl group.

In an embodiment, in Formula 1E, $R_{21}$ and $R_{22}$ may be identical to each other.

In an embodiment, in Formula 1E, $R_{21}$ and $R_{22}$ may be different from each other.

In an embodiment, in Formula 1E, $R_{23}$ may be hydrogen or deuterium.

In an embodiment, the organometallic compound represented by Formula 1E may satisfy Condition 3E, Condition 4E, or any combination thereof:

Condition 3E
$R_{10}$ in Formula 1E is represented by Formula 3E.
Condition 4E
$R_{12}$ in Formula 1E is represented by Formula 4E.

Formula 3E

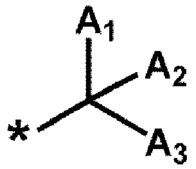

Formula 4E

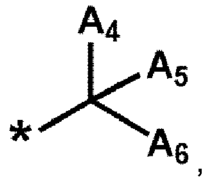

In Formulae 3E and 4E,
$A_1$ to $A_6$ may each independently be:

hydrogen or deuterium; or
a $C_1$-$C_{20}$ alkyl group, a $C_3$-$C_{10}$ cycloalkyl group, a $C_6$-$C_{60}$ aryl group, or a $C_1$-$C_{60}$ heteroaryl group, each unsubstituted or substituted with deuterium, a $C_1$-$C_{20}$ alkyl group, a $C_3$-$C_{10}$ cycloalkyl group, or any combination thereof; and
* indicates a binding site to a neighboring atom.

In an exemplary embodiment, Formula 3E may satisfy one of Condition 3-1E to Condition 3-5E and/or Formula 4E may satisfy one of Condition 4-1E to Condition 4-5E:

Condition 3-1E
$A_1$ to $A_3$ are not all hydrogen, simultaneously.
Condition 3-2E
$A_1$ to $A_3$ are each independently a $C_1$-$C_{20}$ alkyl group, or a $C_3$-$C_{10}$ cycloalkyl group, each unsubstituted or substituted with deuterium, a $C_1$-$C_{20}$ alkyl group, a $C_3$-$C_{10}$ cycloalkyl group, or any combination thereof.
Condition 3-3E

$A_1$ and $A_2$ are each independently a $C_1$-$C_{20}$ alkyl group, or a $C_3$-$C_{10}$ cycloalkyl group, each unsubstituted or substituted with deuterium, a $C_1$-$C_{20}$ alkyl group, a $C_3$-$C_{10}$ cycloalkyl group, or any combination thereof, and
$A_3$ is a $C_2$-$C_{20}$ alkyl group, or a $C_3$-$C_{10}$ cycloalkyl group, each unsubstituted or substituted with deuterium, a $C_1$-$C_{20}$ alkyl group, a $C_3$-$C_{10}$ cycloalkyl group, or any combination thereof.

Condition 3-4E

$A_1$ is a $C_1$-$C_{20}$ alkyl group, or a $C_3$-$C_{10}$ cycloalkyl group, each unsubstituted or substituted with deuterium, a $C_1$-$C_{20}$ alkyl group, a $C_3$-$C_{10}$ cycloalkyl group, or any combination thereof, and
$A_2$ and $A_3$ are each independently a $C_2$-$C_{20}$ alkyl group or a $C_3$-$C_{10}$ cycloalkyl group, each unsubstituted or substituted with deuterium, a $C_1$-$C_{20}$ alkyl group, a $C_3$-$C_{10}$ cycloalkyl group, or any combination thereof.

Condition 3-5E

$A_1$ is hydrogen or deuterium,
$A_2$ is a $C_1$-$C_{20}$ alkyl group, or a $C_3$-$C_{10}$ cycloalkyl group, each unsubstituted or substituted with deuterium, a $C_1$-$C_{20}$ alkyl group, a $C_3$-$C_{10}$ cycloalkyl group, or any combination thereof, and
$A_3$ is a $C_2$-$C_{20}$ alkyl group, or a $C_3$-$C_{10}$ cycloalkyl group, each unsubstituted or substituted with deuterium, a $C_1$-$C_{20}$ alkyl group, a $C_3$-$C_{10}$ cycloalkyl group, or any combination thereof.

Condition 4-1E
$A_4$ to $A_6$ are not all hydrogen, simultaneously.
Condition 4-2E
$A_4$ to $A_6$ are each independently a $C_1$-$C_{20}$ alkyl group, or a $C_3$-$C_{10}$ cycloalkyl group, each unsubstituted or substituted with deuterium, a $C_1$-$C_{20}$ alkyl group, a $C_3$-$C_{10}$ cycloalkyl group, or any combination thereof.

Condition 4-3E

$A_4$ and $A_5$ are each independently a $C_1$-$C_{20}$ alkyl group, or a $C_3$-$C_{10}$ cycloalkyl group, each unsubstituted or substituted with deuterium, a $C_1$-$C_{20}$ alkyl group, a $C_3$-$C_{10}$ cycloalkyl group, or any combination thereof, and $A_6$ is a $C_2$-$C_{20}$ alkyl group, or a $C_3$-$C_{10}$ cycloalkyl group, each unsubstituted or substituted with deuterium, a $C_1$-$C_{20}$ alkyl group, a $C_3$-$C_{10}$ cycloalkyl group, or any combination thereof.

Condition 4-4E

$A_4$ is a $C_1$-$C_{20}$ alkyl group, or a $C_3$-$C_{10}$ cycloalkyl group, each unsubstituted or substituted with deuterium, a $C_1$-$C_{20}$ alkyl group, a $C_3$-$C_{10}$ cycloalkyl group, or any combination thereof, and $A_5$ and $A_6$ are each independently a $C_2$-$C_{20}$ alkyl group, or a $C_3$-$C_{10}$ cycloalkyl group, each unsubstituted or substituted with deuterium, a $C_1$-$C_{20}$ alkyl group, a $C_3$-$C_{10}$ cycloalkyl group, or any combination thereof.

Condition 4-5E
$A_4$ is hydrogen or deuterium,

$A_5$ is a $C_1$-$C_{20}$ alkyl group, or a $C_3$-$C_{10}$ cycloalkyl group, each unsubstituted or substituted with deuterium, a $C_1$-$C_{20}$ alkyl group, a $C_3$-$C_{10}$ cycloalkyl group, or any combination thereof, and $A_6$ is a $C_2$-$C_{20}$ alkyl group, or a $C_3$-$C_{10}$ cycloalkyl group, each unsubstituted or substituted with deuterium, a $C_1$-$C_{20}$ alkyl group, a $C_3$-$C_{10}$ cycloalkyl group, or any combination thereof.

In an embodiment, $R_{10}$, $R_{12}$, or a combination thereof (for example, both $R_{10}$ and $R_{12}$) in Formula 1E may be a substituted or unsubstituted $C_3$-$C_{10}$ cycloalkyl group.

In an embodiment, $R_{10}$, $R_{12}$, or a combination thereof (for example, both $R_{10}$ and $R_{12}$) in Formula 1E may each independently be a cyclopentyl group, a cyclohexyl group, a cycloheptyl group, a cyclooctyl group, an adamantyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, or a bicyclo[2.2.2]octyl group, each unsubstituted or substituted with deuterium, -F, $-CD_3$, $-CD_2H$, $-CDH_2$, $-CF_3$, $-CF_2H$, $-CFH_2$, a cyano group, a $C_1$-$C_{10}$ alkyl group, or any combination thereof.

In an embodiment, $R_{10}$ and $R_{12}$ in Formula 1E may be identical to each other.

In an embodiment, $R_{10}$ and $R_{12}$ in Formula 1E may be different from each other.

In an embodiment, $R_{11}$ in Formula 1E may be hydrogen, deuterium, or a methyl group.

In an embodiment, a case in which $R_{10}$ and $R_{12}$ in Formula 1E are each a methyl group and $R_{11}$ in Formula 1E is hydrogen is excluded from the scope of this disclosure.

In an embodiment, in Formulae 1E, 3E and 4E,

$R_1$ to $R_{12}$ and $R_{23}$ may each independently be hydrogen, deuterium,-F, a cyano group, a nitro group, $-SF_5$, $-CH_3$, $-CD_3$, $-CD_2H$, $-CDH_2$, $-CF_3$,$-CF_2H$, $-CFH_2$, a group represented by any one of Formulae 9-1 to 9-66, a group represented by any one of Formulae 9-1 to 9-66 in which at least one hydrogen is substituted with deuterium, a group represented by any one of Formulae 10-1 to 10-118, a group represented by any one of Formulae 10-1 to 10-118 in which at least one hydrogen is substituted with deuterium, a group represented by any one of Formulae 10-201 to 10-342, a group represented by any one of Formulae 10-201 to 10-342 in which at least one hydrogen is substituted with deuterium, $-Si(Q_3)(Q_4)(Q_5)$, or $-Ge(Q_3)(Q_4)(Q_5)$ (wherein $Q_3$ to $Q_5$ are the same as described herein); and/or at least one of $R_1$ to $R_5$ may each independently be deuterium, -F, a cyano group, a nitro group, $-SF_5$, $-CH_3$, $-CD_3$, $-CD_2H$, $-CDH_2$, $-CF_3$, $-CF_2H$, $-CFH_2$, a group represented by any one of Formulae 9-1 to 9-66, a group represented by any one of Formulae 9-1 to 9-66 in which at least one hydrogen is substituted with deuterium, a group represented by any one of Formulae 10-1 to 10-118, a group represented by any one of Formulae 10-1 to 10-118 in which at least one hydrogen is substituted with deuterium, a group represented by any one of Formulae 10-201 to 10-342, a group represented by any one of Formulae 10-201 to 10-342 in which at least one hydrogen is substituted with deuterium, $-Si(Q_3)(Q_4)(Q_5)$, or $-Ge(Q_3)(Q_4)(Q_5)$ (wherein $Q_3$ to $Q_5$ are the same as described herein); and/or $R_{21}$ may be a group represented by one of Formulae 9-1 to 9-36, a group represented by one of Formulae 9-1 to 9-36 in which at least one hydrogen is substituted with deuterium, a group represented by one of Formulae 10-1 to 10-9, or a group represented by one of Formulae 10-1 to 10-9 in which at least one hydrogen is substituted with deuterium; and/or
$R_{22}$ may be $-CH_3$, $-CD_3$, $-CD_2H$, $-CDH_2$, a group represented by one of Formulae 9-1 to 9-36, a group represented by one of Formulae 9-1 to 9-36 in which at least one hydrogen is substituted with deuterium, a group represented by one of Formulae 10-1 to 10-9, or a group represented by one of Formulae 10-1 to 10-9 in which at least one

hydrogen is substituted with deuterium; and/or

$A_1$ to $A_6$ may each independently be hydrogen, deuterium, $-CH_3$, $-CD_3$,$-CD_2H$, $-CDH_2$, a group represented by one of Formulae 9-1 to 9-66, a group represented by one of Formulae 9-1 to 9-66 in which at least one hydrogen is substituted with deuterium, a group represented by one of Formulae 10-1 to 10-9, or a group represented by one of Formulae 10-1 to 10-9 in which at least one hydrogen is substituted with deuterium. Above Formulae 9-1 to 9-66, 10-1 to 10-118 and 10-201 to 10-342 are the same as described in connection with Formula 1A.

In Formula 1E, two or more of $R_1$ to $R_9$ may optionally be linked to each other to form a $C_5$-$C_{30}$ carbocyclic group unsubstituted or substituted with at least one $R_{1a}$ group or a $C_2$-$C_{30}$ heterocyclic group unsubstituted or substituted with at least one $R_{1a}$ group, and two or more of $R_{10}$ to $R_{12}$ may optionally be linked to each other to form a $C_5$-$C_{30}$ carbocyclic group unsubstituted or substituted with at least one $R_{1a}$ group or a $C_2$-$C_{30}$ heterocyclic group unsubstituted or substituted with at least one $R_{1a}$ group.

Descriptions for $R_{1a}$ are the same as descriptions for $R_1$ of Formula 1E.

Although the ligand $L_2$ in Formulae 1B to 1E is shown to have the structure

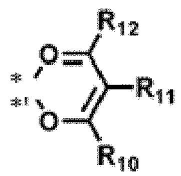
and
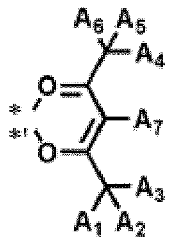
,

in some embodiments, the ligand $L_2$ may have a more general structure

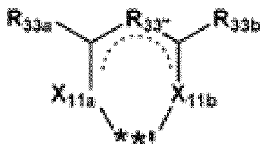
,

wherein

$X_{11a}$ and $X_{11b}$ are each independently selected from N, O, $N(R_{34})$, $P(R_{35})(R_{36})$, and $As(R_{37})(R_{38})$;

$R_{33''}$ is selected from a single bond, a double bond, a substituted or unsubstituted $C_1$-$C_5$ alkylene group, and a substituted or unsubstituted $C_2$-$C_5$ alkenylene group;

$R_{33a}$, $R_{33b}$, and $R_{34}$ to $R_{38}$ are each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, and $-Si(Q_{41})(Q_{42})(Q_{43})$;

wherein $Q_{41}$ to $Q_{43}$ are each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group; and

* and *' each indicates a binding site to Ir in Formulae 1B to 1E.

Description of Formula 1F

The organometallic compound may be represented by Formula 1F:

Formula 1F $M(L_1)_{n1}(L_2)_{n2}$.

M in Formula 1F may be a first-row transition metal, a second-row transition metal, or a third-row transition metal, of the Periodic Table of Elements,

$L_1$ in Formula 1F may be a ligand represented by Formula 2F,
n1 in Formula 1F may be 1, 2, or 3, wherein, when n1 is two or more, two or more $L_1$ may be identical to or different from each other,
$L_2$ in Formula 1F may be a monodentate ligand, a bidentate ligand, a tridentate ligand, or a tetradentate ligand,
n2 in Formula 1F may be 0, 1, 2, 3, or 4, wherein, when n2 is two or more, two or more $L_2$ may be identical to or different from each other, and
$L_1$ and $L_2$ in Formula 1F may be different from each other:

Formula 2F

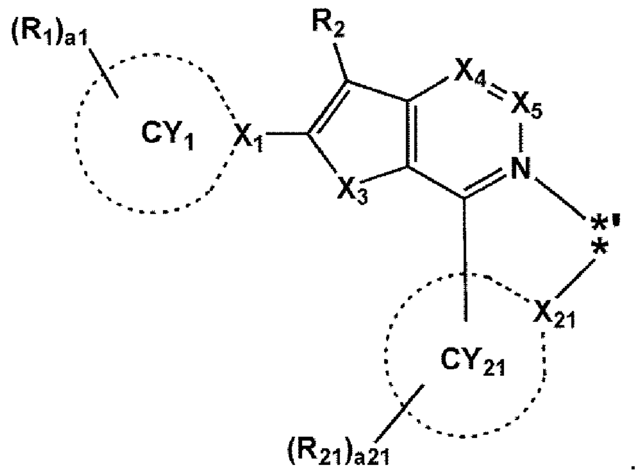

Formula 2F is the same as described below.
For example, n1 may be 1 or 2.
$L_2$ in Formula 1F may be a monodentate ligand, a bidentate ligand, a tridentate ligand, or a tetradentate ligand, and n2 in Formula 1F indicates the number of $L_2$ and may be 0, 1, 2, 3, or 4. When n2 is two or more, two or more $L_2$ may be identical to or different from each other. $L_2$ is the same as described below.
For example, n2 in Formula 1F may be 1 or 2.
$L_1$ and $L_2$ in Formula 1F may be different from each other.
In one embodiment, M may be Ir or Os, and the sum of n1 and n2 may be 3 or 4; or M may be Pt, and the sum of n1 and n2 may be 2.
In Formula 2F, $X_1$ may be C, N, Si, or P, and $X_{21}$ may be C or N.
For example, in Formula 2F, $X_{21}$ may be C.
In Formula 2F, ring $CY_1$ and ring $CY_{21}$ may each independently be a $C_3$-$C_{60}$ carbocyclic group or a $C_1$-$C_{60}$ heterocyclic group. Descriptions for ring $CY_1$ and ring $CY_{21}$ are the same as descriptions for $CY_1$ of Formula 1A.
In one or more embodiments, ring $CY_1$ may be a cyclopentane group, a cyclohexane group, a cycloheptane group, a cycloctane group, an adamantane group, a norbornane group, a norbornene group, a cyclopentene group, a cyclohexene group, a cycloheptene group, a benzene group, a naphthalene group, a fluorene group, a phenanthrene group, an anthracene group, a fluoranthene group, a triphenylene group, a pyrene group, a chrysene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, an isoindole group, an indole group, an indazole group, a purine group, a quinoline group, an isoquinoline group, a benzoquinoline group, a quinoxaline group, a quinazoline group, a cinnoline group, a carbazole group, a phenanthroline group, a benzimidazole group, a benzofuran group, a benzothiophene group, an isobenzothiazole group, a benzoxazole group, an isobenzoxazole group, a triazole group a tetrazole group, an oxadiazole group, a triazine group, a dibenzofuran

group, a dibenzothiophene group, a dibenzosilole group, a benzocarbazole group, a dibenzocarbazole group, an imidazopyridine group, or an imidazopyrimidine group, but embodiments of the present disclosure are not limited thereto.

In Formula 2F, $X_3$ may be O, S, Se, or $N(R_3)$, $X_4$ may be N or $C(R_4)$, and $X_5$ may be N or $C(R_5)$.

In one embodiment, $X_3$ may be O or S, and $X_5$ may be $C(R_5)$.

In one or more embodiments, $X_3$ may be O or S, and $X_4$ may be N.

In one or more embodiments, $X_4$ may be N, and $X_5$ may be $C(R_5)$.

In one or more embodiments, $X_4$ may be $C(R_4)$, and $X_5$ may be $C(R_5)$.

In Formula 2F, descriptions for $R_1$ to $R_5$ and $R_{21}$ are each independently the same as descriptions for $R_4$ of Formula 1A.

In Formula 2F, a1 and a21 each indicate the number of $R_1$ and the number of $R_{21}$, respectively, and may each independently be an integer from 0 to 20 (for example, an integer from 0 to 10 or an integer from 0 to 5). When a1 is two or more, two or more $R_1$ may be identical to or different from each other, and when a21 is two or more, two or more $R_{21}$ may be identical to or different from each other.

In Formula 2F, ring $CY_1$ and $R_2$ are not linked to each other, and $R_1$ and $R_2$ are not linked to each other.

In one embodiment, a group represented by

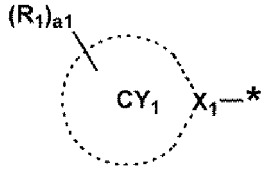

in Formula 2F may be a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, or a monovalent non-aromatic condensed heteropolycyclic group, each unsubstituted or substituted with $R_1$ in the number of a1.

In Formula 2F, $R_1$ and $R_2$ may each independently be:

hydrogen, deuterium, -F, -Cl, -Br, -I, a cyano group, or $-SF_5$; or
a $C_1$-$C_{60}$ alkyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, or a monovalent non-aromatic condensed heteropolycyclic group, each unsubstituted or substituted with a deuterium, -F, -Cl, -Br, -I, $-CD_3$, $-CD_2H$, $-CDH_2$, $-CF_3$,$-CF_2H$, $-CFH_2$, a cyano group, a $C_1$-$C_{20}$ alkyl group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a phenyl group, a biphenyl group, a naphthyl group, a pyridinyl group, or a pyrimidinyl group, and
a1 may be an integer from 0 to 10.

In one or more embodiments, a group represented by

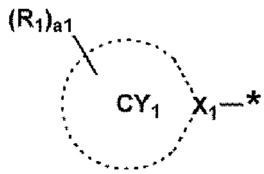

in Formula 2F may be a phenyl group, a biphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each unsubstituted or substituted with an $R_1$ in the number of a1,

In Formula 2F, $R_1$ and $R_2$ may each independently be:

hydrogen, deuterium, -F, -Cl, -Br, -I, a cyano group, or $-SF_5$; or
a methyl group, an ethyl group, a propyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decanyl group, an isodecanyl group, a sec-decanyl group, a tert-decanyl group, a $C_1$-$C_{10}$ alkoxy, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a phenyl group, a biphenyl group, a naphthyl group, a pyridinyl group, a pyrimidinyl group, a dibenzofuranyl group, or a dibenzothiophenyl group, each unsubstituted or substituted with a deuterium, -F, -Cl, -Br, -I, $-CD_3$, $-CD_2H$, $-CDH_2$, $-CF_3$, $-CF_2H$, $-CFH_2$, a cyano group, a $C_1$-$C_{20}$ alkyl group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a phenyl group, a biphenyl group, a naphthyl group, a pyridinyl group, a pyrimidinyl group, a dibenzofuranyl group, or a dibenzothiophenyl group, and a1 may be an integer from 0 to 5, but embodiments of the present disclosure are not limited thereto.

In one or more embodiments, a group represented by

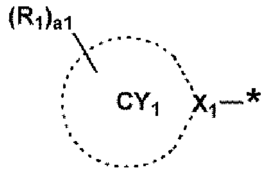

in Formula 2F may be a group represented by one of Formulae 10-13(1) to 10-13(18) or 10-13:

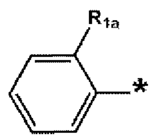
10-13(1)

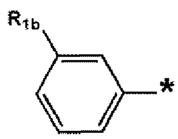
10-13(2)

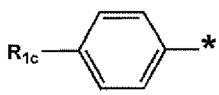
10-13(3)

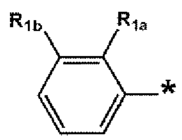
10-13(4)

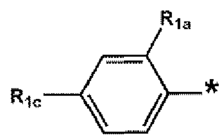
10-13(5)

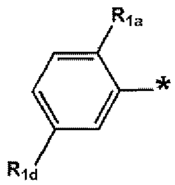
10-13(6)

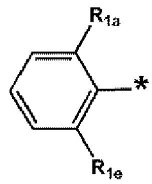
10-13(7)

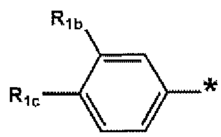
10-13(8)

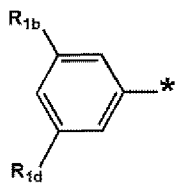
10-13(9)

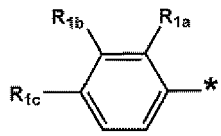
10-13(10)

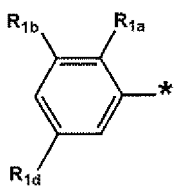
10-13(11)

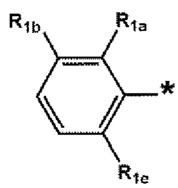
10-13(12)

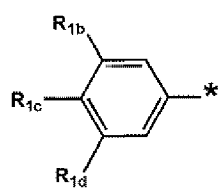
10-13(13)

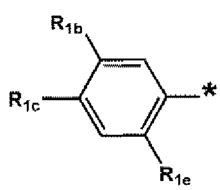
10-13(14)

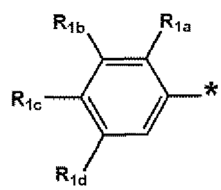
10-13(15)

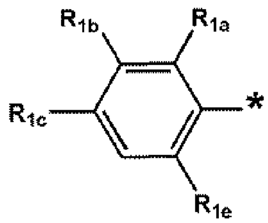

10-13(16)

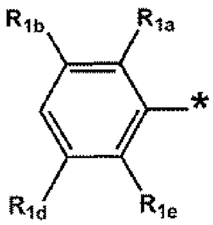

10-13(17)

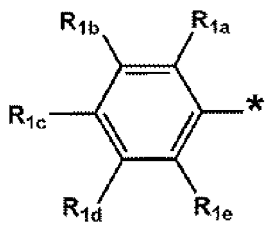

10-13(18)

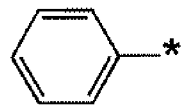

10-13

.

In Formulae 10-13(1) to 10-13(18) and 10-13, $R_{1a}$ to $R_{1e}$ may each independently the same as defined in connection with $R_1$ of Formula 1F wherein $R_{1a}$ to $R_{1e}$ may each independently not be hydrogen, and * indicates a binding site to a neighboring atom.

In one or more embodiments, in Formula 2F,

$X_4$ may be $C(R_4)$, and
R4 may be hydrogen, deuterium, -F, -Cl, -Br, -I, $-SF_5$, a cyano group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group,$-N(Q_1)(Q_2)$, $-Si(Q_3)(Q_4)(Q_5)$, $-B(Q_6)(Q_7)$, or $-P(=O)(Q_8)(Q_9)$.

In one or more embodiments, in Formula 2F,

$X_4$ may be $C(R_4)$, and
$R_4$ may be a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group.

In one or more embodiments, in Formula 2F, $X_4$ may be N.

For example, a group represented by

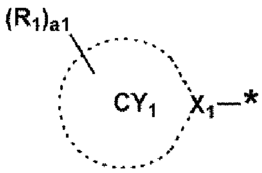

in Formula 2F may be a group represented by any one of Formulae 10-1 to 10-118, a group represented by any one of Formulae 10-1 to 10-118 in which at least one hydrogen is substituted with deuterium, a group represented by any one of Formulae 10-201 to 10-342, or a group represented by any one of Formulae 10-201 to 10-342 in which at least one hydrogen is substituted with deuterium, and/or $R_1$ to $R_5$ and $R_{21}$ may each independently be hydrogen, deuterium, -F, a cyano group, a nitro group, $-SF_5$, $-CH_3$, $-CD_3$, $-CD_2H$, $-CDH_2$, $-CF_3$, $-CF_2H$, $-CFH_2$, a group represented by any one of Formulae 9-1 to 9-66, a group represented by any one of Formulae 9-1 to 9-66 in which at least one hydrogen is substituted with deuterium, a group represented by any one of Formulae 10-1 to 10-118, a group represented by any one of Formulae 10-1 to 10-118 in which at least one hydrogen is substituted with deuterium, a group represented by any one of Formulae 10-201 to 10-342, a group represented by any one of Formulae 10-201 to 10-342 in which at least one hydrogen is substituted with deuterium, or $-Si(Q_3)(Q_4)(Q_5)$ (wherein $Q_3$ to $Q_5$ are the same as described herein). Above Formulae 9-1 to 9-66, 10-1 to 10-118 and 10-201 to 10-342 are the same as described in connection with Formula 1A.

In Formula 2F, $R_4$ and $R_5$ may optionally be linked to form a $C_5$-$C_{30}$ carbocyclic group that is unsubstituted or substituted with $R_{10a}$ or a $C_1$-$C_{30}$ heterocyclic group that is unsubstituted or substituted with $R_{10a}$, a plurality of neighboring $R_{21}$ may optionally be linked to form a $C_5$-$C_{30}$ carbocyclic group that is unsubstituted or substituted with $R_{10a}$ or a $C_1$-$C_{30}$

heterocyclic group that is unsubstituted or substituted with $R_{10a}$, and $R_{10a}$ may be the same as defined in connection with $R_{21}$. The $C_5$-$C_{30}$ carbocyclic group and the $C_1$-$C_{30}$ heterocyclic group may each independently be the same as described elsewhere herein. Descriptions for $R_{10a}$ are the same as descriptions for $R_{21}$ of Formula 1F.

In Formula 2F, * and *' each indicate a binding site to M in Formula 1F.

A group represented by

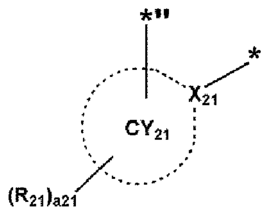

in Formula 2F may be a group represented by one of Formulae CY21-1 to CY21-31:

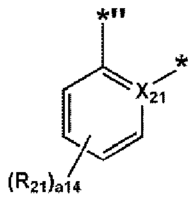

CY21-1

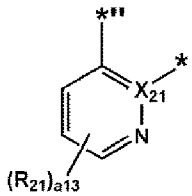

CY21-2

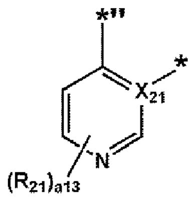

CY21-3

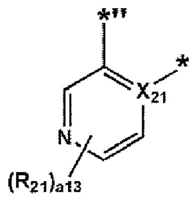

CY21-4

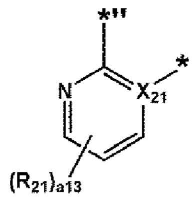

CY21-5

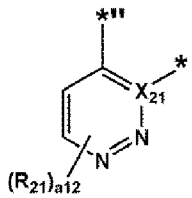

CY21-6

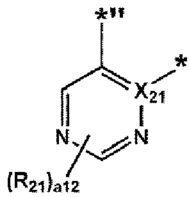

CY21-7

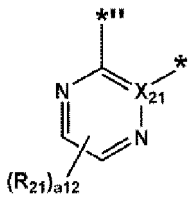

CY21-8

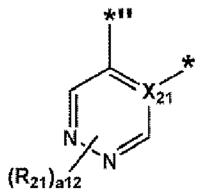

CY21-9

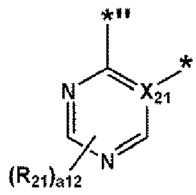

CY21-10

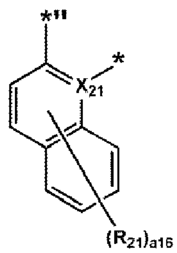

CY21-11

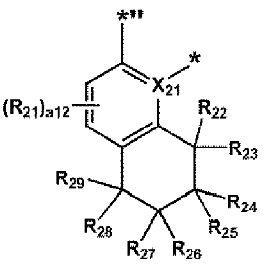

CY21-12

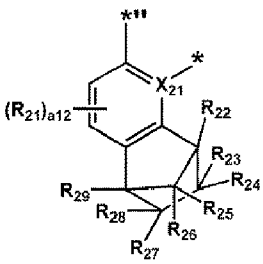

CY21-13

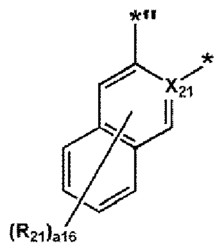

CY21-14

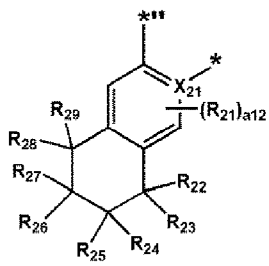

CY21-15

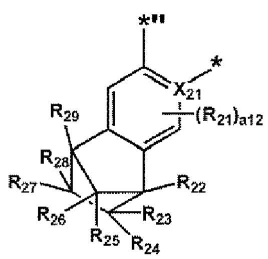

CY21-16

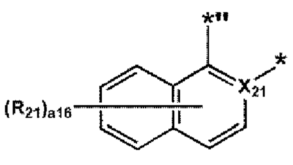

CY21-17

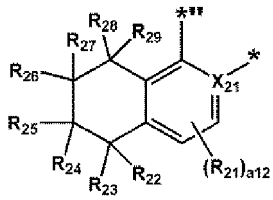

CY21-18

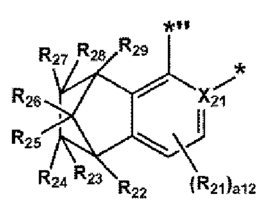

CY21-19

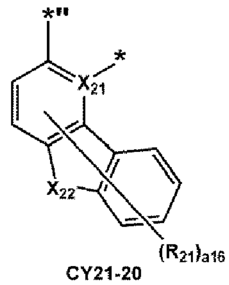

CY21-20

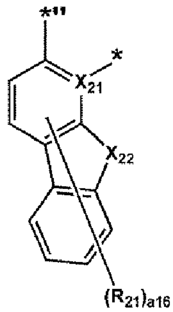

CY21-21

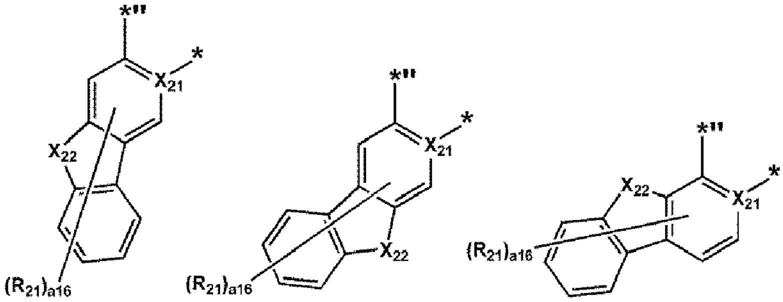

CY21-22 CY21-23 CY21-24

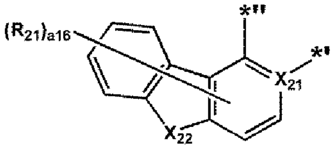

CY21-25

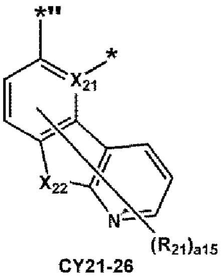

CY21-26

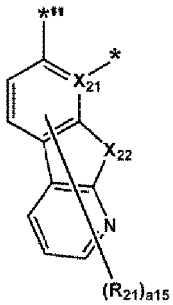

CY21-27

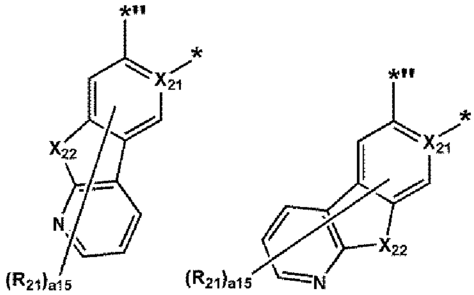

CY21-28 CY21-29

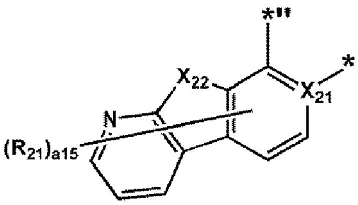

CY21-30

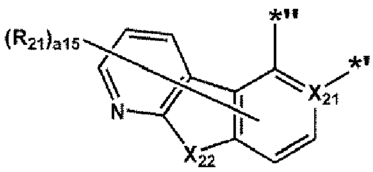

CY21-31

.

In Formulae CY21-1 to CY21-31,

$X_{21}$ and $R_{21}$ may each independently be the same as described in Formula 1F,
$X_{22}$ may be $C(R_{22})(R_{23})$, $N(R_{22})$, O, S, or $Si(R_{22})(R_{23})$,
$R_{22}$ to $R_{29}$ may each independently be the same as defined in connection with $R_{21}$ of Formula 1F,
a16 may be an integer from 0 to 6,
a15 may be an integer from 0 to 5,
a14 may be an integer from 0 to 4,
a13 may be an integer from 0 to 3,
a12 may be an integer from 0 to 2,
*" indicates a binding site to a carbon atom of a neighboring 6-membered ring in Formula 2F, and
* indicates a binding site to M in Formula 1F.

In one embodiment, a group represented by

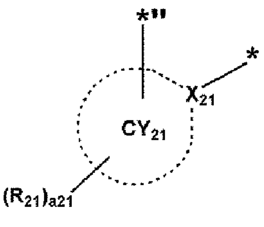

in Formula 2F may be a group represented by Formulae CY21(1) to CY21(56) or a group represented by Formulae CY21-20 to CY21-31:

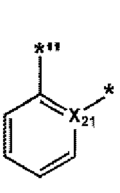
CY21(1)
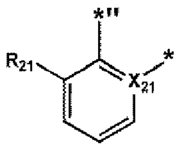
CY21(2)
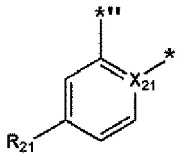
CY21(3)
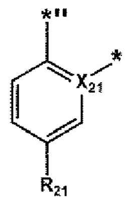
CY21(4)
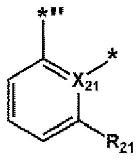
CY21(5)
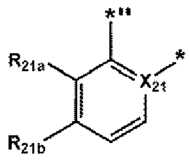
CY21(6)

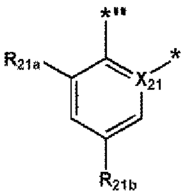
CY21(7)
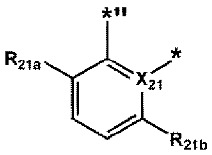
CY21(8)
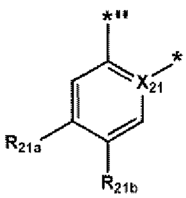
CY21(9)
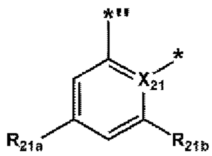
CY21(10)
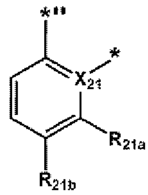
CY21(11)
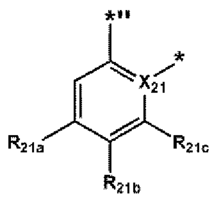
CY21(12)

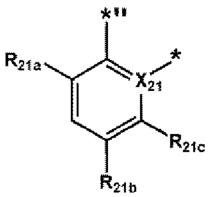
CY21(13)
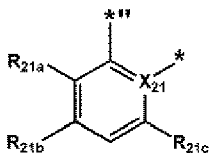
CY21(14)
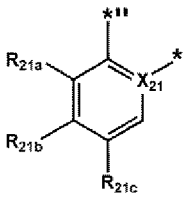
CY21(15)
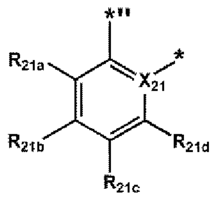
CY21(16)
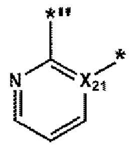
CY21(17)
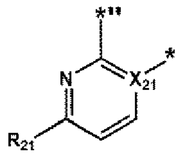
CY21(18)

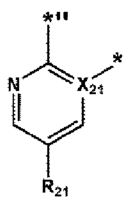
CY21(19)
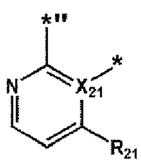
CY21(20)
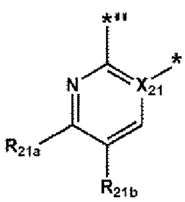
CY21(21)
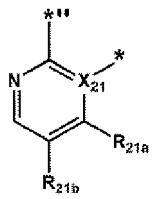
CY21(22)
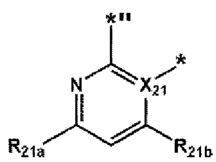
CY21(23)
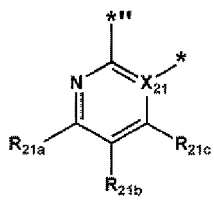
CY21(24)

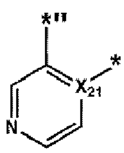
CY21(25)
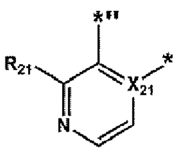
CY21(26)
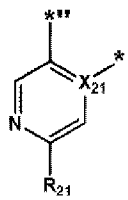
CY21(27)
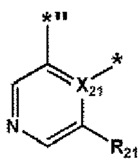
CY21(28)
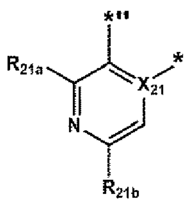
CY21(29)
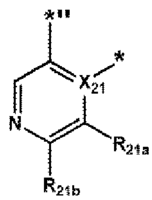
CY21(30)

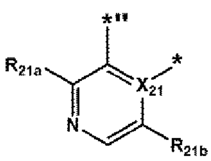
CY21(31)
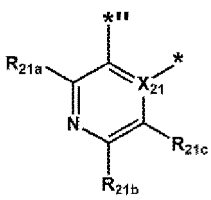
CY21(32)
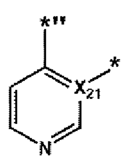
CY21(33)
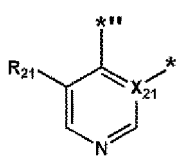
CY21(34)
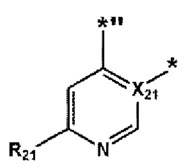
CY21(35)
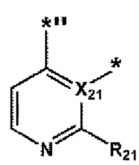
CY21(36)

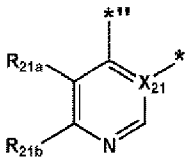
CY21(37)

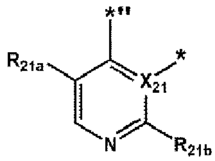
CY21(38)

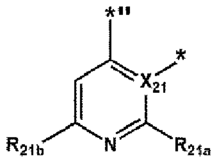
CY21(39)

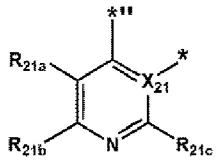
CY21(40)

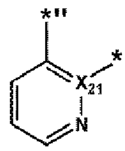
CY21(41)

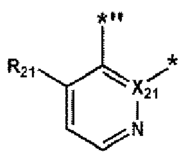
CY21(42)

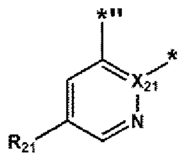
CY21(43)

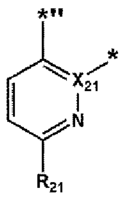
CY21(44)

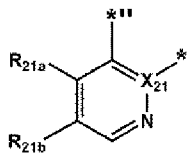
CY21(45)

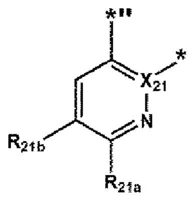
CY21(46)

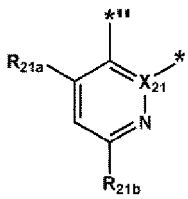
CY21(47)

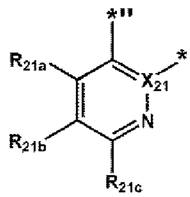
CY21(48)

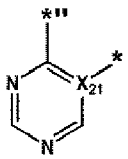
CY21(49)

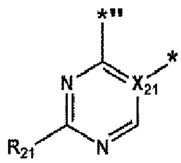
CY21(50)

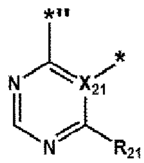
CY21(51)

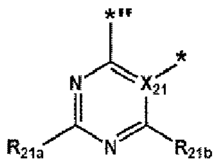
CY21(52)

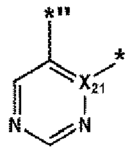
CY21(53)

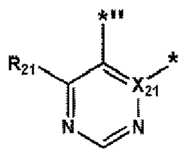
CY21(54)

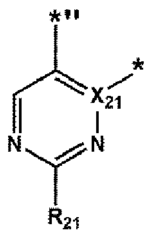
CY21(55)

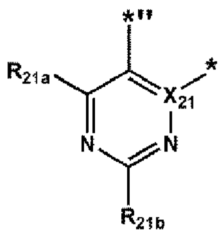
CY21(56).

In Formulae CY21(1) to CY21(56),

$X_{21}$ and $R_{21}$ may each independently be the same as described in Formula 2F,
$R_{21a}$ to $R_{21d}$ may each independently be the same as defined in connection with $R_{21}$ of Formula 2F, wherein $R_{21}$ and $R_{21a}$ to $R_{21d}$ are not each independently hydrogen,
*" indicates a binding site to a carbon atom of a neighboring 6-membered ring in Formula 2F, and
* indicates a binding site to M in Formula 1F.

In Formula 1F, descriptions for $L_2$ are the same as descriptions for $L_2$ of Formula 1H.

Description of Formula 1G

The organometallic compound may be represented by Formula 1G:

Formula 1G $M(L_1)_{n1}(L_2)_{n2}$.

In Formula 1G, descriptions for M, n1 and n2 are each independently the same as the descriptions for M, n1 and n2 of Formula 1F.

In Formula 1G, descriptions for $L_2$ are the same as the descriptions for $L_2$ of Formula 1H.

$L_1$ in Formula 1G may be a ligand represented by Formula 2G:

Formula 2G

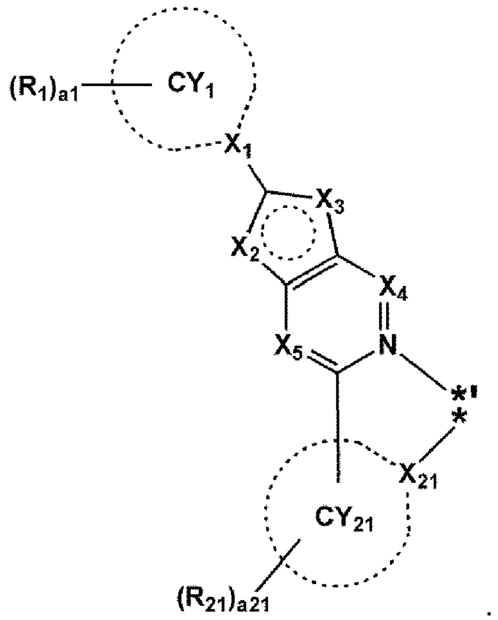

In Formula 2G, descriptions for $X_1$, $X_{21}$, ring $CY_1$, ring $CY_2$, $X_4$, $X_5$, $R_1$, $R_4$, $R_5$, $R_{21}$, a1 and a21 are each independently the same as $X_1$, $X_{21}$, ring $CY_1$, ring $CY_2$, $X_4$, $X_5$, $R_1$, $R_4$, $R_5$, $R_{21}$, a1 and a21 of Formula 2F.

In Formula 2G, $X_2$ and $X_3$ may each independently be O, S, Se, or $C(R_2)$, and one selected from $X_2$ and $X_3$ may be O, S, or Se. Descriptions for $R_2$ are the same as the descriptions for $R_{21}$ Formula 2F.

For example, in Formula 2G, i) $X_2$ may each independently be O, S or Se and $X_3$ may be $C(R_2)$; or ii) $X_2$ may be or $C(R_2)$ and $X_3$ may each independently be O, S or Se.

[0297] * and *' each indicate a binding site to M in Formula 1G.

In an embodiment, in Formula 1G, $L_1$ may be a ligand represented by Formula 2GA or 2GB, but embodiments of the present disclosure are not limited thereto:

Formula 2GA

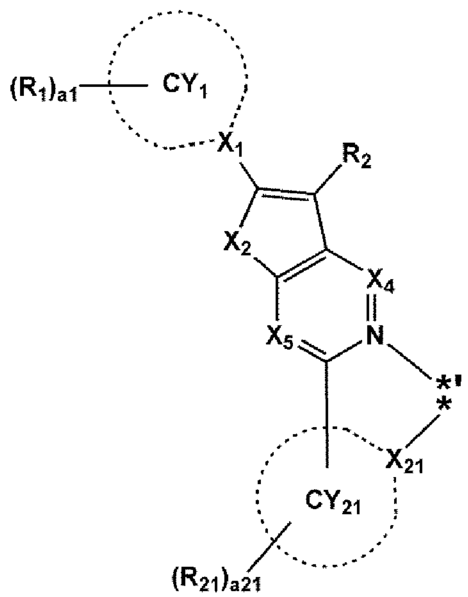

Formula 2GB

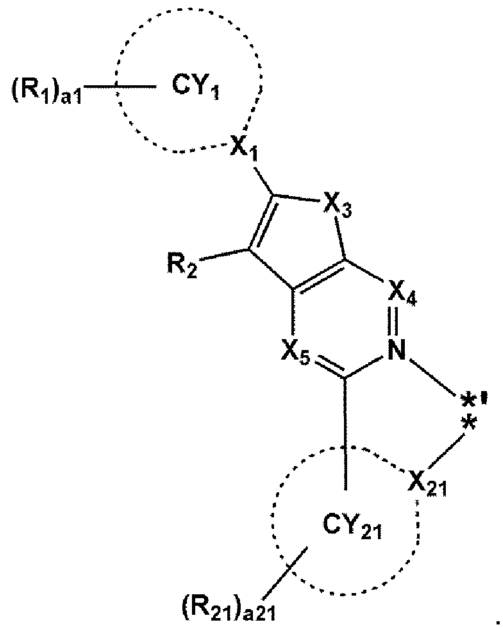

In Formulae 2GA and 2GB, $X_1$, $X_{21}$, ring $CY_1$, ring $CY_{21}$, $X_4$, $X_5$, $R_1$, $R_2$, a1, a21, *, and *' are each independently the same as described in Formula 1G, and $X_2$ and $X_3$ may be O, S, or Se.

Description of Formula 1H

The organometallic compound may be represented by Formula 1H:

Formula 1H $M(L_1)_{n1}(L_2)_{n2}$.

In Formula 1H, descriptions for M, n1 and n2 are each independently the same as M, n1 and n2 of Formula 1F.

$L_1$ in Formula 1H may be a ligand represented by Formula 2H:

Formula 2H

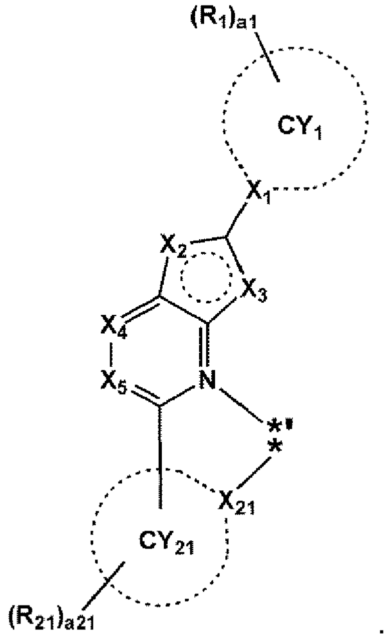

In Formula 2H, descriptions for $X_1$, $X_{21}$, ring $CY_1$, ring $CY_2$, $X_4$, $X_5$, $R_1$, $R_4$, $R_5$, $R_{21}$, a1 and a21 are each independently the same as the descriptions for $X_1$, $X_{21}$, ring $CY_1$, ring $CY_2$, $X_4$, $X_5$, $R_1$, $R_4$, $R_5$, $R_{21}$, a1 and a21 of Formula 2F.

In Formula 2H, $X_2$ and $X_3$ may each independently be O, S, Se, or $C(R_2)$, and one selected from $X_2$ and $X_3$ may be O, S, or Se. Descriptions for $R_2$ are the same as the descriptions for $R_{21}$ of Formula 2F.

For example, in Formula 2H, i) $X_2$ may each independently be O, S or Se and $X_3$ may be $C(R_2)$; or ii) $X_2$ may be $C(R_2)$ and $X_3$ may each independently be O, S or Se.

**[0306]** * and *' each indicate a binding site to M in Formula 1H.

In an embodiment, $L_1$ in Formula 1H may be a ligand represented by Formula 2HA or 2HB, but embodiments of the present disclosure are not limited thereto:

Formula 2HA

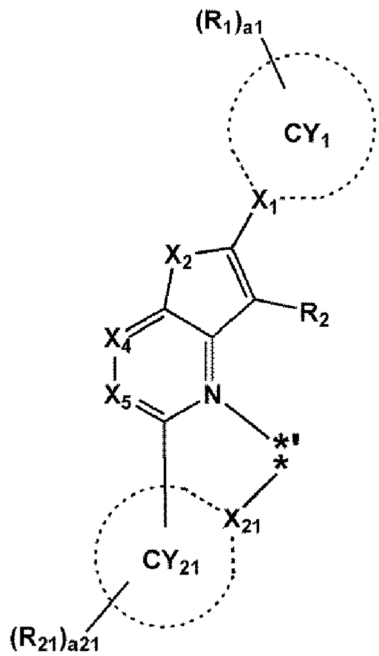

Formula 2HB

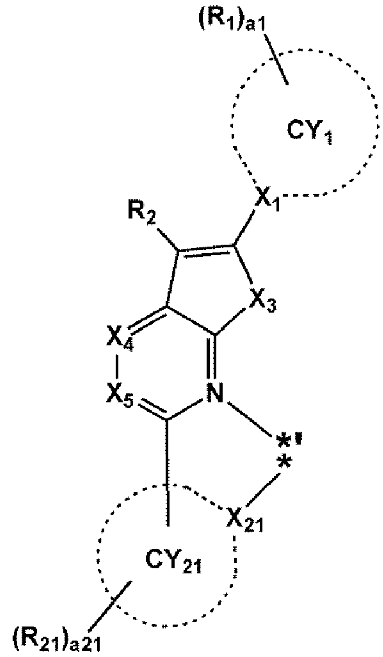

.

In Formulae 2HA and 2HB, $X_1$, $X_{21}$, ring $CY_1$, ring $CY_{21}$, $X_4$, $X_5$, $R_1$, $R_2$, a1, a21, *, and *' are each independently the same as described in Formula 1H, and $X_2$ and $X_3$ may each independently be O, S, or Se.

In Formula 1H, $L_2$ may be selected from bidentate ligands linked to M of Formula 1H via O, S, N, C, P, Si, or As.

In an embodiment, $L_2$ in Formula 1H may be a bidentate ligand represented by Formula 3H:

Formula 3H

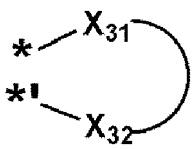

.

In Formula 3H,

$X_{31}$ and $X_{32}$ may each independently be O, S, N, C, P, Si, or As,

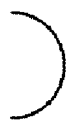

indicates an arbitrary atom group that links $X_{31}$ to $X_{32}$, and
* and *' each indicate a binding site to M in Formula 1H.

For example, in Formula 3H, i) $X_{31}$ and $X_{32}$ may each independently be O; ii) $X_{31}$ may be O, and $X_{32}$ may be N, or iii) $X_{31}$ may be N, and $X_{32}$ may be C, but embodiments of the present disclosure are not limited thereto.

In one or more embodiments, in Formula 1H, $L_2$ may be a group represented by one of Formula 3HA to 3HF:

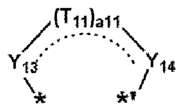
3HA

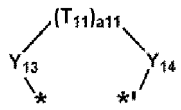
3HB

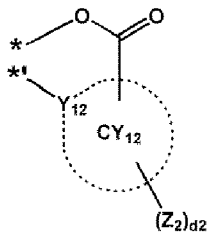
3HC

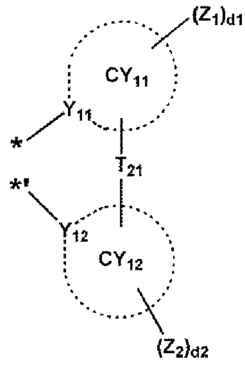
3HD

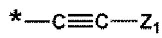
3HE

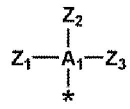
3HF

.

In Formulae 3HA to 3HF,

$Y_{13}$ may be O, N, $N(Z_1)$, $P(Z_1)(Z_2)$, or $AS(Z_1)(Z_2)$,
$Y_{14}$ may be O, N, $N(Z_3)$, $P(Z_3)(Z_4)$, or $As(Z_3)(Z_4)$,
$T_{11}$ may each independently be a single bond, a double bond, *-$C(Z_{11})(Z_{12})$-*', *-$C(Z_{11})=C(Z_{12})$-*', *=$C(Z_{11})$-*', *-$C(Z_{11})$=*', *=$C(Z_{11})-C(Z_{12})=C(Z_{13})$-*', *-$C(Z_{11})=C(Z_{12})-C(Z_{13})$=*', *-$N(Z_{11})$-*', or a $C_5$-$C_{30}$ carbocyclic group unsubstituted or substituted with at least one $Z_{11}$,
a11 may be an integer from 1 to 10,
$Y_{11}$ and $Y_{12}$ may each independently be C or N,
$T_{21}$ may be a single bond, a double bond, O, S, $C(Z_{11})(Z_{12})$, $Si(Z_{11})(Z_{12})$, or $N(Z_{11})$,
ring $CY_{11}$ and ring $CY_{12}$ may each independently be a $C_5$-$C_{30}$ carbocyclic group or a $C_1$-$C_{30}$ heterocyclic group,
$A_1$ may be P or As,
$Z_1$ to $Z_4$ and $Z_{11}$ to $Z_{13}$ are each independently the same as described in connection with $R_{21}$ in Formula 1H,
d1 and d2 may each independently be an integer from 0 to 10, and
* and *' each indicate a binding site to M in Formula 1H.

In Formulae 3HA to 3HF, the $C_5$-$C_{30}$ carbocyclic group and the $C_1$-$C_{30}$ heterocyclic group are each independently the same as described herein.

For example, a group represented by

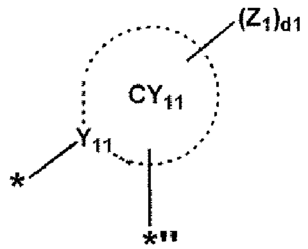

in Formula 3HD may be a group represented by one of Formulae CY11-1 to CY11-34, and/or a group represented by

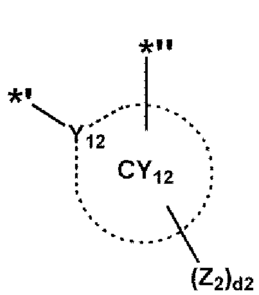

in Formulae 3HC and 3HD may be a group represented by one of Formulae CY12-1 to CY12-34:

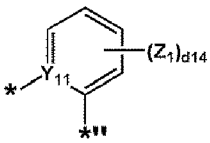
CY11-1

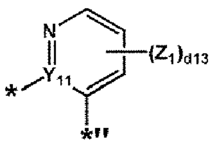
CY11-2

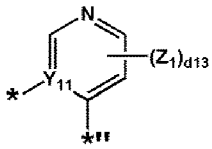
CY11-3

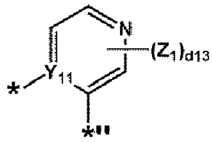
CY11-4

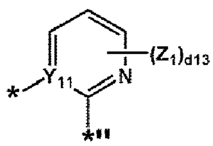
CY11-5

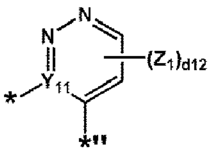
CY11-6

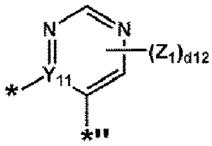
CY11-7

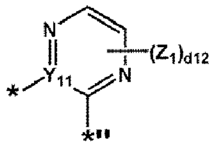
CY11-8

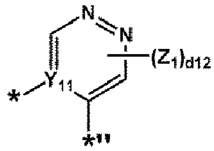
CY11-9

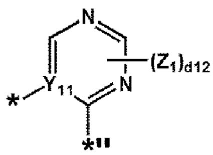
CY11-10

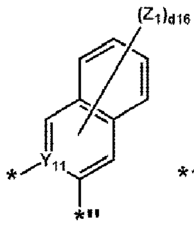
CY11-11

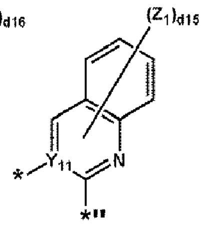
CY11-12

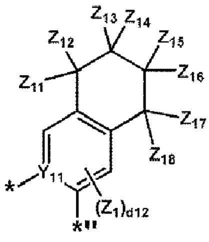
CY11-13

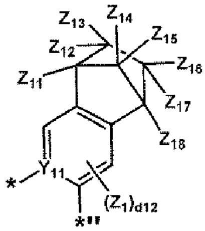
CY11-14

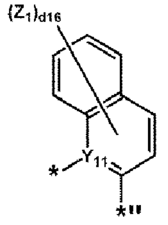
CY11-15

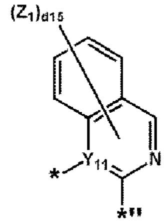
CY11-16

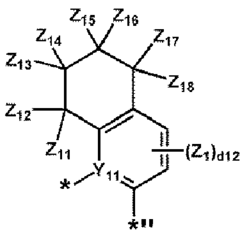
CY11-17

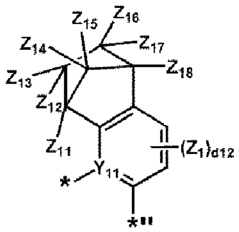
CY11-18

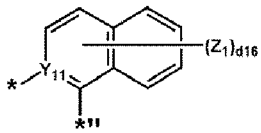
CY11-19

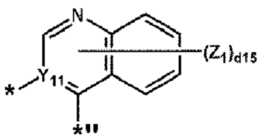
CY11-20

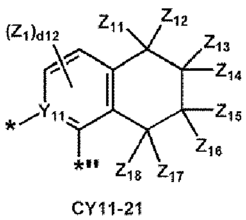
CY11-21

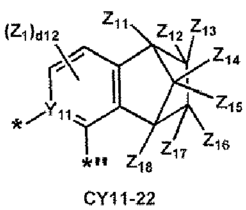
CY11-22

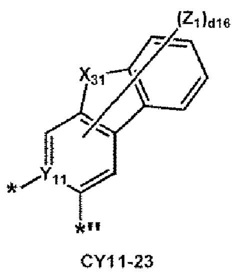
CY11-23

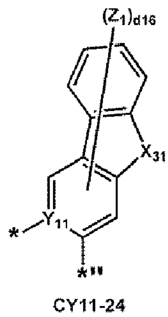
CY11-24

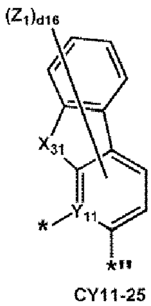
CY11-25

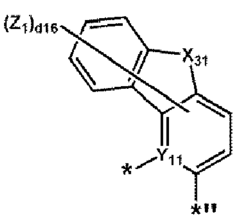
CY11-26

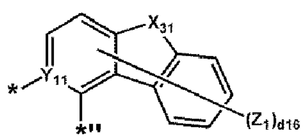
CY11-27

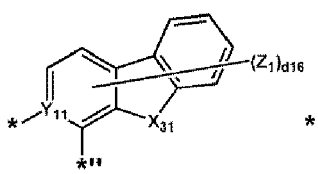
CY11-28

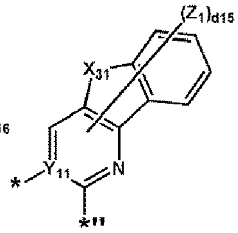
CY11-29

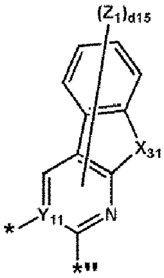
CY11-30

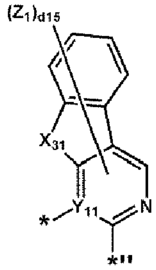
CY11-31

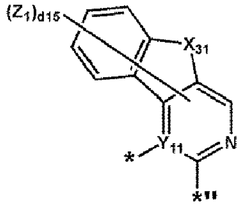
CY11-32

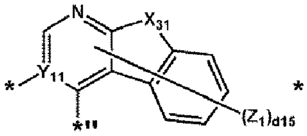
CY11-33

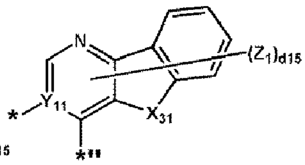
CY11-34

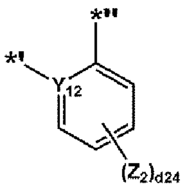
CY12-1

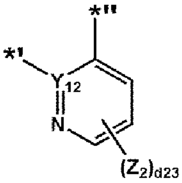
CY12-2

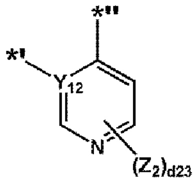
CY12-3

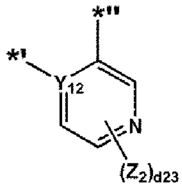
CY12-4

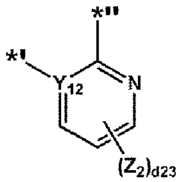
CY12-5

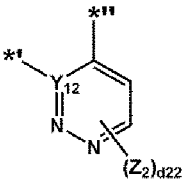
CY12-6

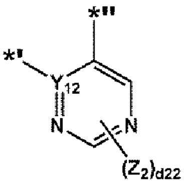
CY12-7

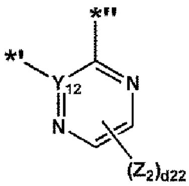
CY12-8

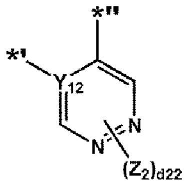
CY12-9

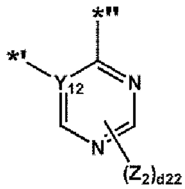
CY12-10

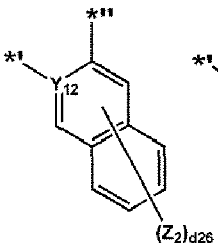
CY12-11

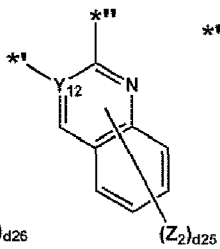
CY12-12

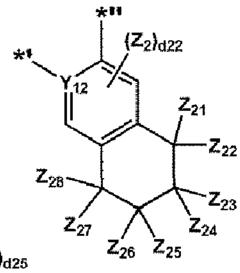
CY12-13

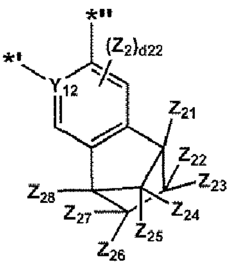
CY12-14

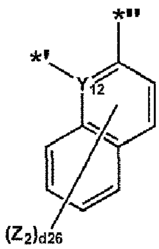
CY12-15

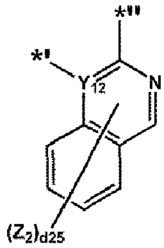
CY12-16

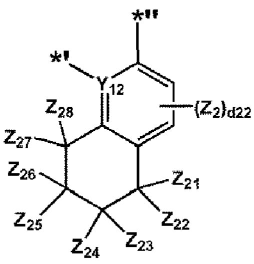
CY12-17

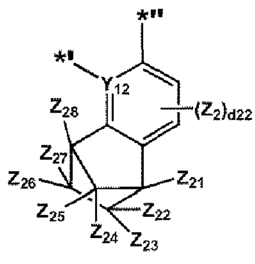
CY12-18

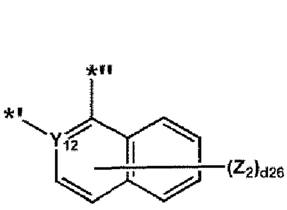
CY12-19

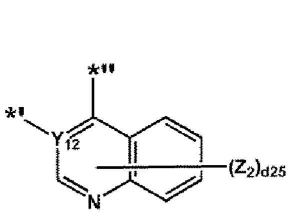
CY12-20

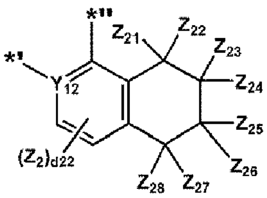
CY12-21

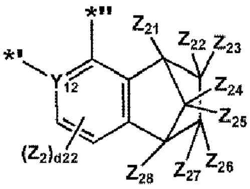
CY12-22

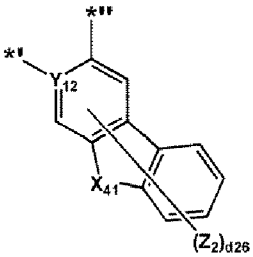
CY12-23

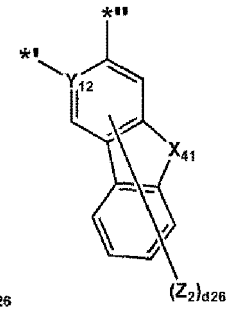
CY12-24

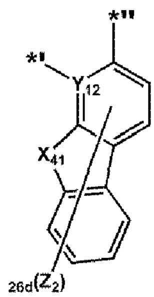
CY12-25

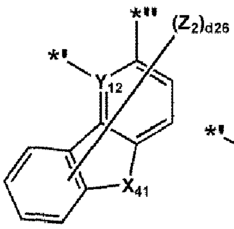
CY12-26

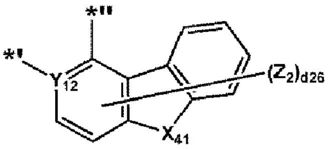
CY12-27

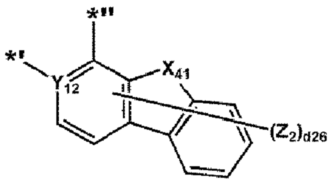
CY12-28

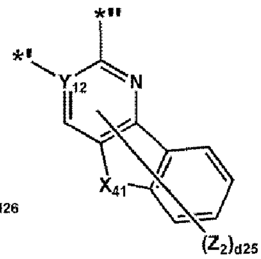
CY12-29

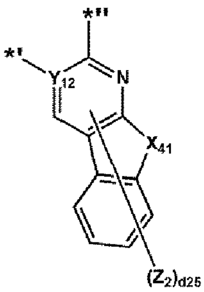
CY12-30

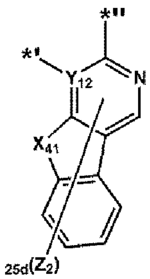
CY12-31

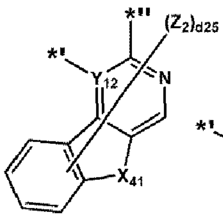
CY12-32

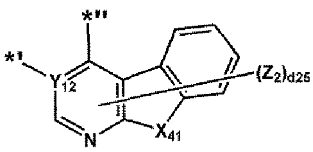
CY12-33

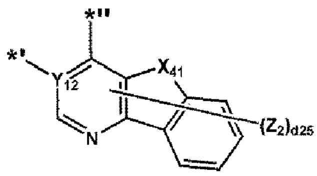
CY12-34

.

In Formulae CY11-1 to CY11-34 and CY12-1 to CY12-34,

$X_{31}$ may be O, S, $N(Z_{11})$, $C(Z_{11})(Z_{12})$, or $Si(Z_{11})(Z_{12})$,
$X_{41}$ may be O, S, $N(Z_{21})$, $C(Z_{21})(Z_{22})$, or $Si(Z_{21})(Z_{22})$,
$Y_{11}$, $Y_{12}$, $Z_1$, and $Z_2$ are each independently the same as described in Formula 1H,
$Z_{11}$ to $Z_{18}$ and $Z_{21}$ to $Z_{28}$ are each independently the same as described in connection with $R_{21}$ in Formula 1H,
d12 and d22 may each independently be an integer from 0 to 2,
d13 and d23 may each independently be an integer from 0 to 3,
d14 and d24 may each independently be an integer from 0 to 4,
d15 and d25 may each independently be an integer from 0 to 5,
d16 and d26 may each independently be an integer from 0 to 6, and
in Formulae CY11-1 to CY11-34 and CY12-1 to CY12-34, * and *' each indicate a binding site to M in Formula 1H, and *" indicates a binding site to a neighboring atom in Formula 3HC or a binding site to $T_{21}$ in Formula 3HD.

In an embodiment, in Formula 1H, $L_2$ may be a group represented by one of Formulae 3-1(1) to 3-1(66) and 3-1(301) to 3-1(309), but embodiments of the present disclosure are not limited thereto:

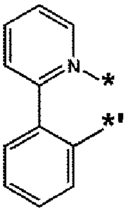
3-1(1)

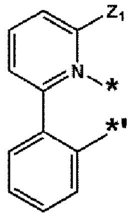
3-1(2)

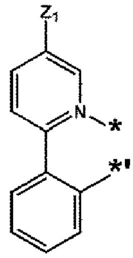
3-1(3)

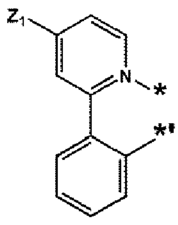
3-1(4)

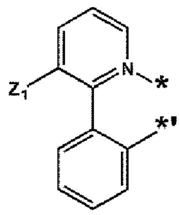
3-1(5)

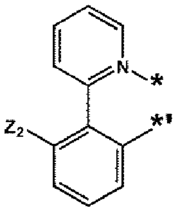
3-1(6)

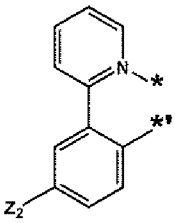
3-1(7)

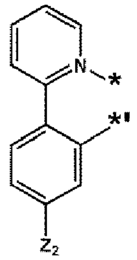
3-1(8)

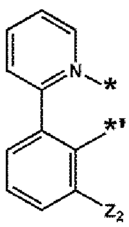
3-1(9)

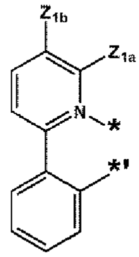
3-1(10)

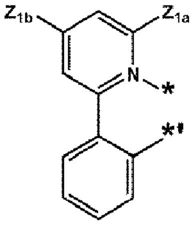
3-1(11)

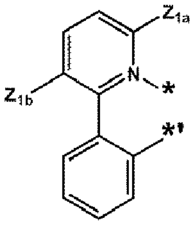
3-1(12)

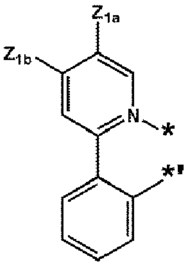
3-1(13)

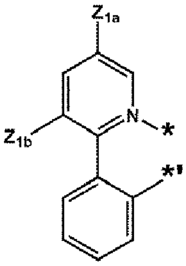
3-1(14)

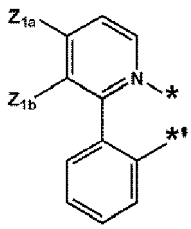
3-1(15)

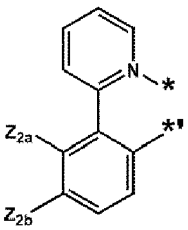
3-1(16)

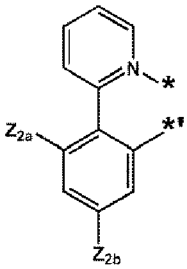
3-1(17)

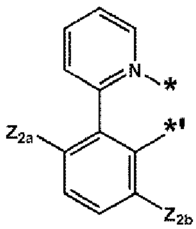
3-1(18)

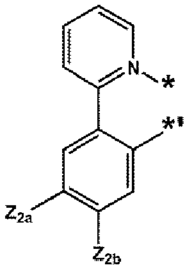
3-1(19)

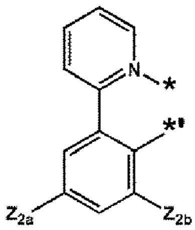
3-1(20)

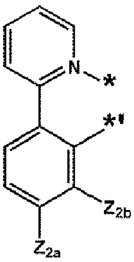
3-1(21)

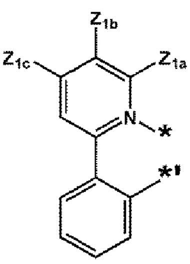
3-1(22)

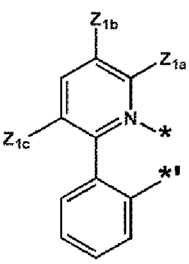
3-1(23)

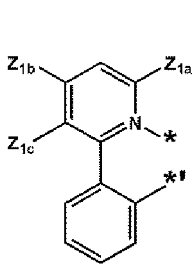
3-1(24)

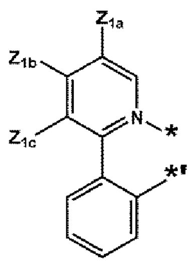
3-1(25)

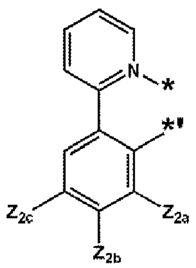
3-1(26)

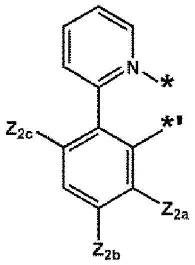
3-1(27)

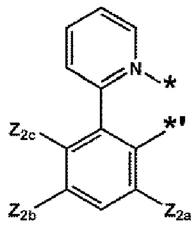
3-1(28)

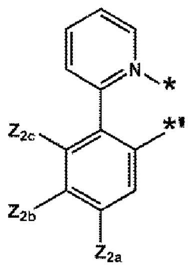
3-1(29)

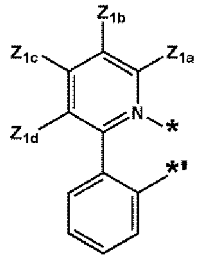
3-1(30)

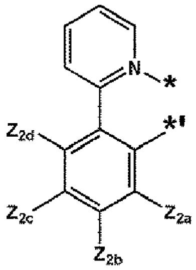
3-1(31)

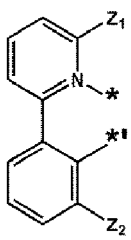
3-1(32)

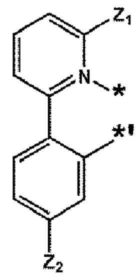
3-1(33)

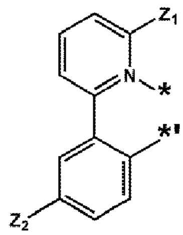
3-1(34)

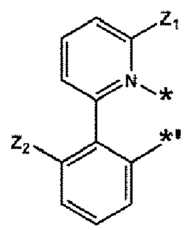
3-1(35)

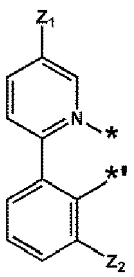
3-1(36)

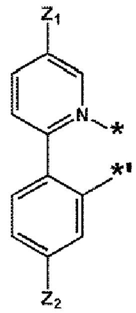
3-1(37)

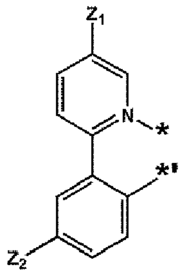
3-1(38)

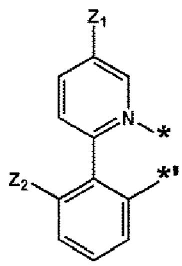
3-1(39)

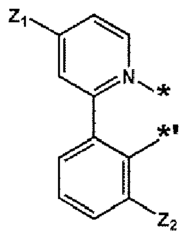
3-1(40)

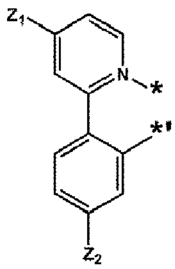
3-1(41)

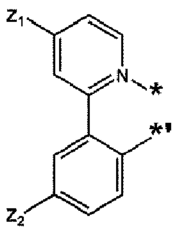
3-1(42)

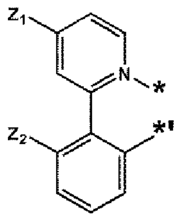
3-1(43)

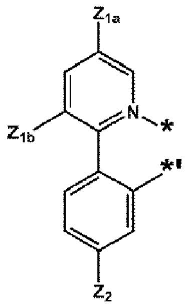
3-1(44)

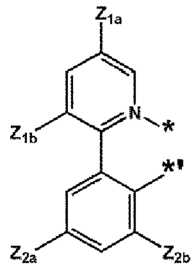
3-1(45)

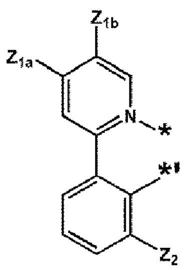
3-1(46)

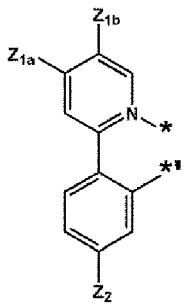
3-1(47)

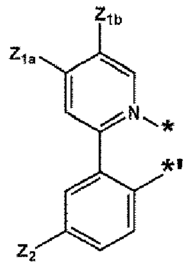
3-1(48)

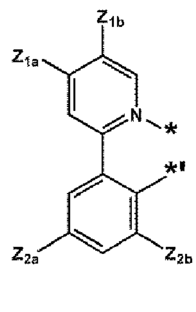
3-1(49)

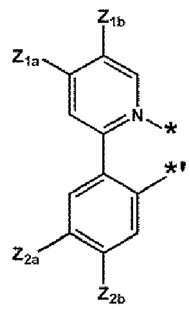
3-1(50)

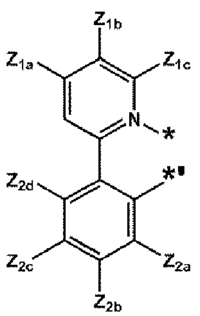
3-1(51)

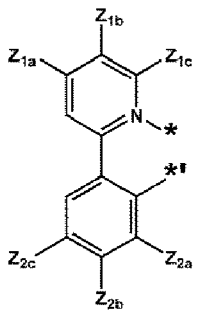
3-1(52)

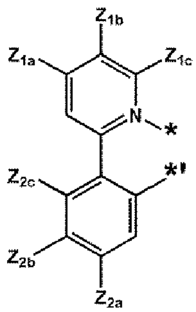
3-1(53)

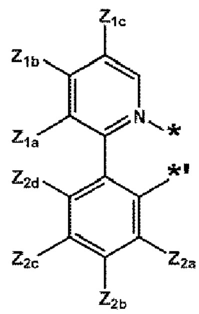
3-1(54)

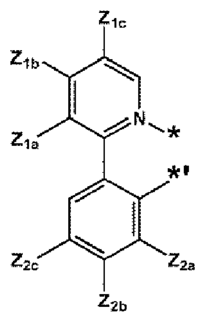
3-1(55)

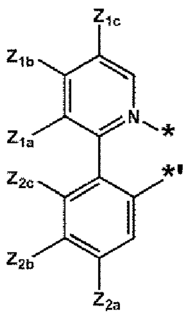
3-1(56)

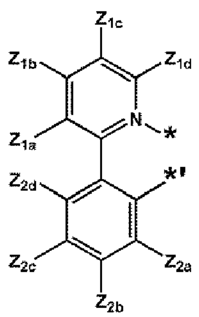
3-1(57)

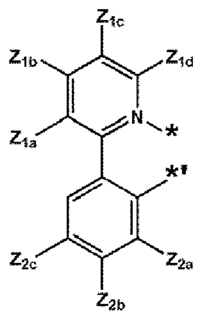
3-1(58)

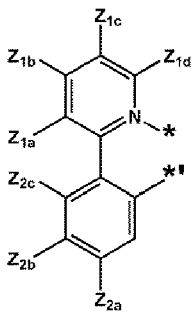
3-1(59)

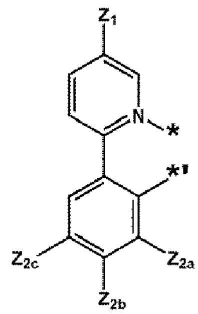
3-1(60)

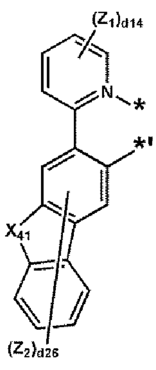
3-1(61)

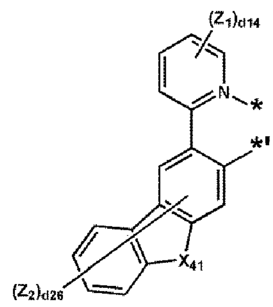
3-1(62)

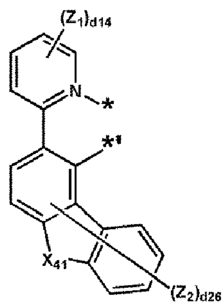
3-1(63)

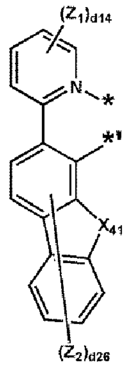
3-1(64)

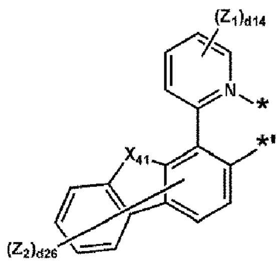
3-1(65)

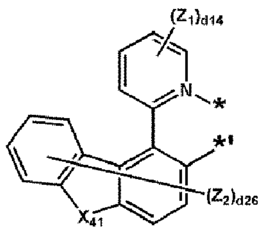

3-1(66)

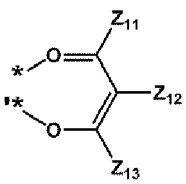

3-1(301)

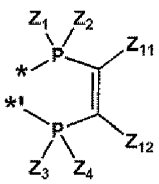

3-1(302)

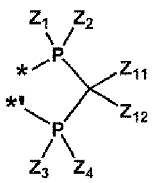

3-1(303)

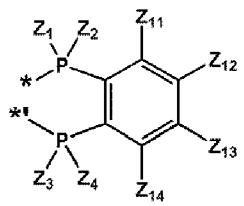

3-1(304)

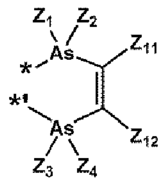

3-1(305)

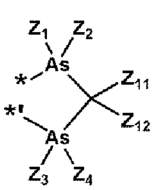

3-1(306)

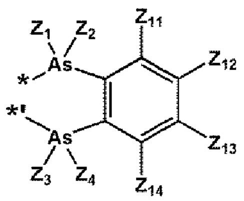

3-1(307)

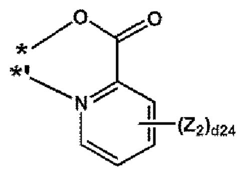

3-1(308)

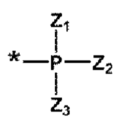

3-1(309)

In Formulae 3-1(1) to 3-1(66) and 3-1(301) to 3-1(309),

$X_{41}$ may be O, S, $N(Z_{21})$, $C(Z_{21})(Z_{22})$, or $Si(Z_{21})(Z_{22})$,
$Z_1$ to $Z_4$, $Z_{1a}$, $Z_{1b}$, $Z_{1c}$, $Z_{1d}$, $Z_{2a}$, $Z_{2b}$, $Z_{2c}$, $Z_{2d}$, and $Z_{11}$ to $Z_{14}$ are each independently the same as described in connection with $R_{21}$ in Formula 1H,
d14 and d24 may each independently be an integer from 0 to 4,
d26 may be an integer from 0 to 6, and
* and *' each indicate a binding site to M in Formula 1H.

Description of Formulae 1I to 1K

The organometallic compound may be represented by one of Formulae 1I to 1K:

Formula 1I

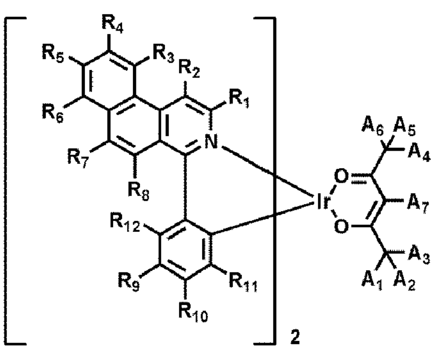

Formula 1J

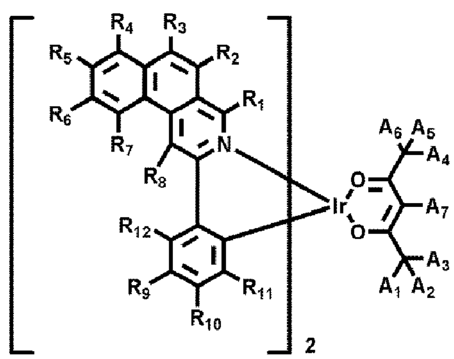

Formula 1K

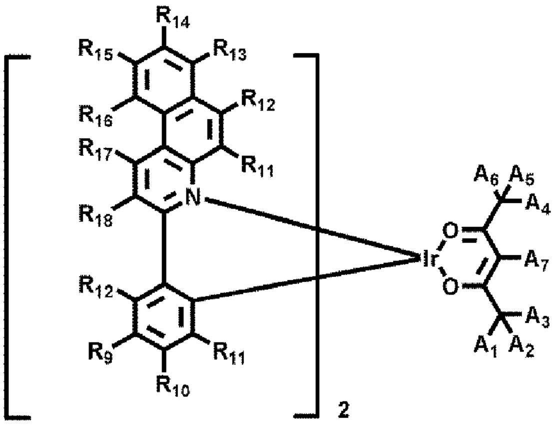

In Formulae 1I to 1K, $R_1$ to $R_{12}$ and $A_7$ may each independently be hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-Ge(Q_3)(Q_4)(Q_5)$,$-B(Q_6)(Q_7)$, $-P(=O)(Q_8)(Q_9)$, or $-P(Q_8)(Q_9)$, wherein $Q_1$ to $Q_9$ are each independently the same as described herein.

In an embodiment, $R_1$ to $R_{12}$ and $A_7$ of Formulae 1I to 1K may each independently be,
hydrogen, deuterium, -F, or a cyano group; or
a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a biphenyl group, a terphenyl group, a naphthyl group, a pyridinyl group, a pyrimidinyl group, a carbazolyl group, a fluorenyl group, a dibenzosilolyl group, a dibenzofuranyl group, or a dibenzothiophenyl group, each unsubstituted or substituted with deuterium, -F, a cyano group, a $C_1$-$C_{20}$ alkyl group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a biphenyl group, a terphenyl group, a naphthyl group, a pyridinyl group, a pyrimidinyl group, a carbazolyl group, a fluorenyl group, a dibenzosilolyl group, a dibenzofuranyl group, a dibenzothiophenyl group, or any combination thereof.

At least one of $R_1$ to $R_{12}$ of Formulae 1I to 1K (for example, one or two of $R_1$ to $R_{12}$) may each independently be -F or a fluorinated $C_1$-$C_{60}$ alkyl group.

In an embodiment, at least one of $R_1$ to $R_8$ of Formulae 1I to 1K (for example, one or two of $R_1$ to $R_8$) may each independently be -F or a fluorinated $C_1$-$C_{20}$ alkyl group.

In an embodiment, at least one of $R_1$ to $R_{12}$ of Formulae 1I to 1K may each independently be:

-F; or
a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a

sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each substituted with at least one -F.

In an embodiment, at least one of $R_2$ to $R_8$ of Formulae 1I to 1K (for example, one or two of $R_2$ to $R_8$) may each independently be -F or a fluorinated $C_1$-$C_{60}$ alkyl group.
In an embodiment, at least one of $R_4$ to $R_6$ of Formulae 1I to 1K (for example, one or two of $R_4$ to $R_6$) may each independently be -F or a fluorinated $C_1$-$C_{60}$ alkyl group.
In an embodiment, in Formulae 1I to 1K,

i) $R_2$ may be -F or a fluorinated $C_1$-$C_{60}$ alkyl group and $R_1$ and $R_3$ to $R_8$ may be hydrogen;
ii) $R_3$ may be -F or a fluorinated $C_1$-$C_{60}$ alkyl group and $R_1$, $R_2$ and $R_4$ to $R_8$ may be hydrogen;
iii) $R_4$ may be -F or a fluorinated $C_1$-$C_{60}$ alkyl group and $R_1$ to $R_3$ and $R_5$ to $R_8$ may be hydrogen;
iv) $R_5$ may be -F or a fluorinated $C_1$-$C_{60}$ alkyl group and $R_1$ to $R_4$ and $R_6$ to $R_8$ may be hydrogen;
v) $R_6$ may be -F or a fluorinated $C_1$-$C_{60}$ alkyl group and $R_1$ to $R_5$, $R_7$ and $R_8$ may be hydrogen;
vi) $R_7$ may be -F or a fluorinated $C_1$-$C_{60}$ alkyl group and $R_1$ to $R_6$ and $R_8$ may be hydrogen;
vii) $R_8$ may be -F or a fluorinated $C_1$-$C_{60}$ alkyl group and $R_1$ to $R_7$ may be hydrogen; or
viii) $R_4$ may be -F or a fluorinated $C_1$-$C_{60}$ alkyl group, $R_5$ may be a $C_1$-$C_{60}$ alkyl group and $R_1$ to $R_3$ and $R_6$ to $R_8$ may be hydrogen.

In one or more embodiments, in Formulae 1I to 1K, $R_9$ and $R_{11}$ may not be hydrogen.
In one or more embodiments, in Formulae 1I to 1K, Rg and $R_{11}$ may not be hydrogen, and $R_{10}$ and $R_{12}$ may be hydrogen.
In one or more embodiments, in Formulae 1I to 1K, Rg and $R_{11}$ may be identical to each other.
In one or more embodiments, in Formulae 1I to 1K, Rg and $R_{11}$ may be different from each other.
In one or more embodiments, in Formulae 1I to 1K, $R_9$ and $R_{11}$ may be different from each other, and the number of carbon atoms included in Rg may be different from the number of carbon atoms included in $R_{11}$.
In one or more embodiments, in Formulae 1I to 1K, $R_9$ and $R_{11}$ may each independently be a substituted or unsubstituted $C_1$-$C_{60}$ alkyl group, or a substituted or unsubstituted $C_3$-$C_{10}$ cycloalkyl group.
In one or more embodiments, in Formulae 1I to 1K,

$R_1$ to $R_{12}$ and $A_7$ may each independently be hydrogen, deuterium, -F, a cyano group, a nitro group, $-SF_5$, $-CH_3$, $-CD_3$, $-CD_2H$, $-CDH_2$, $-CF_3$, $-CF_2H$,$-CFH_2$, a group represented by any one of Formulae 9-1 to 9-66, a group represented by any one of Formulae 9-1 to 9-66 in which at least one hydrogen is substituted with deuterium, a group represented by any one of Formulae 9-1 to 9-66 in which at least one hydrogen is substituted with -F, a group represented by any one of Formulae 10-1 to 10-118, a group represented by any one of Formulae 10-1 to 10-118 in which at least one hydrogen is substituted with deuterium, a group represented by any one of Formulae 10-1 to 10-118 in which at least one hydrogen is substituted with-F, a group represented by any one of Formulae 10-201 to 10-342, a group represented by any one of Formulae 10-201 to 10-342 in which at least one hydrogen is substituted with deuterium, a group represented by any one of Formulae 10-201 to 10-342 in which at least one hydrogen is substituted with -F, or $-Si(Q_3)(Q_4)(Q_5)$ (wherein $Q_3$ to $Q_5$ are the same as described herein), and/or
at least one of $R_1$ to $R_{12}$ may each independently be -F, $-CF_3$, $-CF_2H$,$-CFH_2$, or a group represented by any one of Formulae 9-1 to 9-66 in which at least one hydrogen is substituted with -F.

Above Formulae 9-1 to 9-66, 10-1 to 10-118 and 10-201 to 10-342 are the same as described in connection with Formula 1A.
In Formulae 1I to 1K, $A_1$ to $A_6$ may each independently be hydrogen, deuterium, -F, a cyano group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, or a substituted or unsubstituted monovalent non-aromatic condensed heteropolycyclic group.

Formulae 1l to 1K may satisfy Condition 11, Condition 21, or any combination thereof:

Condition 1l At least one of $A_1$ and $A_4$ includes at least two carbon atoms.
Condition 2l $A_1$ to $A_6$ include at least one carbon atom.

In one or more embodiments, Formulae 1l to 1K may satisfy Condition 1(1)l, Condition 2(1)l, or any combination thereof:

Condition 1(1)l At least one of $A_1$ and $A_4$ may each independently be an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, or a bicyclo[2.2.2]octyl group, each unsubstituted or substituted with deuterium, -F, a cyano group, a $C_1$-$C_{20}$ alkyl group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, or any combination thereof.
Condition 2(1)1 $A_1$ to $A_6$ may each independently be a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, or a bicyclo[2.2.2]octyl group, each unsubstituted or substituted with deuterium, -F, a cyano group, a $C_1$-$C_{20}$ alkyl group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, or any combination thereof.

In one or more embodiments, Formulae 1l to 1K may satisfy Condition 1(2)l, Condition 2(2)1, or any combination thereof:

Condition 1(2)l At least one of $A_1$ and $A_4$ may each independently be a group represented by any one of Formulae 9-1 to 9-66, a group represented by any one of Formulae 9-1 to 9-66 in which at least one hydrogen is substituted with deuterium, or a group represented by any one of Formulae 9-1 to 9-66 in which at least one hydrogen is substituted with -F.
Condition 2(2)1 $A_1$ to $A_6$ may each independently be $-CH_3$, $-CD_3$, $-CD_2H$, $-CDH_2$, $-CF_3$, $-CF_2H$, $-CFH_2$, a group represented by any one of Formulae 9-1 to 9-66, a group represented by any one of Formulae 9-1 to 9-66 in which at least one hydrogen is substituted with deuterium, or a group represented by any one of Formulae 9-1 to 9-66 in which at least one hydrogen is substituted with -F.

Above Formulae 9-1 to 9-66 are the same as described in connection with Formula 1A.
In one or more embodiments, $A_7$ in Formulae 1l to 1K may not be hydrogen.
In one or more embodiments, $A_7$ in Formulae 1l to 1K may be hydrogen, a substituted or unsubstituted $C_1$-$C_{60}$ alkyl group, a substituted or unsubstituted $C_3$-$C_{10}$ cycloalkyl group, a phenyl group or a biphenyl group.
In one or more embodiments, in Formulae 1l to 1K, a group represented by *-C($A_1$)($A_2$)($A_3$) and a group represented by *-C($A_4$)($A_5$)($A_6$) may be identical to each other, and * indicates a binding site to a neighboring atom.
In one or more embodiments, in Formulae 1l to 1K a group represented by *-C($A_1$)($A_2$)($A_3$) and a group represented by *-C($A_4$)($A_5$)($A_6$) may be different from each other, and * indicates a binding site to a neighboring atom.
In Formulae 1l to 1K, 1) two or more of $R_1$ to $R_{12}$ may optionally be linked to form a $C_5$-$C_{30}$ carbocyclic group

unsubstituted or substituted with at least one $R_{1a}$ or a $C_1$-$C_{30}$ heterocyclic group unsubstituted or substituted with at least one $R_{1a}$, and/or 2) two or more of $A_1$ to $A_7$ may optionally be linked to form a $C_5$-$C_{30}$ carbocyclic group unsubstituted or substituted with at least one $R_{1a}$ or a $C_1$-$C_{30}$ heterocyclic group unsubstituted or substituted with at least one $R_{1a}$. Here, $R_{1a}$ is the same as defined in connection with $R_7$ of Formula 11.

In an embodiment, i) two or more of $A_1$ to $A_3$ (for example, all of $A_1$ to $A_3$) in Formulae 1I to 1K may be linked to form a $C_5$-$C_{30}$ carbocyclic group unsubstituted or substituted with at least one $R_{1a}$ or a $C_1$-$C_{30}$ heterocyclic group unsubstituted or substituted with at least one $R_{1a}$ (that is, a group represented by *-C($A_1$)($A_2$)($A_3$) may be a $C_5$-$C_{30}$ carbocyclic group unsubstituted or substituted with at least one $R_{1a}$ or a $C_1$-$C_{30}$ heterocyclic group unsubstituted or substituted with at least one $R_{1a}$), and/or ii) two or more of $A_4$ to $A_6$ (for example, all of $A_4$ to $A_6$) in Formulae 1I to 1K may be linked to form a $C_5$-$C_{30}$ carbocyclic group unsubstituted or substituted with at least one $R_{1a}$ or a $C_1$-$C_{30}$ heterocyclic group unsubstituted or substituted with at least one $R_{1a}$ (that is, a group represented by *-C($A_4$)($A_5$)($A_6$) may be a $C_5$-$C_{30}$ carbocyclic group unsubstituted or substituted with at least one $R_{1a}$ or a $C_1$-$C_{30}$ heterocyclic group unsubstituted or substituted with at least one $R_{1a}$). As described above, since the organometallic compound satisfies Condition 1 related to the PMI diagram and a radiative decay rate of $2.5x10^5$ $s^{-1}$ or more at the "same time", internal quantum emission efficiency and optical orientation may be improved to provide excellent external quantum emission efficiency. Therefore, an electronic device, for example, an organic light-emitting device, which includes the organometallic compound, may have excellent quantum emission efficiency and excellent roll-off ratio, simultaneously.

Synthesis methods of the organometallic compound may be understood by one of ordinary skill in the art in view of the following embodiments.

The organometallic compound is suitable for use in an organic layer of an organic light-emitting device, for example, for use as a dopant in an emission layer of the organic layer. Thus, another aspect provides an organic light-emitting device that includes: a first electrode; a second electrode; and an organic layer that is disposed between the first electrode and the second electrode, the organic layer includes an emission layer, and the organic layer includes at least one organometallic compound.

The organic light-emitting device may have, due to the inclusion of an organic layer including the organometallic compound, excellent quantum emission efficiency and roll-off ratio, simultaneously.

The organometallic compound may be used between a pair of electrodes of an organic light-emitting device. For example, the organometallic compound may be included in the emission layer. In this regard, the organometallic compound may act as a dopant, and the emission layer may further include a host (that is, an amount of the organometallic compound is smaller than an amount of the host).

In one or more embodiments, the emission layer may include a host and a dopant, and the dopant may include the organometallic compound. The dopant may be a red or green phosphorescent dopant.

The expression "(an organic layer) includes at least one organometallic compounds" as used herein may include an embodiment in which "(an organic layer) includes identical organometallic compounds represented by Formula 1A" and an embodiment in which "(an organic layer) includes two or more different organometallic compounds represented by Formula 1A."

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In an embodiment, in the organic light-emitting device, the first electrode may be an anode, the second electrode may be a cathode, and the organic layer may further include a hole transport region disposed between the first electrode and the emission layer and an electron transport region disposed between the emission layer and the second electrode, wherein the hole transport region may include a hole injection layer, a hole transport layer, an electron blocking layer, or any combination thereof, and wherein the electron transport region may include a hole blocking layer, an electron transport layer, an electron injection layer, or any combination thereof.

The term "organic layer" as used herein refers to a single layer and/or a plurality of layers between the first electrode and the second electrode of the organic light-emitting device. The "organic layer" may include, in addition to an organic compound, an organometallic complex including metal.

FIG. 2 is a schematic view of an organic light-emitting device 10 according to an embodiment. Hereinafter, the structure of an organic light-emitting device according to an embodiment and a method of manufacturing an organic light-emitting device according to an embodiment will be described in connection with FIG. 2. The organic light-emitting device 10 includes a first electrode 11, an organic layer 15, and a second electrode 19, which are sequentially stacked.

A substrate may be additionally disposed under the first electrode 11 or above the second electrode 19. For use as the substrate, any substrate that is used in general organic light-emitting devices may be used, and the substrate may be a glass substrate or a transparent plastic substrate, each having excellent mechanical strength, thermal stability, transparency, surface smoothness, ease of handling, and water resistance.

The first electrode 11 may be formed by depositing or sputtering a material for forming the first electrode 11 on the substrate. The first electrode 11 may be an anode. The material for forming the first electrode 11 may be a high

work function to facilitate hole injection. The first electrode 11 may be a reflective electrode, a semi-transmissive electrode, or a transmissive electrode. The material for forming the first electrode may be, for example, indium tin oxide (ITO), indium zinc oxide (IZO), tin oxide ($SnO_2$), and zinc oxide (ZnO). In one or more embodiments, magnesium (Mg), aluminum (Al), aluminum-lithium (Al-Li), calcium (Ca), magnesium-indium (Mg-In), or magnesium-silver (Mg-Ag) may be used as the material for forming the first electrode.

The first electrode 11 may have a single-layered structure or a multi-layered structure including two or more layers. For example, the first electrode 11 may have a three-layered structure of ITO/Ag/ITO, but the structure of the first electrode 110 is not limited thereto.

The organic layer 15 is disposed on the first electrode 11.

The organic layer 15 may include a hole transport region, an emission layer, and an electron transport region.

The hole transport region may be disposed between the first electrode 11 and the emission layer.

The hole transport region may include a hole injection layer, a hole transport layer, an electron blocking layer, a buffer layer, or any combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, which are sequentially stacked in this stated order from the first electrode 11.

A hole injection layer may be formed on the first electrode 11 by using one or more suitable methods selected from vacuum deposition, spin coating, casting, or Langmuir-Blodgett (LB) deposition.

When a hole injection layer is formed by vacuum deposition, the deposition conditions may vary according to a compound that is used to form the hole injection layer, and the structure and thermal characteristics of the hole injection layer. For example, the deposition conditions may include a deposition temperature of about 100 to about 500°C, a vacuum pressure of about $10^{-8}$ torr to about $10^{-3}$ torr, and a deposition rate of about 0.01 Angstroms per second (Å/sec) to about 100 Å/sec. However, the deposition conditions are not limited thereto.

When the hole injection layer is formed using spin coating, coating conditions may vary according to the material used to form the hole injection layer, and the structure and thermal properties of the hole injection layer. For example, a coating speed may be from about 2,000 revolutions per minute (rpm) to about 5,000 rpm, and a temperature at which a heat treatment is performed to remove a solvent after coating may be from about 80°C to about 200°C. However, the coating conditions are not limited thereto.

Conditions for forming a hole transport layer and an electron blocking layer may be understood by referring to conditions for forming the hole injection layer.

The hole transport region may include m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzene sulfonic acid (PANI/DBSA), poly(3,4-ethylenedioxythiophene)/poly(4-styrene sulfonate) (PEDOT/PSS), polyaniline/camphor sulfonic acid (PANI/CSA), polyaniline/poly(4-styrene sulfonate) (PANI/PSS), a compound represented by Formula 201 below, a compound represented by Formula 202 below, or any combination thereof:

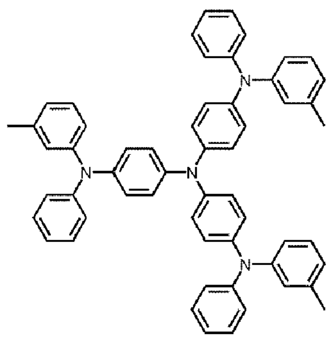
m-MTDATA

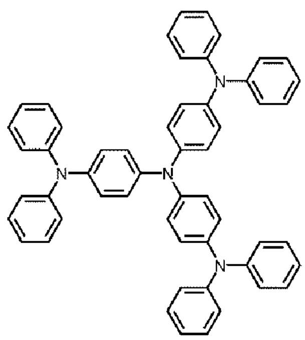
TDATA

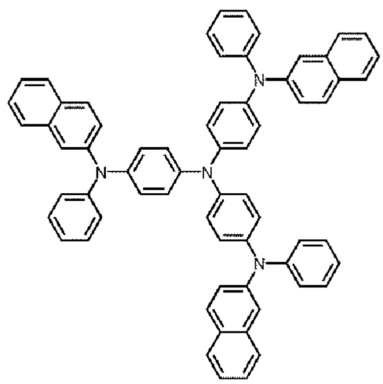
2-TNATA

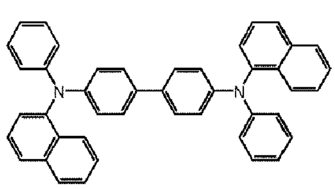

NPB

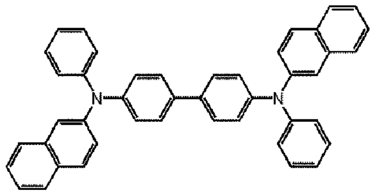

β-NPB

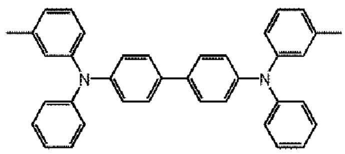

TPD

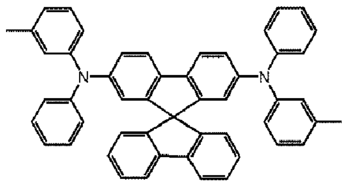

Spiro-TPD

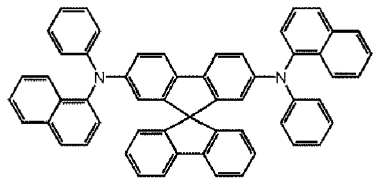

Spiro-NPB

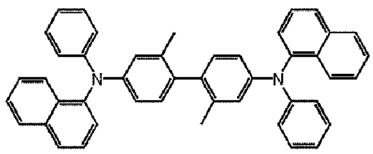

methylated NPB

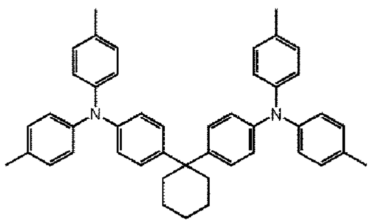

TAPC

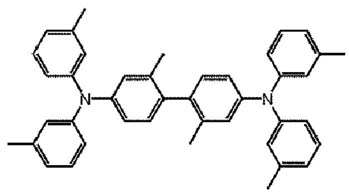

HMTPD

Formula 201

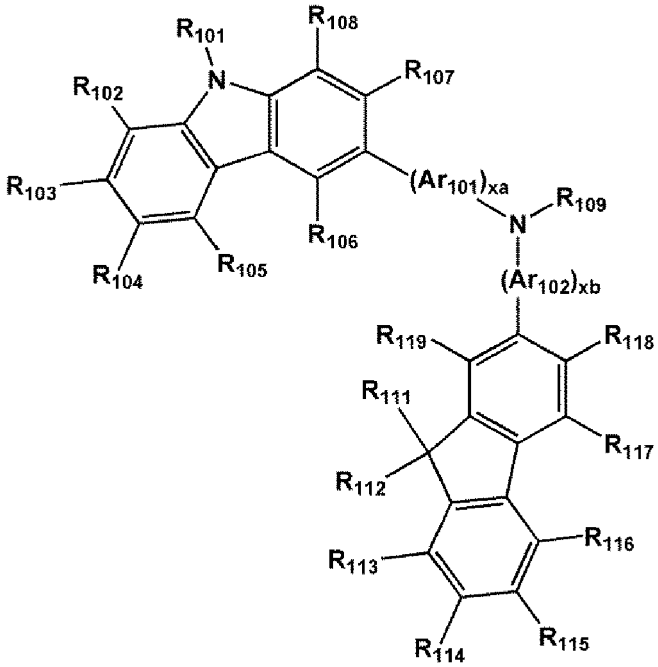

Formula 202

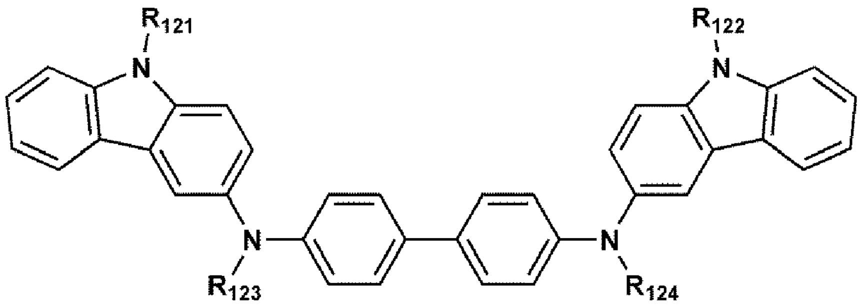

$Ar_{101}$ and $Ar_{102}$ in Formula 201 may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, or any combination thereof.

In Formula 201, xa and xb may each independently be an integer from 0 to 5, or may be 0, 1, or 2. For example, xa is 1 and xb is 0, but xa and xb are not limited thereto.

In Formulae 201 and 202, $R_{101}$ to $R_{108}$, $R_{111}$ to $R_{119}$, and $R_{121}$ to $R_{124}$ may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (for example, a methyl group, an ethyl group, a propyl group, a butyl group, a pentyl group, a hexyl group, and so on), or a $C_1$-$C_{10}$ alkoxy group (for example, a methoxy group, an ethoxy group, a propoxy group, a butoxy group, a pentoxy group, and so on);

a $C_1$-$C_{10}$ alkyl group or a $C_1$-$C_{10}$ alkoxy group, each substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or any combination thereof;

a phenyl group, a naphthyl group, an anthracenyl group, a fluorenyl group, or a pyrenyl group, each unsubstituted or substituted with deuterium, - F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group,a $C_1$-$C_{10}$ alkoxy group, or any combination thereof,

but embodiments of the present disclosure are not limited thereto.

In Formula 201, $R_{109}$ may be a phenyl group, a naphthyl group, an anthracenyl group, or a pyridinyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, a pyridinyl group, or any combination thereof.

In an embodiment, the compound represented by Formula 201 may be represented by Formula 201A, but embodiments of the present disclosure are not limited thereto:

Formula 201A

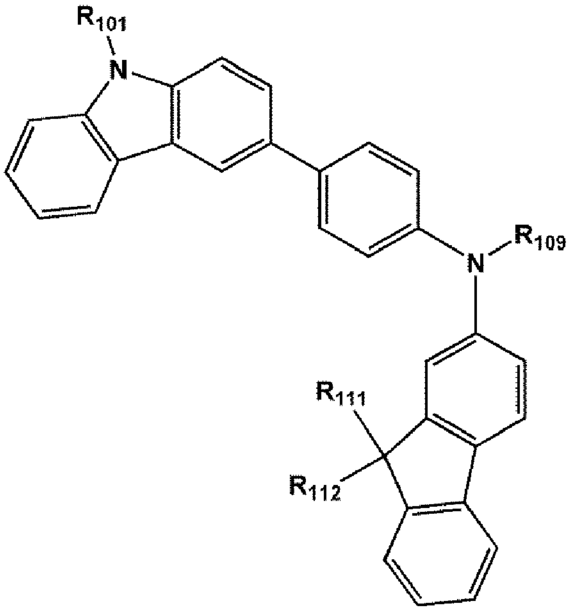

.

In Formula 201A, $R_{101}$, $R_{111}$, $R_{112}$, and $R_{109}$ are each independently the same as described above.

For example, the hole transport region may include at least one of Compounds HT1 to HT21, but are not limited thereto:

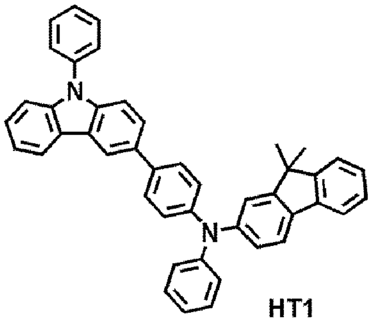

HT1

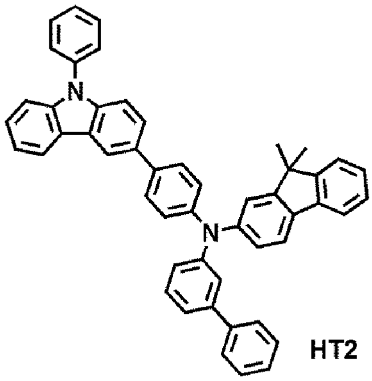

HT2

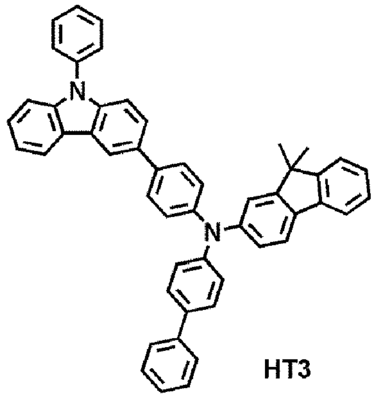

HT3

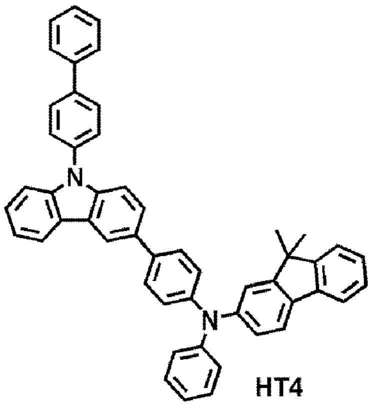

HT4

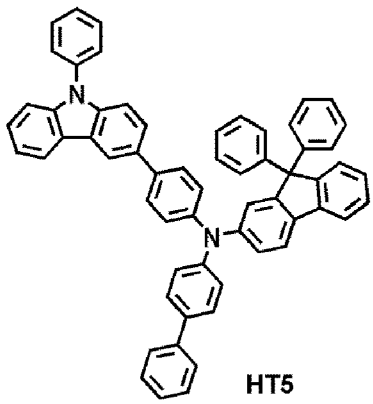

HT5

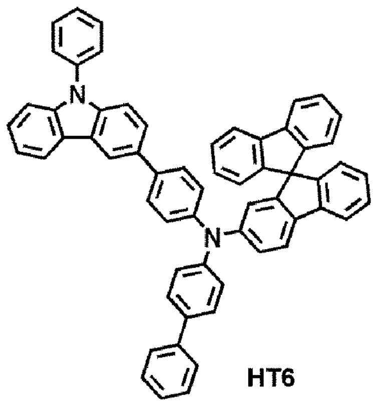

HT6

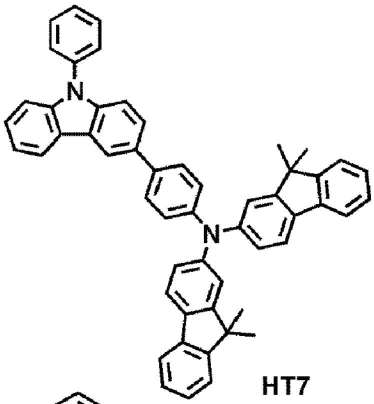

HT7

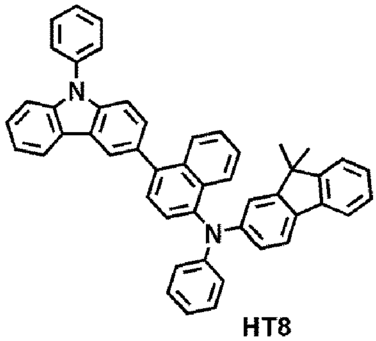

HT8

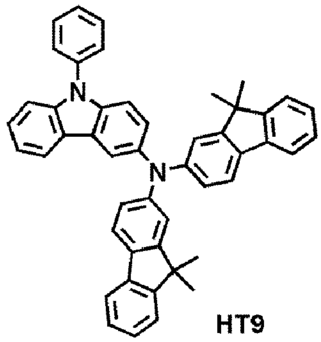

HT9

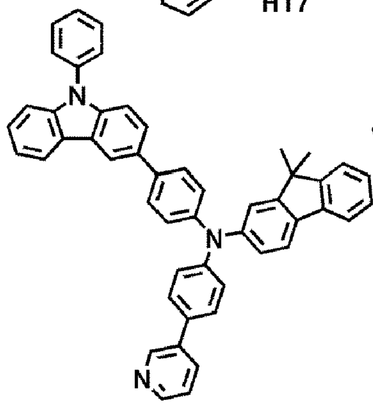

HT10

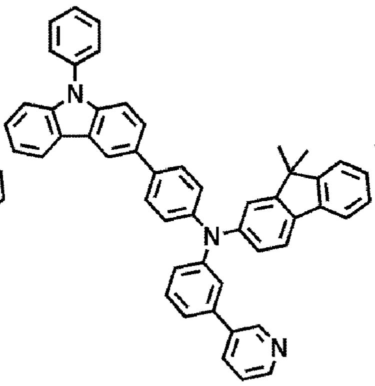

HT11

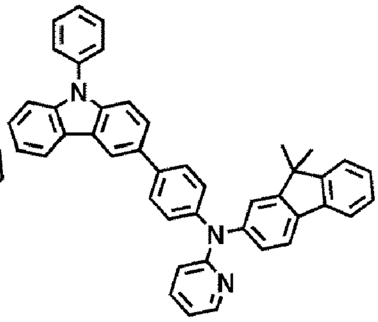

HT12

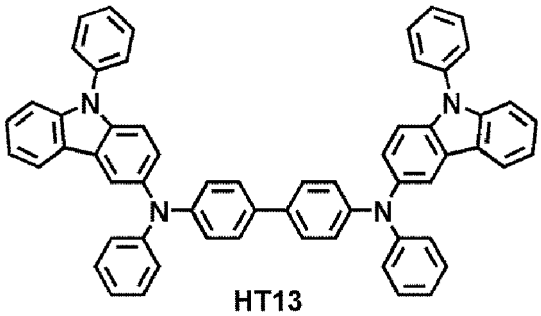

HT13

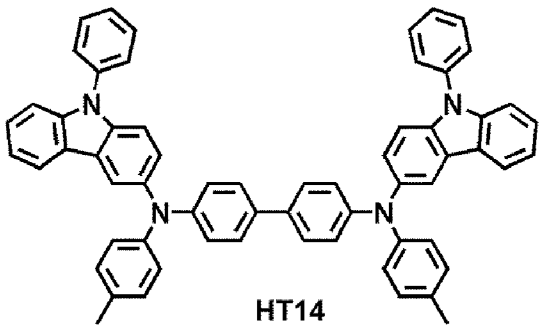

HT14

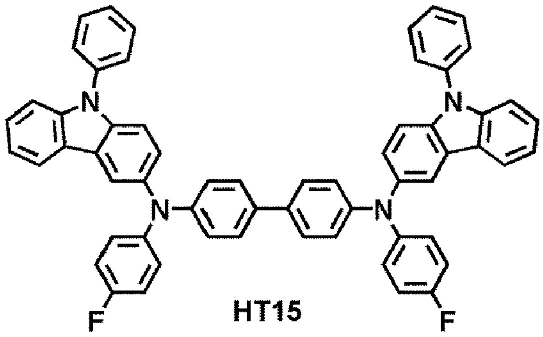

HT15

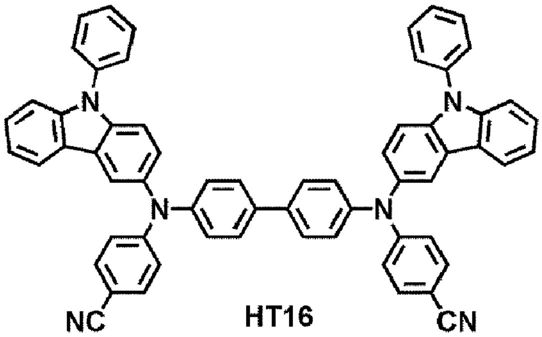

HT16

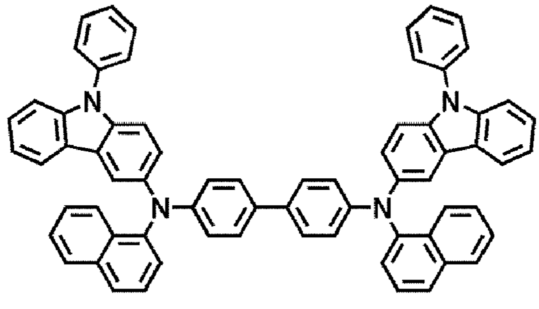

HT17

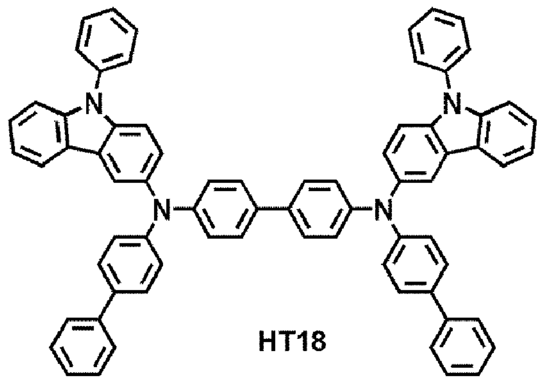

HT18

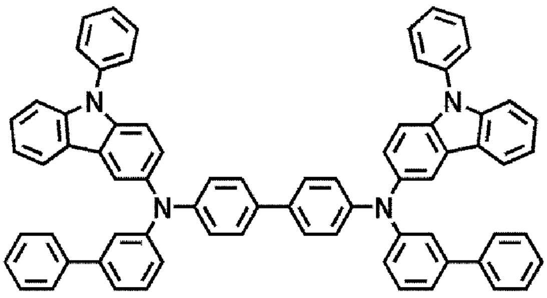

HT19

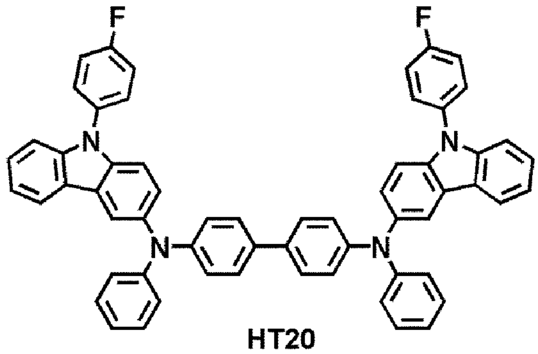

HT20

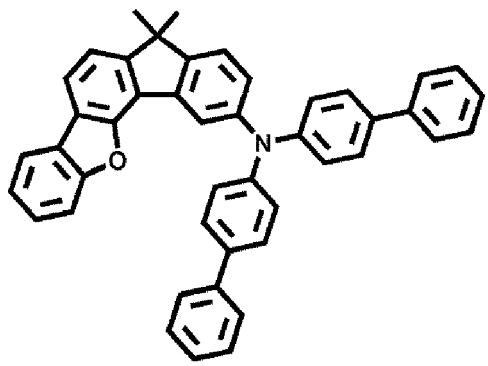

HT21

A thickness of the hole transport region may be in a range of about 100 Angstroms (Å) to about 10,000 Å, for example, about 100 Å to about 1,000 Å. When the hole transport region includes at least one of a hole injection layer a hole transport layer and an electron blocking layer, the thickness of the hole injection layer may be in a range of about 100 Å to about 10,000 Å, and for example, about 100 Å to about 1,000 Å, and the thickness of the hole transport layer may be in a range of about 50 Å to about 2,000 Å, and for example, about 100 Å to about 1,500 Å. While not wishing to be bound by theory, it is understood that when the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be one selected from a quinone derivative, a metal oxide, a cyano group-containing compound, or any combination thereof, but embodiments of the present disclosure are not limited thereto. Non-limiting examples of the p-dopant are a quinone derivative, such as tetracyanoquinonedimethane (TCNQ), 2,3,5,6-tetrafluoro-tetracyano-1,4-benzoquinonedimethane (F4-TCNQ), or F6-TCNNQ; a metal oxide, such as a tungsten oxide or a molybdenium oxide; a cyano group-containing compound,

such as Compound HT-D1; or any combination thereof but are not limited thereto:

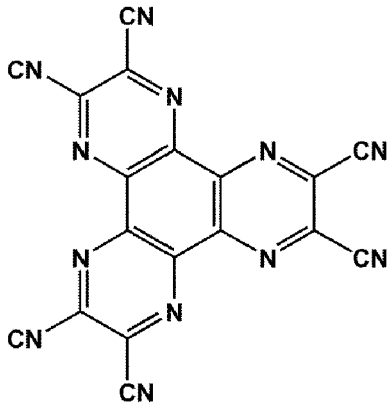

HT-D1

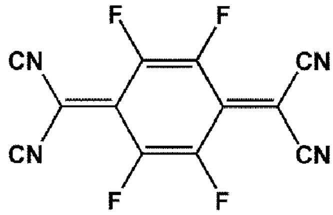

F4-TCNQ

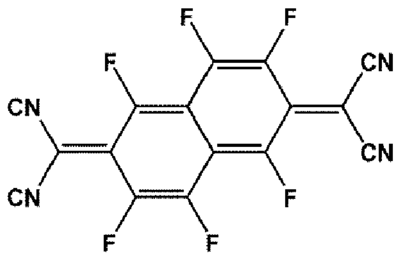

F6-TCNNQ .

The hole transport region may include a buffer layer.

Also, the buffer layer may compensate for an optical resonance distance according to a wavelength of light emitted from the emission layer, and thus, efficiency of a formed organic light-emitting device may be improved.

Meanwhile, when the hole transport region includes an electron blocking layer, a material for the electron blocking layer may be selected from materials for the hole transport region described above and materials for a host to be explained later. However, the material for the electron blocking layer is not limited thereto. For example, when the hole transport region includes an electron blocking layer, a material for the electron blocking layer may be mCP, Compound H21, or any combination thereof.

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a compound that is used to form the emission layer.

The emission layer may include a host and a dopant, and the dopant may include the organometallic compound satisfying both Condition 1 and the radiative decay rate described herein.

The host may include at least one selected from TPBi, TBADN, ADN (also referred to as "DNA"), CBP, CDBP, TCP, mCP, Compound H50, Compound H51, Compound H52, or any combination thereof:

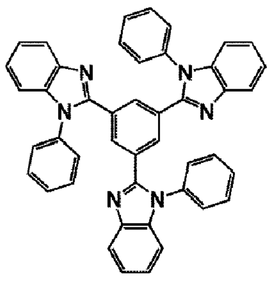

TPBi

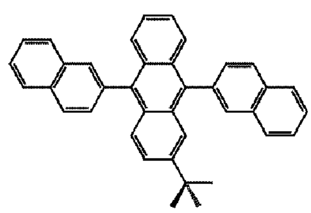

TBADN

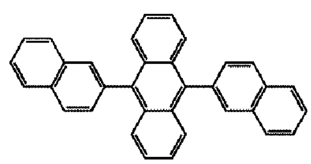

ADN

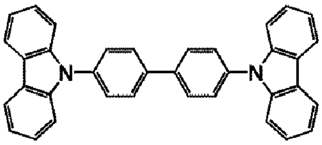

CBP

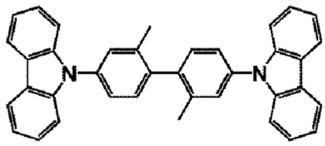

CDBP

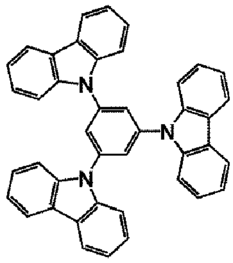

TCP

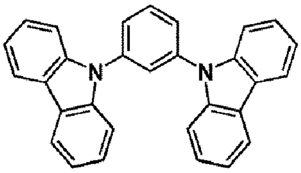

mCP

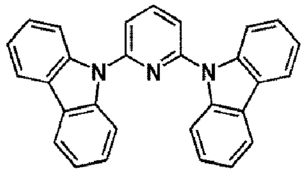

H50

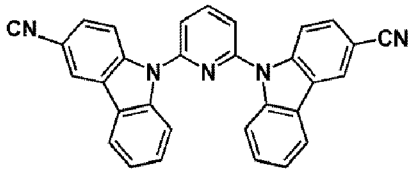

H51

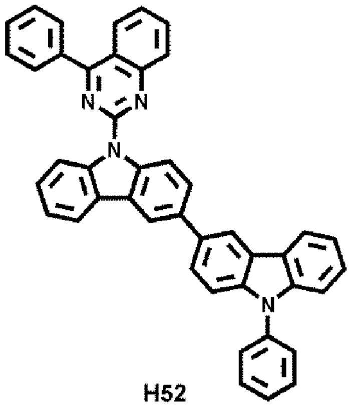

H52

.

In one or more embodiments, the host may include a carbazole group, a fluorene group, a spiro-bifluorene group, a dibenzofuran group, a dibenzothiophene group, a dibenzosilole group, an indenocarbazole group, an indolocarbazole group, a benzofurocarbazole group, a benzothienocarbazole group, an acridine group, a dihydroacridine group, a triindolobenzene group, an azadibenzofuran group, an azadibenzothiophene group, an azacarbazole group, an azafluorene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a phenazine group, a cinnoline group, a cyano group, a phosphine oxide group, a sulfoxide group, or any combination thereof.

In one or more embodiments, the host may include a hole-transporting host and an electron-transporting host, wherein the hole-transporting host and the electron-transporting host may be different from each other.

For example, the electron-transporting host may include at least one electron-transporting moiety,

the hole-transporting host may not include an electron-transporting moiety nor an amine-containing group, and

the electron-transporting moiety may be a cyano group, a $\pi$ electron-depleted nitrogen-containing cyclic group, groups represented by the following formulae, or any combination thereof, but embodiments of the present disclosure are not limited thereto:

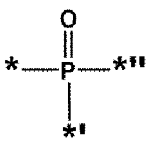
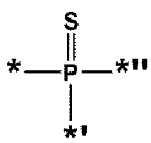
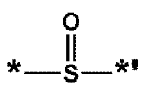
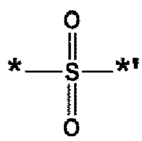

.

In the formulae above, *, *', and *" each indicate a binding site to a neighboring atom.

When the organic light-emitting device is a full-color organic light-emitting device, the emission layer may be patterned into a red emission layer, a green emission layer, and/or a blue emission layer. In one or more embodiments, due to a stacked structure including a red emission layer, a green emission layer, and/or a blue emission layer, the emission layer may emit white light.

When the emission layer includes a host and a dopant, an amount of the dopant may be in a range of about 0.01 parts by weight to about 15 parts by weight based on 100 parts by weight of the host, but embodiments of the present disclosure are not limited thereto.

The dopant may include the organometallic compound described herein. For example, the dopant may be a red, green, or blue phosphorescent dopant.

A thickness of the emission layer may be in a range of about 100 Å to about 1,000 Å, for example, about 200 Å to about 600 Å. While not wishing to be bound by theory, it is understood that when the thickness of the emission layer is within this range, excellent light-emission characteristics may be obtained without a substantial increase in driving voltage.

Then, an electron transport region may be disposed on the emission layer.

The electron transport region may include a hole blocking layer, an electron transport layer, an electron injection layer, or any combination thereof.

For example, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, BCP, BPhen, BAlq, or any combination thereof, but embodiments of the present disclosure are not limited thereto:

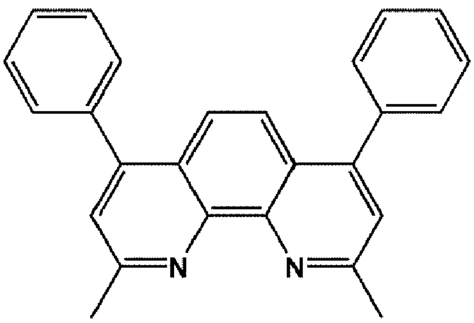

BCP

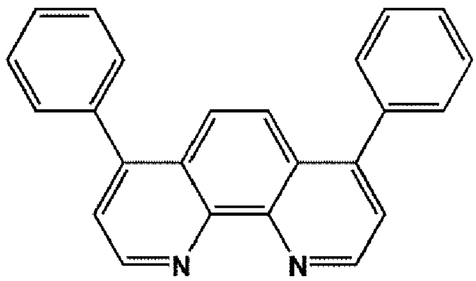

Bphen .

Alternatively, the electron blocking layer may include a host, a material for an electron transport layer, a material for an electron injection layer, or any combination thereof.

A thickness of the hole blocking layer may be in a range of about 20 Å to about 1,000 Å, for example, about 30 Å to about 600 Å. While not wishing to be bound by theory, it is understood that when the thickness of the hole blocking layer is within these ranges, the hole blocking layer may have improved hole blocking ability without a substantial increase in driving voltage.

The electron transport layer may include BCP, BPhen, TPBi, $Alq_3$, BAlq, TAZ, NTAZ, or any combination thereof:

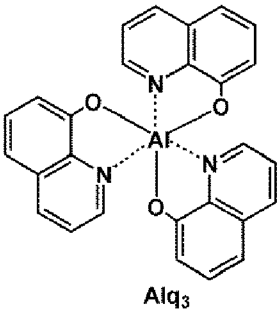

Alq$_3$

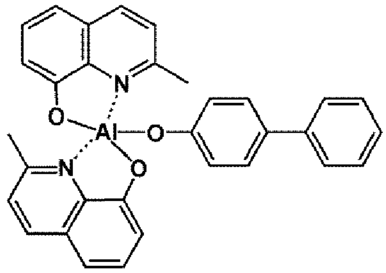

BAlq

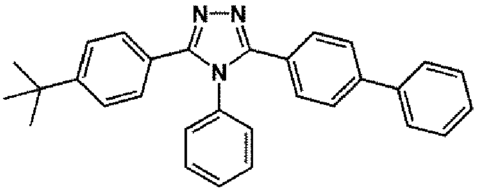

TAZ

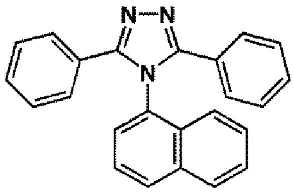

NTAZ

In one or more embodiments, the electron transport layer may include at least one of ET1 to ET25, but are not limited thereto:

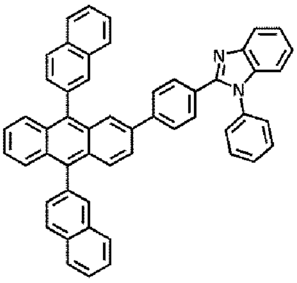

ET1

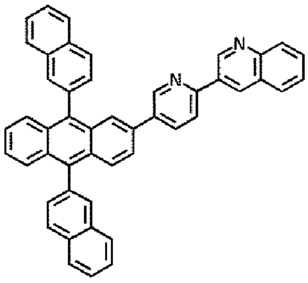

ET2

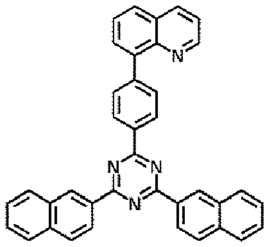

ET3

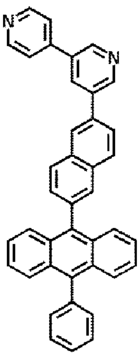

ET4

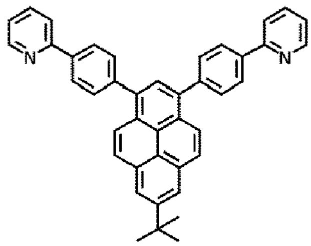

ET5

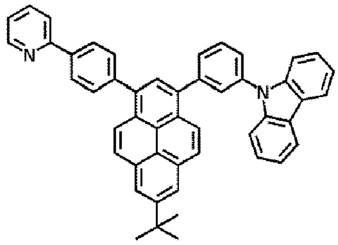

ET6

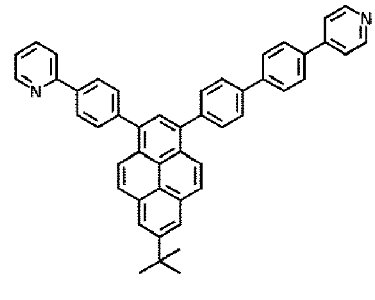

ET7

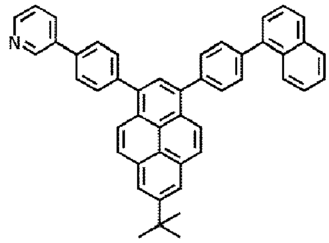

ET8

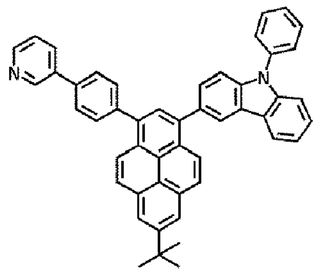

ET9

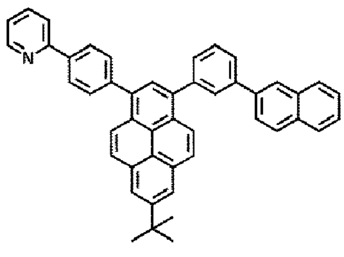

ET10

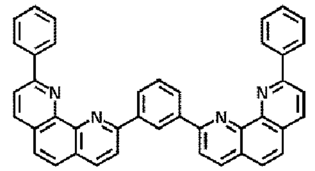

ET11

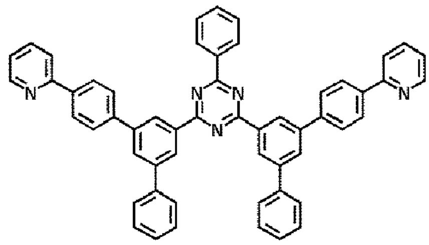

ET12

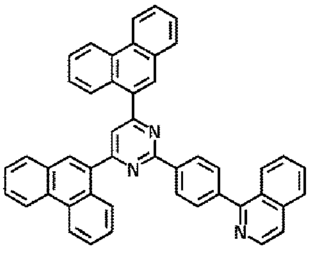

ET13

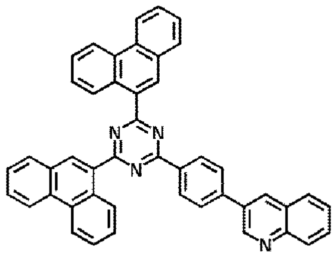

ET14

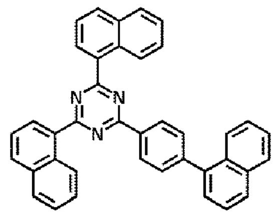

ET15

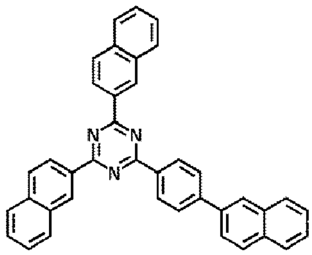

ET16

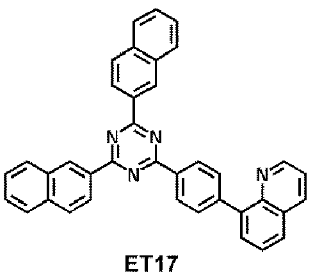

ET17

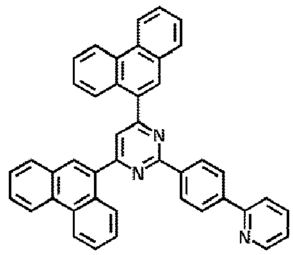

ET18

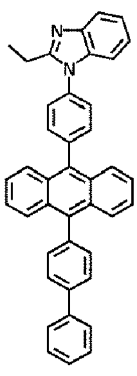

ET19

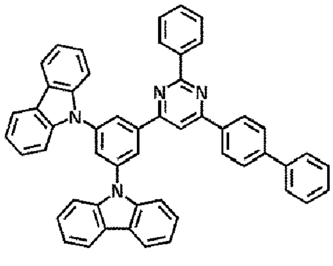

ET20

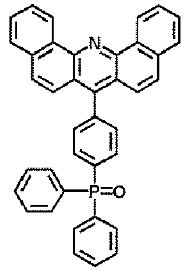

ET21

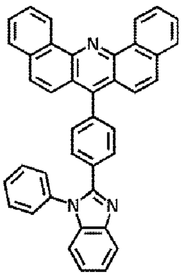
ET22

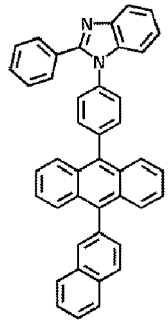
ET23

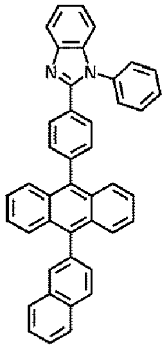
ET24

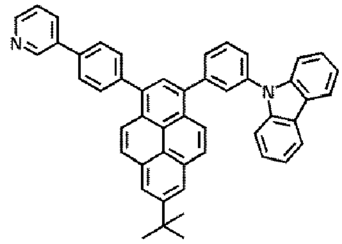
ET25

.

A thickness of the electron transport layer may be in a range of about 100 Å to about 1,000 Å, for example, about 150 Å to about 500 Å. While not wishing to be bound by theory, it is understood that when the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 or ET-D2:

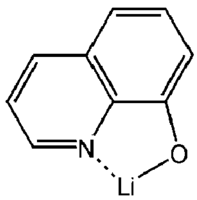
ET-D1

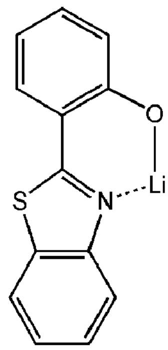
ET-D2

.

The electron transport region may include an electron injection layer that promotes flow of electrons from the second electrode 19 thereinto.

The electron injection layer may include LiF, NaCl, CsF, $Li_2O$, BaO, or any combination thereof.

A thickness of the electron injection layer may be in a range of about 1 Å to about 100 Å, for example, about 3 Å to about 90 Å. While not wishing to be bound by theory, it is understood that when the thickness of the electron injection layer is within the range described above, the electron injection layer may have satisfactory electron injection characteristics without a substantial increase in driving voltage.

The second electrode 19 is disposed on the organic layer 15. The second electrode 19 may be a cathode. A material for forming the second electrode 19 may be selected from metal, an alloy, an electrically conductive compound, or any combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be used as a material for forming the second electrode 19. In one or more embodiments, to manufacture a top-emission type light-emitting device, a transmissive electrode formed using ITO or IZO may be used as the second electrode 19.

Hereinbefore, the organic light-emitting device 20 has been described with reference to FIG. 2, but embodiments of the present disclosure are not limited thereto.

In an embodiment, the organic light-emitting device may satisfy at least one of Condition 10, Condition 11, Condition 12, Condition 13 and Condition 14:

Condition 10 The organic light-emitting device may further comprise the hole transport region disposed between the first electrode and the emission layer and the hole transport region may comprise the p-dopant.

Condition 11 The organic light-emitting device may further comprise the hole transport region disposed between

the first electrode and the emission layer and the hole transport region may not comprise m-MTDATA.

Condition 12 The organic light-emitting device may further comprise the hole transport region disposed between the first electrode and the emission layer and the hole transport region may not comprise NPB.

Condition 13 The organic light-emitting device may further comprise the hole transport region disposed between the first electrode and the emission layer and the hole transport region may not comprise 2-TNATA.

Condition 14 The organic light-emitting device may further comprise the electron transport region disposed between the emission layer and the second electrode and the electron transport region may not comprise $Alq_3$.

The term "$C_1$-$C_{60}$ alkyl group" as used herein refers to a linear or branched saturated aliphatic hydrocarbon monovalent group having 1 to 60 carbon atoms, and non-limiting examples thereof include a methyl group, an ethyl group, a propyl group, an iso-butyl group, a sec-butyl group, a tert-butyl group, a pentyl group, an iso-amyl group, and a hexyl group. The term "$C_1$-$C_{60}$ alkylene group" as used herein refers to a divalent group having the same structure as the $C_1$-$C_{60}$ alkyl group.

The term "$C_1$-$C_{60}$ alkoxy group" as used herein refers to a monovalent group represented by $-OA_{101}$ (wherein $A_{101}$ is the $C_1$-$C_{60}$ alkyl group), and non-limiting examples thereof include a methoxy group, an ethoxy group, and an iso-propyloxy group.

The term "$C_2$-$C_{60}$ alkenyl group" as used herein refers to a hydrocarbon group formed by including at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group formed by including at least one carbon-carbon triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having the same structure as the $C_3$-$C_{10}$ cycloalkyl group.

The term "$C_1$-$C_{10}$ heterocycloalkyl group" as used herein refers to a monovalent saturated monocyclic group having at least one heteroatom selected from N, O, P, Si and S as a ring-forming atom and 1 to 10 carbon atoms, and non-limiting examples thereof include a tetrahydrofuranyl group, and a tetrahydrothiophenyl group. The term "$C_1$-$C_{10}$ heterocycloalkylene group" as used herein refers to a divalent group having the same structure as the $C_1$-$C_{10}$ heterocycloalkyl group.

The term "$C_3$-$C_{10}$ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group that has at least one heteroatom selected from N, O, P, Si, and S as a ring-forming atom, 1 to 10 carbon atoms, and at least one carbon-carbon double bond in its ring. Examples of the $C_1$-$C_{10}$ heterocycloalkenyl group are a 2,3-dihydrofuranyl group, and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Non-limiting examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.

The term "$C_7$-$C_{60}$ alkylaryl group" as used herein refers to a $C_1$-$C_{60}$ aryl group substituted with at least one $C_6$-$C_{60}$ alkyl group.

The term "$C_1$-$C_{60}$ heteroaryl group" as used herein refers to a monovalent group having a carbocyclic aromatic system that has at least one heteroatom selected from N, O, P, Si, and S as a ring-forming atom, and 1 to 60 carbon atoms. The term "$C_1$-$C_{60}$ heteroarylene group" as used herein refers to a divalent group having a carbocyclic aromatic system that has at least one heteroatom selected from N, O, P, and S as a ring-forming atom, and 1 to 60 carbon atoms. Non-limiting examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include two or more rings, the rings may be fused to each other.

The term "$C_2$-$C_{60}$ alkyl heteroaryl group" as used herein refers to a $C_1$-$C_{60}$ heteroaryl group substituted with at least one $C_1$-$C_{60}$ alkyl group.

The term "$C_6$-$C_{60}$ aryloxy group" as used herein indicates -$OA_{102}$ (wherein $A_{102}$ is the $C_6$-$C_{60}$ aryl group), a $C_6$-$C_{60}$ arylthio group as used herein indicates -$SA_{103}$ (wherein $A_{103}$ is the $C_6$-$C_{60}$ aryl group), and the term "$C_7$-$C_{60}$ arylalkyl group" as used herein indicates -$A_{104}A_{105}$ (wherein $A_{105}$ is the $C_6$-$C_{59}$ aryl group and $A_{104}$ is the $C_1$-$C_{53}$ alkylene group).

The term "$C_1$-$C_{60}$ heteroaryloxy group" as used herein refers to -$OA_{106}$ (wherein $A_{106}$ is the $C_2$-$C_{60}$ heteroaryl group), the term "$C_1$-$C_{60}$ heteroarylthio group" as used herein indicates -$SA_{107}$ (wherein $A_{107}$ is the $C_1$-$C_{60}$ heteroaryl group), and the term "$C_2$-$C_{60}$ heteroarylalkyl group" as used herein refers to -$A_{108}A_{109}$ ($A_{109}$ is a $C_1$-$C_{59}$ heteroaryl group, and $A_{108}$ is a $C_1$-$C_{59}$ alkylene group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 2 to 60 carbon atoms) having two or more rings condensed to each other, a heteroatom selected from N, O, P, Si, and S, other than carbon atoms, as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "$C_5$-$C_{30}$ carbocyclic group" as used herein refers to a saturated or unsaturated cyclic group having, as a ring-forming atom, 5 to 30 carbon atoms only. The $C_5$-$C_{30}$ carbocyclic group may be a monocyclic group or a polycyclic group.

The term "$C_1$-$C_{30}$ heterocyclic group" as used herein refers to a saturated or unsaturated cyclic group having, as a ring-forming atom, at least one heteroatom selected from N, O, Si, P, and S other than 1 to 30 carbon atoms. The $C_1$-$C_{30}$ heterocyclic group may be a monocyclic group or a polycyclic group.

Non-limiting examples of the $C_1$-$C_{60}$ alkyl group, $C_1$-$C_{20}$ alkyl group and/or $C_1$-$C_{10}$ alkyl group include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or any combination thereof, and the like, but embodiments of the present disclosure are not limited thereto.

Non-limiting examples of the $C_1$-$C_{60}$ alkoxy group, $C_1$-$C_{20}$ alkoxy group and/or $C_1$-$C_{10}$ alkoxy group include a methoxy group, an ethoxy group, a propoxy group or a butoxy group, and the like, but embodiments of the present disclosure are not limited thereto.

Non-limiting examples of the $C_3$-$C_{10}$ cycloalkyl group include a cyclopropyl group, a cyclobutyl group, a cyclopentyl group, a cyclohexyl group, a cycloheptyl group, a cyclooctyl group, an adamantyl group, a bicyclo[1.1.1]pentyl group, a bicyclo[2.1,1]hexyl group, a bicyclo[2.2.1]heptyl group, a bicyclo[2.2.2]octyl group, and the like, but embodiments of the present disclosure are not limited thereto.

The deuterium-containing $C_1$-$C_{60}$ alkyl group (or, the deuterium-containing $C_1$-$C_{20}$ alkyl group, the deuterium-containing $C_2$-$C_{20}$ alkyl group, etc.) means a $C_1$-$C_{60}$ alkyl group substituted with a deuterium (or, a $C_1$-$C_{20}$ alkyl group substituted with at least one deuterium, a $C_2$-$C_{20}$ alkyl group substituted with a deuterium, etc.). For example, a deuterium-containing $C_1$ alkyl group (that is, a deuterium-containing methyl group) includes -$CD_3$, -$CD_2H$ and -$CDH_2$.

The deuterium-containing $C_1$-$C_{60}$ alkyl group (or, the deuterium-containing $C_1$-$C_{20}$ alkyl group, the deuterium-containing $C_2$-$C_{20}$ alkyl group, etc.) may be additionally substituted with at least one $C_3$-$C_{10}$ cycloalkyl group. For example, Formula 9-619 is a group corresponding to -$CD_2H$, in which "-H" is substituted with a cyclopentyl group.

The fluorinated $C_1$-$C_{60}$ alkyl group means a $C_1$-$C_{60}$ alkyl group substituted with at least one -F. For example, a fluorinated methyl group includes -$CF_3$, -$CF_2H$ and -$CFH_2$.

At least one substituent of the substituted $C_5$-$C_{30}$ carbocyclic group, the substituted $C_2$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_2$-$C_{10}$ heterocycloalkyl group, the substituted $C_3$-$C_{10}$ cycloalkenyl group, the substituted $C_2$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_7$-$C_{60}$ arylalkyl group, the substituted $C_1$-$C_{60}$ heteroaryl group, the substituted $C_7$-$C_{60}$ arylalkyl group, the substituted $C_1$-$C_{60}$ heteroaryl group, the substituted $C_1$-$C_{60}$ heteroaryloxy group, the substituted $C_1$-$C_{60}$ heteroarylthio group, the substituted $C_2$-$C_{60}$ heteroarylalkyl group, the substituted monovalent non-aromatic condensed polycyclic group, and the substituted monovalent non-aromatic condensed heteropolycyclic group may be:

a deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, or a $C_1$-$C_{60}$ alkoxy group;
a $C_1$-$C_{60}$ alkyl group, a $C_2$-$C_{60}$ alkenyl group, a $C_2$-$C_{60}$ alkynyl group, or a $C_1$-$C_{60}$ alkoxy group, each substituted with deuterium, -F, -Cl, -Br, -I, - $CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_2$-$C_{10}$ heterocycloalkyl group, a $C_3$-$C_{10}$ cycloalkenyl group, a $C_2$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, - $N(Q_{11})(Q_{12})$, $-Si(Q_{13})(Q_{14})(Q_{15})$, $-Ge(Q_{13})(Q_{14})(Q_{15})$, $-B(Q_{16})(Q_{17})$, - $P(=O)(Q_{18})(Q_{19})$, $-P(Q_{18})(Q_{19})$, or any combination thereof;
a $C_3$-$C_{10}$ cycloalkyl group, a $C_2$-$C_{10}$ heterocycloalkyl group, a $C_3$-$C_{10}$ cycloalkenyl group, a $C_2$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group, each unsubstituted or substituted with deuterium, -F, - Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_2$-$C_{10}$ heterocycloalkyl group, a $C_3$-$C_{10}$ cycloalkenyl group, a $C_2$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-Ge(Q_{23})(Q_{24})(Q_{25})$, $-B(Q_{26})(Q_{27})$, - $P(=O)(Q_{28})(Q_{29})$, $-P(Q_{28})(Q_{29})$, or any combination thereof;
$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, - $P(=O)(Q_{38})(Q_{39})$, or $-P(Q_{38})(Q_{39})$; or
any combination thereof. For example, a $CH_2CN$ group is a C1 group substituted with a cyano group.

$Q_1$ to $Q_9$, $Q_{11}$ to $Q_{19}$, $Q_{21}$ to $Q_{29}$, and $Q_{31}$ to $Q_{39}$ in this disclosure may each independently be hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a $C_1$-$C_{60}$ alkyl group unsubstituted or substituted with deuterium, a $C_1$-$C_{60}$ alkyl group, a $C_6$-$C_{60}$ aryl group, or any combination thereof; a $C_2$-$C_{60}$ alkenyl group; a $C_2$-$C_{60}$ alkynyl group; a $C_1$-$C_{60}$ alkoxy group; a $C_3$-$C_{10}$ cycloalkyl group; a $C_2$-$C_{10}$ heterocycloalkyl group; a $C_3$-$C_{10}$ cycloalkenyl group; a $C_2$-$C_{10}$ heterocycloalkenyl group; a $C_6$-$C_{60}$ aryl group unsubstituted or substituted with deuterium, a $C_1$-$C_{60}$ alkyl group, a $C_6$-$C_{60}$ aryl group, or any combination thereof; a $C_6$-$C_{60}$ aryloxy group; a $C_6$-$C_{60}$ arylthio group; a $C_7$-$C_{60}$ arylalkyl group; a $C_1$-$C_{60}$ heteroaryl group; a $C_1$-$C_{60}$ heteroaryloxy group; a $C_1$-$C_{60}$ heteroarylthio group; a $C_2$-$C_{60}$ heteroarylalkyl group; a monovalent non-aromatic condensed polycyclic group; or a monovalent non-aromatic condensed heteropolycyclic group.

For example, $Q_1$ to $Q_9$, $Q_{11}$ to $Q_{19}$, $Q_{21}$ to $Q_{29}$, and $Q_{31}$ to $Q_{39}$ in this disclosure may each independently be:

$-CH_3$, $-CD_3$, $-CD_2H$, $-CDH_2$, $-CH_2CH_3$, $-CH_2CD_3$, $-CH_2CD_2H$, - $CH_2CDH_2$, $-CHDCH_3$, $-CHDCD_2H$, $-CHDCDH_2$, $-CHDCD_3$, $-CD_2CD_3$, - $CD_2CD_2H$, or $-CD_2CDH_2$; or
an n-propyl group, an iso-propyl group, an n-butyl group, a sec-butyl group, an iso-butyl group, a tert-butyl group, an n-pentyl group, a tert-pentyl group, a neopentyl group, an iso-pentyl group, a sec-pentyl group, a 3-pentyl group, a sec-iso-pentyl group, a phenyl group, a biphenyl group or a naphthyl group, each unsubstituted or substituted with deuterium, a $C_1$-$C_{10}$ alkyl group, a phenyl group, or any combination thereof.

For example, a $C_5$-$C_{30}$ carbocyclic group (that is unsubstituted or substituted with an $R_{10a}$ group) and a $C_2$-$C_{30}$ heterocyclic group (that is unsubstituted or substituted with an $R_{10a}$ group) may each independently be a cyclopentane group, a silole group, an azasilole group, a diazasilole group, a triazasilole group, an adamantane group, a norbornene group, a bicyclo[1.1.1]pentane group, a bicyclo[2.1.1]hexane group, a bicyclo[2.2.1]heptane group, a bicyclo[2.2.2]octane group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene-5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group, each unsubstituted or substituted with an $R_{1a}$ group, but embodiments of the present disclosure are not limited thereto.Hereinafter, a compound and an organic light-emitting device according to embodiments are described in detail with reference to Synthesis Example and Examples. However, the organic light-emitting device is not limited thereto. The expression "'A' is used instead of 'B'" used in describing Synthesis Examples means that a molar equivalent of "A" was identical to a molar equivalent of "B".

EXAMPLES

Synthesis Example of Compound Pt-1

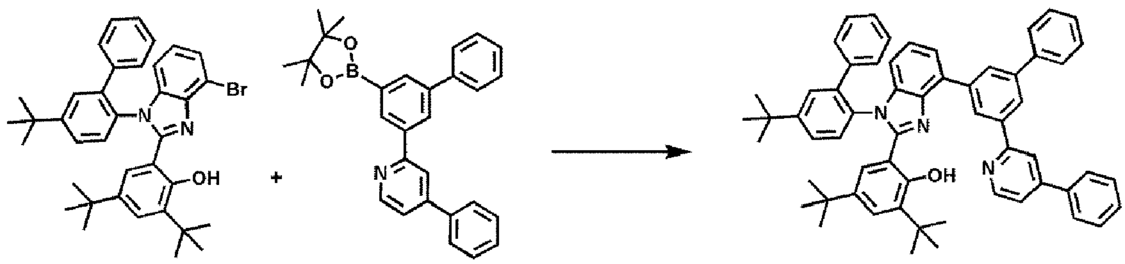

Pt-1(1) Pt-1(2) Pt-1(3)

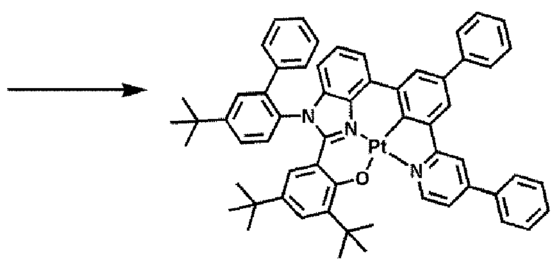

Pt-1

Synthesis of Intermediate Pt-1(3)

Intermediate Pt-1(1) (2.5 grams (g), 4.0 millimoles, mmol), Intermediate Pt-1(2) (1.6 g, 3.7 mmol), tetrakis(triphenylphosphine)palladium(0) (0.3 g, 0.3 mmol), and potassium carbonate (1.5 g, 11.0 mmol) were mixed with 60 milliliters (mL) of tetrahydrofuran (THF) and 20 mL of distilled water, and the reaction mixture was stirred for 12 hours under reflux. The reaction solution was cooled to room temperature, and the organic layer was extracted by using methylene chloride (MC). The obtained organic layer was dried by using anhydrous magnesium sulfate ($MgSO_4$) and filtered to obtain a filtrate. The residue obtained therefrom under reduced pressure was purified by column chromatography (EA:hexane) as an eluent to obtain 2.5 g (83 %) of Intermediate Pt-1(3).

Synthesis of Compound Pt-1

Intermediate Pt-1(3) (1.6 g, 2.0 mmol) and $K_2PtCl_4$ (1.0 g, 2.4 mmol) were mixed with 20 mL of acetic acid, and the reaction mixture was stirred for 18 hours under reflux. The reaction was cooled, the solid obtained therefrom was filtered, and the crude product was purified by column chromatography (MC:hexane) to obtain 1.1 g (53 %) of Compound Pt-1. The obtained compound was identified by Mass and HPLC analysis.
HRMS (MALDI) calcd for $C_{60}H_{55}N_3OPt$: m/z 1028.3993, Found: 1028.3987.

Synthesis Example of Compound Pt-2

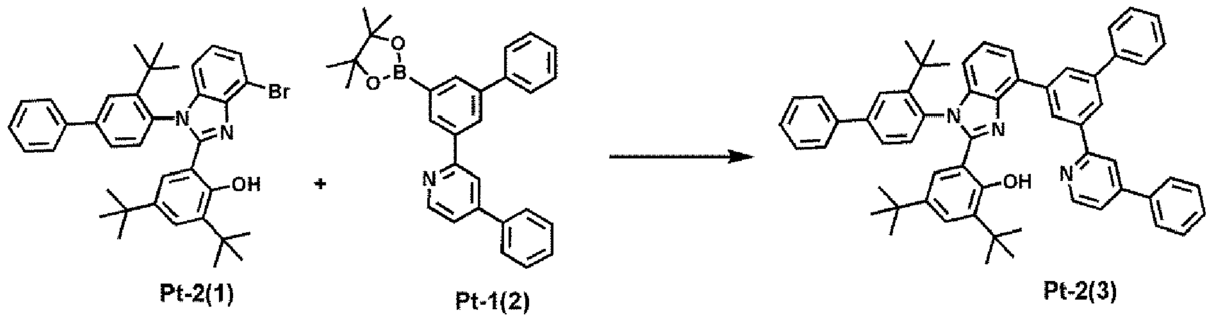

Pt-2(1) Pt-1(2) Pt-2(3)

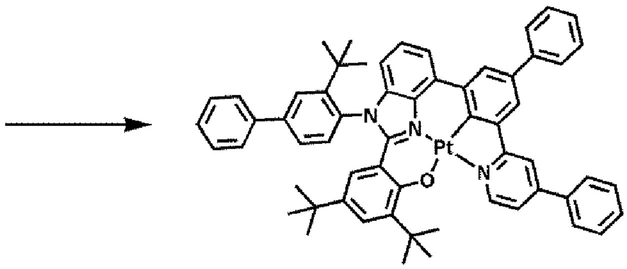

Pt-2

Synthesis of Intermediate Pt-2(3)

2.3 g (77 %) of Intermediate Pt-2(3) was obtained in the same manner as Synthesis of Intermediate Pt-1(3), except that Intermediate Pt-2(1) was used instead of Intermediate Pt-1(1).

Synthesis of Compound Pt-2

0.95 g (48 %) of Intermediate Pt-2 was obtained in the same manner as Synthesis of Compound Pt-1, except that Intermediate Pt-2(3) was used instead of Intermediate Pt-1(3). The obtained compound was identified by Mass and HPLC analysis.
HRMS (MALDI) calcd for $C_{60}H_{55}N_3OPt$: m/z 1028.3993, Found: 1028.4001.

Synthesis Example of Compound Ir-1

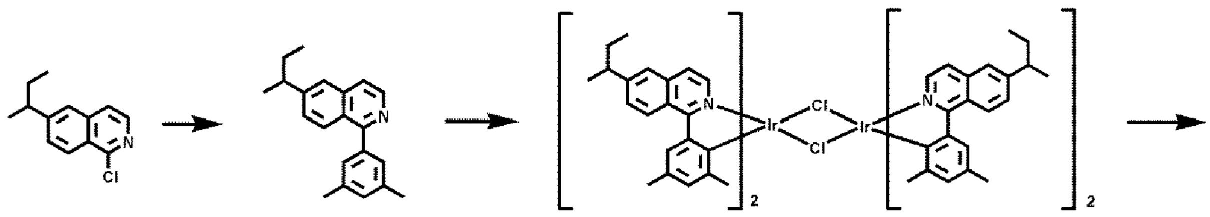

Ir-1(1) Ir-1(2)

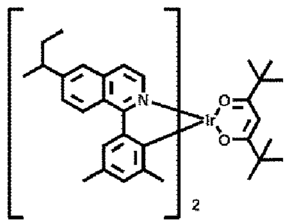

Ir-1

Synthesis of Intermediate Ir-1(1)

1-chloro-6-(sec-butyl)isoquinoline (4.56 grams (g), 20.76 millimoles, mmol), (3,5-dimethylphenyl)boronic acid (4.67 g, 31.14 mmol), $Pd(PPh_3)_4$ (1.92 g, 1.66 mmol), and $K_2CO_3$ (7.17 g, 51.90 mmol) were mixed with 60 milliliters (mL) of tetrahydrofuran (THF) and 30 mL of distilled water, and the mixed solution was stirred under reflux for 18 hours. After the temperature was cooled to room temperature, methylene chloride (MC) was used to extract the organic layer, and then, anhydrous magnesium sulfate ($MgSO_4$) was added to dry the organic layer. The resulting solution was filtered, and the filtrate was evaporated to produce a residue. The residue was then purified by column chromatography with EA:Hexane = 1:10 as an eluent, thereby obtaining Intermediate Ir-1 (1) (5.60 g, yield of 93 %).
MALDI-TOFMS (m/z): $C_{21}H_{23}N$ (M+) 289.

Synthesis of Intermediate Ir-1(2)

Intermediate Ir-1(1) (5.58 g, 19.3 mmol) and iridium chloride hydrate (3.02 g) were mixed with 45 mL of 2-ethoxyethanol and 15 mL of distilled water, and the mixed solution was stirred under reflux for 24 hours. After a reaction was complete, the temperature was cooled to room temperature. The resulting solids produced form the reaction were separated by filtration and thoroughly washed with water/methanol/hexane sequentially to produce a solid product. The solid product was dried in a vacuum oven, thereby obtaining Intermediate Ir-1(2) (3.9 g, yield of 50.3 %).

Synthesis of Compound Ir-1

Intermediate Ir-1(2) (1.30 g, 0.81 mmol), 2,2,6,6-tetramethylheptane-3,5-dione (1.49 g, 8.14 mmol), and $Na_2CO_3$ (0.83 g, 8.14 mmol) were mixed with 15 mL of 2-ethoxyethanol, and the mixed solution was stirred under reflux for 24 hours. After a reaction was complete, the resulting solids produced from the reaction were separated by filtration and thoroughly washed using ethanol and hexane to produce residues. The residues were purified by column chromatography with dichloromethane:n-hexane = 1:1 (v/v) as an eluent, thereby obtaining Compound Ir-1 (0.78 g, yield of 50.6%). Then, Compound Ir-1 was identified by Mass and HPLC.
HRMS(MALDI) calcd for $C_{53}H_{63}IrN_2O_2$: m/z 952.4519, Found: 952.4517.

Synthesis Example of Compound Ir-2

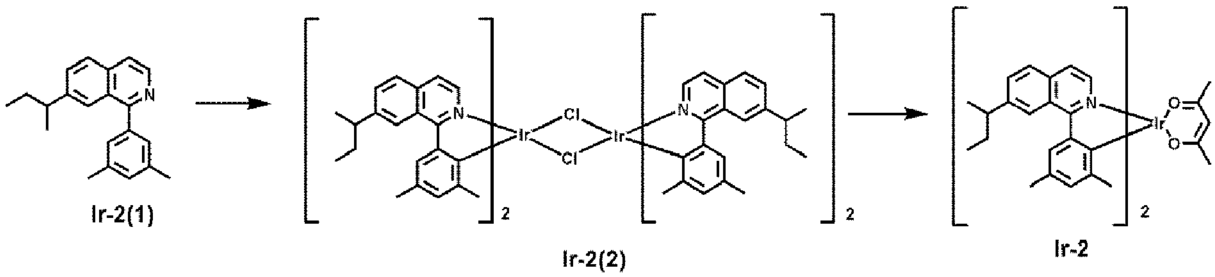

Ir-2(1) Ir-2(2) Ir-2

Synthesis of Intermediate Ir-2(2)

2.1 g (70 %) of Intermediate Ir-2(2) was obtained in the same manner as Synthesis of Intermediate Ir-1(2), except that Intermediate Ir-2(1) was used instead of Intermediate Ir-1(1).

Synthesis of Compound Ir-2

0.8 g (40 %) of Compound Ir-2 was obtained in the same manner as Synthesis of Compound Ir-1, except that Intermediate Ir-2(2) and pentane-2,4-dione were used instead of Intermediate Ir-1(2) and 2,2,6,6-tetramethylheptane-3,5-dione, respectively.
HRMS (MALDI) calcd for $C_{47}H_{51}IrN_2O_2$: m/z 868.3580, Found: 868.3498.

Synthesis Example of Compound Ir-3

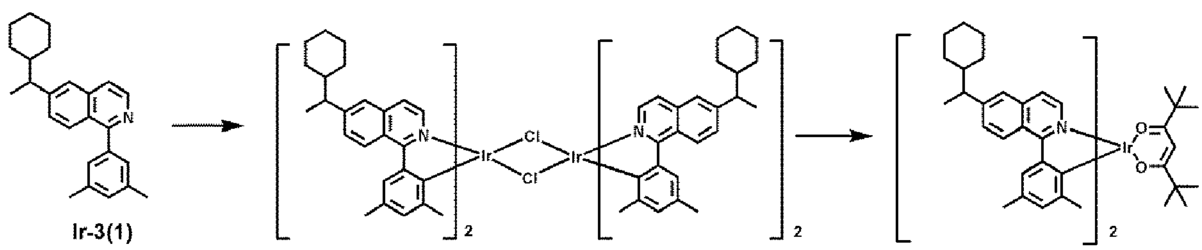

Ir-3(1) Ir-3(2) Ir-3

Synthesis of Intermediate Ir-3(2)

1.6 g (53 %) of Intermediate Ir-3(2) was obtained in the same manner as Synthesis of Intermediate Ir-1(2), except that Intermediate Ir-3(1) was used instead of Intermediate Ir-1(1).

Synthesis of Compound Ir-3

0.95 g (48 %) of Compound Ir-3 was obtained in the same manner as Synthesis of Compound Ir-1, except that Intermediate Ir-3(2) was used instead of Intermediate Ir-1(2). The obtained compound was identified by Mass and HPLC analysis.
HRMS (MALDI) calcd for $C_{53}H_{63}IrN_2O_2$: m/z 952.4519, Found: 952.4512.

Synthesis Example of Compound Ir-4

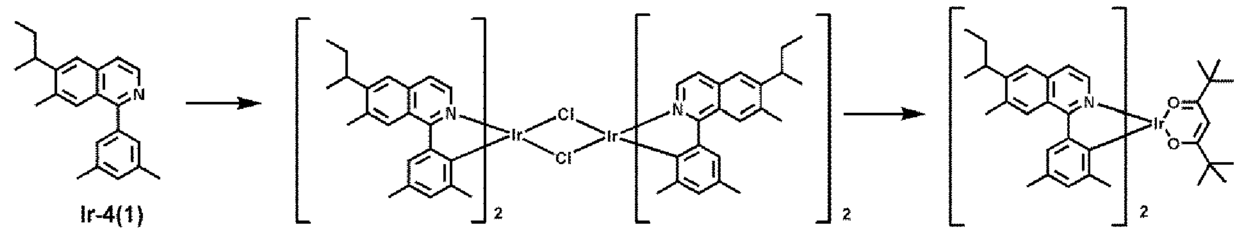

Ir-4(1) Ir-4(2) Ir-4

Synthesis of Intermediate Ir-4(2)

1.4 g (47 %) of Intermediate Ir-4(2) was obtained in the same manner as Synthesis of Intermediate Ir-1(2), except that Intermediate Ir-4(1) was used instead of Intermediate Ir-1(1).

Synthesis of Compound Ir-4

1.1 g (55 %) of Compound Ir-4 was obtained in the same manner as Synthesis of Compound Ir-1, except that Intermediate Ir-4(2) was used instead of Intermediate Ir-1(2). The obtained compound was identified by Mass and HPLC analysis.
HRMS (MALDI) calcd for $C_{55}H_{67}IrN_2O_2$: m/z 980.4832, Found: 980.4839.

Synthesis Example of Compound Ir-5

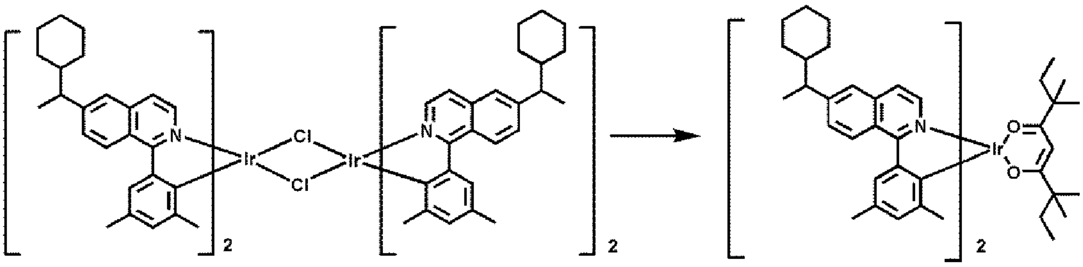

Ir-3(2) Ir-5

0.8 g (40 %) of Compound Ir-5 was obtained in the same manner as Synthesis of Compound Ir-3, except that 3,3,7,7-tetramethylnonane-4,6-dione was used instead of 2,2,6,6-tetramethylheptane-3,5-dione. The obtained compound was identified by Mass and HPLC analysis.
HRMS (MALDI) calcd for $C_{63}H_{79}IrN_2O_2$: m/z 1088.5771, Found: 1088.5761.

Synthesis Example of Compound Ir-6

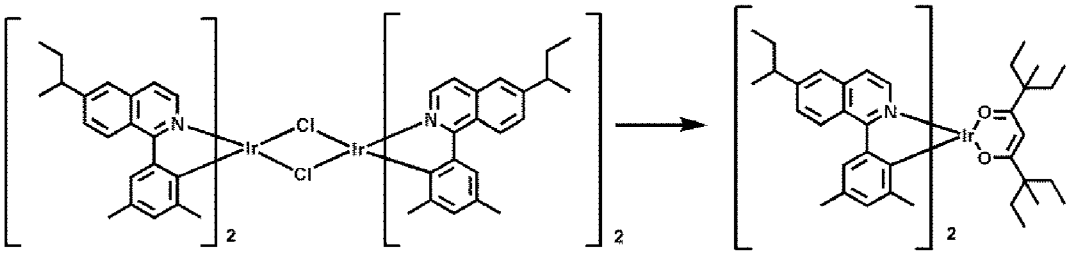

Ir-1(2) Ir-6

0.8 g (40 %) of Ir-6 was obtained in the same manner as Synthesis of Compound Ir-1, except that 3,7-diethyl-3,7-dimethylnonane-4,6-dione was used instead of 2,2,6,6-tetramethylheptane-3,5-dione. The obtained compound was identified by Mass and HPLC analysis.
HRMS (MALDI) calcd for $C_{57}H_{71}IrN_2O_2$: m/z 1008.5145, Found: 1008.5150.

Synthesis Example of Compound Ir-7

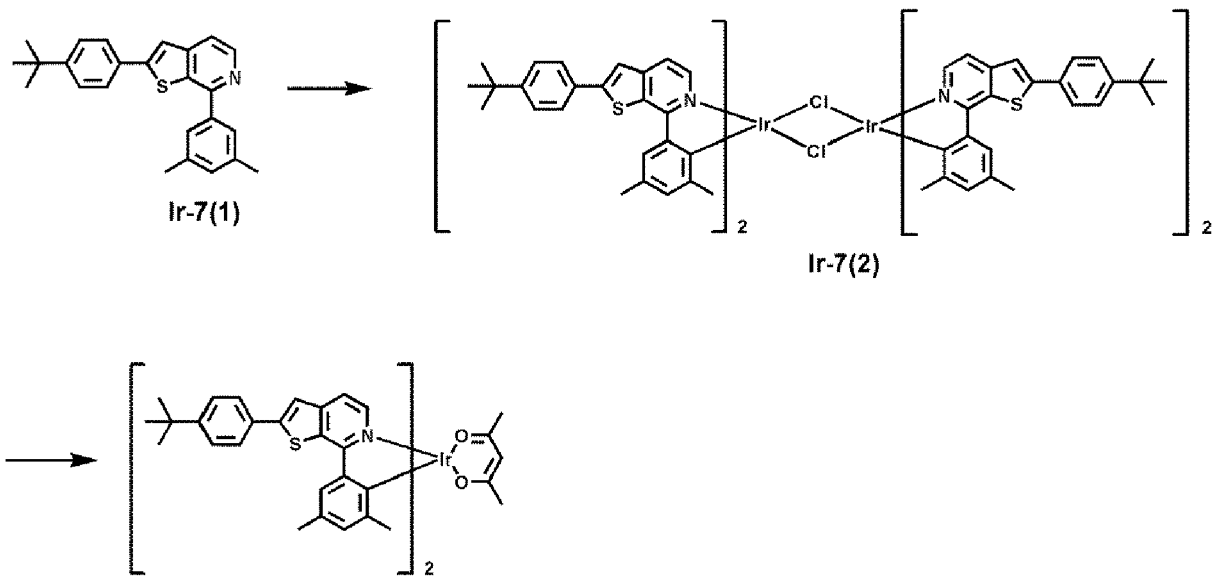

Ir-7(1)

Ir-7(2)

Ir-7

Synthesis of Intermediate Ir-7(2)

2.2 g (73 %) of Intermediate Ir-7(2) was obtained in the same manner as Synthesis of Intermediate Ir-1(2), except that Intermediate Ir-7(1) was used instead of Intermediate Ir-1(1).

Synthesis of Compound Ir-7

0.7 g (35 %) of Compound Ir-7 was obtained in the same manner as Synthesis of Compound Ir-1, except that Intermediate Ir-7(2) and pentane-2,4-dione were used instead of Intermediate Ir-1(2) and 2,2,6,6-tetramethylheptane-3,5-dione, respectively. The obtained compound was identified by Mass and HPLC analysis.
HRMS (MALDI) calcd for $C_{55}H_{55}IrN_2O_2S_2$: m/z 1032.3334, Found: 1032.3339.

Synthesis Example of Compound Ir-8

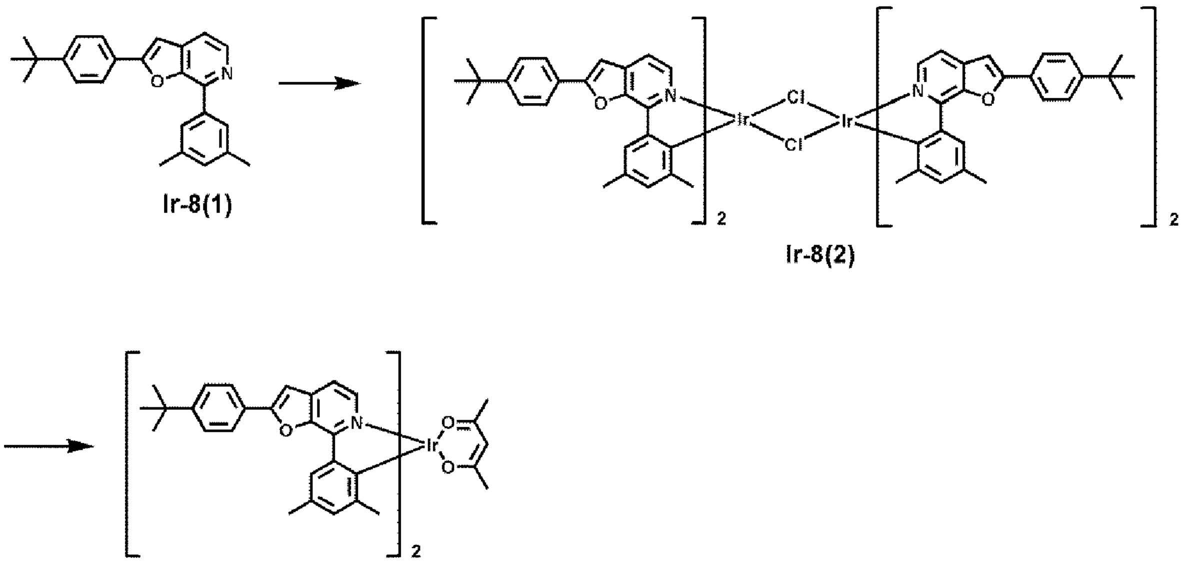

Ir-8(1)

Ir-8(2)

Ir-8

Synthesis of Intermediate Ir-8(2)

1.9 g (63 %) of Intermediate Ir-8(2) was synthesized in the same manner as Synthesis of Intermediate Ir-1(2), except that Intermediate Ir-8(1) was used instead of Intermediate Ir-1(1).

Synthesis of Compound Ir-8

0.8 g (40 %) of Compound Ir-8 was obtained in the same manner as Synthesis of Compound Ir-1, except that Intermediate Ir-8(2) and pentane-2,4-dione were used instead of Intermediate Ir-1(2) and 2,2,6,6-tetramethylheptane-3,5-dione, respectively. The obtained compound was identified by Mass and HPLC analysis.
HRMS (MALDI) calcd for $C_{55}H_{55}IrN_2O_4$: m/z 1000.3791, Found: 1000.3799.

Synthesis Example of Compound Ir-9

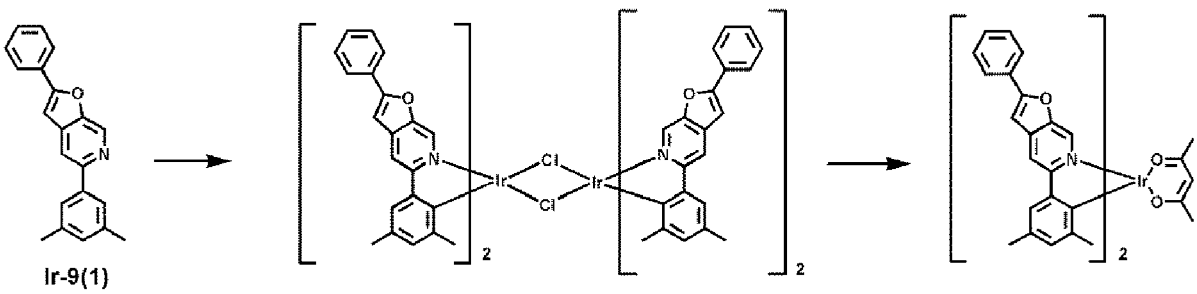

Ir-9(1)

Ir-9(2)

Ir-9

Synthesis of Intermediate Ir-9(2)

1.5 g (50 %) of Intermediate Ir-9(2) was obtained in the same manner as Synthesis of Intermediate Ir-1(2), except that Intermediate Ir-9(1) was used instead of Intermediate Ir-1(1).

Synthesis of Compound Ir-9

0.5 g (25 %) of Compound Ir-9 was obtained in the same manner as Synthesis of Compound Ir-1, except that Intermediate Ir-9(2) and pentane-2,4-dione were used instead of Intermediate Ir-1(2) and 2,2,6,6-tetramethylheptane-3,5-dione, respectively. The obtained compound was identified by Mass and HPLC analysis.

HRMS (MALDI) calcd for $C_{47}H_{39}IrN_2O_4$: m/z 888.2539, Found: 888.2530.

Synthesis Example of Compound Ir-10

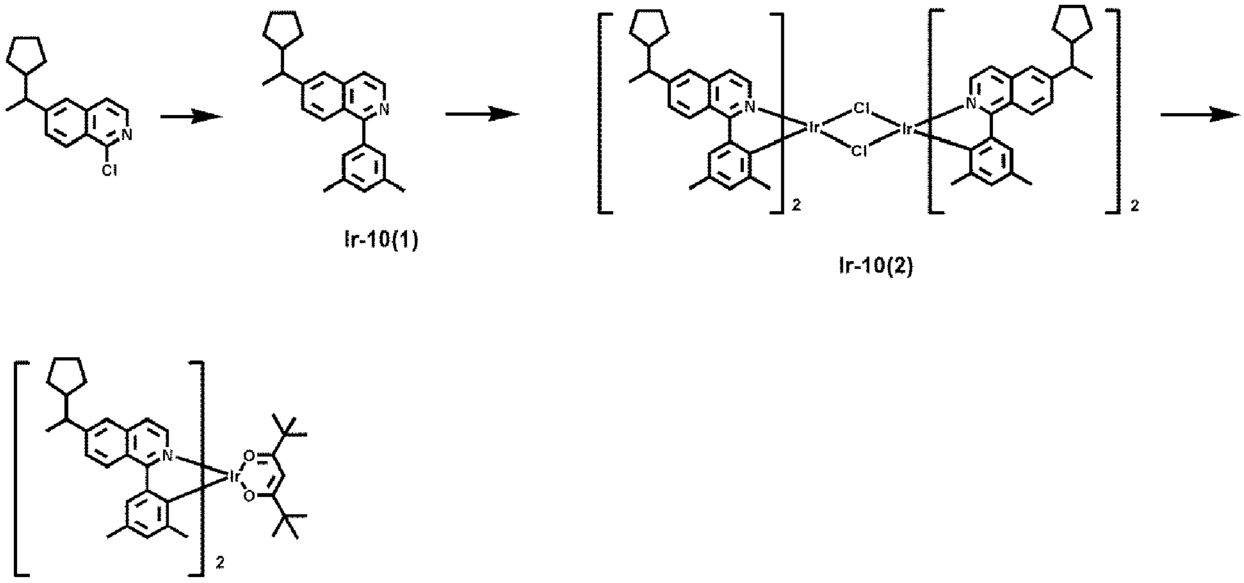

Ir-10(1)

Ir-10(2)

Ir-10

Synthesis of Intermediate Ir-10(1)

Intermediate Ir-10(1) (5.95 g, yield of 87 %) was synthesized in the same manner as in the synthesis of Intermediate Ir-1(1), except that 1-chloro-6-(1-cyclopentyl-ethyl)Isoquinoline (5.39 g, 20.76 mmol) was used instead of 1-chloro-6-(sec-butyl)isoquinoline.
HRMS(MALDI) calcd for $C_{24}H_{29}N$: m/z 331.2300, Found: 331.2311.

Synthesis of Intermediate Ir-10(2)

Intermediate Ir-10(2) was synthesized in the same manner as in the synthesis of Intermediate Ir-1(2), except that Intermediate Ir-10(1) was used instead of Intermediate Ir-1(1).

Synthesis of Compound Ir-10

Compound Ir-10 (0.68 g, yield of 41 %) was synthesized in the same manner as in the synthesis of Compound Ir-1, except that Intermediate Ir-10(2) was used instead of Intermediate Ir-1(2).
HRMS(MALDI) calcd for $C_{59}H_{71}IrN_2O_2$: m/z 1032.5145, Found: 1032.5151.

Synthesis Example of Compound Ir-11

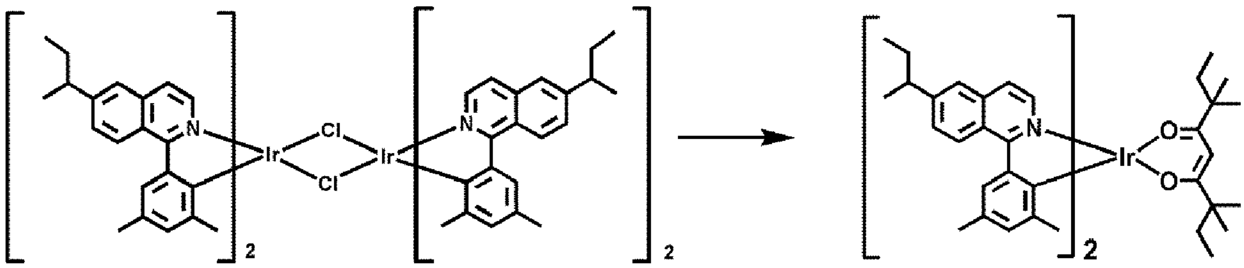

Ir-1(2)

Ir-11

Intermediate Ir-1(2) (1.56 g, 0.97 mmol), 3,3,7,7-tetramethylnonane-4,6-dione (2.06 g, 9.69 mmol), $Na_2CO_3$ (1.02g, 9.69 mmol), and 2-ethoxyethanol (20 mL) were mixed together, and the mixed solution was stirred for 24 hours. The mixture obtained therefrom was filtered, and the filtered solid was thoroughly washed by using ethanol and hexane, and purified by using column chromatography under conditions of dichloromethane:n-hexane=1:1(v/v), thereby obtaining 1.40 g (74 %) of Compound Ir-11.
HRMS(MALDI) calcd for $C_{55}H_{67}IrN_2O_2$: m/z 980.37, Found: 980.39

Synthesis Example of Compound Ir-12

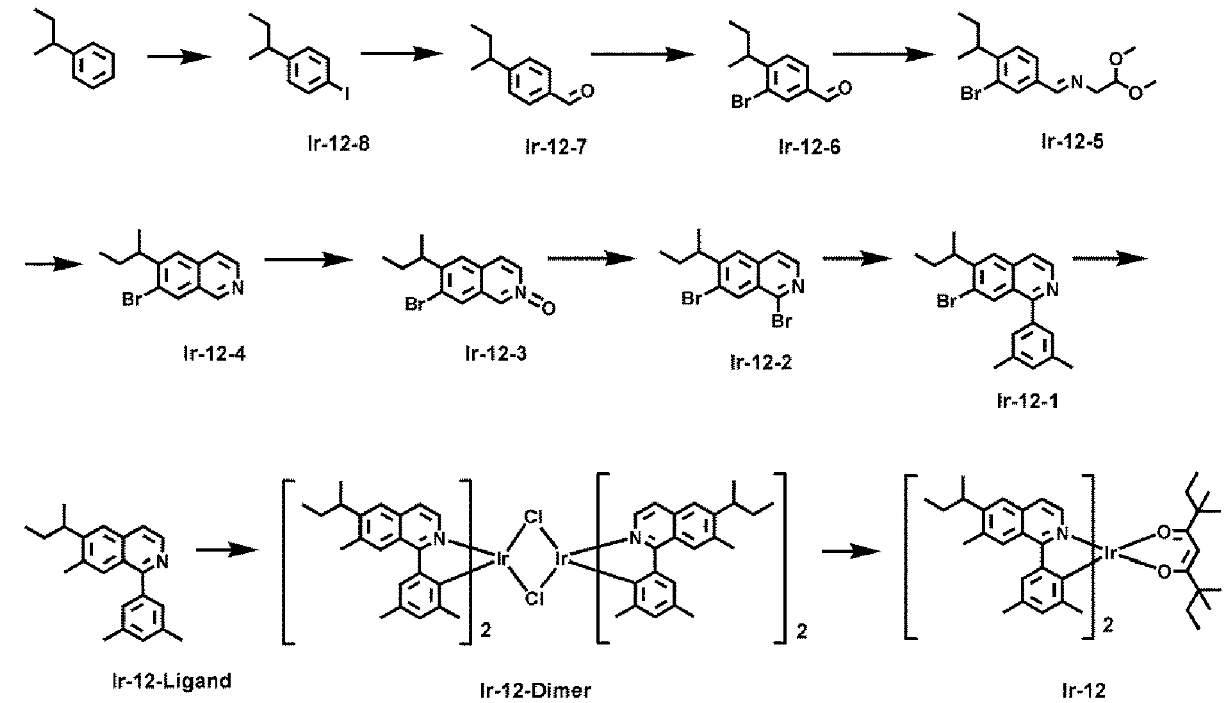

Ir-12-8 Ir-12-7 Ir-12-6 Ir-12-5

Ir-12-4 Ir-12-3 Ir-12-2 Ir-12-1

Ir-12-Ligand Ir-12-Dimer Ir-12

Synthesis of Intermediate Ir-12-8

72 ml (461.3 mmol) of sec-butylbenzene was mixed with 450 ml of acetonitrile, and 88.0 g (346.0 mmol) of iodine and 122.6 g (346.0 mmol) of Selectfluor (1-chloromethyl-4-fluoro-1,4-diazoniabicyclo[2.2.2]octane bis(tetrafluoroborate)) were added thereto. The mixture was then stirred at a temperature of 60 °C for 4 hours. After the completion of the reaction, the reaction mixture was mixed with dichloromethane, and an extraction process was performed thereon using saturated sodium thiosulfate. An organic layer obtained therefrom was then dried with magnesium sulfate, and subjected to distillation under reduced pressure. The resulting product was purified by liquid chromatography, thereby obtaining 75.0 g (yield: 63 %) of Intermediate Ir-12-8.
LC-MS m/z = 261$(M+H)^+$

Synthesis of Intermediate Ir-12-7

148 g (512.9 mmol) of Intermediate Ir-12-8 was mixed with 500 ml of tetrahydrofuran, and 205 ml (205 mmol) of 1.0 M isopropylmagnesium chloride solution was slowly added thereto. The mixture was then stirred at a temperature of 0 °C. After 10 minutes, 256 ml (410 mmol) of a 1.6 M n-butyl lithium (BuLi) solution was slowly added thereto, and then, the mixed solution was stirred for 1 hour. Afterwards, 51 ml (666.7 mmol) of DMF was slowly added thereto dropwise at a temperature of -10 °C, and the resulting solution was stirred at room temperature for 1 hour. After the completion of the reaction, an extraction process was performed on the reaction mixture by using ethyl acetate and an aqueous hydrochloric acid solution. An organic layer obtained therefrom was dried with magnesium sulfate, and subjected to distillation under reduced pressure. The resulting product was purified by liquid chromatography, thereby obtaining 83.2 g (yield: 100 %) of Intermediate Ir-12-7.
LC-MS m/z = 163$(M+H)^+$

Synthesis of Intermediate Ir-12-6

44 g (326.6 mmol) of $AlCl_3$ was added to 100 ml of dichloromethane, and the mixture was heated at a temperature of 40 °C. 30 g (186.6 mmol) of Intermediate Ir-12-7 mixed with 6 ml of dichloromethane was slowly added thereto, and the resulting mixture was then stirred for 30 minutes. 10 ml (205.3 mmol) of bromine was added thereto for 1 hour. After the completion of the reaction, the reaction mixture was slowly added to iced water, and an organic layer obtained therefrom was then dried with magnesium sulfate, and subjected to distillation under reduced pressure. The resulting product was purified by liquid chromatography, thereby obtaining 27 g (yield: 60 %) of Intermediate Ir-12-6.
LC-MS m/z = 241$(M+H)^+$

Synthesis of Intermediate Ir-12-5

27 g (112.7 mmol) of Intermediate Ir-12-6 was mixed with 100 ml of chloroform, and 18 ml (169 mmol) of aminoacetaldehyde dimethyl acetal was slowly added thereto at room temperature. After 1 hour, the mixture was heated at a temperature of 100 °C to remove a solvent therefrom. The resulting reaction mixture was then cooled to room temperature, and without a separate purification process, Intermediate Ir-12-5 was obtained.

Synthesis of Intermediate Ir-12-4

37 g (113.6 mmol) of Intermediate Ir-12-5 was mixed with 100 ml of chloroform, and 11 ml (113.6 mmol) of ethyl chloroformate and 16 ml (136.3 mmol) of trimethyl phosphite were slowly added dropwise thereto at a temperature of 0 °C sequentially in the stated order. The reaction mixture obtained therefrom was then stirred at room temperature for 48 hours, and 454 ml (454 mmol) of 1.0 M $TiCl_4$ was slowly added dropwise thereto at a temperature of 0 °C. The resulting mixture was then heated under reflux for about 48 hours. After the completion of the reaction, the reaction mixture was cooled to room temperature, and then, added to iced water. A water layer obtained therefrom was washed using dichloromethane, and added to 256 g (908.5 mmol) of tartrate solution. The mixed solution was neutralized with saturated $NaHCO_3$ solution, and an extraction process was performed thereon using dichloromethane. An organic layer obtained therefrom was purified by liquid chromatography, thereby obtaining 11 g (yield: 38 %) of Intermediate Ir-12-4.
LC-MS m/z = 264$(M+H)^+$

Synthesis of Intermediate Ir-12-3

11 g (43.2 mmol) of Intermediate Ir-12-4 was mixed with 90 ml of dichloromethane, and 15 g (86.4 mmol) of mCPBA was slowly added dropwise thereto at a temperature of 0 °C. The reaction mixture was stirred for about 18 hours at room temperature, and then, an extraction process was performed thereon using 6 N KOH solution. An organic layer obtained therefrom was dried with magnesium sulfate, and without a separate purification process, 12 g (yield: 100 %) of Intermediate Ir-12-3 was obtained.

Synthesis of Intermediate Ir-12-2

12 g (43.2 mmol) of Intermediate Ir-12-3 was mixed with 90 ml of dichloromethane, and 15 g (52 mmol) of $POBr_3$ was slowly added dropwise thereto at a temperature of 0 °C. Then, 1.7 ml (22 mmol) of DMF was slowly added thereto, and the mixture was stirred for about 18 hours at room temperature. After the completion of the reaction, the reaction solution was neutralized with a saturated $NaHCO_3$ solution, and an extraction process was performed thereon using dichloromethane. An organic layer obtained therefrom was dried with magnesium sulfate, and purified by liquid

chromatography, thereby obtaining 3.8 g (yield: 26 %) of Intermediate Ir-12-2.
LC-MS m/z = 342$(M+H)^+$

Synthesis of Intermediate Ir-12-1

3.8 g (10.9 mmol) of Intermediate Ir-12-2 was mixed with 40 ml of toluene and 8 ml of EtOH, and 1.5 g (9.8 mmol) of 3,5-dimethylphenyl boronic acid, 0.6 g (0.5 mmol) of a $Pd(PPh_3)_4$, and 8 ml of 2.0 N $Na_2CO_3$ solution were added thereto. The mixture was then heated under reflux at a temperature of 85 °C for 18 hours. After the completion of the reaction, an extraction process was performed thereon using 50 ml of ethyl acetate. An organic layer obtained therefrom was dried with magnesium sulfate, and purified by liquid chromatography, thereby obtaining 3.6 g (yield: 90 %) of Intermediate Ir-12-1.
LC-MS m/z = 368$(M+H)^+$

Synthesis of Intermediate Ir-12-Ligand

4.1 mmol of Intermediate Ir-12-1 was mixed with 80 ml of THF. 2.1 g (8.2 mmol) of DABAL-$Me_3$ (triethylenediaminine bis(trimethylaluminum)), 0.4 g (0.4 mmol) of a $Pd(PPh_3)_4$, and 0.4 g (0.4 mmol) of Xphos (2-dicyclohexylphosphino-2',4',6'-triisopropylbiphenyl) were added thereto, the mixture was heated under reflux at a temperature of 80 °C for 18 hours. After the completion of the reaction, the reaction mixture was neutralized with HCl, and then, an extraction process was performed thereon using 100 ml of ethyl acetate. An organic layer obtained therefrom was then dried with magnesium sulfate, and then, subjected to distillation under reduced pressure. The resulting product was purified by liquid chromatography, thereby obtaining 0.9 g (yield: 90 %) of Intermediate Ir-12-Ligand.
LC-MS m/z = 304$(M+H)^+$

Synthesis of Ir-12-Dimer

2.96 mmol of Intermediate Ir-12-Ligand and 0.5 g (1.41 mmol) of iridium chloride were mixed with 45 mL of 2-ethoxyethanol and 15 mL of distilled water, and the resulting solution was stirred under reflux for 24 hours. When the reaction was complete, the temperature was lowered to room temperature. A solid produced therefrom was separated by filtration, and then, sufficiently washed using water/methanol/hexane in the stated order. The resulting solid was dried in a vacuum oven, thereby obtaining Ir-12-Dimer (yield: 77 %).

Synthesis of Compound Ir-12

0.57 mmol of Ir-12-Dimer, 1.43 mmol of 3,3,7,7-tetramethylnonane-4,6-dione, and 0.18 g (1.71 mmol) of $Na_2CO_3$ were mixed with 15 mL of 2-ethoxyethanol, and the mixed solution was stirred for 24 hours. When the reaction was complete, a solid obtained by filtering the reaction mixture was washed sufficiently with ethanol and hexane, and then, was subjected to column chromatography under conditions of dichloromethane: n-hexane=1:1(v/v), thereby obtaining Compound Ir-12 (yield: 45 %). The synthesized compound was identified by LCMS.
LC-MS m/z = 1009$(M+H)^+$

Synthesis Example of Compound Ir-13

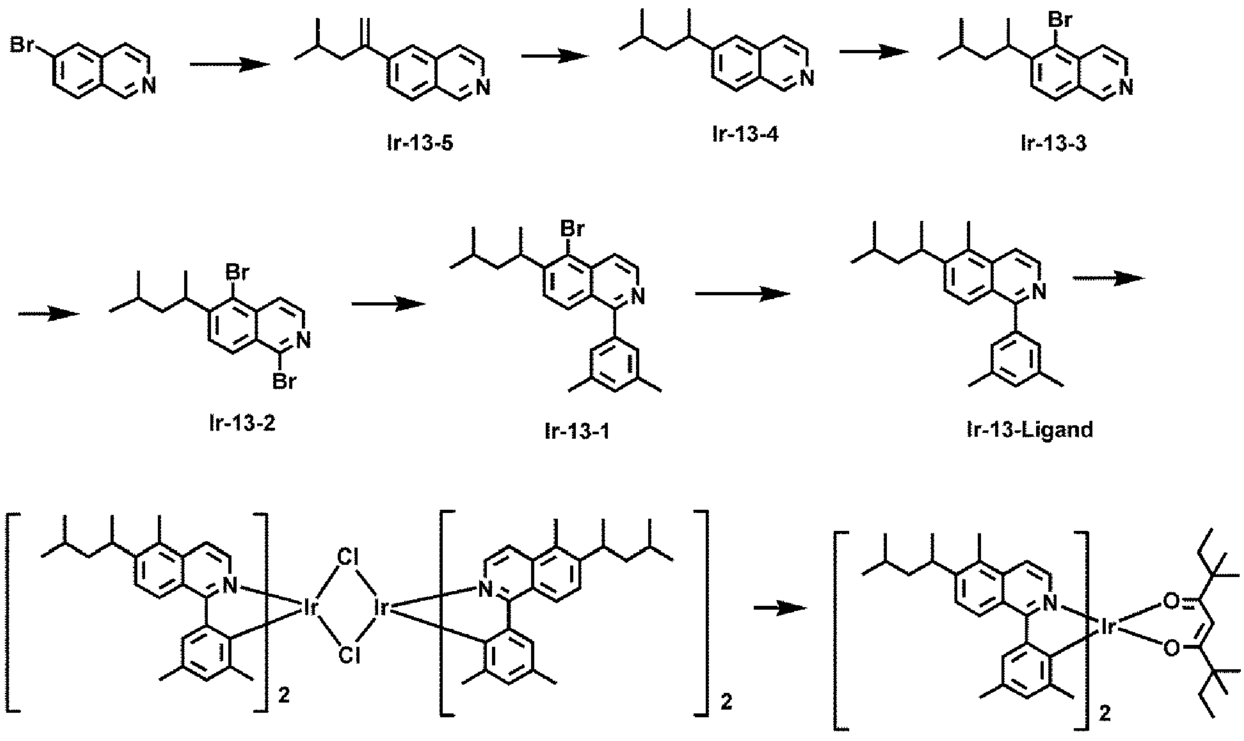

Ir-13-5 Ir-13-4 Ir-13-3

Ir-13-2 Ir-13-1 Ir-13-Ligand

Ir-13-Dimer Ir-13

Synthesis of Intermediate Ir-13-5

20 g (96.1 mmol) of 6-bromoisoquinoline was mixed with 120 ml of tetrahydrofuran, and 11 g (9.6 mmol) of $Pd(PPh_3)_4$, 18 g (144.2 mmol) of (4-methylpent-1-en-2-yl)boronic acid, 33.2 g (240.5 mmol) of $K_2CO_3$, and 30 ml of water were added thereto. The mixture was then heated under reflux at a temperature of 80 °C for about 18 hours. After the completion of the reaction, an extraction process was performed thereon using ethyl acetate. An organic layer obtained therefrom was dried with magnesium sulfate, and purified by liquid chromatography, thereby obtaining 16 g (yield: 80 %) of Intermediate Ir-13-5.
LC-MS m/z = $212(M+H)^+$

Synthesis of Intermediate Ir-13-4

55.3 mmol of Intermediate Ir-13-5 was mixed with 200 ml of methanol, and 1.0 g (10 wt%) of a $Pd(PPh_3)_4$ was added thereto. By injecting hydrogen thereto, the mixed solution was stirred for 18 hours. After the completion of the reaction, the reaction mixture was passed through a celite pad, and then, concentrated under reduced pressure. The resulting product was purified by liquid chromatography, thereby obtaining Intermediate Ir-13-4 (yield: 95 %).
LC-MS m/z = $214(M+H)^+$

Synthesis of Intermediate Ir-13-3

5.8 g (43.2 mmol) of $AlCl_3$ was mixed with 120 ml of chloroform, and the mixture was stirred at a temperature of 55 °C for 30 minutes. Then, 4.6 g (21.6 mmol) of Intermediate Ir-13-4 mixed with a small amount of chloroform was slowing added dropwise thereto, and the resulting mixture was stirred at a temperature of 55 °C for 1 hour. Subsequently, 1.2 ml (32.4 mmol) of bromine mixed with 30 ml of chloroform was slowly added dropwise thereto, and the resulting mixture was stirred for 3 hours. After the completion of the reaction, an extraction process was performed thereon using iced water and saturated sodium thiosulfate. An organic layer obtained therefrom was dried with magnesium sulfate, and purified by liquid chromatography, thereby obtaining 2.3 g (yield: 40 %) of Intermediate Ir-13-3.
LC-MS m/z = $292(M+H)^+$

Synthesis of Intermediate Ir-13-2

1.7 g (yield: 70 %) of Intermediate Ir-13-2 was synthesized in the same manner as in the synthesis of Intermediate

Ir-12-2, except that Intermediate Ir-13-3 was used instead of Intermediate Ir-12-3.
LC-MS m/z = 370(M+H)$^+$

Synthesis of Intermediate Ir-13-1

Intermediate Ir-13-1 was synthesized in the same manner as in the synthesis of Intermediate Ir-12-1, except that Intermediate Ir-13-2 was used instead of Intermediate Ir-12-2.
LC-MS m/z = 396(M+H)$^+$

Synthesis of Intermediate Ir-13-Ligand

0.8 g (yield: 85 %) of Intermediate Ir-13-Ligand was synthesized in the same manner as in the synthesis of Intermediate Ir-12-Ligand, except that Intermediate Ir-13-1 was used instead of Intermediate Ir-12-1. The synthesized compound was identified by LCMS.
LC-MS m/z = 332(M+H)$^+$

Synthesis of Ir-13-Dimer

Ir-13-Dimer was synthesized in the same manner as in the synthesis of Ir-12-Dimer, except that Intermediate Ir-13-Ligand was used instead of Intermediate Ir-12-Ligand.

Synthesis of Compound Ir-13

0.5 g (yield: 46 %) of Compound Ir-13 was synthesized in the same manner as in the synthesis of Compound Ir-12, except that Ir-13-Dimer was used instead of Ir-12-Dimer. The synthesized compound was identified by LCMS.
LC-MS m/z = 1065(M+H)$^+$

Synthesis Example of Compound Ir-14

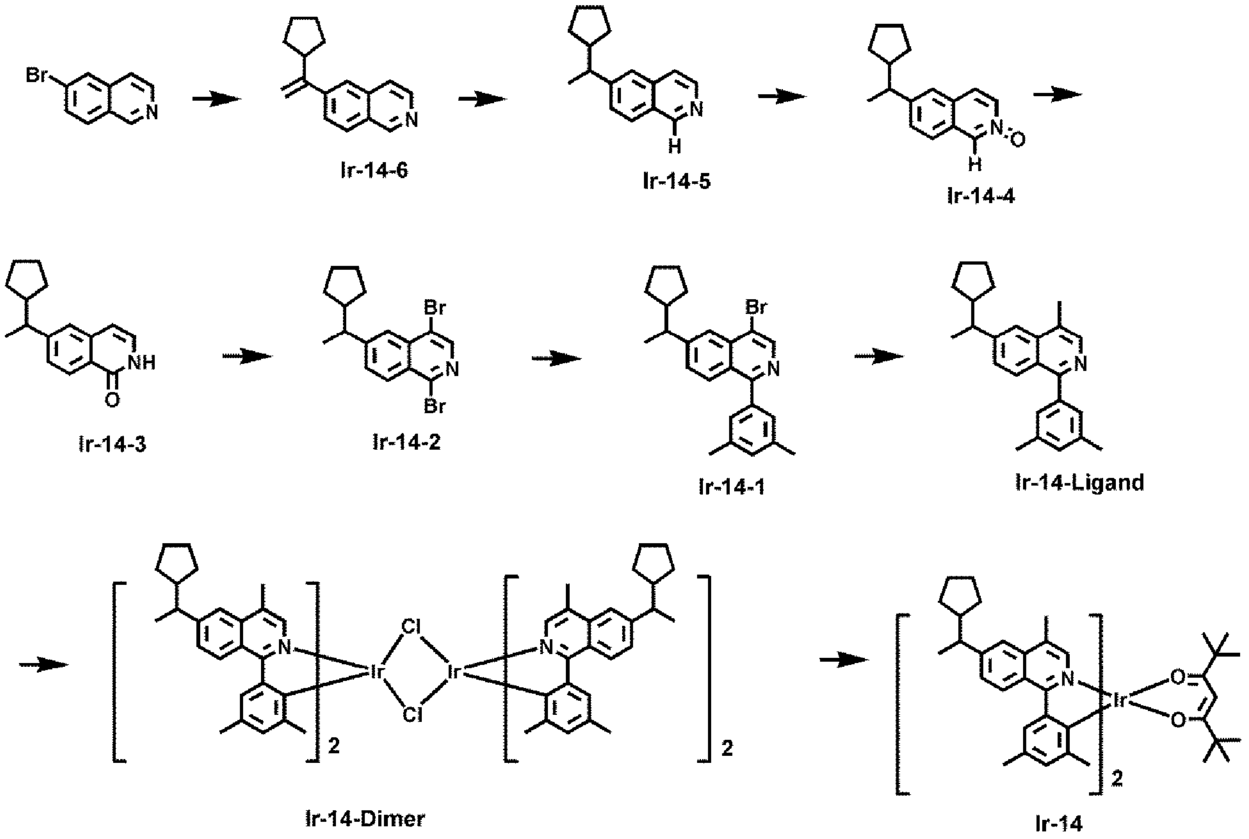
Ir-14-6
Ir-14-5
Ir-14-4
Ir-14-3
Ir-14-2
Ir-14-1
Ir-14-Ligand
Ir-14-Dimer
Ir-14

Synthesis of Intermediate Ir-14-6

44 g (181.4 mmol) of 6-bromoisoquinoline was mixed with 400 ml of tetrahydrofuran (THF) and 100 ml of water, 181.4 mmol of 2-(1-cyclopentylvinyl)-4,4,5,5-tetramethyl-1,3,2-dioxaborolane, 14.7 g (12.7 mmol) of a $Pd(PPh_3)_4$, and 63.0 g (453.0 mmol) of $K_2CO_3$ were added thereto, and the mixture was heated under reflux at a temperature of 80 °C for 18 hours. After the completion of the reaction, the reaction mixture was concentrated under reduced pressure, and an extraction process was performed thereon using 200 ml of ethyl acetate. An organic layer obtained therefrom was then dried with magnesium sulfate, and then, subjected to distillation under reduced pressure. The resulting product was purified by liquid chromatography, thereby obtaining 18.0 g (yield: 46 %) of Intermediate Ir-14-6.

Synthesis of Intermediate Ir-14-5

55.3 mmol of Intermediate Ir-14-6 was mixed with 200 ml of methanol, and 1.0 g (10 wt%) of a $Pd(PPh_3)_4$ was added thereto. By injecting hydrogen thereto, the mixed solution was stirred for 18 hours. After the completion of the reaction, the reaction mixture was passed through a celite pad, and then, concentrated under reduced pressure. The resulting product was purified by liquid chromatography, thereby obtaining Intermediate Ir-14-5.

Synthesis of Intermediate Ir-14-4

50.0 mmol of Intermediate Ir-14-5 was mixed with 60 ml of $CH_2Cl_2$, and 100.0 mmol of 3-chlorobenzoic acid (mCPBA) was slowly added thereto dropwise at a temperature of 0 °C. The resulting product was stirred for one day. After the completion of the reaction, an extraction process was performed on the reaction mixture by using 6N KOH, and an organic layer obtained therefrom was dried with magnesium sulfate. The resulting product was purified by liquid chromatography, thereby obtaining Intermediate Ir-14-4.

Synthesis of Intermediate Ir-14-3

47.2 mmol of Intermediate Ir-14-4 was mixed with acetic anhydride, and the mixed solution was heated under reflux. After the completion of the reaction, an extraction process was performed on the reaction mixture by using saturated sodium bicarbonate. An organic layer obtained therefrom was dried with magnesium sulfate, and then, was subjected to distillation under reduced pressure. The resulting product was purified by liquid chromatography, thereby obtaining Intermediate Ir-14-3.

Synthesis of Intermediate Ir-14-2

34.8 mmol of Intermediate Ir-14-3 was mixed with 350 ml of $CH_2Cl_2$, and 24 g (87.4 mmol) of $POBr_3$ was slowly added thereto dropwise at a temperature of 0 °C. Then, 5.0 ml of DMF was added thereto, and the resulting solution was stirred for 24 h at room temperature. After the completion of the reaction, an extraction process was performed on the reaction mixture by using saturated sodium bicarbonate. An organic layer obtained therefrom was dried with magnesium sulfate, and then, was subjected to distillation under reduced pressure. The resulting product was purified by liquid chromatography, thereby obtaining Intermediate Ir-14-2.

Synthesis of Intermediate Ir-14-1

Intermediate Ir-14-1 was synthesized in the same manner as in the synthesis of Intermediate Ir-12-1, except that Intermediate Ir-14-2 was used instead of Intermediate Ir-12-2.

Synthesis of Intermediate Ir-14-Ligand

Intermediate Ir-14-Ligand was synthesized in the same manner as in the synthesis of Intermediate Ir-12-Ligand, except that Intermediate Ir-14-1 was used instead of Intermediate Ir-12-1.
LC-MS m/z = 344$(M+H)^+$

Synthesis of Ir-14-Dimer

Ir-14-Dimer was synthesized in the same manner as in the synthesis of Ir-12-Dimer, except that Intermediate Ir-14-Ligand was used instead of Intermediate Ir-12-Ligand.

Synthesis of Compound Ir-14

1.5 g (0.82 mmol) of Ir-14-Dimer, 0.38 g (2.05 mmol) of 2,2,6,6-tetramethylheptane-3,5-dione, and 0.34 g (2.46 mmol) of $K_2CO_3$ were mixed with 30 ml of 2-ethoxyethanol, and the mixture was stirred for 48 hours. When the reaction proceeded, a solid obtained by filtering the reaction mixture was sufficiently washed with methanol and hexane, and then, was subjected to column chromatography under conditions of dichloromethane: n-hexane=1:2(v/v), thereby obtaining 0.8 g (yield: 46 %) of Compound Ir-14. The synthesized compound was identified by LCMS.
LC-MS m/z = 1061$(M+H)^+$

Synthesis Example of Compound Ir-15

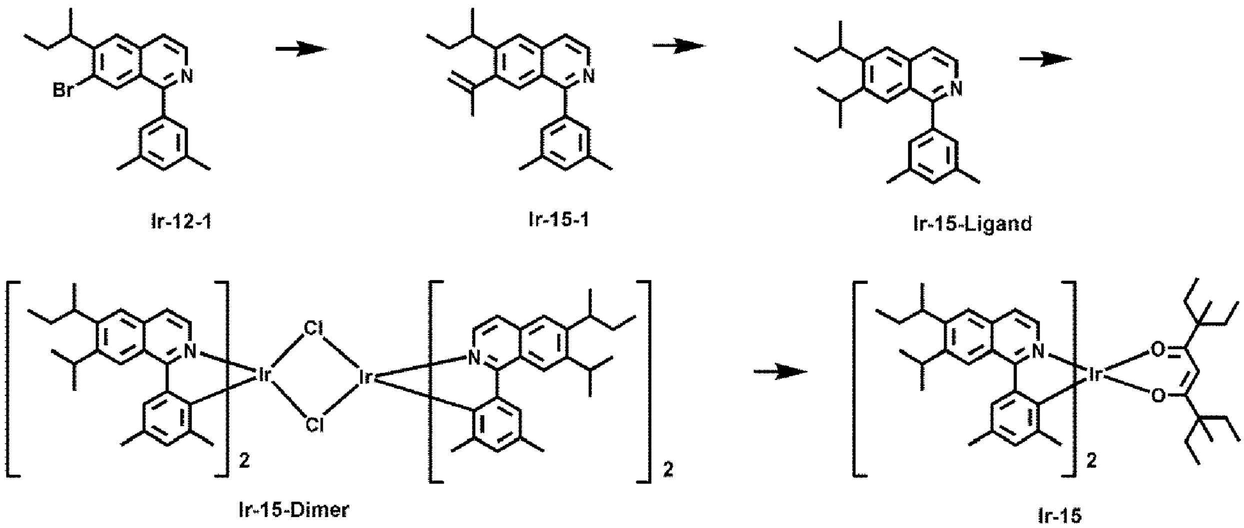

Ir-12-1 Ir-15-1 Ir-15-Ligand

Ir-15-Dimer Ir-15

Synthesis of Intermediate Ir-15-1

1.52 g (4.12 mmol) of Intermediate Ir-12-1 was mixed with 400 ml of THF and 60 ml of water, and 1.0 g (6.2 mmol) of 4,4,5,5-tetramethyl-2-(prop-1-en-2-yl)-1,3,2-dioxaborolane, 0.3 g (0.3 mmol) of $Pd(PPh_3)_4$, and 1.4 g (10.3 mmol) of $K_2CO_3$ were added thereto. The mixture was then heated under reflux at a temperature of 80 °C for 18 hours. After the completion of the reaction, the reaction mixture was concentrated under reduced pressure, and an extraction process was performed thereon using 30 ml of ethyl acetate. An organic layer obtained therefrom was then dried with magnesium sulfate, and then, subjected to distillation under reduced pressure. The resulting product was purified by liquid chromatography, thereby obtaining 1.1 g (yield: 81 %) of Intermediate Ir-15-1.
LC-MS m/z = 330$(M+H)^+$

Synthesis of Intermediate Ir-15-Ligand

1.0 g (3.0 mmol) of Intermediate Ir-15-1 was mixed with 50 ml of MeOH, and 19.0 g (30.0 mmol) of ammonium formate and 0.15 g of Pd/C were added thereto. The mixture was then heated under reflux at a temperature of 70 °C for 6 hours. After the completion of the reaction, the reaction mixture was filtered through a celite pad, and then, concentrated under reduced pressure. The resulting product was purified by liquid chromatography, thereby obtaining 0.9 g (yield: 95 %) of Intermediate Ir-15-Ligand.
LC-MS m/z = 332$(M+H)^+$

Synthesis of Ir-15-Dimer

Ir-15-Dimer was synthesized in the same manner as in the synthesis of Ir-12-Dimer, except that Intermediate Ir-15-Ligand was used instead of Intermediate Ir-12-Ligand.

Synthesis of Compound Ir-15

0.6 g (yield: 47 %) of Compound Ir-15 was synthesized in the same manner as in the synthesis of Compound Ir-12, except that Ir-15-Dimer and 3,7-diethyl-3,7-dimethylnonane-4,6-dione were used instead of Ir-12-Dimer and 3,3,7,7-tetramethylnonane-4,6-dione, respectively.
LC-MS m/z = 1093$(M+H)^+$

Synthesis Example of Compound Ir-16

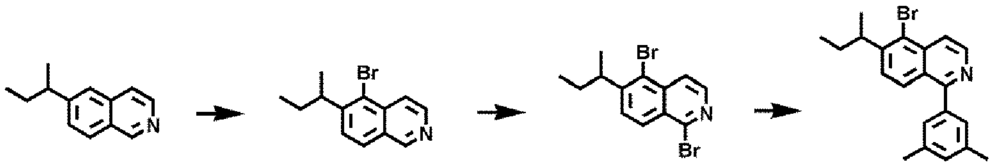

Ir-16-5 Ir-16-4 Ir-16-3 Ir-16-2

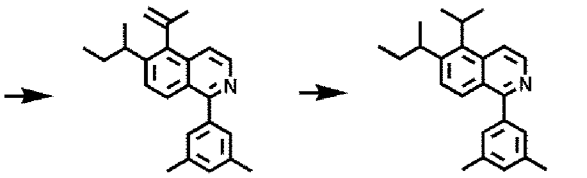

Ir-16-1 Ir-16-Ligand

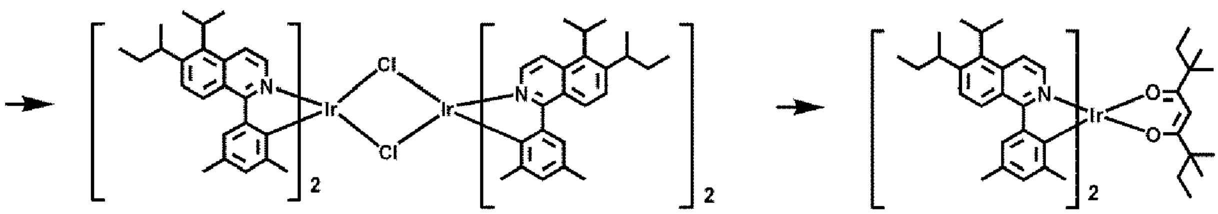

Ir-16-Dimer Ir-16

Synthesis of Intermediate Ir-16-4

Intermediate Ir-16-4 was synthesized in the same manner as in the synthesis of Intermediate Ir-13-3, except that Intermediate Ir-16-5 was used instead of Intermediate Ir-13-4.

Synthesis of Intermediate Ir-16-3

Intermediate Ir-16-3 was synthesized in the same manner as in the synthesis of Intermediate Ir-13-2, except that Intermediate Ir-16-4 was used instead of Intermediate Ir-13-3.

Synthesis of Intermediate Ir-16-2

Intermediate Ir-16-2 was synthesized in the same manner as in the synthesis of Intermediate Ir-13-1, except that Intermediate Ir-16-3 was used instead of Intermediate Ir-13-2.
LC-MS m/z = 369$(M+H)^+$

Synthesis of Intermediate Ir-16-1

Intermediate Ir-16-1 was synthesized in the same manner as in the synthesis of Intermediate Ir-12-1, except that Intermediate Ir-16-2 was used instead of Intermediate Ir-12-2.

LC-MS m/z = 330(M+H)$^+$

Synthesis of Intermediate Ir-16-Ligand

Intermediate Ir-16-Ligand was synthesized in the same manner as in the synthesis of Intermediate Ir-15-Ligand, except that Intermediate Ir-16-1 was used instead of Intermediate Ir-15-1.
LC-MS m/z = 332(M+H)$^+$

Synthesis of Ir-16-Dimer

Ir-16-Dimer was synthesized in the same manner as in the synthesis of Ir-12-Dimer, except that Intermediate Ir-16-Ligand was used instead of Intermediate Ir-12-Ligand

Synthesis of Compound Ir-16

0.9 g (yield: 46 %) of Compound Ir-16 was synthesized in the same manner as in the synthesis of Compound Ir-12, except that Ir-16-Dimer was used instead of Ir-12-Dimer.
LC-MS m/z = 1065(M+H)$^+$

Synthesis Example of Compound Ir-1

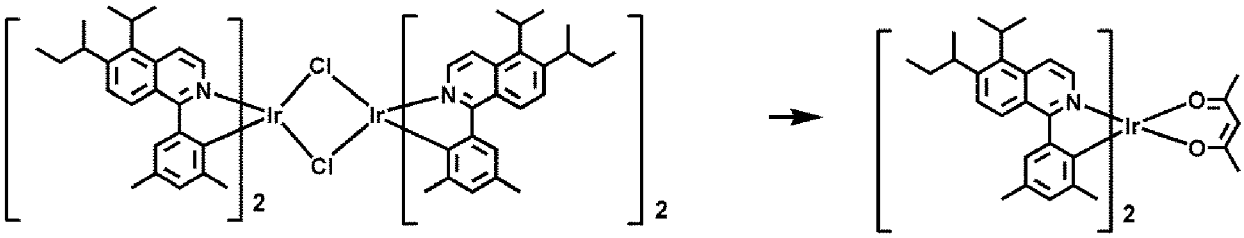

Ir-16-Dimer

Ir-17

0.7 g (yield: 45 %) of Compound Ir-17 was synthesized in the same manner as in the synthesis of Compound Ir-16, except that pentane-2,4-dione was used instead of 3,3,7,7-tetramethylnonane-4,6-dione.
LC-MS m/z = 953(M+H)$^+$

Synthesis Example 1 of Compound Ir-18

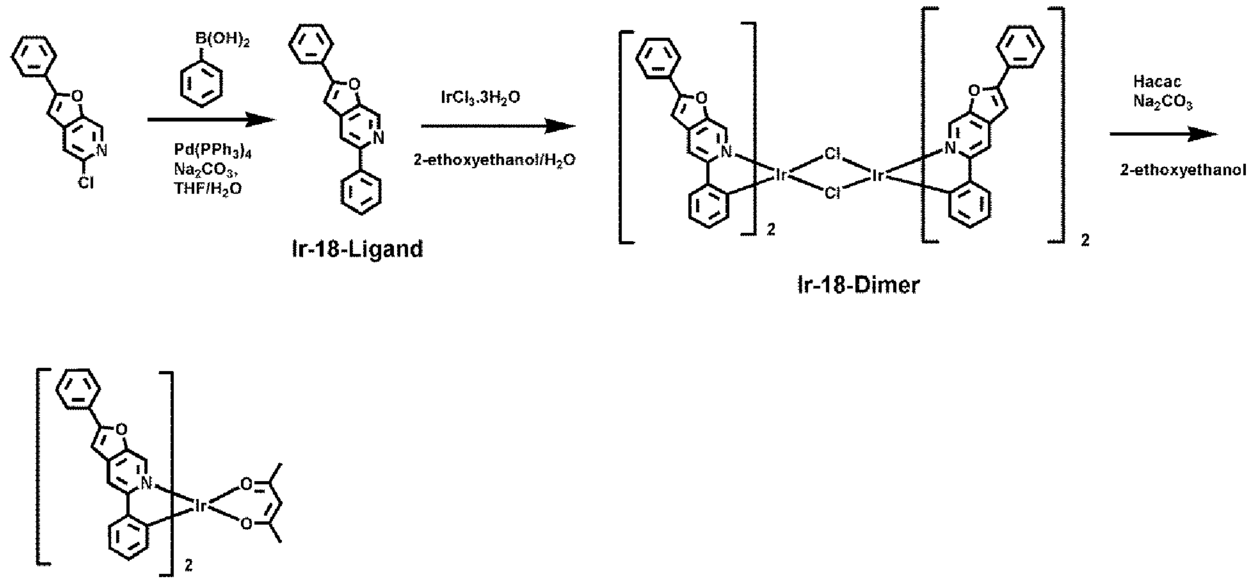


Ir-18-Ligand

Ir-18-Dimer

Ir-18

Synthesis of Intermediate Ir-18-Ligand

5-chloro-2-phenylfuro[2,3-c]pyridine (2.55 g, 11.1 mmol), phenylboronic acid (2.603 g, 16.64 mmol), $Pd(PPh_3)_4$ (1.03 g, 0.89 mmol), and $K_2CO_3$ (3.83 g, 27.7 mmol) were mixed with 60 mL of tetrahydrofuran and 30 mL of distilled water, stirred at a temperature of 90 °C for 18 hours, and then cooled to room temperature. The reaction mixture was extracted with ethyl acetate, dried by using anhydrous magnesium sulfate ($MgSO_4$), and filtered to obtain a filtrate. The filtrate was concentrated under vacuum to obtain a residue. The residue was purified by column chromatography with ethyl acetate:hexane = 1:2 (v/v) as an eluent to obtain Intermediate Ir-18-Ligand (2.90 g, 83 %).
LC-MS m/z = 272.31 $(M+H)^+$.

Synthesis of Intermediate Ir-18-Dimer

Intermediate Ir-18-Ligand (1.99 g, 7.32 mmol) and Iridium chloride hydrate (1.15 g, 3.25 mmol) were mixed with 21 mL of 2-ethoxy ethanol and 7 mL of distilled water, stirred at a temperature of 120 °C for 24 hours under reflux, and then cooled to room temperature. A solid obtained therefrom was filtered, and the filtered solid was sufficiently washed in the order of water/methanol/hexane. The solid was dried in a vacuum oven to obtain Intermediate Ir-18-Dimer (1.95 g, 78 %). The obtained compound was used in a next reaction without additional purification.

Synthesis of Compound Ir-18

30 mL of 2-ethoxy ethanol was added to Intermediate Ir-18-Dimer (1.94 g, 1.26 mmol), acetyl acetone (1.26 g, 12.6 mmol), and $Na_2CO_3$ (1.33 g, 12.6 mmol), and stirred at room temperature for 12 hours. The reaction mixture was extracted using ethyl acetate, dried by using anhydrous magnesium sulfate ($MgSO_4$), and filtered to obtain a filtrate. The filtrate was concentrated under vacuum to obtain a residue. The residue was purified by column chromatography with methylene chloride:hexane = 1:4 (v/v) as an eluent to obtain Compound Ir-18 (0.453 g, 22 %). The obtained compound was identified by Mass and HPLC analysis.
HRMS(MALDI-TOF) calcd for $C_{43}H_{31}IrN_2O_4$: m/z 832.1913, Found: 832.1912.

Synthesis Example of Compound Ir-19

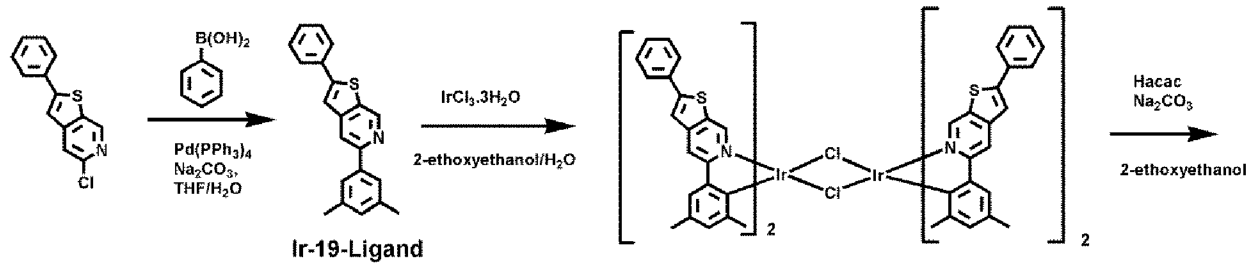


Ir-19-Ligand

Ir-19-Dimer

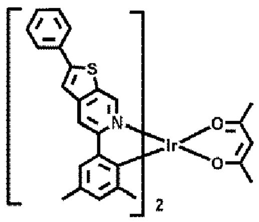

Ir-19

Synthesis of Intermediate Ir-19-Ligand

5-chloro-2-phenylthieno[2,3-c]pyridine (2.34 g, 9.51 mmol), (3,5-dimethylphenyl)boronic acid (2.64 g, 17.56 mmol), $Pd(PPh_3)_4$ (1.08 g, 0.94 mmol), and $K_2CO_3$ (4.05 g, 29.3 mmol) were mixed with 60 mL of tetrahydrofuran and 30 mL of distilled water, stirred at a temperature of 90 °C for 18 hours, and then cooled to room temperature. The reaction mixture was extracted using ethyl acetate, dried by using anhydrous magnesium sulfate ($MgSO_4$), and filtered to obtain a filtrate. The filtrate was concentrated under vacuum to obtain a residue. The residue was purified by column chromatography with ethyl acetate:hexane = 1:2 (v/v) as an eluent to obtain Intermediate Ir-19-Ligand (2.54 g, 85 %).
LC-MS m/z = 316 $(M+H)^+$.

Synthesis of Intermediate Ir-19-Dimer

Intermediate Ir-19-Ligand (2.07 g, 6.57 mmol) and iridium chloride hydrate (1.07 g, 3.03 mmol) were mixed with 21 mL of 2-ethoxy ethanol and 7 mL of distilled water, stirred at a temperature of 120 °C for 24 hours under reflux, and then cooled to room temperature. A solid obtained therefrom was filtered, and the filtered solid sufficiently washed in the order of water/methanol/hexane. The solid was dried in a vacuum oven to obtain Intermediate Ir-19-Dimer (2.11 g, 84 %). The obtained compound was used in a next reaction without additional purification.

Synthesis of Compound Ir-19

30 mL of 2-ethoxy ethanol was added to Intermediate Ir-19-Dimer (2.05 g, 1.20 mmol), acetyl acetone (1.29 g, 12.9 mmol), and $Na_2CO_3$ (1.37 g, 12.9 mmol), and stirred at room temperature for 12 hours. The reaction mixture was extracted using ethyl acetate, dried by using anhydrous magnesium sulfate ($MgSO_4$), and filtered to obtain a filtrate. The filtrate was concentrated under vacuum to obtain a residue. The residue was purified by column chromatography with methylene chloride:hexane = 1:4 (v/v) as an eluent to obtain Compound Ir-19 (0.41 g, 19 %). The obtained compound was identified by Mass and HPLC analysis.
HRMS (MALDI-TOF) calcd for $C_{47}H_{39}IrN_2O_2S_2$: m/z 920.2082, Found: 920.2080.

Synthesis Example of Compound Ir-20

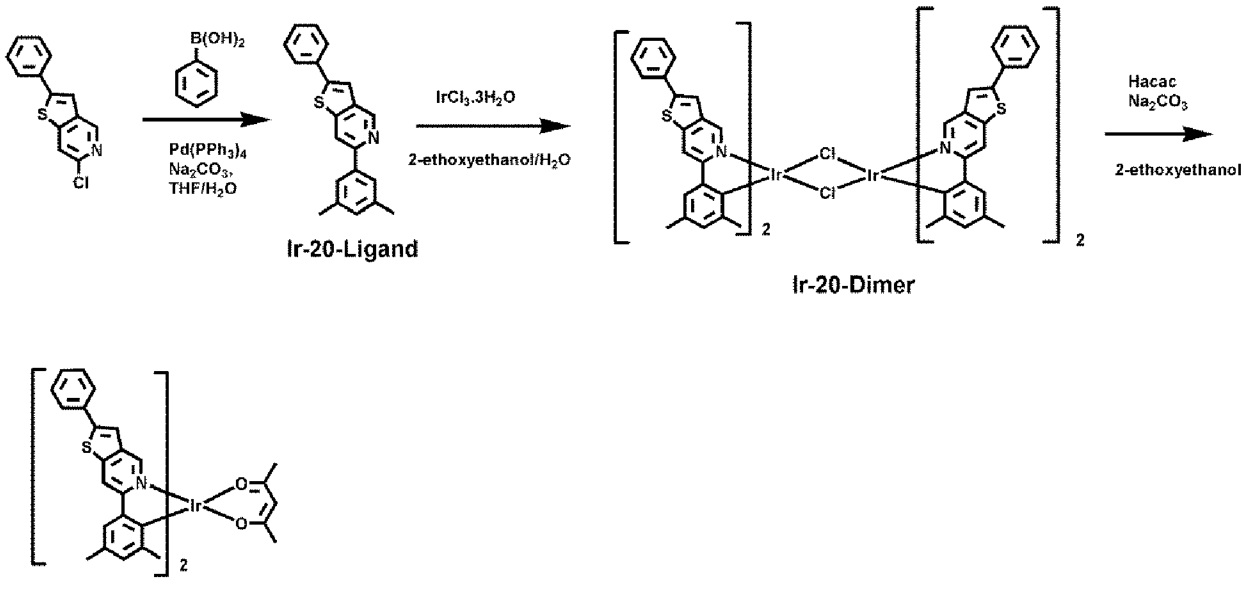


Ir-20-Ligand

Ir-20-Dimer

Ir-20

Synthesis of Intermediate Ir-20-Ligand

6-chloro-2-phenylthieno[3,2-c]pyridine (2.34 g, 9.51 mmol), (3,5-dimethylphenyl)boronic acid (2.64 g, 17.56 mmol), $Pd(PPh_3)_4$ (1.08 g, 0.94 mmol), and $K_2CO_3$ (4.05 g, 29.3 mmol) were mixed with 60 mL of tetrahydrofuran and 30 mL of distilled water, stirred at a temperature of 90 °C for 18 hours, and then cooled to room temperature. The reaction mixture was extracted using ethyl acetate, dried by using anhydrous magnesium sulfate ($MgSO_4$), and filtered to obtain a filtrate. The filtrate was concentrated under vacuum to obtain a residue. The residue was purified by column chromatography with ethyl acetate:hexane = 1:2 (v/v) as an eluent to obtain Intermediate Ir-20-Ligand (2.67 g, 87 %).
LC-MS m/z = 316 $(M+H)^+$.

Synthesis of Intermediate Ir-20-Dimer

Intermediate Ir-20-Ligand (2.32 g, 7.36 mmol) and iridium chloride hydrate (1.07 g, 3.03 mmol) were mixed with 21 mL of 2-ethoxy ethanol and 7 mL of distilled water, stirred at a temperature of 120 °C for 24 hours under reflux, and then cooled to room temperature. A solid obtained therefrom was filtered, and the filtered solid sufficiently washed in the order of water/methanol/hexane. The solid was dried in a vacuum oven to obtain Intermediate Ir-20-Dimer (2.25 g, 80%). The obtained compound was used in a next reaction without additional purification.

Synthesis of Compound Ir-20

30 mL of 2-ethoxy ethanol was added to Intermediate Ir-20-Dimer (2.14 g, 1.25 mmol), acetyl acetone (1.29 g, 12.9 mmol), and $Na_2CO_3$ (1.37 g, 12.9 mmol), and stirred at room temperature for 12 hours. The reaction mixture was extracted using ethyl acetate, dried by using anhydrous magnesium sulfate ($MgSO_4$), and filtered to obtain a filtrate. The filtrate was concentrated under vacuum to obtain a residue. The residue was purified by column chromatography with methylene chloride:hexane = 1:4 (v/v) as an eluent to obtain Compound Ir-20 (0.526 g, 23%). The obtained compound was identified by Mass and HPLC analysis.
HRMS (MALDI-TOF) calcd for $C_{47}H_{39}IrN_2O_2$ $S_2$: m/z 920.2082, Found: 920.2081.

Synthesis Example of Compound Ir-21

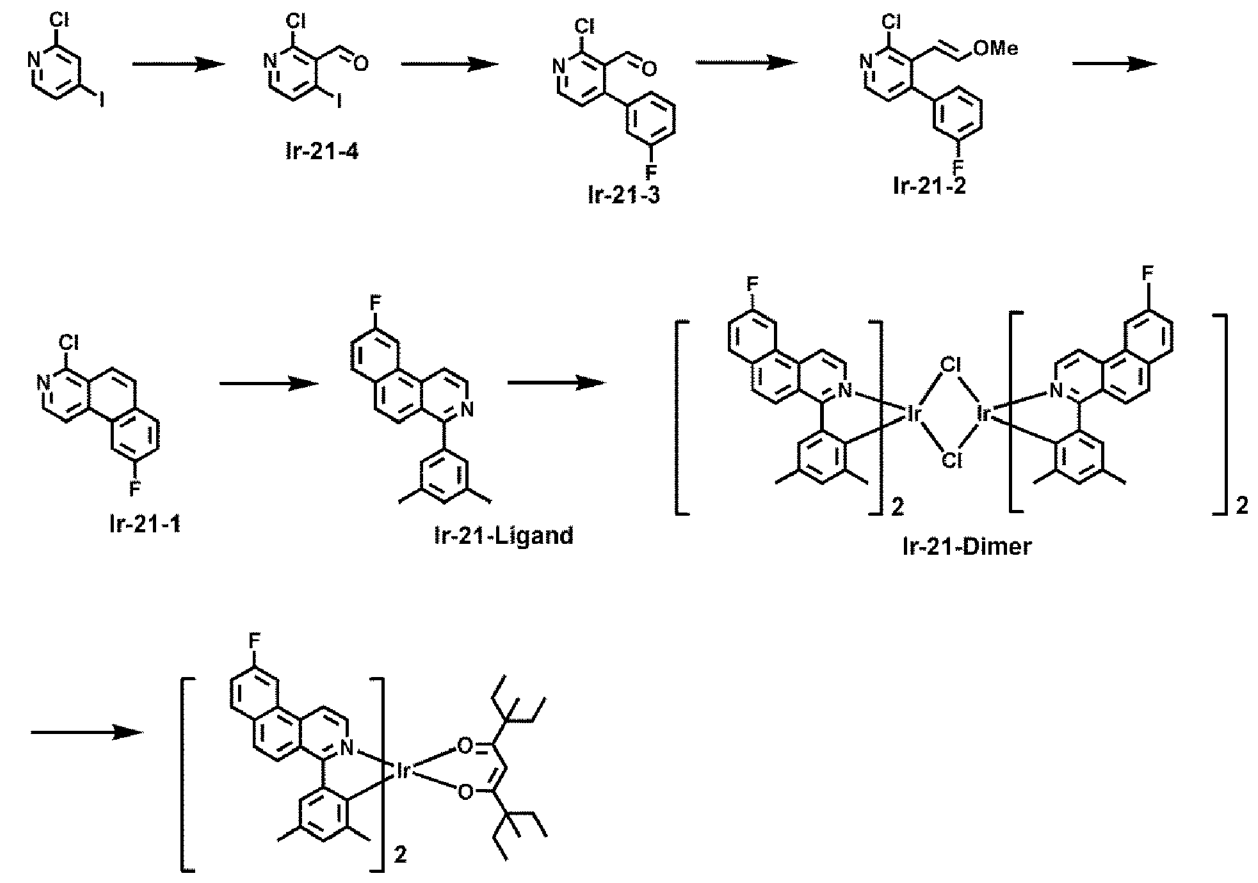

Ir-21-4 Ir-21-3 Ir-21-2

Ir-21-1 Ir-21-Ligand Ir-21-Dimer

Ir-21

Synthesis of Intermediate Ir-21-4

5g (20.9mmol) of 2-chloro-4-iodopyridine was mixed with 50 ml of anhydrous THF 50ml, and then 12.5ml (25mmol) of lithium diisopropylamide in THF was slowly added dropwise thereto at a temperature of -78°C. After 3 hours, 2.5ml (32mmol) of ethylformate was slowly added dropwise thereto and then stirred at room termperature for 18 hours. The organic layer was extracted from the resulting mixture using water and ethyl acetate and dried by using magnesium sulfate ($MgSO_4$). The solvent was removed under reduced pressure, and the residue obtained therefrom was purified by column chromatograph to obtain 2.2 g (40%) of Intermediate Ir-21-4.
LC-MS m/z = 268$(M+H)^+$

Synthesis of Intermediate Ir-21-3

1.9g (7.2mmol) of Intermediate Ir-21-4 was mixed with 60 mL of acetonitrile and 15 mL of water, 0.4g (0.5 mmol) of $PdCl_2(PPh_3)_2$, 1.0g (7.2mmol) of 3-fluorophenylboronic acid and 2.5g (18.0mmol) of $K_2CO_3$ were added thereto and the reaction mixture was stirred at a temperature of 80°C for 18 hours under reflux. The resulting mixture was concentrated under reduced pressure and an extraction process was performed thereon using dichloromethane and water. The resulting organic layer was dried by using magnesium sulfate ($MgSO_4$), the solvent was removed from the resulting organic layer under reduced pressure, and the residue obtained therefrom was purified by column chromatography to obtain 1.4 g (78%) of Intermediate Ir-21-3.
LC-MS m/z = 236$(M+H)^+$

Synthesis of Intermediate Ir-21-2

5.4g (15.8 mmol) of methoxymethyl)triphenylphosphonium chloride was mixed with 50 mL of anhydrous ethyl ether, 16 mL of 1.0M Potassium *tert*-butoxide solution was added dropwise thereto and was stirred at a room temperature for 1 hour. Then, a mixture of 30 mL of anhydrous THF and 1.5g (6.3 mmol) of Intermediate Ir-21-3 was slowly added dropwise thereto and was stirred at a room temperature for 18 hours. The organic layer was extracted from the resulting

mixture using water and ethyl acetate and dried by using magnesium sulfate ($MgSO_4$). The solvent was removed under reduced pressure, and the residue obtained therefrom was purified by column chromatography to obtain 1.6 g (95%) of Intermediate Ir-21-2.
LC-MS m/z = 264$(M+H)^+$

Synthesis of Intermediate Ir-21-1

1.4g (5.1mmol) of Intermediate Ir-21-2 was mixed with 40 mL of dichloromethane, 3.0 mL of methanesulfonic acid was slowly dropwise thereto and was stirred at a room temperature for 18 hours. The organic layer was extracted from the resulting mixture using saturated sodium hydrogen carbonate and dried by using magnesium sulfate ($MgSO_4$). The solvent was removed under reduced pressure, and the residue obtained therefrom was purified by column chromatography to obtain 1.0 g (90%) of Intermediate Ir-21-1.
LC-MS m/z = 232$(M+H)^+$

Synthesis of Intermediate Ir-21-Ligand

1.0g (4.1 mmol) of Intermediate Ir-21 -1 was mixed with 40 mL of THF and 10 mL of water, 0.9g (6.2 mmol) of 3,5-dimethylphenylboronic acid, 0.09g (0.4 mmol) of $Pd(OAc)_2$, 0.35g (0.82 mmol) of Sphos and 1.4g (10.3 mmol) of $K_2CO_3$ were added thereto and was stirred for 1 day under reflux. The organic layer was extracted from the resulting mixture using water and ethyl acetate and dried by using magnesium sulfate ($MgSO_4$). The solvent was removed under reduced pressure, and the residue obtained therefrom was purified by column chromatography to obtain 1.1 g (85%) of Intermediate Ir-21-Ligand.
LC-MS m/z = 302$(M+H)^+$

Synthesis of Intermediate Ir-21-Dimer

1.05g (3.4 mmol) of Intermediate Ir-21-Ligand and 0.6g (1.6 mmol) of iridium chloride were mixed with 40 mL of 2-ethoxyethanol and 15 mL of distilled water, and the resulting solution was stirred under reflux for 24 hours. When the reaction was complete, the temperature was lowered to room temperature. A solid produced therefrom was separated by filtration, and then, sufficiently washed using water/methanol/hexane in the stated order. The resulting solid was dried in a vacuum oven, thereby obtaining 1.1 g of Ir-21-Dimer.

Synthesis of Compound Ir-21

1.0g (0.63 mmol) of Ir-21-Dimer, 0.9g (4.5 mmol) of 3,7-diethyl-3,7-dimethylnonane-4,6-dione, and 0.48g (4.5 mmol) of $Na_2CO_3$ were mixed with 40 mL of 2-ethoxyethanol, and the mixed solution was stirred for 24 hours at a temperature of 90°C. When the reaction was complete, a solid obtained by filtering the reaction mixture was subjected to column chromatography, thereby obtaining 1.0 g of Compound Ir-21 (yield: 80 %).
LC-MS m/z = 1035$(M+H)^+$

Synthesis Example of Compound Ir-22

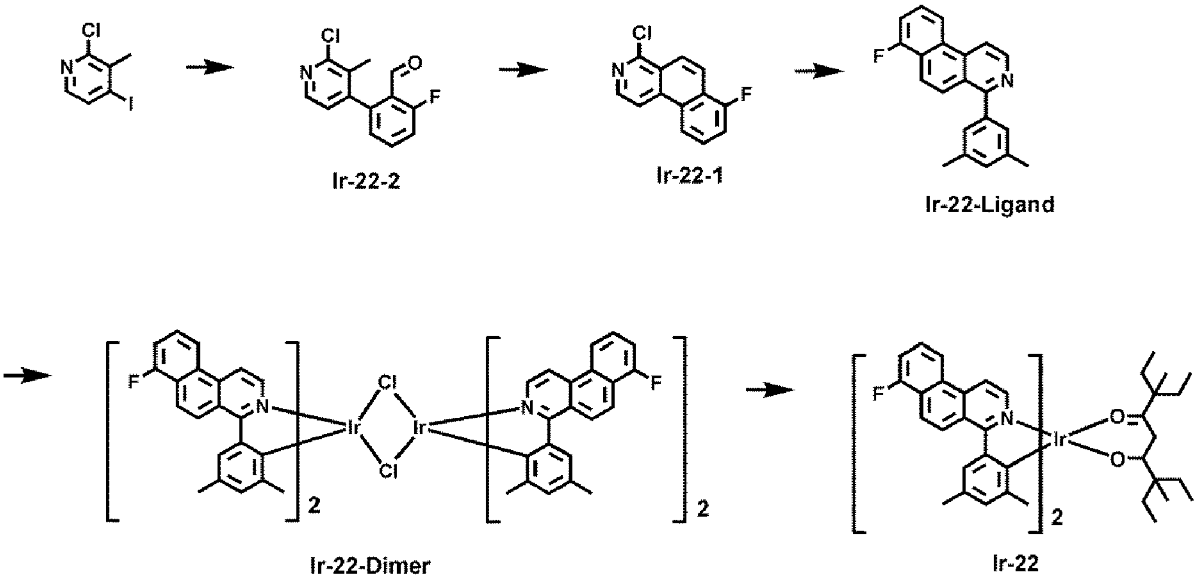

Ir-22-2 Ir-22-1 Ir-22-Ligand

Ir-22-Dimer Ir-22

Synthesis of Intermediate Ir-22-2

6.0g (23.7mmol) of 2-chloro-4-iodo-3-methylpyridine was mixed with 80 mL of acetonitrile and 20ml of water, 1.2g (1.6 mmol) of $PdCl_2(PPh_3)_2$, 4.4g (26.1mmol) of 3-fluoro-2-formylphenyl)boronic acid, and 8.2g (59.2mmol) of $K_2CO_3$ were added thereto and stirred for 18 hours at a temperature of 80°C. The resulting mixture was concentrated under reduced pressure and an extraction process was performed thereon using water and ethyl acetate. The resulting organic layer was dried by using magnesium sulfate ($MgSO_4$), the solvent was removed from the resulting organic layer under reduced pressure, and the residue obtained therefrom was purified by column chromatography to obtain 5.0 g (85%) of Intermediate Ir-22-2.
LC-MS m/z = 250$(M+H)^+$

Synthesis of Intermediate Ir-22-1

4.0g (16.0mmol) of Intermediate Ir-22-2 was mixed with 150 mL of anhydrous N,N-Dimethylformamide, 19ml (19.2mmol) of 1.0M potassium tert-butoxide solution in THF was slowly added dropwise, and heated for 6 hours at a temperature of 80°C. When the reaction was complete, the organic layer was extracted from the resulting mixture using water and ethyl acetate, dried by using magnesium sulfate ($MgSO_4$) and filtered. From the resultant, the solvent was removed under reduced pressure, and the residue obtained therefrom was purified by column chromatography to obtain 1.3 g (35%) of Intermediate Ir-22-1.
LC-MS m/z = 232$(M+H)^+$

Synthesis of Intermediate Ir-22-Ligand

1.4 g (85 %) of Intermediate Ir-22-Ligand was synthesized in the same manner as Synthesis of Intermediate Ir-21-Ligand, except that Intermediate Ir-22-1 was used instead of Intermediate Ir-21-1.
LC-MS m/z = 303$(M+H)^+$

Synthesis of Intermediate Ir-22-Dimer

Intermediate Ir-22-Dimer was synthesized in the same manner as Synthesis of Intermediate Ir-21-Dimer, except that Intermediate Ir-22-Ligand was used instead of Intermediate Ir-21-Ligand.

Synthesis of Compound Ir-22

0.6 g (47 %) of Compound Ir-22 was synthesized in the same manner as Synthesis of Compound Ir-21, except that Intermediate Ir-22-Dimer was used instead of Intermediate Ir-21-Dimer.
LC-MS m/z = 1035$(M+H)^+$

Synthesis Example of Compound Ir-23

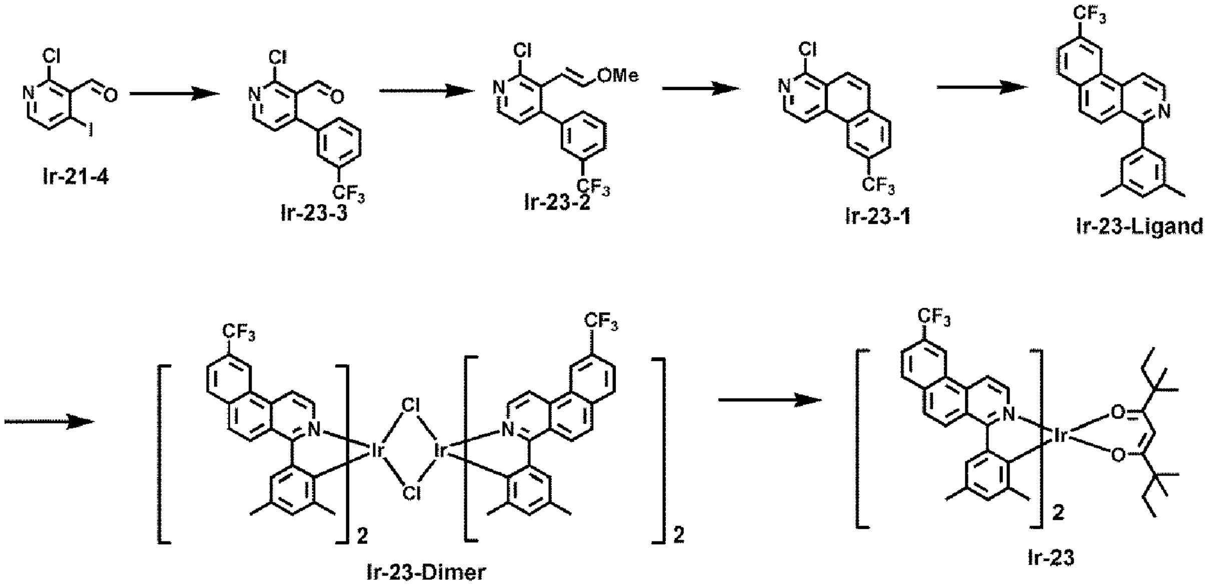

Ir-21-4 Ir-23-3 Ir-23-2 Ir-23-1 Ir-23-Ligand

Ir-23-Dimer Ir-23

Synthesis of Intermediate Ir-23-3

2.5 g (73 %) of Intermediate Ir-23-3 was synthesized in the same manner as Synthesis of Intermediate Ir-21-3, except that 3-(trifluoromethyl)phenylboronic acid was used instead of 3-fluorophenylboronic acid.
LC-MS m/z = 286(M+H)$^+$

Synthesis of Intermediate Ir-23-2

2.7 g (99 %) of Intermediate Ir-23-2 was synthesized in the same manner as Synthesis of Intermediate Ir-21-2, except that Intermediate Ir-23-3 was used instead of Intermediate Ir-21-3.
LC-MS m/z = 314(M+H)$^+$

Synthesis of Intermediate Ir-23-1

1.1 g (45 %) of Intermediate Ir-23-1 was synthesized in the same manner as Synthesis of Intermediate Ir-21-1, except that Intermediate Ir-23-2 was used instead of Intermediate Ir-21-2.
LC-MS m/z = 282(M+H)$^+$

Synthesis of Intermediate Ir-23-Ligand

1.1 g (80 %) of Intermediate Ir-23-Ligand was synthesized in the same manner as Synthesis of Intermediate Ir-21-Ligand, except that Intermediate Ir-23-1 was used instead of Intermediate Ir-21-1.
LC-MS m/z = 352(M+H)$^+$

Synthesis of Intermediate Ir-23-Dimer

Intermediate Ir-23-Dimer was synthesized in the same manner as Synthesis of Intermediate Ir-21-Dimer, except that Intermediate Ir-23-Ligand was used instead of Intermediate Ir-21-Ligand.

Synthesis of Compound Ir-23

0.7 g (43 %) of Compound Ir-23 was synthesized in the same manner as Synthesis of Compound Ir-21, except that Intermediate Ir-23-Dimer and 3,3,7,7-tetramethylnonane-4,6-dione were used instead of Intermediate Ir-21-Dimer and 3,7-diethyl-3,7-dimethylnonane-4,6-dione, respectively.

LC-MS m/z = 1107(M+H)+

Synthesis Example of Compound Ir-24

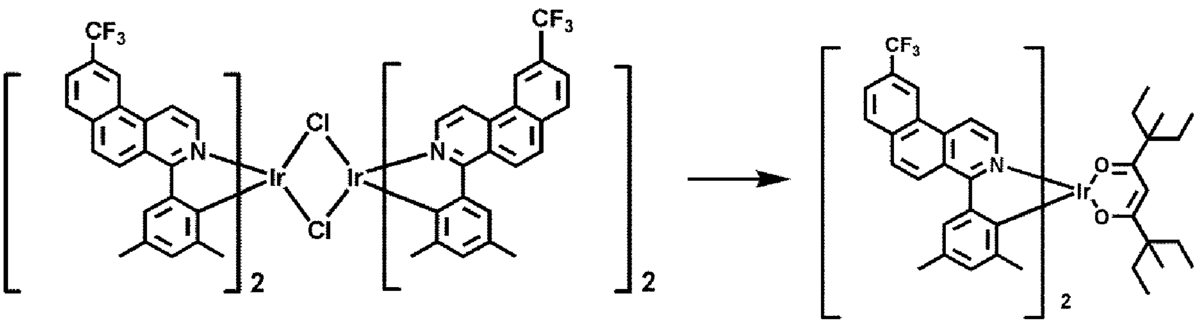

Ir-23-Dimer

Ir-24

19.00 g (11.48 mmol) of Ir-23-Dimer, 13.80 g (57.40 mmol) of 3,7-diethyl-3,7-dimethylnonane-4,6-dione, and 12.17 g (114.80 mmol) of $Na_2CO_3$ were mixed with 300 mL of 2-ethoxyethanol, and the mixed solution was stirred for 24 hours. When the reaction was complete, a solid produced therefrom was separated by filtration, and then, sufficiently washed using methanol and hexane. The resulting solid was subjected to column chromatography under conditions of dichloromethane: n-hexane=1:1(v/v), thereby obtaining 13.00 g of Compound Ir-24 (yield: 55 %).
HRMS(MALDI) calcd for $C_{59}H_{57}F_6IrN_2O_2$: m/z 1132.38, Found: 1132.35

Synthesis Example of Compound Ir-25

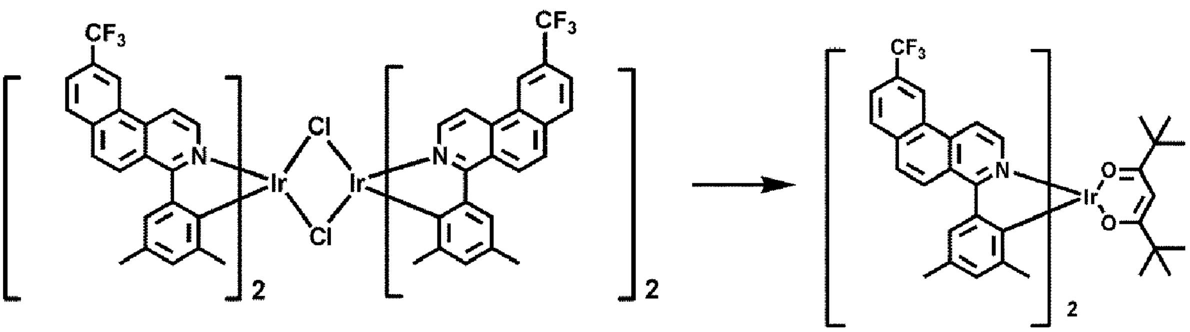

Ir-23-Dimer

Ir-25

5 g (50 %) of Compound Ir-25 was synthesized in the same manner as Synthesis of Compound Ir-24, except that 2,2,6,6-tetramethylheptane-3,5-dione was used instead of 3,7-diethyl-3,7-dimethylnonane-4,6-dione.
(HRMS(MALDI) calcd for $C_{55}H_{49}F_6IrN_2O_2$: m/z 1076.33, Found: 1076.35)

Evaluation Example 1-1: Evaluation of x coordinate value and y coordinate value of PMI diagram

A molecular structure of Compound Pt-A was optimized by using a B3LYP/LanL2DZ function with respect to a transition metal (Pt) included in Compound Pt-A and a B3LYP/6-31G(D,P) function with respect to an organic ligand included in Compound Pt-A, and a DFT calculation was performed by using Gaussian program to evaluate three PMIs of Compound Pt-A. The smallest value among the evaluated three PMIs of Compound Pt-A was defined as $I_1$, and the greatest value was defined as $I_3$. A value between $I_1$ and $I_3$ was defined as $I_2$. $I_1/I_3$ of Compound Pt-A was defined as x that is a x coordinate value in the PMI diagram of Compound Pt-A, and $I_2/I_3$ of Compound Pt-A was defined as y that is a y coordinate value in the PMI diagram of Compound Pt-A. This process was sequentially performed on Compounds Pt-B to Pt-I and Pt-1 to Pt-2, and results of the study are shown in Table 1 to 4.

Table 1

| Compound No. | x | 1.02-x | 1.95-2.7x | y | 1.02 - x ≤ y ≤ 1.95 - 2.7x Satisfaction status ○ : Satisfied X : Not satisfied |
|---|---|---|---|---|---|
| Pt-A | 0.414 | 0.606 | 0.8322 | 0.610 | ○ |
| Pt-B | 0.416 | 0.604 | 0.8268 | 0.599 | X |
| Pt-C | 0.523 | 0.497 | 0.5379 | 0.524 | ○ |
| Pt-D | 0.493 | 0.527 | 0.6189 | 0.607 | ○ |
| Pt-E | 0.262 | 0.758 | 1.2426 | 0.805 | ○ |
| Pt-F | 0.361 | 0.659 | 0.9753 | 0.664 | ○ |
| Pt-G | 0.243 | 0.777 | 1.2939 | 0.805 | ○ |
| Pt-H | 0.398 | 0.622 | 0.8754 | 0.667 | ○ |
| Pt-I | 0.273 | 0.747 | 1.2129 | 0.86 | ○ |
| Pt-1 | 0.326 | 0.694 | 1.0698 | 0.779 | ○ |
| Pt-2 | 0.276 | 0.744 | 1.2048 | 0.784 | ○ |

Table 2

| Compound No. | x | 1.06-x | 1.95-2.7x | y | 1.06 - x ≤ y ≤ 1.95 - 2.7x Satisfaction status ○ : Satisfied X : Not satisfied |
|---|---|---|---|---|---|
| Pt-A | 0.414 | 0.646 | 0.8322 | 0.61 | X |
| Pt-B | 0.416 | 0.644 | 0.8268 | 0.599 | X |
| Pt-C | 0.523 | 0.537 | 0.5379 | 0.524 | X |
| Pt-D | 0.493 | 0.567 | 0.6189 | 0.607 | ○ |
| Pt-E | 0.262 | 0.798 | 1.2426 | 0.805 | ○ |
| Pt-F | 0.361 | 0.70 | 0.9753 | 0.664 | X |
| Pt-G | 0.243 | 0.817 | 1.2939 | 0.805 | X |
| Pt-H | 0.398 | 0.662 | 0.8754 | 0.667 | ○ |
| Pt-I | 0.273 | 0.787 | 1.2129 | 0.86 | ○ |
| Pt-1 | 0.326 | 0.734 | 1.0698 | 0.779 | ○ |
| Pt-2 | 0.276 | 0.784 | 1.2048 | 0.784 | ○ |

Table 3

| Compound No. | x | 1.06-x | 4.70-10.0x | y | 1.06 - x ≤ y ≤ 4.70 - 10.0x Satisfaction status ○ : Satisfied X : Not satisfied |
|---|---|---|---|---|---|
| Pt-A | 0.414 | 0.646 | 0.56 | 0.61 | X |
| Pt-B | 0.416 | 0.644 | 0.54 | 0.599 | X |

(continued)

| Compound No. | x | 1.06-x | 4.70-10.0x | y | 1.06 - x ≤ y ≤ 4.70 - 10.0x Satisfaction status ○ : Satisfied X : Not satisfied |
|---|---|---|---|---|---|
| Pt-C | 0.523 | 0.537 | -0.53 | 0.524 | X |
| Pt-D | 0.493 | 0.567 | -0.23 | 0.607 | X |
| Pt-E | 0.262 | 0.798 | 2.08 | 0.805 | ○ |
| Pt-F | 0.361 | 0.70 | 1.09 | 0.664 | X |
| Pt-G | 0.243 | 0.817 | 2.27 | 0.805 | X |
| Pt-H | 0.398 | 0.662 | 0.72 | 0.667 | ○ |
| Pt-I | 0.273 | 0.787 | 1.97 | 0.86 | ○ |
| Pt-1 | 0.326 | 0.734 | 1.44 | 0.779 | ○ |
| Pt-2 | 0.276 | 0.784 | 1.94 | 0.784 | ○ |

Table 4

| Compound No. | x | 1.02-x | 1.16-x | y | 1.02 - x ≤ y ≤ 1.16 - x Satisfaction status ○ : Satisfied X : Not satisfied |
|---|---|---|---|---|---|
| Pt-A | 0.414 | 0.606 | 0.746 | 0.61 | ○ |
| Pt-B | 0.416 | 0.604 | 0.744 | 0.599 | X |
| Pt-C | 0.523 | 0.497 | 0.637 | 0.524 | ○ |
| Pt-D | 0.493 | 0.527 | 0.667 | 0.607 | ○ |
| Pt-E | 0.262 | 0.758 | 0.898 | 0.805 | ○ |
| Pt-F | 0.361 | 0.66 | 0.799 | 0.664 | ○ |
| Pt-G | 0.243 | 0.777 | 0.917 | 0.805 | ○ |
| Pt-H | 0.398 | 0.622 | 0.762 | 0.667 | ○ |
| Pt-I | 0.273 | 0.747 | 0.887 | 0.86 | ○ |
| Pt-1 | 0.326 | 0.694 | 0.834 | 0.779 | ○ |
| Pt-2 | 0.276 | 0.744 | 0.884 | 0.784 | ○ |

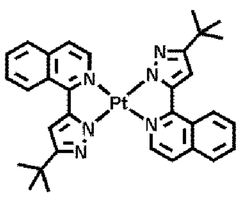

**Pt-A**

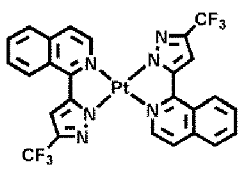

**Pt-B**

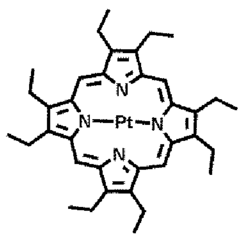

**Pt-C**

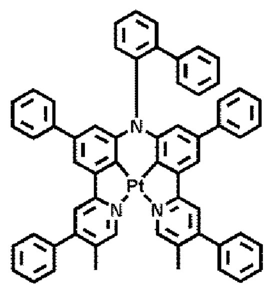

**Pt-D**

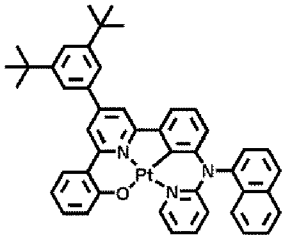
**Pt-E**

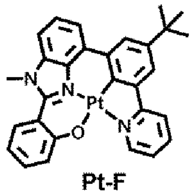
**Pt-F**

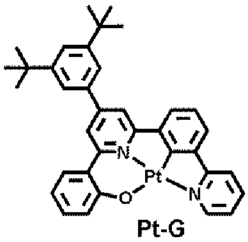
**Pt-G**

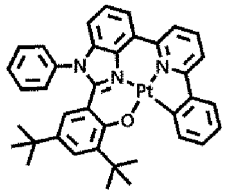
**Pt-H**

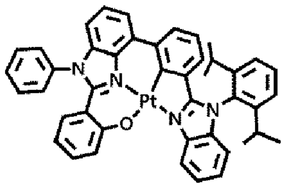
**Pt-I**

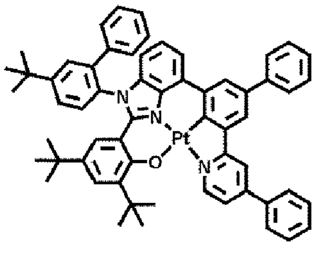
**Pt-1**

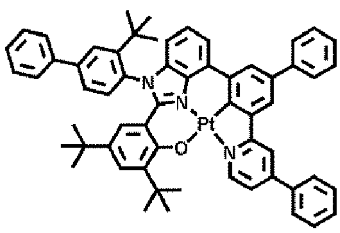
**Pt-2**

Evaluation Example 2-1: Evaluation of radiative decay rate

mCP and Compound Pt-A were co-deposited on a quartz substrate at a weight ratio of 96:4 at a vacuum degree of $10^{-7}$ torr to form a film having a thickness of 40 nanometers (nm).

A PL spectrum of the film was evaluated at room temperature by using a PicoQuant TRPL measurement system FluoTime 300 and a PicoQuant pumping source PLS340 (excitation wavelength = 340 nm, spectral width = 20 nm), a wavelength of a main peak of the spectrum was determined, and PLS340 repeatedly measured the number of photons emitted from the film at the wavelength of the main peak due to a photon pulse (pulse width = 500 picoseconds, ps) applied to the film according to time based on time-correlated single photon counting (TCSPC), thereby obtaining a sufficiently fittable TRPL curve. $T_{decay}$(Ex) (decay time) of the film was obtained by fitting one or more exponential decay functions to the result obtained therefrom, and the radiative decay rate that is a reciprocal of $T_{decay}$(Ex) was calculated. Then, the radiative decay rate of Compound Pt-A was evaluated. The function used for fitting is expressed by Equation 20, and the greatest value of $T_{decay}$ obtained from each exponential decay function used for fitting was taken as $T_{decay}$(Ex). At this time, a baseline or background signal curve was obtained by repeating the same measurement once more for the same measurement time as the measurement time for obtaining the TRPL curve in a dark state (a state in which a pumping signal applied to the predetermined film was blocked), and the baseline or background signal curve was used for fitting as a baseline.

Equation 20

$$f(t) = \sum_{i=1}^{n} A_i \, exp\left(-t/T_{decay,i}\right)$$

The measurement of the radiative decay time was performed on Compounds Pt-B to Pt-I and Pt-1 to Pt-2, and results of the study are shown in Table 5.

Table 5

| Compound No. | Radiative decay rate ($s^{-1}$) |
|---|---|
| Pt-A | $8.60 \times 10^4$ |
| Pt-B | $3.00 \times 10^4$ |
| Pt-C | $5.80 \times 10^3$ |
| Pt-D | $2.10 \times 10^5$ |
| Pt-E | $2.42 \times 10^5$ |
| Pt-F | $1.37 \times 10^5$ |
| Pt-G | $1.25 \times 10^5$ |
| Pt-H | $1.02 \times 10^5$ |
| Pt-I | $1.21 \times 10^5$ |
| Pt-1 | $4.79 \times 10^5$ |
| Pt-2 | $4.09 \times 10^5$ |
| *$s^{-1}$ = reverse seconds | |

Referring to Table 5, it is confirmed that all of Compounds Pt-A to Pt-I have a radiative decay rate of less than $2.5 \times 10^5 s^{-1}$.

Evaluation Example 3-1 : Evaluation of horizontal orientation ratio

mCP and Compound Pt-1 were co-deposited on a quartz substrate at a weight ratio of 96:4 at a vacuum degree of $10^{-7}$ torr to form a film having a thickness of 40 nm, and a sealing glass plate was attached to the film to seal the film.

A PL of the film for each angle was measured from -150° to +150° by using a CoCoLink Luxol-OLED/analyzer LOA-100, and a horizontal orientation ratio of Compound Pt-1 was calculated by using a fitting program of an analyzer. Results of the study are shown in Table 6. This process was repeated on Compound Pt-2, and results of the study are also shown in Table 6.

Table 6

| Sample No. | Co-deposition materials | Horizontal orientation ratio (%) |
|---|---|---|
| Pt-1 | mCP : Compound Pt-1 (4 weight%) | 88 |
| Pt-2 | mCP : Compound Pt-2 (4 weight%) | 90 |

Referring to Table 6, it is confirmed that Compounds Pt-1 to Pt-2 have an excellent horizontal orientation ratio, that is, excellent horizontal optical orientation.

Comparative Example Pt-A

A glass substrate on which an ITO electrode was patterned as an anode was cut to a size of 50 mm x 50 mm x 0.5 mm (mm = millimeters), sonicated with isopropyl alcohol, and pure water each for 5 minutes, and then cleaned by exposure to ultraviolet rays and ozone for 30 minutes.

Then, HT3 and F6-TCNNQ were co-deposited on the ITO electrode at a weight ratio of 98 : 2 to form a hole injection layer having a thickness of 100 Å, and HT3 was deposited on the hole injection layer to form a hole transport layer having a thickness of 1,650 Å.

CBP (host) and Pt-A (dopant) were co-deposited on the hole transport layer at a weight ratio of 90 : 10 to form an emission layer having a thickness of 400 Å.

Then, ET3 and ET-D1 were co-deposited on the emission layer at a volumn ratio of 50 : 50 to form an electron transport layer having a thickness of 350 Å, ET-D1 was deposited on the electron transport layer to form an electron injection layer having a thickness of 10 Å, Al was vacuum-deposited on the electron injection layer to form a cathode having a thickness of 1000 Å, thereby completing the manufacture of an organic light-emitting device having a structure

of ITO (1500 Å) / HT3+F6TCNNQ (2 wt%) (100Å) / HT3 (1650Å) / CBP + Pt-A(10wt%) (400Å) / ET3+ET-D1 (50%) (350Å) / ET-D1 (10Å) / Al(1000A).

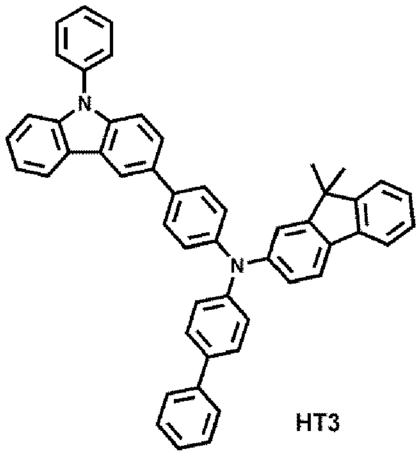
HT3

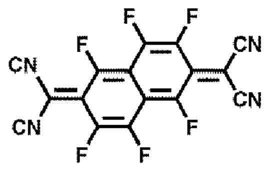
F6-TCNNQ

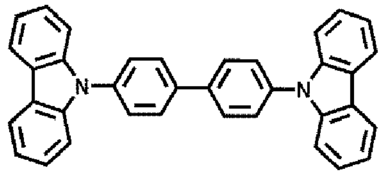
CBP

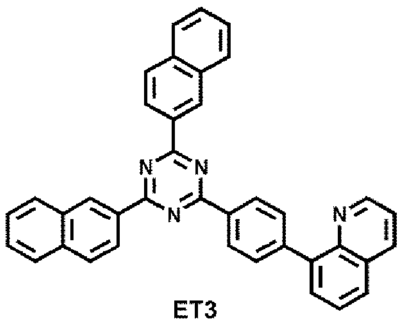
ET3

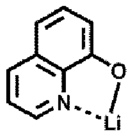
ET-D1

Comparative Examples Pt-B to Pt-I and Examples Pt-1 to Pt-2

Organic light-emitting devices were manufactured in the same manner as in Comparative Example Pt-A, except that Compounds shown in Table 7 were each used instead of Compound Pt-A as a dopant in forming an emission layer.

Evaluation Example 4-1 : Evaluation of characteristics of organic light-emitting devices

The maximum quantum emission efficiency (relative value) and roll-off ratio of the organic light-emitting devices manufactured according to Comparative Examples Pt-A to Pt-I and Examples Pt-1 to Pt-2were evaluated by using a current-voltage meter (Keithley 2400) and a luminance meter (Minolta Cs-1000A), and results of the study are shown in Table 7. The roll-off ratio was calculated by Equation 30.

Equation 30

Roll-off ratio= {1- (efficiency at 8,000 nit / maximum luminescent efficiency)} X 100%

Table 7

| | Dopant compound No. | Maximum quantum emission efficiency (relative value, %) | Roll-off ratio (%) (at 8000 nit) |
|---|---|---|---|
| Comparative Example Pt-A | Pt-A | 67 | 35 |
| Comparative Example Pt-B | Pt-B | 41 | 21 |

(continued)

| | Dopant compound No. | Maximum quantum emission efficiency (relative value, %) | Roll-off ratio (%) (at 8000 nit) |
|---|---|---|---|
| Comparative Example Pt-C | Pt-C | 52 | 89 |
| Comparative Example Pt-D | Pt-D | 96 | 25 |
| Comparative Example Pt-E | Pt-E | 63 | 13 |
| Comparative Example Pt-F | Pt-F | 70 | 11 |
| Comparative Example Pt-G | Pt-G | 67 | 13 |
| Comparative Example Pt-H | Pt-H | 67 | 37 |
| Comparative Example Pt-I | Pt-I | 59 | 21 |
| Example Pt-1 | Pt-1 | 100 | 8 |
| Example Pt-2 | Pt-2 | 96 | 4 |

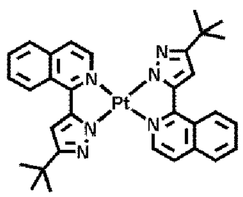
Pt-A

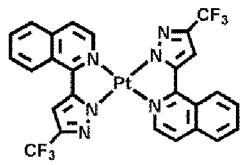
Pt-B

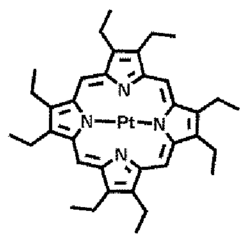
Pt-C

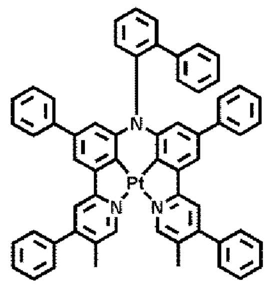
Pt-D

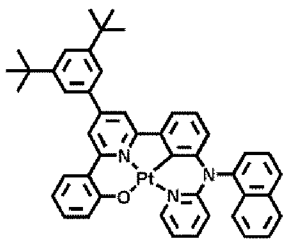
Pt-E

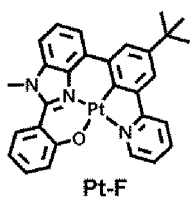
Pt-F

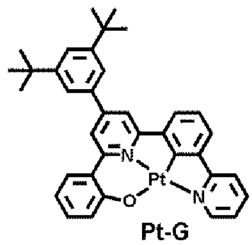
Pt-G

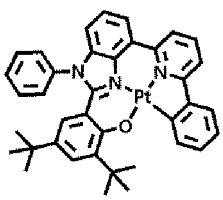
Pt-H

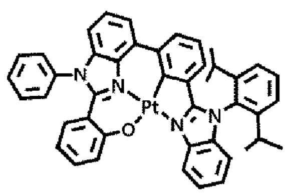
Pt-I

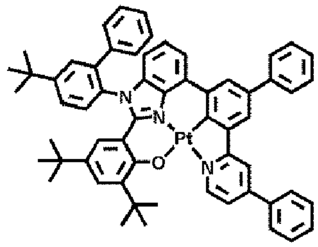

Pt-1

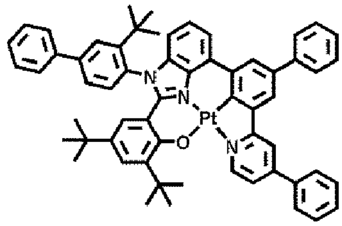

Pt-2

Referring to Table 7, it is confirmed that the organic light-emitting devices of Examples Pt-1 to Pt-2 have improved quantum emission efficiency and improved roll-off ratio, as compared with those of the organic light-emitting devices of Comparative Examples Pt-A to Pt-I.

Evaluation Example 1-2: Evaluation of x coordinate value and y coordinate value of PMI diagram

x and y in the PMI diagrams of Compounds Ir-A to Ir-L and Ir-1 to Ir-25 were evaluated using the same manner as Evaluation Example 1-1 and results of the study are shown in Tables 8 to 11.

Table 8

| Compound No. | x | 1.02-x | 1.95-2.7x | y | 1.02 - x ≤ y ≤ 1.95 - 2.7x Satisfaction status ○ : Satisfied X : Not satisfied |
|---|---|---|---|---|---|
| Ir-A | 0.422 | 0.597 | 0.8106 | 0.963 | X |
| Ir-B | 0.390 | 0.630 | 0.897 | 0.926 | X |
| Ir-C | 0.591 | 0.429 | 0.3543 | 0.869 | X |
| Ir-D | 0.487 | 0.533 | 0.6351 | 0.999 | X |
| Ir-E | 0.711 | 0.310 | 0.0303 | 0.953 | X |
| Ir-F | 0.635 | 0.385 | 0.2355 | 0.649 | X |
| Ir-G | 0.417 | 0.603 | 0.8241 | 0.864 | X |
| Ir-H | 0.384 | 0.640 | 0.9132 | 0.922 | X |
| Ir-I | 0.383 | 0.637 | 0.9159 | 0.936 | X |
| Ir-J | 0.392 | 0.628 | 0.8916 | 0.956 | X |
| Ir-K | 0.412 | 0.608 | 0.8376 | 0.954 | X |
| Ir-L | 0.480 | 0.540 | 0.654 | 0.895 | X |
| Ir-1 | 0.325 | 0.695 | 1.0725 | 0.912 | ○ |
| Ir-2 | 0.274 | 0.746 | 1.2102 | 0.974 | ○ |
| Ir-3 | 0.246 | 0.774 | 1.2858 | 0.992 | ○ |
| Ir-4 | 0.319 | 0.701 | 1.0887 | 0.971 | ○ |
| Ir-5 | 0.303 | 0.717 | 1.1319 | 0.968 | ○ |
| Ir-6 | 0.342 | 0.678 | 1.0266 | 0.986 | ○ |
| Ir-7 | 0.110 | 0.910 | 1.653 | 0.993 | ○ |
| Ir-8 | 0.131 | 0.889 | 1.5963 | 0.986 | ○ |
| Ir-9 | 0.322 | 0.698 | 1.0806 | 0.954 | ○ |
| Ir-10 | 0.248 | 0.772 | 1.2804 | 0.938 | ○ |

(continued)

| Compound No. | x | 1.02-x | 1.95-2.7x | y | 1.02 - x ≤ y ≤ 1.95 - 2.7x Satisfaction status ○ : Satisfied X : Not satisfied |
|---|---|---|---|---|---|
| Ir-11 | 0.350 | 0.670 | 1.005 | 0.918 | ○ |
| Ir-12 | 0.353 | 0.667 | 0.9969 | 0.914 | ○ |
| Ir-13 | 0.267 | 0.753 | 1.2291 | 0.944 | ○ |
| Ir-14 | 0.251 | 0.769 | 1.2723 | 0.948 | ○ |
| Ir-15 | 0.350 | 0.670 | 1.0050 | 0.936 | ○ |
| Ir-16 | 0.338 | 0.680 | 1.0374 | 0.942 | ○ |
| Ir-17 | 0.253 | 0.767 | 1.2669 | 0.965 | ○ |
| Ir-18 | 0.220 | 0.800 | 1.356 | 0.963 | ○ |
| Ir-19 | 0.268 | 0.752 | 1.2264 | 0.968 | ○ |
| Ir-20 | 0.299 | 0.721 | 1.1427 | 0.961 | ○ |
| Ir-21 | 0.385 | 0.635 | 0.9105 | 0.902 | ○ |
| Ir-22 | 0.383 | 0.637 | 0.9159 | 0.909 | ○ |
| Ir-23 | 0.319 | 0.701 | 1.0887 | 0.970 | ○ |
| Ir-24 | 0.347 | 0.670 | 1.0131 | 0.971 | ○ |
| Ir-25 | 0.294 | 0.726 | 1.1562 | 0.959 | ○ |

Table 9

| Compound No. | x | 1.06-x | 1.95-2.7x | **y** | 1.06 - x ≤ y ≤ 1.95 - 2.7x Satisfaction status ○ : Satisfied X : Not satisfied |
|---|---|---|---|---|---|
| Ir-A | 0.422 | 0.638 | 0.8106 | 0.963 | X |
| Ir-B | 0.39 | 0.67 | 0.897 | 0.926 | X |
| Ir-C | 0.591 | 0.469 | 0.3543 | 0.869 | X |
| Ir-D | 0.487 | 0.573 | 0.6351 | 0.999 | X |
| Ir-E | 0.711 | 0.35 | 0.0303 | 0.953 | X |
| Ir-F | 0.635 | 0.425 | 0.2355 | 0.649 | X |
| Ir-G | 0.417 | 0.643 | 0.8241 | 0.864 | X |
| Ir-H | 0.384 | 0.676 | 0.9132 | 0.922 | X |
| Ir-I | 0.383 | 0.677 | 0.9159 | 0.936 | X |
| Ir-J | 0.392 | 0.668 | 0.8916 | 0.956 | X |
| Ir-K | 0.412 | 0.648 | 0.8376 | 0.954 | X |
| Ir-L | 0.48 | 0.58 | 0.654 | 0.895 | X |
| Ir-1 | 0.325 | 0.735 | 1.0725 | 0.912 | ○ |
| Ir-2 | 0.274 | 0.786 | 1.2102 | 0.974 | ○ |
| Ir-3 | 0.246 | 0.814 | 1.2858 | 0.992 | ○ |

(continued)

| Compound No. | x | 1.06-x | 1.95-2.7x | y | 1.06 - x ≤ y ≤ 1.95 - 2.7x Satisfaction status ○ : Satisfied X : Not satisfied |
|---|---|---|---|---|---|
| Ir-4 | 0.319 | 0.741 | 1.0887 | 0.971 | ○ |
| Ir-5 | 0.303 | 0.757 | 1.1319 | 0.968 | ○ |
| Ir-6 | 0.342 | 0.718 | 1.0266 | 0.986 | ○ |
| Ir-7 | 0.11 | 0.95 | 1.653 | 0.993 | ○ |
| Ir-8 | 0.131 | 0.93 | 1.5963 | 0.986 | ○ |
| Ir-9 | 0.322 | 0.738 | 1.0806 | 0.954 | ○ |
| Ir-10 | 0.248 | 0.812 | 1.2804 | 0.938 | ○ |
| Ir-11 | 0.35 | 0.71 | 1.005 | 0.918 | ○ |
| Ir-12 | 0.353 | 0.707 | 0.9969 | 0.914 | ○ |
| Ir-13 | 0.267 | 0.793 | 1.2291 | 0.944 | ○ |
| Ir-14 | 0.251 | 0.809 | 1.2723 | 0.948 | ○ |
| Ir-15 | 0.35 | 0.71 | 1.005 | 0.936 | ○ |
| Ir-16 | 0.338 | 0.722 | 1.0374 | 0.942 | ○ |
| Ir-17 | 0.253 | 0.807 | 1.2669 | 0.965 | ○ |
| Ir-18 | 0.22 | 0.84 | 1.356 | 0.963 | ○ |
| Ir-19 | 0.268 | 0.792 | 1.2264 | 0.968 | ○ |
| Ir-20 | 0.299 | 0.76 | 1.1427 | 0.961 | ○ |
| Ir-21 | 0.385 | 0.675 | 0.9105 | 0.902 | ○ |
| Ir-22 | 0.383 | 0.677 | 0.9159 | 0.909 | ○ |
| Ir-23 | 0.319 | 0.741 | 1.0887 | 0.97 | ○ |
| Ir-24 | 0.347 | 0.713 | 1.0131 | 0.971 | ○ |
| Ir-25 | 0.294 | 0.766 | 1.1562 | 0.959 | ○ |

Table 10

| Compound No. | x | 1.06-x | 4.7-10x | y | 1.06 - x ≤ y ≤ 4.7 - 10x Satisfaction status ○ : Satisfied X : Not satisfied |
|---|---|---|---|---|---|
| Ir-A | 0.422 | 0.638 | 0.48 | 0.963 | X |
| Ir-B | 0.39 | 0.67 | 0.8 | 0.926 | X |
| Ir-C | 0.591 | 0.469 | -1.21 | 0.869 | X |
| Ir-D | 0.487 | 0.573 | -0.17 | 0.999 | X |
| Ir-E | 0.711 | 0.35 | -2.41 | 0.953 | X |
| Ir-F | 0.635 | 0.425 | -1.65 | 0.649 | X |
| Ir-G | 0.417 | 0.643 | 0.53 | 0.864 | X |
| Ir-H | 0.384 | 0.676 | 0.86 | 0.922 | X |

(continued)

| Compound No. | x | 1.06-x | 4.7-10x | y | 1.06 - x ≤ y ≤ 4.7 - 10x Satisfaction status ○ : Satisfied X : Not satisfied |
|---|---|---|---|---|---|
| Ir-I | 0.383 | 0.677 | 0.87 | 0.936 | X |
| Ir-J | 0.392 | 0.668 | 0.78 | 0.956 | X |
| Ir-K | 0.412 | 0.648 | 0.58 | 0.954 | X |
| Ir-L | 0.48 | 0.58 | -0.1 | 0.895 | X |
| Ir-1 | 0.325 | 0.735 | 1.45 | 0.912 | ○ |
| Ir-2 | 0.274 | 0.786 | 1.96 | 0.974 | ○ |
| Ir-3 | 0.246 | 0.814 | 2.24 | 0.992 | ○ |
| Ir-4 | 0.319 | 0.741 | 1.51 | 0.971 | ○ |
| Ir-5 | 0.303 | 0.757 | 1.67 | 0.968 | ○ |
| Ir-6 | 0.342 | 0.718 | 1.28 | 0.986 | ○ |
| Ir-7 | 0.11 | 0.95 | 3.6 | 0.993 | ○ |
| Ir-8 | 0.131 | 0.93 | 3.39 | 0.986 | ○ |
| Ir-9 | 0.322 | 0.738 | 1.48 | 0.954 | ○ |
| Ir-10 | 0.248 | 0.812 | 2.22 | 0.938 | ○ |
| Ir-11 | 0.35 | 0.71 | 1.2 | 0.918 | ○ |
| Ir-12 | 0.353 | 0.707 | 1.17 | 0.914 | ○ |
| Ir-13 | 0.267 | 0.793 | 2.03 | 0.944 | ○ |
| Ir-14 | 0.251 | 0.809 | 2.19 | 0.948 | ○ |
| Ir-15 | 0.35 | 0.71 | 1.2 | 0.936 | ○ |
| Ir-16 | 0.338 | 0.722 | 1.32 | 0.942 | ○ |
| Ir-17 | 0.253 | 0.807 | 2.17 | 0.965 | ○ |
| Ir-18 | 0.22 | 0.84 | 2.5 | 0.963 | ○ |
| Ir-19 | 0.268 | 0.792 | 2.02 | 0.968 | ○ |
| Ir-20 | 0.299 | 0.76 | 1.71 | 0.961 | ○ |
| Ir-21 | 0.385 | 0.675 | 0.85 | 0.902 | X |
| Ir-22 | 0.383 | 0.677 | 0.87 | 0.909 | X |
| Ir-23 | 0.319 | 0.741 | 1.51 | 0.97 | ○ |
| Ir-24 | 0.347 | 0.713 | 1.23 | 0.971 | ○ |
| Ir-25 | 0.294 | 0.766 | 1.76 | 0.959 | ○ |

Table 11

| Compound No. | x | 1.0-0.5x | 1.95-2.7x | y | 1.0 - 0.5x ≤ y ≤ 1.95 - 2.7x Satisfaction status ○ : Satisfied X : Not satisfied |
|---|---|---|---|---|---|
| Ir-A | 0.422 | 0.789 | 0.8106 | 0.963 | X |

(continued)

| Compound No. | x | 1.0-0.5x | 1.95-2.7x | **y** | 1.0 - 0.5x ≤ y ≤ 1.95 - 2.7x Satisfaction status ○ : Satisfied X : Not satisfied |
|---|---|---|---|---|---|
| Ir-B | 0.39 | 0.805 | 0.897 | 0.926 | X |
| Ir-C | 0.591 | 0.7045 | 0.3543 | 0.869 | X |
| Ir-D | 0.487 | 0.7565 | 0.6351 | 0.999 | X |
| Ir-E | 0.711 | 0.64 | 0.0303 | 0.953 | X |
| Ir-F | 0.635 | 0.6825 | 0.2355 | 0.649 | X |
| Ir-G | 0.417 | 0.7915 | 0.8241 | 0.864 | X |
| Ir-H | 0.384 | 0.808 | 0.9132 | 0.922 | X |
| Ir-I | 0.383 | 0.8085 | 0.9159 | 0.936 | X |
| Ir-J | 0.392 | 0.804 | 0.8916 | 0.956 | X |
| Ir-K | 0.412 | 0.794 | 0.8376 | 0.954 | X |
| Ir-L | 0.48 | 0.76 | 0.654 | 0.895 | X |
| Ir-1 | 0.325 | 0.8375 | 1.0725 | 0.912 | ○ |
| Ir-2 | 0.274 | 0.863 | 1.2102 | 0.974 | ○ |
| Ir-3 | 0.246 | 0.877 | 1.2858 | 0.992 | ○ |
| Ir-4 | 0.319 | 0.8405 | 1.0887 | 0.971 | ○ |
| Ir-5 | 0.303 | 0.8485 | 1.1319 | 0.968 | ○ |
| Ir-6 | 0.342 | 0.829 | 1.0266 | 0.986 | ○ |
| Ir-7 | 0.11 | 0.945 | 1.653 | 0.993 | ○ |
| Ir-8 | 0.131 | 0.93 | 1.5963 | 0.986 | ○ |
| Ir-9 | 0.322 | 0.839 | 1.0806 | 0.954 | ○ |
| Ir-10 | 0.248 | 0.876 | 1.2804 | 0.938 | ○ |
| Ir-11 | 0.35 | 0.825 | 1.005 | 0.918 | ○ |
| Ir-12 | 0.353 | 0.8235 | 0.9969 | 0.914 | ○ |
| Ir-13 | 0.267 | 0.8665 | 1.2291 | 0.944 | ○ |
| Ir-14 | 0.251 | 0.8745 | 1.2723 | 0.948 | ○ |
| Ir-15 | 0.35 | 0.825 | 1.005 | 0.936 | ○ |
| Ir-16 | 0.338 | 0.831 | 1.0374 | 0.942 | ○ |
| Ir-17 | 0.253 | 0.8735 | 1.2669 | 0.965 | ○ |
| Ir-18 | 0.22 | 0.89 | 1.356 | 0.963 | ○ |
| Ir-19 | 0.268 | 0.866 | 1.2264 | 0.968 | ○ |
| Ir-20 | 0.299 | 0.85 | 1.1427 | 0.961 | ○ |
| Ir-21 | 0.385 | 0.8075 | 0.9105 | 0.902 | ○ |
| Ir-22 | 0.383 | 0.8085 | 0.9159 | 0.909 | ○ |
| Ir-23 | 0.319 | 0.8405 | 1.0887 | 0.97 | ○ |
| Ir-24 | 0.347 | 0.8265 | 1.0131 | 0.971 | ○ |

(continued)

| Compound No. | x | 1.0-0.5x | 1.95-2.7x | y | 1.0 - 0.5x ≤ y ≤ 1.95 - 2.7x Satisfaction status ○ : Satisfied X : Not satisfied |
|---|---|---|---|---|---|
| Ir-25 | 0.294 | 0.853 | 1.1562 | 0.959 | ○ |

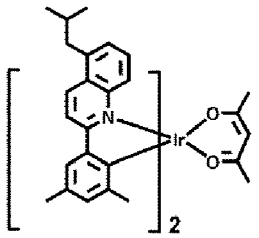
Ir-A
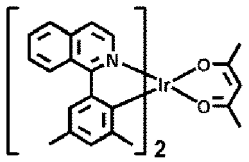
Ir-B
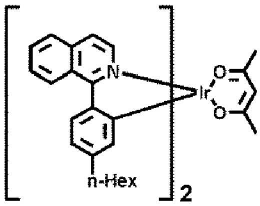
Ir-C
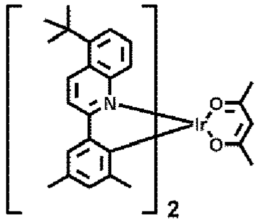
Ir-D
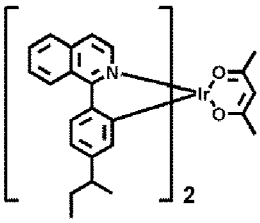
Ir-E
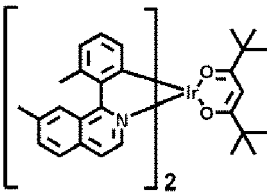
Ir-F
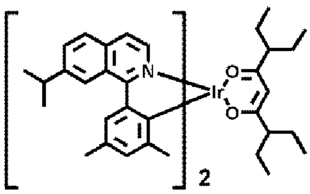
Ir-G
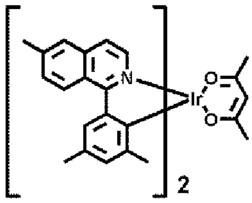
Ir-H
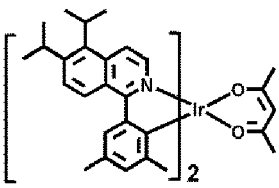
Ir-I
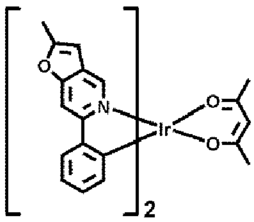
Ir-J
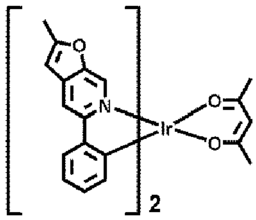
Ir-K
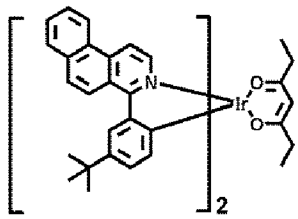
Ir-L
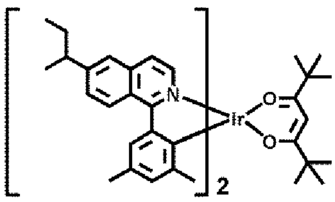
Ir-1
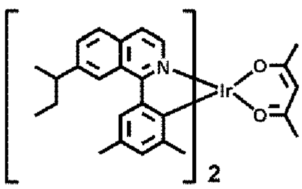
Ir-2
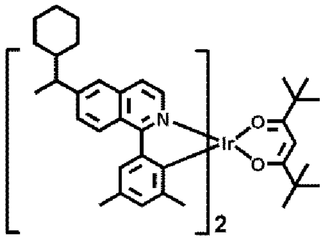
Ir-3
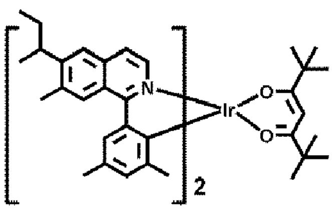
Ir-4
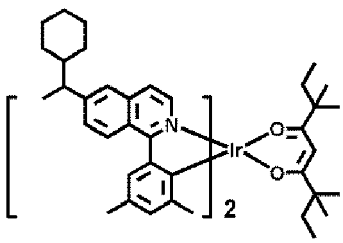
Ir-5
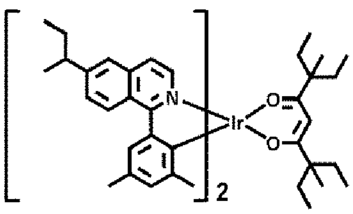
Ir-6

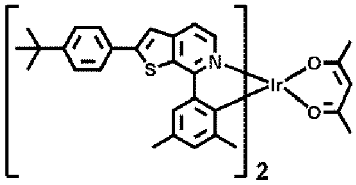
Ir-7

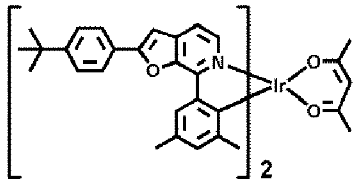
Ir-8

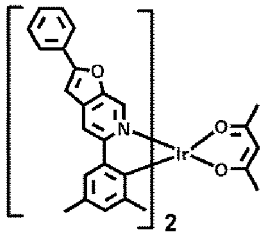
Ir-9

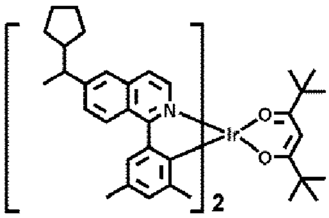
Ir-10

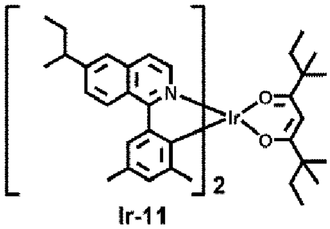
Ir-11

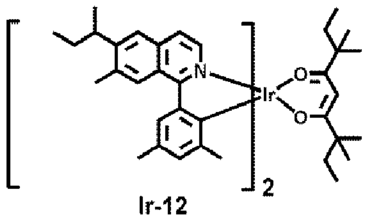
Ir-12

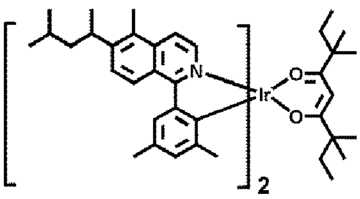
Ir-13

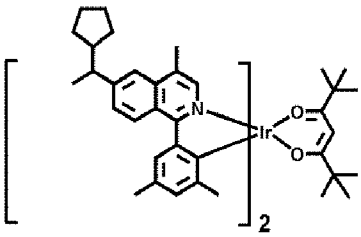
Ir-14

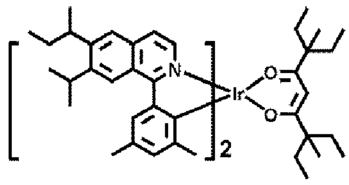
Ir-15

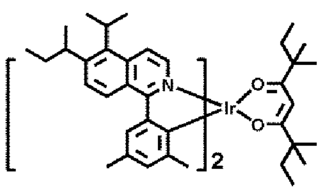
Ir-16

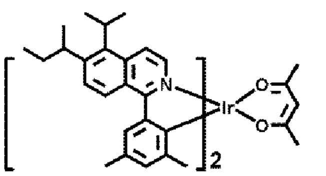
Ir-17

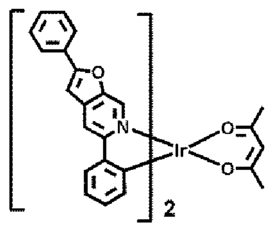
Ir-18

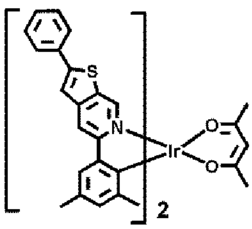
Ir-19

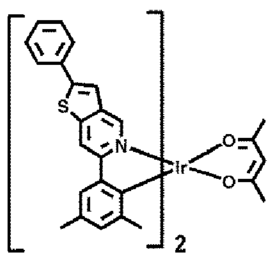
Ir-20

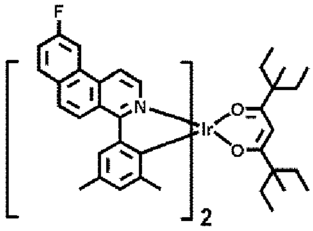
Ir-21

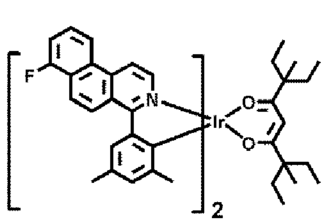
Ir-22

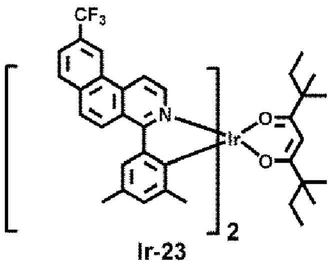

Ir-23

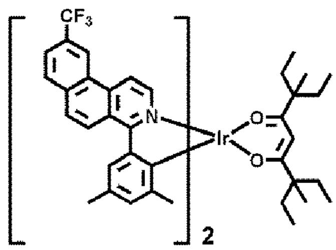

Ir-24

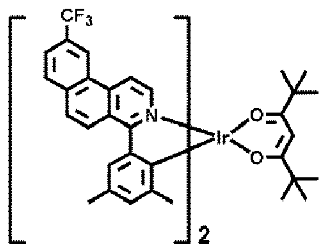

Ir-25

Referring to Tables 8 to 11, it is confirmed that x and y in the PMI diagram of Compounds Ir-A to Ir-L do not satisfy relationships of $1.02 - x \leq y \leq 1.95 - 2.7x$, $1.06 - x \leq y \leq 1.95 - 2.7x$ and $1.0 - 0.5x \leq y \leq 1.95 - 2.7x$.

Evaluation Example 2-2: Evaluation of radiative decay rate

Radiative decay rates of Compounds Ir-A to Ir-L and Ir-1 to Ir-25 were evaluated using the same manner as Evaluation Example 2-1, except that a weight ratio of mCP and Ir Compound is changed to 98 : 2, and results of the study are shown in Table 12.

Table 12

| Compound No. | Radiative decay rate ($s^{-1}$) |
|---|---|
| Ir-A | $5.81 \times 10^5$ |
| Ir-B | $7.42 \times 10^5$ |
| Ir-C | $6.83 \times 10^5$ |
| Ir-D | $5.81 \times 10^5$ |
| Ir-E | $6.92 \times 10^5$ |
| Ir-F | $6.88 \times 10^5$ |
| Ir-G | $7.21 \times 10^5$ |
| Ir-H | $8.02 \times 10^5$ |
| Ir-I | $7.28 \times 10^5$ |
| Ir-J | $1.27 \times 10^5$ |
| Ir-K | $2.93 \times 10^5$ |
| Ir-L | $1.15 \times 10^6$ |
| Ir-1 | $8.81 \times 10^5$ |
| Ir-2 | $7.25 \times 10^5$ |
| Ir-3 | $9.00 \times 10^5$ |
| Ir-4 | $8.04 \times 10^5$ |
| Ir-5 | $9.19 \times 10^5$ |
| Ir-6 | $8.23 \times 10^5$ |
| Ir-7 | $1.49 \times 10^6$ |
| Ir-8 | $1.02 \times 10^6$ |
| Ir-9 | $2.67 \times 10^5$ |
| Ir-10 | $8.55 \times 10^5$ |
| Ir-11 | $9.10 \times 10^5$ |
| Ir-12 | $8.04 \times 10^5$ |

(continued)

| Compound No. | Radiative decay rate ($s^{-1}$) |
|---|---|
| Ir-13 | $9.05 \times 10^5$ |
| Ir-14 | $8.25 \times 10^5$ |
| Ir-15 | $8.28 \times 10^5$ |
| Ir-16 | $7.95 \times 10^5$ |
| Ir-17 | $7.82 \times 10^5$ |
| Ir-18 | $6.70 \times 10^5$ |
| Ir-19 | $1.36 \times 10^6$ |
| Ir-20 | $1.17 \times 10^6$ |
| Ir-21 | $1.26 \times 10^6$ |
| Ir-22 | $1.38 \times 10^6$ |
| Ir-23 | $1.35 \times 10^6$ |
| Ir-24 | $1.45 \times 10^6$ |
| Ir-25 | $1.29 \times 10^6$ |

Evaluation Example 3-2 : Evaluation of horizontal orientation ratio

Horizontal orientation ratio of Compounds Ir-1 to Ir-25 were evaluated using the same manner as Evaluation Example 3-1, except that a weight ratio of mCP and Ir Compound is changed to 98 : 2, and results of the study are shown in Table 13.

Table 13

| Sample No. | Co-deposition materials | Horizontal orientation ratio (%) |
|---|---|---|
| Ir-1 | mCP : Compound Ir-1 (2wt%) | 86 |
| Ir-2 | mCP : Compound Ir-2 (2wt%) | 85 |
| Ir-3 | mCP : Compound Ir-3 (2wt%) | 94 |
| Ir-4 | mCP : Compound Ir-4 (2wt%) | 91 |
| Ir-5 | mCP : Compound Ir-5 (2wt%) | 93 |
| Ir-6 | mCP : Compound Ir-6 (2wt%) | 92 |
| Ir-7 | mCP : Compound Ir-7 (2wt%) | 92 |
| Ir-8 | mCP : Compound Ir-8 (2wt%) | 91 |
| Ir-9 | mCP : Compound Ir-9 (2wt%) | 85 |
| Ir-10 | mCP : Compound Ir-10 (2wt%) | 93 |
| Ir-11 | mCP : Compound Ir-11 (2wt%) | 91 |
| Ir-12 | mCP : Compound Ir-12 (2wt%) | 91 |
| Ir-13 | mCP : Compound Ir-13 (2wt%) | 92 |
| Ir-14 | mCP : Compound Ir-14 (2wt%) | 92 |
| Ir-15 | mCP : Compound Ir-15 (2wt%) | 93 |
| Ir-16 | mCP : Compound Ir-16 (2wt%) | 93 |
| Ir-17 | mCP : Compound Ir-17 (2wt%) | 91 |
| Ir-18 | mCP : Compound Ir-18 (2wt%) | 85 |

(continued)

| Sample No. | Co-deposition materials | Horizontal orientation ratio (%) |
|---|---|---|
| Ir-19 | mCP : Compound Ir-19 (2wt%) | 87 |
| Ir-20 | mCP : Compound Ir-20 (2wt%) | 86 |
| Ir-21 | mCP : Compound Ir-21 (2wt%) | 91 |
| Ir-22 | mCP : Compound Ir-22 (2wt%) | 91 |
| Ir-23 | mCP : Compound Ir-23 (2wt%) | 93 |
| Ir-24 | mCP : Compound Ir-24 (2wt%) | 93 |
| Ir-25 | mCP : Compound Ir-25 (2wt%) | 93 |

Referring to Table 13, it is confirmed that Compounds Ir-1 to Ir-25 have an excellent horizontal orientation ratio, that is, excellent horizontal optical orientation.

Comparative Example Ir-A

A glass substrate on which an ITO electrode was patterned as an anode was cut to a size of 50 mm x 50 mm x 0.5 mm (mm = millimeters), sonicated with isopropyl alcohol, and pure water each for 5 minutes, and then cleaned by exposure to ultraviolet rays and ozone for 30 minutes.

Then, HT3 and F6-TCNNQ were co-deposited on the ITO electrode at a weight ratio of 98 : 2 to form a hole injection layer having a thickness of 100 Å, HT3 was deposited on the hole injection layer to form a hole transport layer having a thickness of 1,350 Å and HT21 was deposited on the hole transport layer to form an electron blocking layer having a thickness of 300 Å.

H52 (host) and Ir-A (dopant) were co-deposited on the electron blocking layer at a weight ratio of 98 : 2 to form an emission layer having a thickness of 400 Å.

Then, ET3 and ET-D1 were co-deposited on the emission layer at a volume ratio of 50 : 50 to form an electron transport layer having a thickness of 350 Å, ET-D1 was deposited on the electron transport layer to form an electron injection layer having a thickness of 10 Å, Al was vacuum-deposited on the electron injection layer to form a cathode having a thickness of 1000 Å, thereby completing the manufacture of an organic light-emitting device having a structure of ITO (1500 Å) / HT3+F6TCNNQ (2 wt%) (100Å) / HT3 (1350Å) / HT21 (300 Å) / H52 + Ir-A(2wt%) (400Å) / ET3+ET-D1 (50%) (350Å) / ET-D1 (10Å) / Al(1000Å).

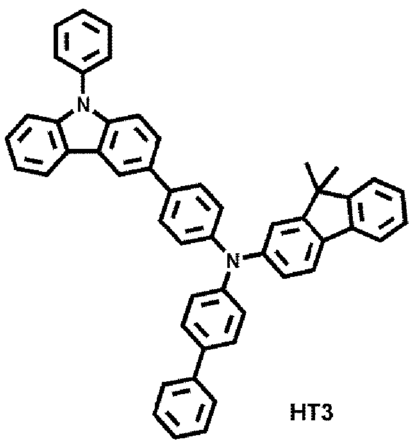

HT3

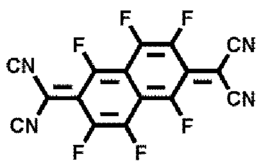

F6-TCNNQ

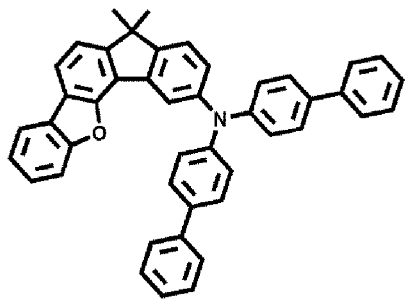

HT21

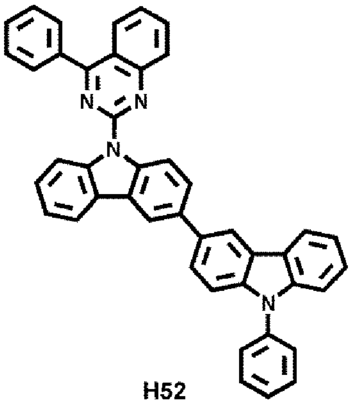

H52

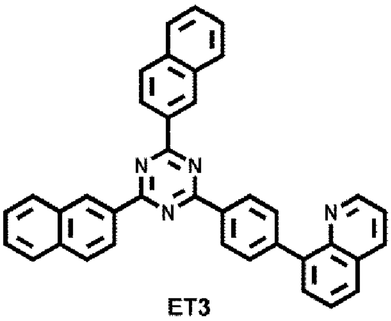

ET3

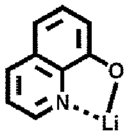

ET-D1

Comparative Examples Ir-B to Ir-L and Examples Ir-1 to Ir-25

Organic light-emitting devices were manufactured in the same manner as in Comparative Example Ir-A, except that Compounds shown in Table 14 were each used instead of Compound Ir-A as a dopant in forming an emission layer.

Evaluation Example 4-2 : Evaluation of characteristics of organic light-emitting devices

The maximum quantum emission efficiency (relative value) and roll-off ratio of the organic light-emitting devices manufactured according to Comparative Examples Ir-A to Ir-L and Examples Ir-1 to Ir-25 were evaluated by using the same manner as Evaluation Example 4-1, and results of the study are shown in Table 8. The roll-off ratio in this Evaluation Example 4-2 was evaluated at 3,500 nit.

Table 14

| | Dopant compound No. | Maximum quantum emission efficiency (relative value, %) | Roll-off ratio (%) (at 3500 nit) |
|---|---|---|---|
| Comparative Example Ir-A | Ir-A | 77 | 16 |
| Comparative Example Ir-B | Ir-B | 71 | 19 |
| Comparative Example Ir-C | Ir-C | 58 | 18 |
| Comparative Example Ir-D | Ir-D | 77 | 17 |
| Comparative Example Ir-E | Ir-E | 65 | 15 |
| Comparative Example Ir-F | Ir-F | 71 | 14 |
| Comparative Example Ir-G | Ir-G | 74 | 15 |
| Comparative Example Ir-H | Ir-H | 77 | 14 |
| Comparative Example Ir-I | Ir-I | 77 | 16 |
| Comparative Example Ir-J | Ir-J | 55 | 18 |
| Comparative Example Ir-K | Ir-K | 58 | 19 |

(continued)

| | Dopant compound No. | Maximum quantum emission efficiency (relative value, %) | Roll-off ratio (%) (at 3500 nit) |
|---|---|---|---|
| Comparative Example Ir-L | Ir-L | 77 | 14 |
| Example Ir-1 | Ir-1 | 81 | 12 |
| Example Ir-2 | Ir-2 | 84 | 13 |
| Example Ir-3 | Ir-3 | 90 | 14 |
| Example Ir-4 | Ir-4 | 87 | 11 |
| Example Ir-5 | Ir-5 | 97 | 10 |
| Example Ir-6 | Ir-6 | 90 | 11 |
| Example Ir-7 | Ir-7 | 100 | 4 |
| Example Ir-8 | Ir-8 | 90 | 5 |
| Example Ir-9 | Ir-9 | 84 | 9 |
| Example Ir-10 | Ir-10 | 84 | 10 |
| Example Ir-11 | Ir-11 | 94 | 12 |
| Example Ir-12 | Ir-12 | 84 | 12 |
| Example Ir-13 | Ir-13 | 87 | 11 |
| Example Ir-14 | Ir-14 | 90 | 12 |
| Example Ir-15 | Ir-15 | 94 | 11 |
| Example Ir-16 | Ir-16 | 94 | 12 |
| Example Ir-17 | Ir-17 | 87 | 10 |
| Example Ir-18 | Ir-18 | 81 | 12 |
| Example Ir-19 | Ir-19 | 87 | 12 |
| Example Ir-20 | Ir-20 | 84 | 12 |
| Example Ir-21 | Ir-21 | 97 | 8 |
| Example Ir-22 | Ir-22 | 97 | 9 |
| Example Ir-23 | Ir-23 | 100 | 8 |
| Example Ir-24 | Ir-24 | 97 | 7 |
| Example Ir-25 | Ir-25 | 100 | 8 |

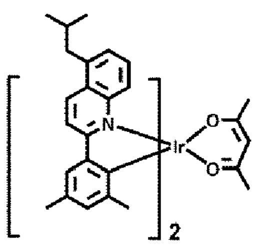
Ir-A

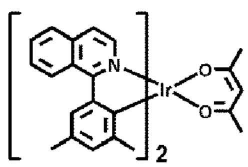
Ir-B

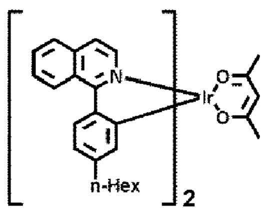
Ir-C

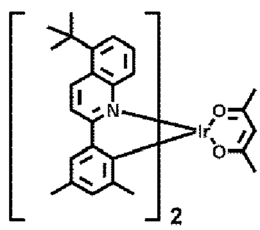
Ir-D

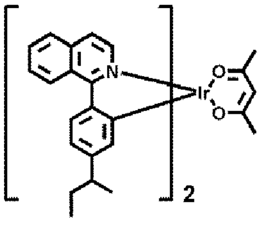
Ir-E

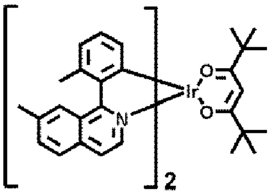
Ir-F

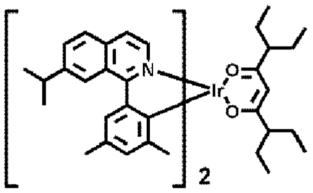
Ir-G

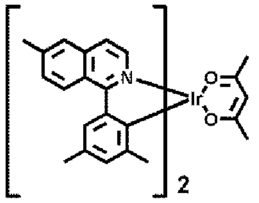
Ir-H

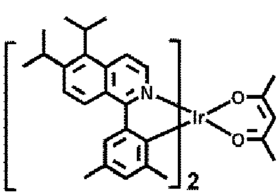
Ir-I

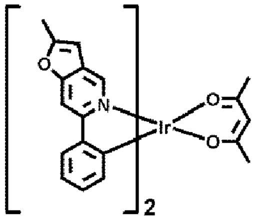
Ir-J

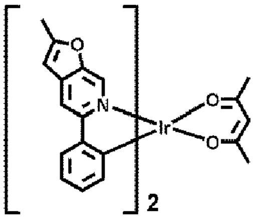
Ir-K

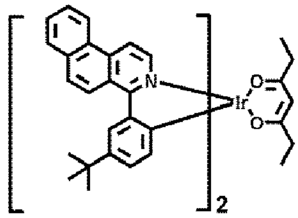
Ir-L

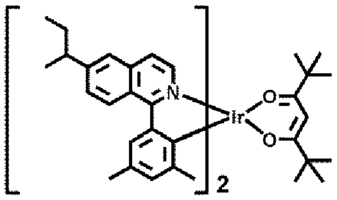
Ir-1

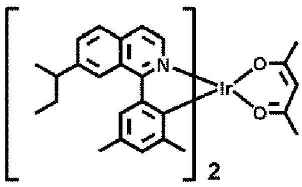
Ir-2

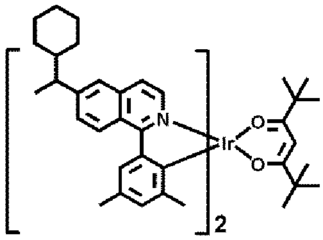
Ir-3

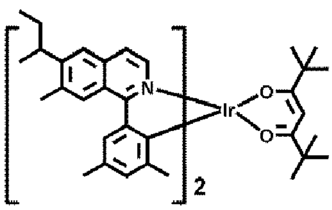
Ir-4

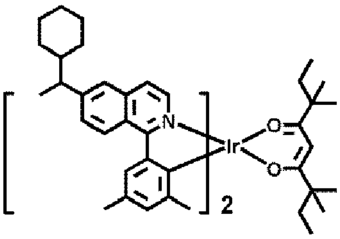
Ir-5

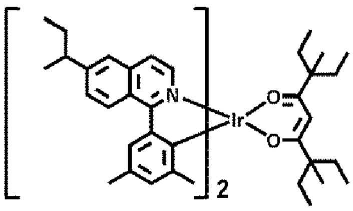
Ir-6

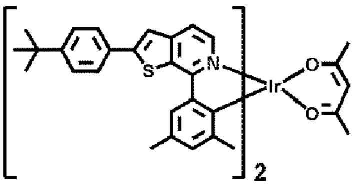
Ir-7

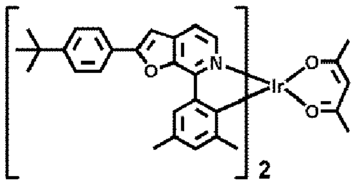
Ir-8

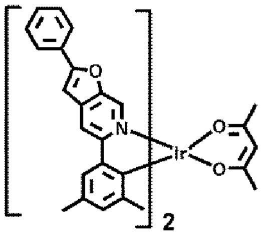
Ir-9

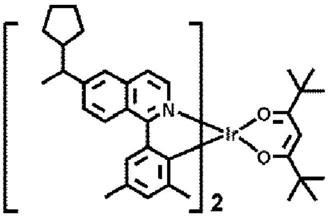
Ir-10

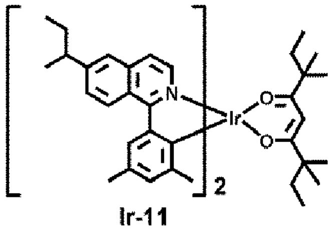
Ir-11

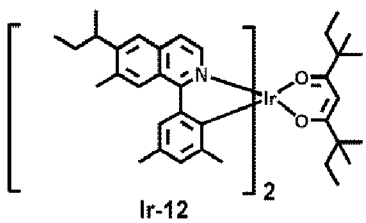
Ir-12

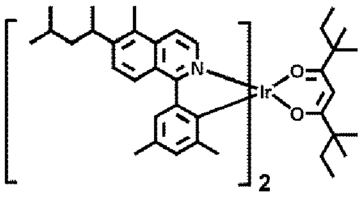

Ir-13

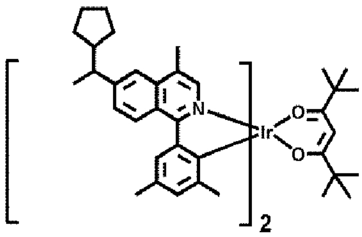

Ir-14

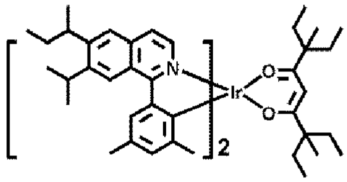

Ir-15

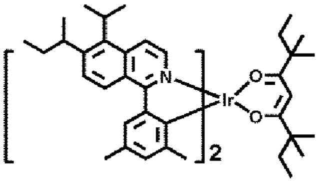

Ir-16

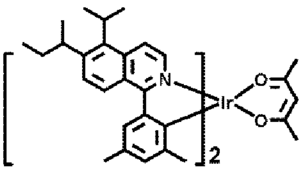

Ir-17

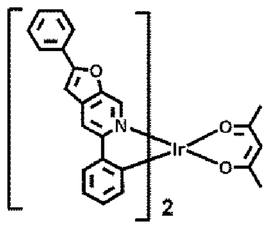

Ir-18

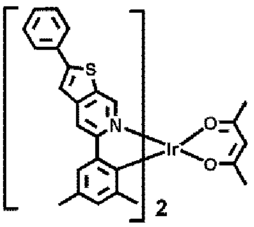

Ir-19

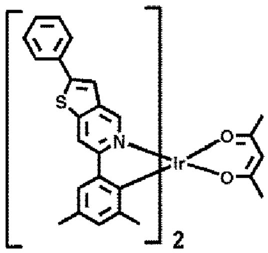

Ir-20

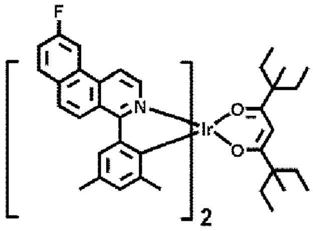

Ir-21

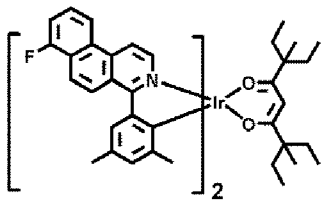

Ir-22

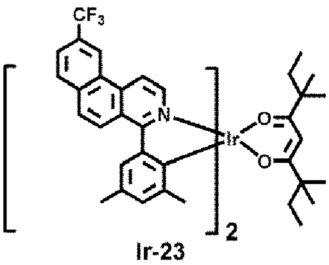

Ir-23

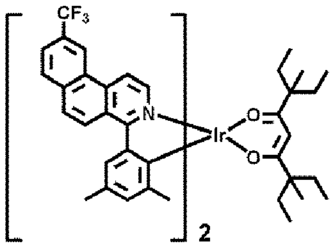

Ir-24

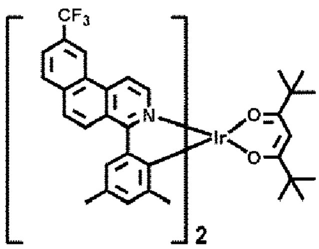

Ir-25

In Ir-C, n-Hex represents n-hexyl group.

Referring to Table 14, it is confirmed that the organic light-emitting devices of Examples Ir-1 to Ir-25 have improved quantum emission efficiency and improved roll-off ratio, as compared with those of the organic light-emitting devices of Comparative Examples Ir-A to Ir-L

Since the organometallic compound has excellent internal quantum emission efficiency and optical orientation, an electronic device, for example, an organic light-emitting device, which includes the organometallic compound, may have excellent external quantum emission efficiency and excellent roll-off ratio.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope of the present description as defined by the following claims.

**Claims**

1. An organometallic compound comprising a transition metal and at least one organic ligand, wherein, the organometallic compound satisfies Condition 1, and the organometallic compound has a radiative decay rate of $2.5 \times 10^5$ reverse seconds or more:

Condition 1

$$1.02 - x \leq y \leq 1.95 - 2.7x,$$

wherein,

in Condition 1, x is an x coordinate value in principal moments of inertia diagram of the organometallic compound, wherein x is $I_1/I_3$ of the organometallic compound,
in Condition 1, y is a y coordinate value in the principal moments of inertia diagram of the organometallic compound, wherein y is $I_2/I_3$ of the organometallic compound,
$I_1$, $I_2$, and $I_3$ are three principal moments of inertia of the organometallic compound, which satisfy a relationship of $I_1 \leq I_2 \leq I_3$,
$I_1$, $I_2$, and $I_3$ are evaluated using a density functional theory method for the organometallic compound,
the radiative decay rate of the organometallic compound is a value calculated from a time-resolved photoluminescence spectrum with respect to film 1, and
the film 1 is a 40-nanometer-thick film obtained by vacuum-codepositing 1,3-di(9H-carbazol-9-yl)benzene and the organometallic compound on a quartz substrate at a weight ratio of 90 : 10 to 99 : 1.

2. The organometallic compound of claim 1, wherein the transition metal is platinum, palladium, gold, or iridium.

3. The organometallic compound of claims 1 or 2, wherein the organometallic compound satisfies Condition 2:

Condition 2

$$1.06 - x \leq y \leq 1.95 - 2.7x,$$

wherein, in Condition 2, x and y are each independently the same as described in claim 1; and/or wherein the organometallic compound satisfies Condition 3:

Condition 3

$$1.06 - x \leq y \leq 4.70 - 10.0x,$$

wherein, in Condition 3, x and y are each independently the same as described in claim 1; and/or wherein the transition metal is platinum and the organometallic compound satisfies Condition 4:

Condition 4

$$1.02 - x \leq y \leq 1.16 - x,$$

wherein, in Condition 4, x and y are each independently the same as described in claim 1; and/or wherein

the transition metal is iridium, and the organometallic compound satisfies Condition 5:

Condition 5

$$1.00 - 0.5x \leq y \leq 1.95 - 2.7x,$$

wherein, in Condition 5, x and y are each independently the same as described in claim 1.

**4.** The organometallic compound of any of claims 1-3, wherein
x is in a range of 0.08 to 0.39; and/or
wherein
y is in a range of 0.30 to 1.00.

**5.** The organometallic compound of any of claims 1-4, wherein
the organometallic compound has a radiative decay rate in a range of $2.5x10^5$ $s^{-1}$ to $2.0x10^6$ $s^{-1}$; and/or
wherein
the organometallic compound has a horizontal orientation ratio of a transition dipole moment in a range of 85 % to 100 %.

**6.** The organometallic compound of any of claims 1-5, wherein
the organic ligand comprises a tetradentate organic ligand, and
the tetradentate organic ligand comprises a $C_3$-$C_8$ nitrogen-containing condensed ring system in which a five membered ring and a six membered ring are condensed to each other.

**7.** The organometallic compound of claim 6, wherein
the tetradentate organic ligand comprises a benzimidazole ring system;
preferably wherein
the tetradentate organic ligand comprises a benzimidazole ring system substituted with a substituted phenyl group and
the substituted phenyl group is substituted with both at least one phenyl group and at least one tert-butyl group.

**8.** The organometallic compound of any of claims 1-7, wherein
the organic ligand comprises a bidentate organic ligand, and
the bidentate organic ligand comprises i) a $C_3$-$C_{15}$ nitrogen-containing condensed ring system in which at least two six membered rings are condensed to each other or ii) a $C_3$-$C_8$ condensed ring system in which a five membered ring and a six membered ring are condensed to each other.

**9.** The organometallic compound of claim 8, wherein
the organic ligand comprises

1) a bidentate organic ligand comprising a quinoline ring and a benzene ring, a bidentate organic ligand comprising an isoquinoline ring and a benzene ring, a bidentate organic ligand comprising an azabenzothiophene ring and a benzene ring, a bidentate organic ligand comprising an azabenzofuran ring and a benzene ring, a bidentate organic ligand comprising a benzoquinoline ring and a benzene ring, or a bidentate organic ligand comprising an benzoisoquinoline ring and a benzene ring; and
2) a bidentate organic ligand linked to the transition metal via oxygen.

**10.** An organic light-emitting device comprising:

a first electrode;
a second electrode; and
an organic layer disposed between the first electrode and the second electrode, wherein the organic layer comprises an emission layer and at least one organometallic compound of any of claims 1-9.

**11.** The organic light-emitting device of claim 10, wherein
the emission layer comprises the organometallic compound.

**12.** The organic light-emitting device of claim 11, wherein
a horizontal orientation ratio of a transition dipole moment of the organometallic compound with respect to a plane of the emission layer is in a range of 85% to 100%.

**13.** The organic light-emitting device of claim 12, wherein
the emission layer further comprises a host;
preferably wherein
the host comprises a carbazole group, a fluorene group, a spiro-bifluorene group, a dibenzofuran group, a dibenzothiophene group, a dibenzosilole group, an indenocarbazole group, an indolocarbazole group, a benzofurocarbazole group, a benzothienocarbazole group, an acridine group, a dihydroacridine group, a triindolobenzene group, an azadibenzofuran group, an azadibenzothiophene group, an azacarbazole group, an azafluorene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a phenazine group, a cinnoline group, a cyano group, a phosphine oxide group, a sulfoxide group, or any combination thereof.

**14.** The organic light-emitting device of claim 13, wherein
the host comprises a hole-transporting host and an electron-transporting host, and
the hole-transporting host and the electron-transporting host are different from each other.

**15.** The organic light-emitting device of claim 14, wherein
the electron-transporting host comprises at least one electron-transporting moiety,
the hole-transporting host does not comprise an electron-transporting moiety or an unsubstituted or substituted amine group, and
the electron-transporting moiety is a cyano group, a π electron-depleted nitrogen-containing cyclic group, a group represented by one of the following formulae, or any combination thereof:

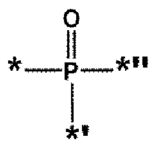 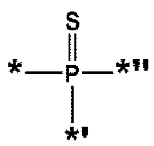 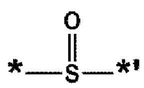 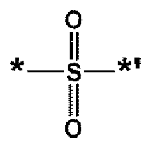 ,

wherein, in the formulae, *, *', and *" each indicate a binding site to a neighboring atom.

FIG. 1

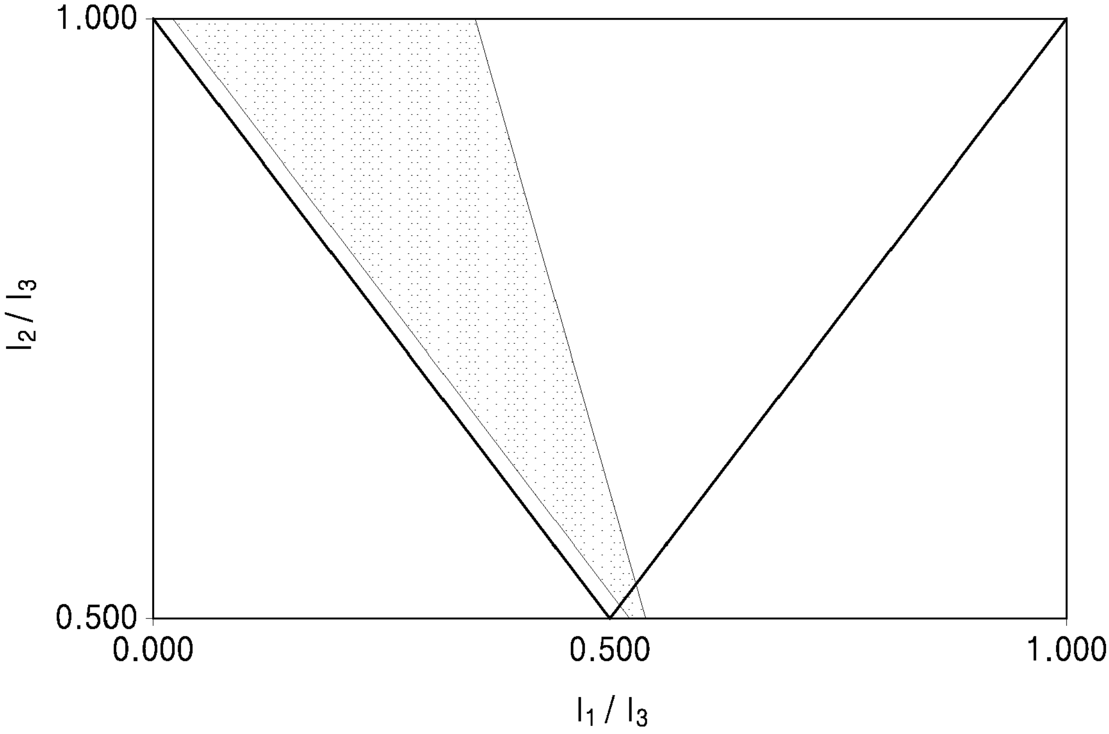

FIG. 2

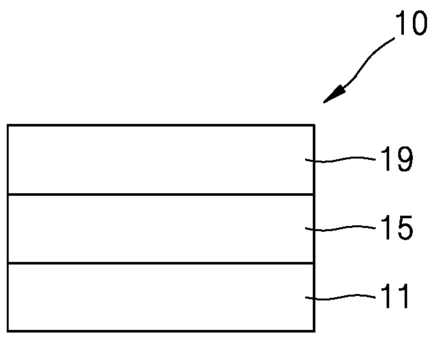

Europäisches Patentamt
European Patent Office
Office européen des brevets

# EUROPEAN SEARCH REPORT

Application Number
EP 19 20 1655

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| E | EP 3 560 940 A1 (SAMSUNG ELECTRONICS CO LTD [KR]) 30 October 2019 (2019-10-30)<br>* page 61; claims 13,14; compounds 1,2 *<br>----- | 1-5,8-13 | INV.<br>H01L51/54 |
| X<br><br>Y | EP 3 266 790 A1 (SAMSUNG ELECTRONICS CO LTD [KR]) 10 January 2018 (2018-01-10)<br>* page 74; claims 13,14; compounds 3-524 *<br>----- | 1-7,<br>10-13<br>14,15 | |
| X<br><br>Y | EP 2 602 302 A2 (UNIVERSAL DISPLAY CORP [US]) 12 June 2013 (2013-06-12)<br>* page 10; claims 12-15; compound 10 *<br>----- | 1-5,8-13<br><br>14,15 | |
| X | WO 2018/105986 A1 (ROHM & HAAS ELECT MATERIALS KOREA LTD [KR])<br>14 June 2018 (2018-06-14)<br>* page 10; compounds D-26 *<br>* paragraph [0028] *<br>----- | 1-5,8-13 | |
| Y | US 2016/164020 A1 (KIM JANG JOO [KR] ET AL) 9 June 2016 (2016-06-09)<br>* paragraph [0012] *<br>* paragraph [0019] *<br>* paragraph [0043] *<br>* paragraph [0054] *<br>* paragraph [0071] *<br>----- | 14,15 | TECHNICAL FIELDS SEARCHED (IPC)<br>H01L |

The present search report has been drawn up for all claims

1

| Place of search | Date of completion of the search | Examiner |
|---|---|---|
| Munich | 3 February 2020 | Beierlein, Udo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 19 20 1655

This annex lists the patent family members relating to the patent documents cited in the above-mentioned European search report. The members are as contained in the European Patent Office EDP file on
The European Patent Office is in no way liable for these particulars which are merely given for the purpose of information.

03-02-2020

| Patent document cited in search report | Publication date | Patent family member(s) | Publication date |
|---|---|---|---|
| EP 3560940 A1 | 30-10-2019 | CN 110386951 A | 29-10-2019 |
| | | EP 3560940 A1 | 30-10-2019 |
| | | JP 2019189604 A | 31-10-2019 |
| | | US 2019326527 A1 | 24-10-2019 |
| EP 3266790 A1 | 10-01-2018 | CN 107573383 A | 12-01-2018 |
| | | EP 3266790 A1 | 10-01-2018 |
| | | JP 2018002722 A | 11-01-2018 |
| | | KR 20180005128 A | 15-01-2018 |
| | | KR 20190084015 A | 15-07-2019 |
| | | TW 201808977 A | 16-03-2018 |
| | | US 2018013078 A1 | 11-01-2018 |
| EP 2602302 A2 | 12-06-2013 | CN 103159798 A | 19-06-2013 |
| | | CN 108358975 A | 03-08-2018 |
| | | EP 2602302 A2 | 12-06-2013 |
| | | JP 6332904 B2 | 30-05-2018 |
| | | JP 6426676 B2 | 21-11-2018 |
| | | JP 2013121957 A | 20-06-2013 |
| | | JP 2017014275 A | 19-01-2017 |
| | | KR 20130065595 A | 19-06-2013 |
| | | KR 20190088453 A | 26-07-2019 |
| | | TW 201329203 A | 16-07-2013 |
| | | TW 201728742 A | 16-08-2017 |
| | | TW 201920599 A | 01-06-2019 |
| | | US 2013146848 A1 | 13-06-2013 |
| | | US 2017047531 A1 | 16-02-2017 |
| | | US 2020006675 A1 | 02-01-2020 |
| WO 2018105986 A1 | 14-06-2018 | CN 109952358 A | 28-06-2019 |
| | | EP 3551721 A1 | 16-10-2019 |
| | | KR 20180065353 A | 18-06-2018 |
| | | US 2019326525 A1 | 24-10-2019 |
| | | WO 2018105986 A1 | 14-06-2018 |
| US 2016164020 A1 | 09-06-2016 | KR 20160067629 A | 14-06-2016 |
| | | US 2016164020 A1 | 09-06-2016 |

EPO FORM P0459

For more details about this annex : see Official Journal of the European Patent Office, No. 12/82